(19) Europäisches Patentamt
European Patent Office
Office européen des brevets

(11) **EP 2 267 785 A2**

(12) **EUROPÄISCHE PATENTANMELDUNG**

(43) Veröffentlichungstag:
29.12.2010 Patentblatt 2010/52

(51) Int Cl.:
*H01L 29/78* (2006.01)  *H01L 29/739* (2006.01)
*H01L 29/872* (2006.01)  *H01L 29/40* (2006.01)
*H01L 29/06* (2006.01)  *H01L 29/08* (2006.01)

(21) Anmeldenummer: 10184344.9

(22) Anmeldetag: 27.07.2006

(84) Benannte Vertragsstaaten:
**DE FR GB NL**

(30) Priorität: 27.07.2005 DE 102005035153
19.08.2005 DE 102005039331
03.03.2006 DE 102006009942
17.05.2006 US 435979

(62) Dokumentnummer(n) der früheren Anmeldung(en)
nach Art. 76 EPÜ:
**06776463.9 / 1 908 119**

(71) Anmelder: **Infineon Technologies Austria AG**
**9500 Villach (AT)**

(72) Erfinder:
• **Pfirsch, Frank**
**81545 München (DE)**
• **Mauder, Anton**
**83059 Kolbermoor (DE)**

• **Willmeroth, Armin**
**86163 Augsburg (DE)**
• **Sedlmaier, Stefan**
**81547 München (DE)**
• **Zundel, Markus**
**85658 Egmating (DE)**
• **Hirler, Franz**
**84424 Isen (DE)**
• **Mittal, Arunjai**
**81547 München (DE)**

(74) Vertreter: **Patentanwälte**
**Westphal, Mussgnug & Partner**
**Herzog-Wilhelm-Strasse 26**
**80331 München (DE)**

Bemerkungen:
Diese Anmeldung ist am 30-09-2010 als Teilanmeldung zu der unter INID-Code 62 erwähnten Anmeldung eingereicht worden.

(54) **Halbleiterbauelement mit einer Driftzone und einer Driftsteuerzone**

(57) Beschrieben wird ein Halbleiterbauelement das einen Halbleiterkörper (100) und folgende weitere Merkmale aufweist:
- eine Driftzone (2; 211) eines ersten Leitungstyps in dem Halbleiterkörper (100),
- eine Driftsteuerzone (3; 241) aus einem Halbleitermaterial, die zumindest abschnittsweise benachbart zu der Driftzone (2) in dem Halbleiterkörper angeordnet ist,
- ein Akkumulationsdielektrikum (4; 251), das zwischen der Driftzone (2; 211) und der Driftsteuerzone (3; 241) angeordnet ist,
- eine erste Bauelementzone (8; 212) und eine beabstandet zu der ersten Bauelementzone (8) angeordnete zweite Bauelementzone (5; 214), zwischen denen die Driftzone (2; 211) angeordnet ist,
- ein kapazitives Bauelement (50; 263), das zwischen die Driftsteuerzone (3; 241) und die erste Bauelementzone (8; 212) geschaltet ist.

FIG 18

**Beschreibung**

BEREICH DER ERFINDUNG

Die Erfindung betrifft ein Halbleiterbauelement, insbesondere ein Leistungshalbleiterbauelement, mit niedrigem Einschaltwiderstand.

HINTERGRUND DER ERFINDUNG

Ein wichtiges Ziel bei der Entwicklung von Leistungshalbleiterbauelementen besteht darin, möglichst hochsperrende Bauelemente herzustellen, die dennoch einen niedrigen Einschaltwiderstand haben und die gleichzeitig möglichst geringe Schaltverluste aufweisen.

Eine Möglichkeit, den Einschaltwiderstand eines Leistungshalbleiterbauelements bei einer gegebenen Sperrfähigkeit zu reduzieren, ist die Verwendung des Kompensationsprinzips, das beispielsweise in US 4,754,310 (Coe), US 5,216,275 A1 (Chen), US 5,438,215 oder DE 43 09 764 C2 (Tihanyi) beschrieben ist.

Eine weitere Möglichkeit zur Reduzierung des Einschaltwiderstandes eines Halbleiterbauelements besteht im Vorsehen einer gegenüber der Driftzone dielektrisch isolierten Feldelektrode. Derartige Bauelemente sind in US 4,903,189 (Ngo), US 4,941,026 (Temple), US 6,555,873 B2 (Disney), US 6,717,230 B2 (Kocon) oder US 6,853,033 B2 (Liang) beschrieben.

Die EP 1 073 123 A2 (Yasuhara) beschreibt einen lateralen Leistungs-MOSFET, der mehrere in einer Driftzone des Bauelements angeordnete Hilfselektroden aufweist, die durch ein Dielektrikum gegenüber der Driftzone isoliert sind. Diese Hilfselektroden bestehen aus einem halbisolierenden Polysilizium (SIPOS) oder einem Widerstandsmaterial und sind zwischen einen Source- und einen Drainanschluss des Bauelements geschaltet. Die Hilfselektroden bewirken die Ausbildung einer Verarmungszone (depletion layer) in der Driftzone bei sperrend angesteuertem Bauelement.

Die GB 2 089 118 A beschreibt einen Leistungs-MOSFET, der eine Widerstandsschicht aufweist, die sich entlang der Driftzone zwischen einer Gateelektrode und einer Drainelektrode erstreckt und die ein elektrisches Feld in der Driftzone mit dem Ziel einer Erhöhung der Spannungsfestigkeit "aufspreizt".

Die US 5,844,272 (Söderbärg) beschreibt einen lateralen Hochfrequenztransistor mit einer in lateraler Richtung eines Halbleiterkörpers verlaufenden Driftzone.

Die US 2003/0073287 A1 (Kocon) schlägt vor, entlang der Driftstrecke eines Halbleiterbauelements mehrere Feldelektroden, die auf unterschiedlichem Potential liegen, vorzusehen.

Die Aufgabe der vorliegenden Erfindung besteht darin, ein Halbleiterbauelement, insbesondere ein Leistungshalbleiterbauelement, mit einer Driftstrecke/Driftzone bereitzustellen, das einen niedrigen Einschaltwiderstand aufweist.

ZUSAMMENFASSUNG DER ERFINDUNG

Das erfindungsgemäße Halbleiterbauelement weist in einem Halbleiterkörper eine Driftzone und eine Driftsteuerzone aus einem Halbleitermaterial auf, wobei die Driftsteuerzone zumindest abschnittsweise benachbart zu der Driftzone angeordnet ist und wobei ein Akkumulationsdielektrikum zwischen der Driftzone und der Driftsteuerzone angeordnet ist. Die Driftsteuerzone dient bei diesem Bauelement zur Steuerung eines leitenden Kanals in der Driftzone entlang des Akkumulationsdielektrikums.

KURZE BESCHREIBUNG DER FIGUREN

Die Erfindung wird nachfolgend anhand von Figuren näher erläutert.

Figur 1          zeigt einen Abschnitt eines erfindungsgemäßen Halbleiterbauelements, das als planarer MOSFET ausgebildet ist und das einen Halbleiterkörper mit mehreren MOSFET-Zellen und mehreren in der Driftzone angeordneten Driftsteuerzonen aufweist, wobei zwischen der Driftzone und den Driftsteuer- zonen ein Dielektrikum angeordnet ist.

Figur 2          zeigt einen Querschnitt durch einen Abschnitt ei- nes planaren MOSFETs mit mehreren Driftsteuerzo- nen, bei dem sich das Dielektrikum in vertikaler Richtung zwischen zwei einander gegenüberliegen- den Seiten des Halbleiterkörpers erstreckt.

Figur 3          zeigt einen Querschnitt durch einen Abschnitt ei- nes planaren MOSFETs, dessen Driftsteuerzonen sich bis zur Source-seitigen Oberfläche des Halb- leiterkörpers erstrecken.

Figur 4 — zeigt einen Querschnitt durch einen Abschnitt ei- nes erfindungsgemäßen MOSFETs mit an die Bodyzo- nen angrenzenden Kompensationszonen, zwischen de- nen komplementär zu den Bodyzonen dotierte Zwi- schenzonen angeordnet sind, wobei die Driftsteu- erzonen Drain-seitig von den Zwischenzonen ange- ordnet sind.

Figur 5 — zeigt einen MOSFET gemäß Figur 4, bei dem sich das die Driftsteuerzonen umgebende Dielektrikum bis zu den Zwischenzonen erstreckt.

Figur 6 — zeigt einen Querschnitt durch einen Abschnitt ei- nes mehrere Kompensationszonen aufweisenden MOS- FETs mit mehreren Driftsteuerzonen, die in late- raler Richtung voneinander beabstandet sind und die im Bereich unterhalb der Kompensationszonen einen geringeren Abstand aufweisen als in den an- deren Bereichen des Halbleiterkörpers.

Figur 7 — zeigt einen Querschnitt durch einen Abschnitt ei- nes MOSFET mit einer Anzahl in lateraler Richtung äquidistant voneinander beabstandeten Driftsteu- erzonen.

Figur 8 — zeigt einen Querschnitt durch einen Abschnitt ei- nes erfindungsgemäßen Halbleiterbauele- ments, das als Trench-MOSFET mit mehreren, in Gräben des Halbleiterkörpers angeordneten Gateelektroden ausgebildet ist, sowie mit Driftsteuerzonen, die unterhalb der Gateelektroden angeordnet sind.

Figur 9 — zeigt einen Querschnitt durch einen Abschnitt ei- nes Trench-MOSFETs gemäß Figur 8, bei dem die Driftsteuerzonen sowie das zwischen den Drift- steuerzonen und den Driftzonen angeordnete Die- lektrikum von einer zwischen den Gateelektroden und der Driftzone angeordneten Gate- Isolierung beabstandet sind.

Figur 10 — zeigt einen Querschnitt durch einen Abschnitt ei- nes Trench-MOSFETs mit mehreren Driftsteu- erzonen, die in lateraler Richtung jeweils zwischen den Gateelektroden angeordnet sind und wobei sich die Driftsteuerzonen und ein zwischen den Driftsteu- erzonen und der Driftzone angeordnetes Dielektri- kum in vertikaler Richtung zwischen einander ge- genüberliegenden Seiten des Halbleiterkörpers erstrecken.

Figur 11 — zeigt einen Abschnitt eines vertikalen MOSFET entsprechend Figur 8, bei dem das zwischen der Driftzone und der Driftsteuerzone angeordnete Dielektrikum zwei Teilschichten aufweist, zwi- schen denen Luft oder ein Material mit einer niedrigen Dielektrizitätskonstante angeordnet ist.

Figur 12 — zeigt einen Querschnitt durch einen Abschnitt ei- nes MOSFETs mit einer Driftsteuerzone, die zusam- men mit Source-seitig und Drain-seitig an die Driftsteuerzone angrenzenden, stark n-dotierten Verbindungszonen einen Sperrschicht- Feldeffekttransistor bildet, wobei die Driftsteu- erzone über eine erste Diode an die Sourcezone angeschlossen ist.

Figur 13 — zeigt ein Beispiel für den Verlauf der Elektro- nenverteilung eines leitenden MOSFETs nach dem Stand der Technik.

Figur 14 — zeigt ein Beispiel für den Verlauf der Elektro- nenverteilung eines leitenden erfindungsgemäßen MOSFETs gemäß Figur 12.

Figur 15 — zeigt ein Diagramm, in dem der Verlauf des Drain- Source-Stromes eines MOSFETs gemäß dem Stand der Technik und der Verlauf des Drain-Source-Stromes eines erfindungsgemäßen MOSFETs gemäß Figur 12 in Abhängigkeit von der Drain-Source-Spannung $U_{DS}$ ge- genübergestellt sind.

Figur 16 — zeigt einen Querschnitt durch einen Abschnitt ei- nes erfindungsgemäßen MOSFETs gemäß Figur 12, bei dem die Driftsteuerzonen Source-seitig mittels einer schwach p-dotierten Verbin- dungszone gefolgt von einer stark p-dotierten Verbindungszone über eine erste Diode an die Sourcezonen und mittels einer p-dotierten Verbindungszone an die Drainzo- nen angeschlossen sind.

| | |
|---|---|
| Figur 17A | zeigt den MOSFET gemäß Figur 16, bei dem die Sourcezonen und die Driftsteuerzonen über einen Kondensator verbunden sind und bei dem die Drift- steuerzonen und die Gateelektroden über eine zweite Diode miteinander verbunden sind. |
| Figur 17B | zeigt einen gegenüber dem MOSFET in Figur 17A ab- gewandelten MOSFET, bei dem die Driftsteuerzone zumindest abschnittsweise über ein Tunneldie- lektrikum an eine Drainelektrode gekoppelt ist. |
| Figur 18 | zeigt den MOSFET gemäß den Figuren 16 und 17, der mit einer ersten Diode entsprechend Figur 16 so- wie mit einer zweiten Diode und einem Kondensator gemäß Figur 17a beschaltet ist und bei dem die Driftsteuerzonen Drain-seitig mittels einer drit- ten Diode mit den Drainzonen verbunden sind. |
| Figur 19 | zeigt den MOSFET mit der Schaltungsanordnung ge- mäß den Figuren 16 bis 18, bei dem eine Drain- seitige Diode gemäß Figur 15 in den Halbleiter- körper integriert ist und bei dem sich die Drain- zone bis unter die Driftsteuerzone erstreckt. |
| Figur 20 | zeigt ein als MOS-Transistor ausgebildetes Halblei- terbauelement, bei dem zur Verringerung des Ein- schaltwiderstandes eine höher als die Driftzone do- tierte Zwischenzone zwischen der Driftzone und der Bodyzone angeordnet ist. |
| Figur 21 | zeigt in gegenüber Figur 20 abgewandeltes Bauele- ment, bei dem eine Feldelektrode benachbart zu der höher dotierten Zwischenzone angeordnet ist. |
| Figur 22 | zeigt einen Querschnitt durch die in Figur 20 und 21 dargestellten Bauelemente in einer Schnittebene I-I. |
| Figur 23 | zeigt eine Abwandlung der in den Figuren 20 und 21 dargestellten Bauelemente in einer ersten Schnitt- ebene (Figur 23A) und einer zweiten Schnittebene (Figur 23B). |
| Figur 24 | zeigt eine Abwandlung des in Figur 23 dargestell- ten Bauelements. Figur 25 zeigt einen Querschnitt durch das Bauelement gemäß Figur 24 in einer Schnittebene III-III. |
| Figur 26 | zeigt ein als MOS-Transistor realisiertes Halblei- terbauelement, bei dem eine Gateelektrode in verti- kaler Richtung oberhalb einer Driftsteuerzone ange- ordnet ist. |
| Figur 27 | zeigt ein Abwandlung des in Figur 26 dargestellten Bauelements, bei dem die Driftsteuerzone ab- schnittsweise bis an eine Vorderseite eines Halb- leiterkörpers reicht. |
| Figur 28 | zeigt ein als MOS-Transistor realisiertes Halblei- terbauelement, das eine sich an die Bodyzone an- schließende tiefer liegende Bodyzone aufweist. |
| Figur 29 | zeigt einen MOS-Transistor mit einer Schottky-Diode zwischen einer Drainelektrode und einer Driftsteu- erzone. |
| Figur 30 | veranschaulicht ein mögliches Realisierungsverfah- ren für die Schottky-Diode des Bauelements gemäß Figur 29. |
| Figur 31 | zeigt eine erste Abwandlung des Bauelements gemäß Figur 29. |
| Figur 32 | zeigt eine zweite Abwandlung des Bauelements gemäß Figur 29. |
| Figur 33 | veranschaulicht ein mögliches Verfahren zur Her- stellung der in den Figuren 29 bis 32 darge- stellten Halbleiterbauelemente. |
| Figur 34 | zeigt ein als MOS-Transistor realisiertes Halblei- terbauelement, bei dem eine komplementär zu der Drainzone dotierte Halbleiterzone vorhanden ist, die eine Drainelektrode des Bauelements kontak- tiert. |

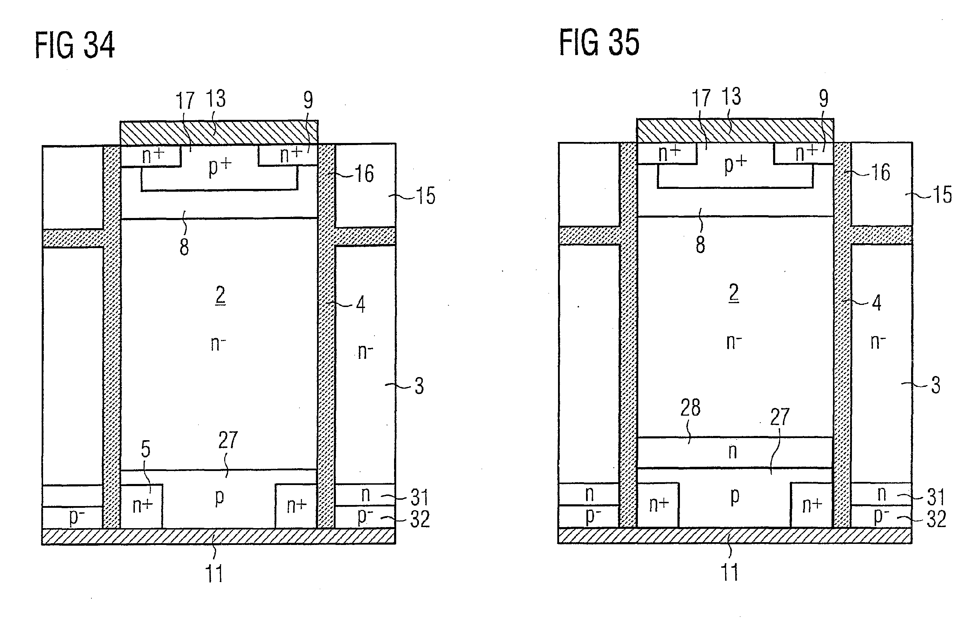

Figur 35      zeigt eine Abwandlung des in Figur 34 dargestellten Bauelements, bei dem eine Feldstoppzone zwischen einer Driftzone und der komplementär zu der Drain- zone dotierten Bauelementzone angeordnet ist.

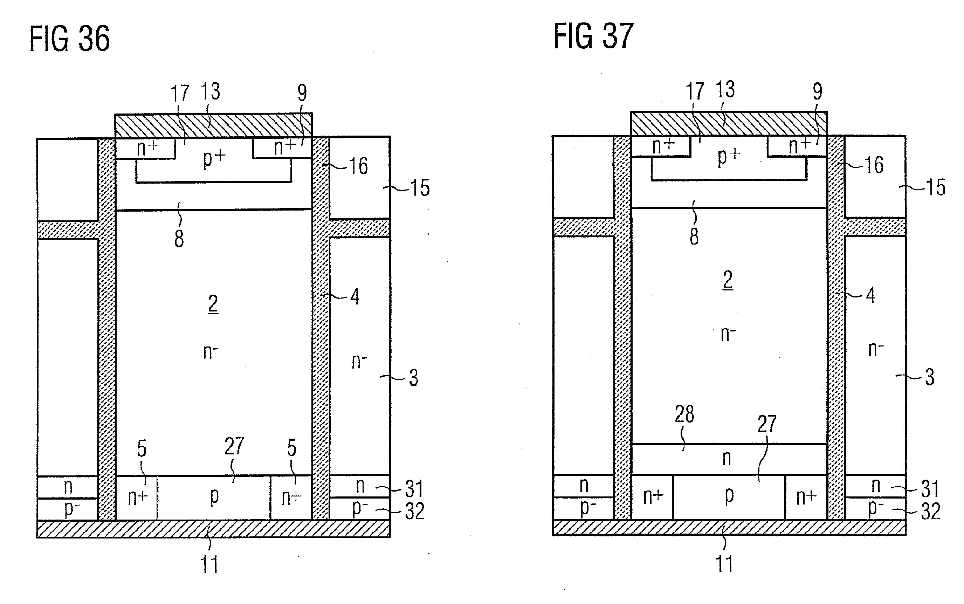

Figuren      36 bis 40 zeigen verschiedene Abwandlungen der in den Figuren 34 und 35 dargestellten Bau- elemente.

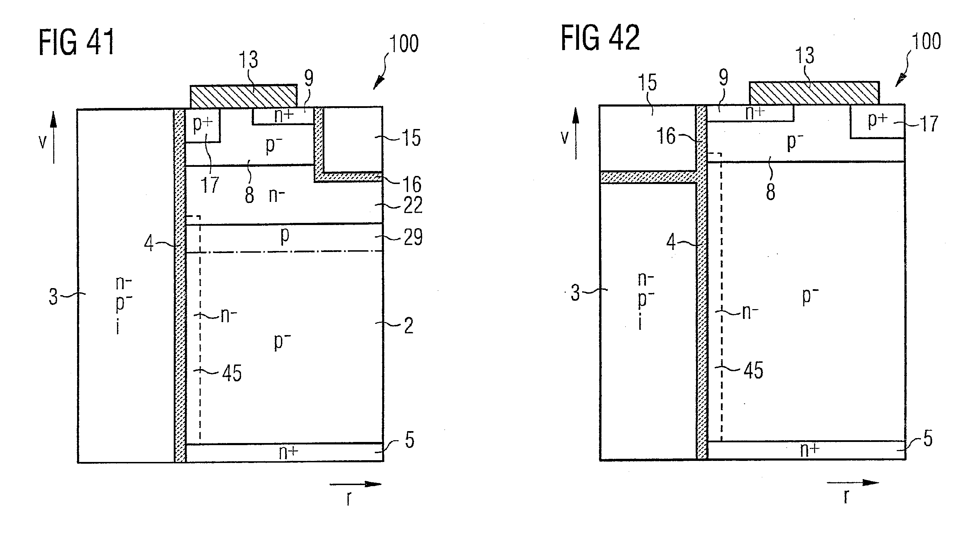

Figur 41      zeigt ein als MOS-Transistor realisiertes Halblei- terbauelement mit einer komplementär zu der Drain- zone dotierten Driftzone.

Figur 42      zeigt eine Abwandlung des in Figur 41 dargestellten Bauelements, wobei eine Gateelektrode in vertikaler Richtung oberhalb einer Driftsteuerzone angeordnet ist.

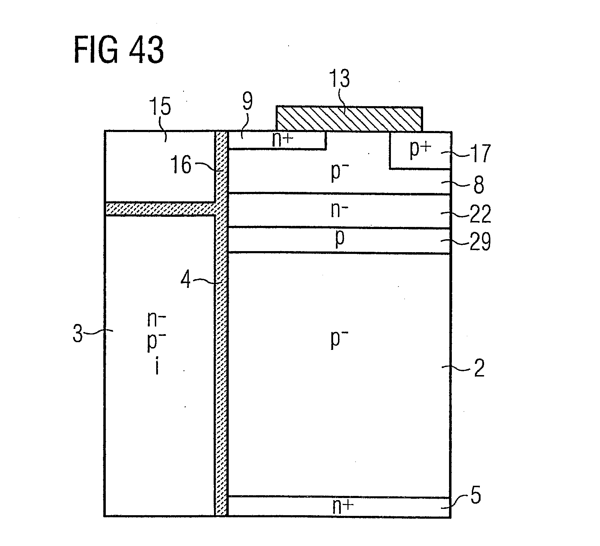

Figur 43      zeigt eine Abwandlung des in Figur 42 dargestellten Bauelements.

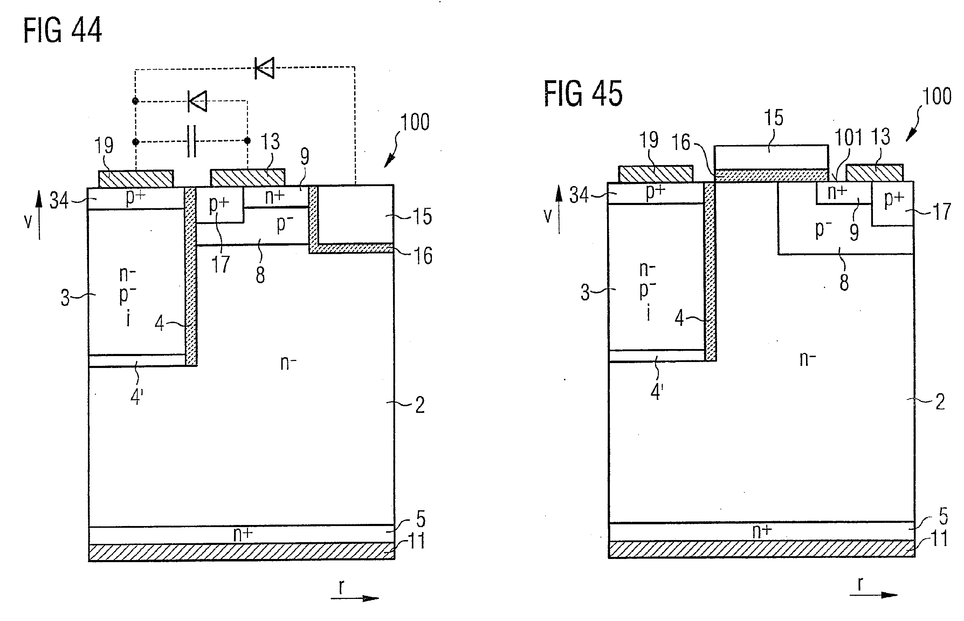

Figur 44      zeigt ein als MOS-Transistor realisiertes Halblei- terbauelement bei dem ein Tunneldielektrikum und ein Abschnitt einer Driftzone zwischen einer Drift- steuerzone und einer Drainzone des Bauelements an- geordnet ist.

Figur 45      zeigt ein gegenüber dem Bauelement in Figur 44 ab- gewandeltes Bauelement, das als planarer MOS- Transistor realisiert ist.

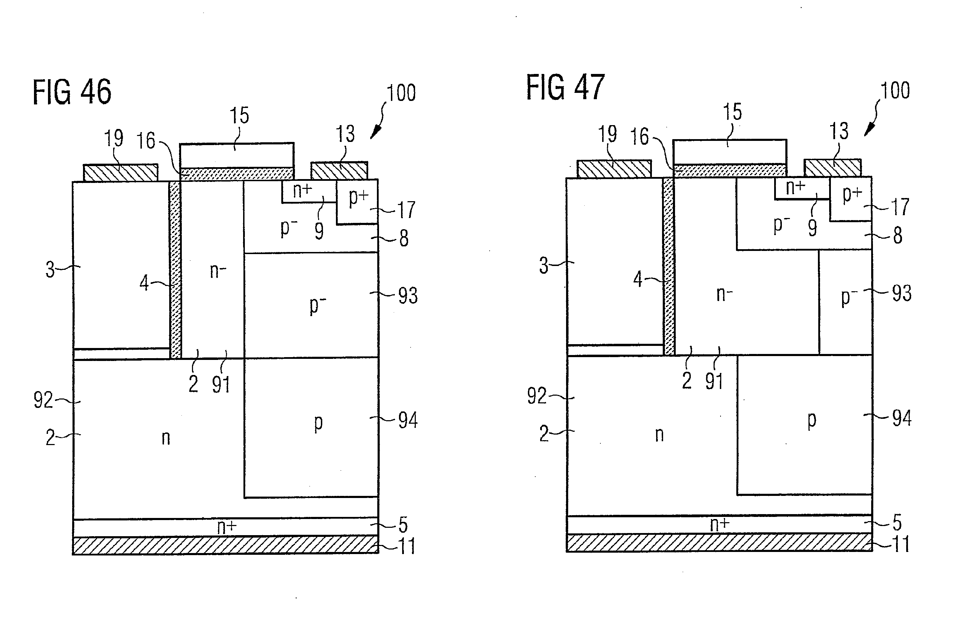

Figur 46      zeigt ein gegenüber Figur 45 abgewandeltes Bauele- ment, bei dem komplementär zueinander dotierte Halbleiterzonen in der Driftzone vorhanden sind.

Figur 47      zeigt ein gegenüber dem Bauelement in Figur 46 ab- gewandeltes Halbleiterbauelement.

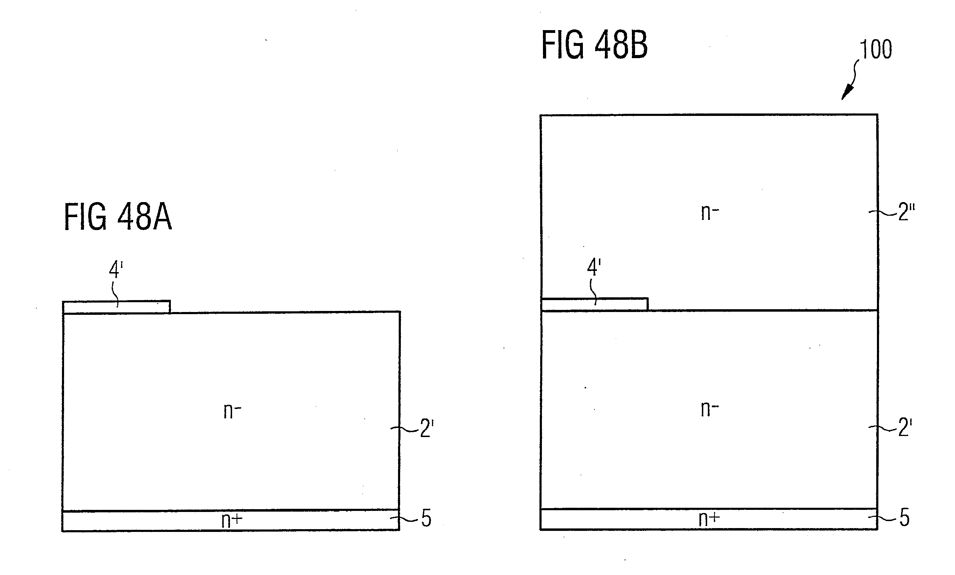

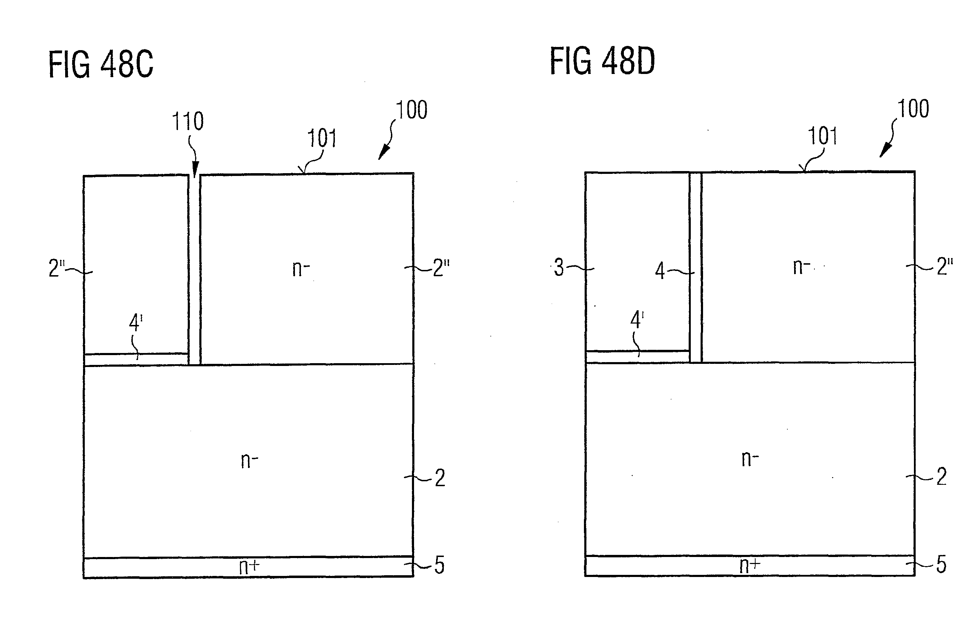

Figur 48      veranschaulicht einzelne Verfahrensschritte zur Herstellung der in den Figuren 44 bis 47 darge- stellten Halbleiterbauelemente.

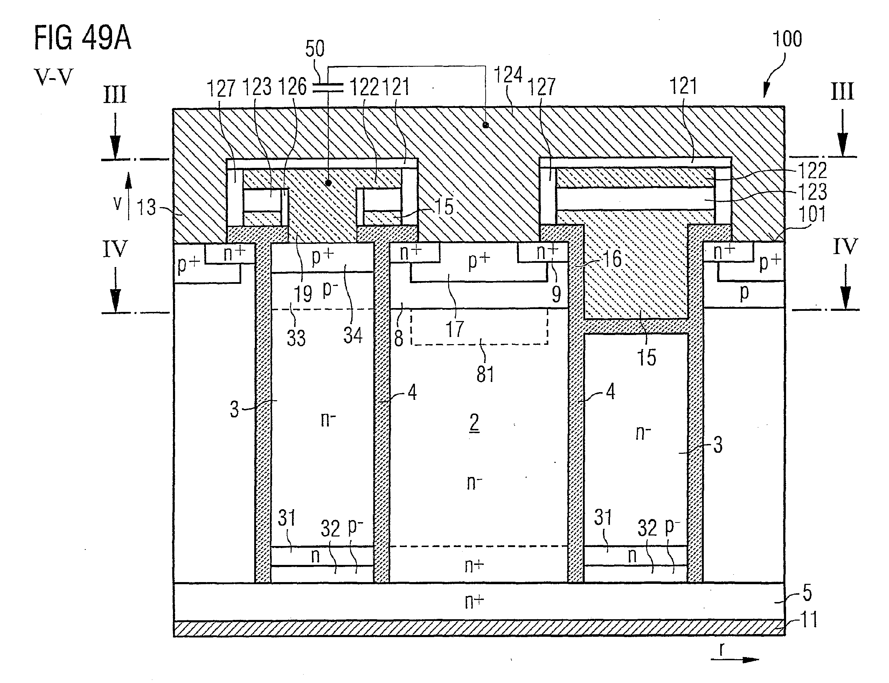

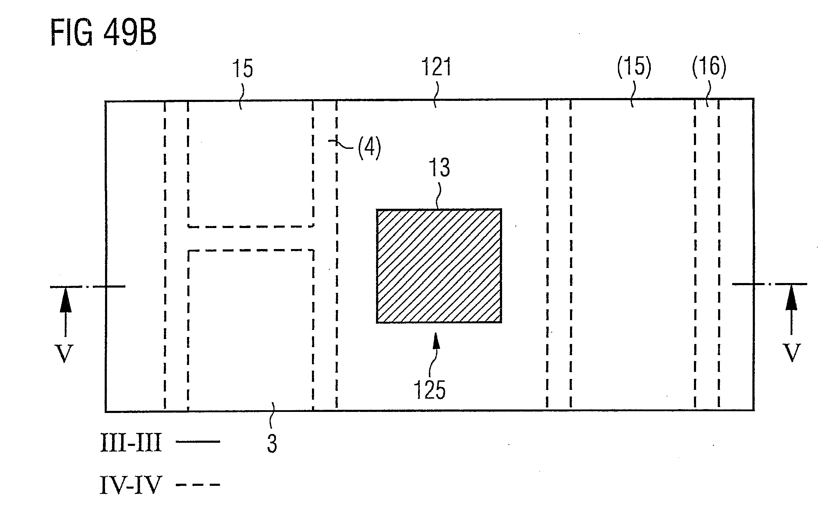

Figur 49      zeigt ein als MOS-Transistor realisiertes Halblei- terbauelement das eine zwischen zwei leitenden Schichten oberhalb eines Halbleiterkörpers integ- rierte Kapazität zwischen einer Sourceelektrode und einer Driftsteuerzone aufweist.

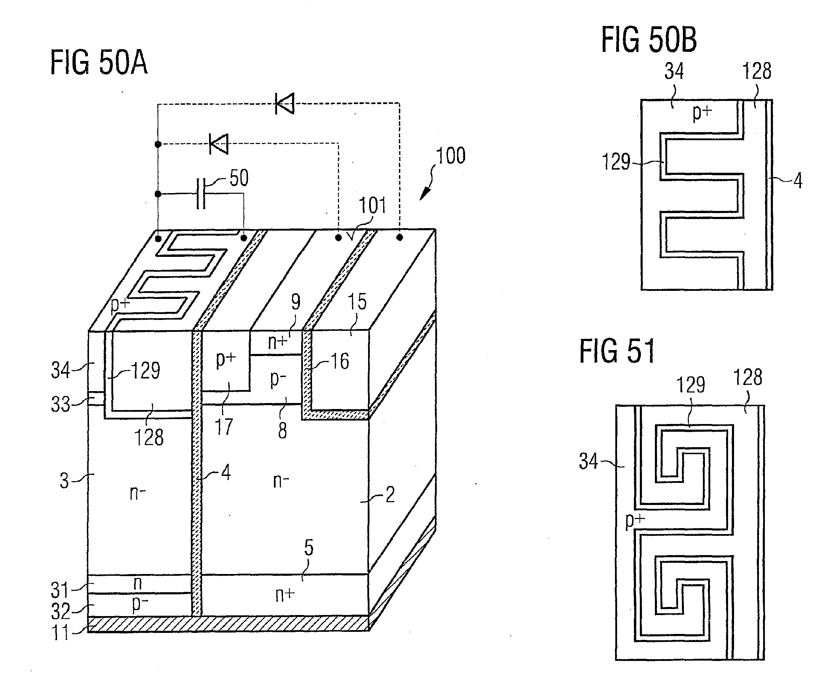

Figuren 50 bis 56      veranschaulichen weitere Möglichkeiten zur Realisierung einer Kapazität in einem Halbleiter- körper.

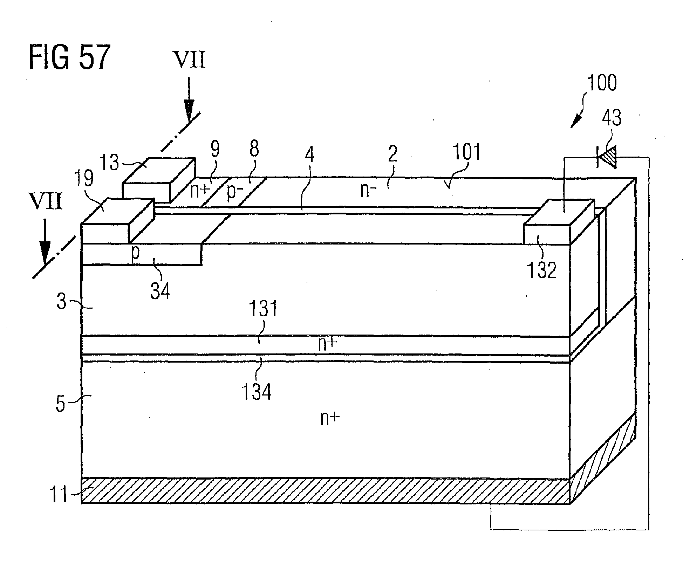

Figur 57      zeigt ein als vertikaler MOS-Transistor realisier- tes Halbleiterbauelement, bei dem eine Draine- lektrode am Rand eines Halbleiterkörpers an eine Driftsteuerzone angeschlossen ist.

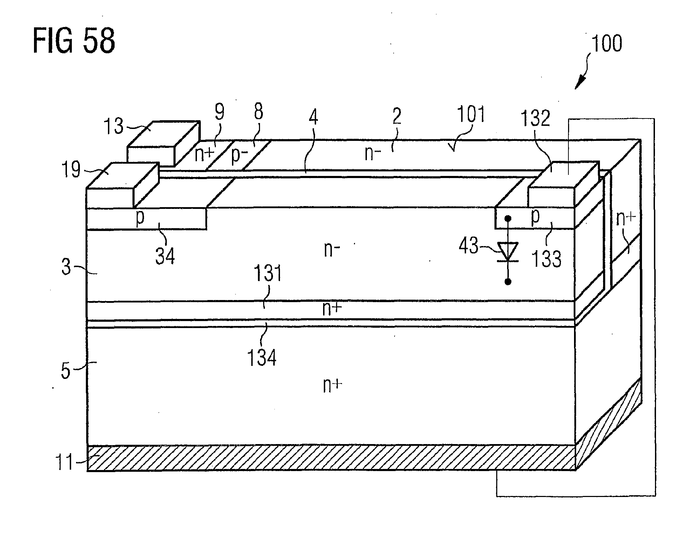

Figuren 58 bis 63      veranschaulichen gegenüber dem Bauelement gemäß Figur 57 abgewandelte Bauelemente.

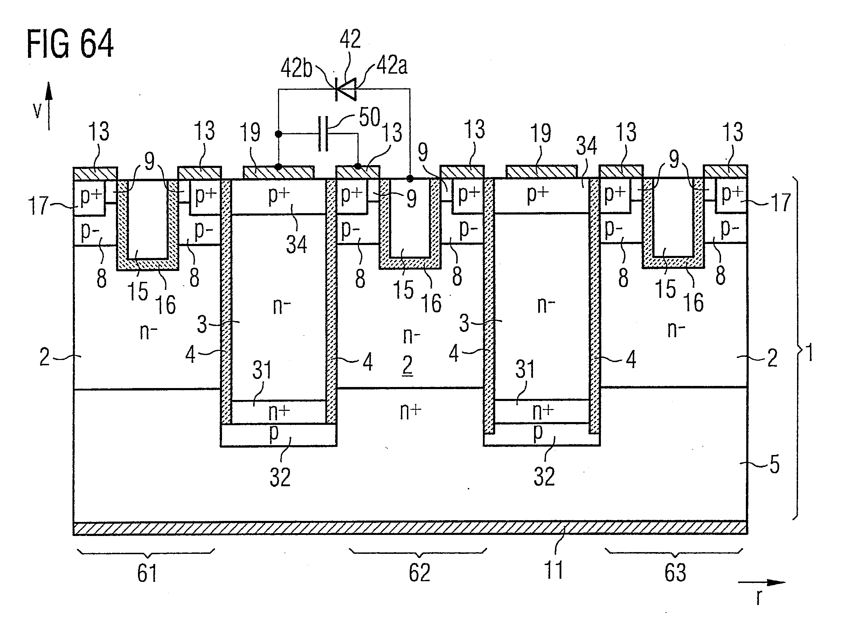

Figur 64      zeigt einen Querschnitt durch einen MOSFET mit mehreren Driftsteuerzonen, von denen jede Drain- seitig über eine integrierte Diode an die Drain- zone angeschlossen und bei dem sich die Drift- steuerzone in vertikaler Richtung bis in die Drainzone hinein erstreckt.

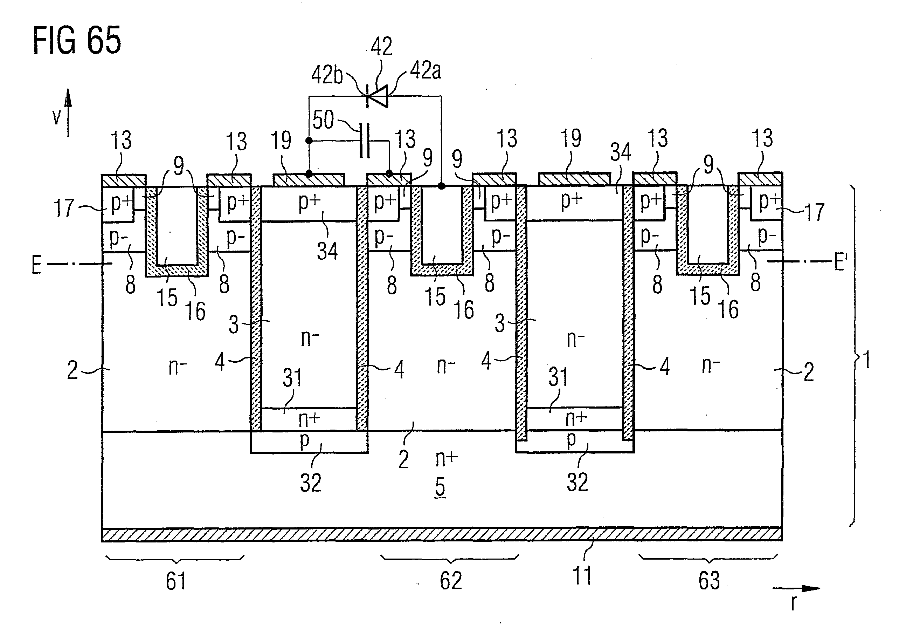

Figur 65      zeigt einen MOSFET entsprechend dem MOSFET gemäß Figur 64, bei dem die Driftsteuerzone in der ver- tikalen Richtung von der hochdotierten Anschluss- zone beabstandet ist.

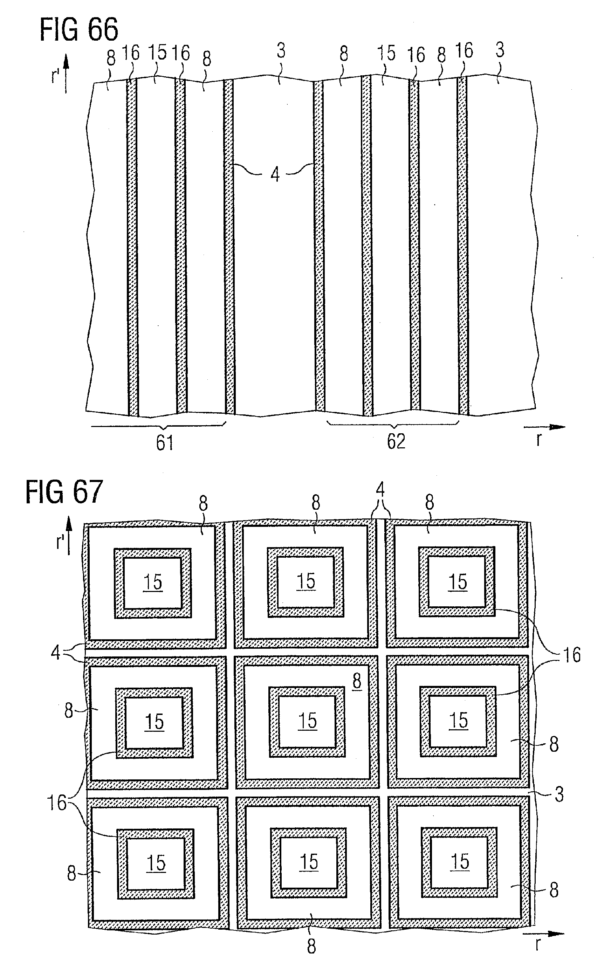

Figur 66      zeigt einen zur vertikalen Richtung senkrecht verlaufenden Querschnitt durch einen erfindungs- gemäßen MOSFET mit Streifenlayout entsprechend dem MOSFET gemäß Figur 65 in einer dort darge- stellten Ebene E-E'.

Figur 67      zeigt einen zur vertikalen Richtung senkrecht verlaufenden Querschnitt durch einen erfindungs- gemäßen MOSFET mit im Querschnitt rechteckiger Zellanordnung.

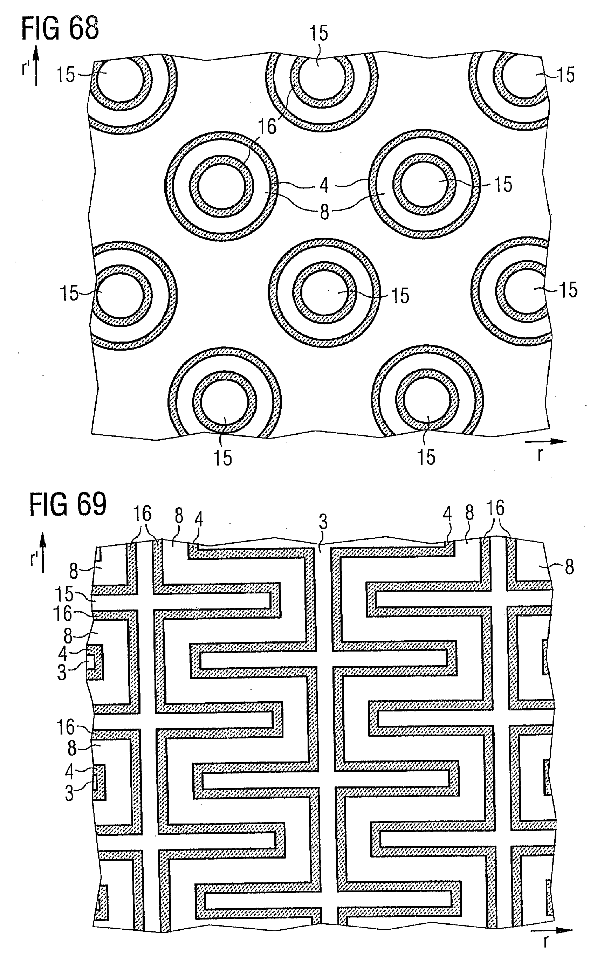

Figur 68      zeigt einen zur vertikalen Richtung senkrecht verlaufenden Horizontalschnitt eines erfindungs- gemäßen MOSFET mit im Querschnitt kreisförmiger Zellanordnung.

| | |
|---|---|
| Figur 69 | zeigt einen zur vertikalen Richtung senkrecht verlaufenden Horizontalschnitt durch einen erfindungsgemäßen MOSFET mit im Querschnitt mäander- artig verlaufender Driftzone. |
| Figur 70 | zeigt im Querschnitt ein als selbstleitender MOS- Transistor realisiertes Halbleiterbauelement. |
| Figur 71 | veranschaulicht ein Halbleiterbauelement, bei dem im Zellenfeld eines Lasttransistors ein Messtran- sistor zur Messung eines Laststromes durch den Lasttransistor angeordnet ist. |
| Figur 72 | zeigt ein Halbleiterbauelement, bei dem im Zellen- feld eines Lasttransistors ein Temperatursensor an- geordnet ist. |
| Figur 73 | zeigt ein gegenüber dem Halbleiterbauelement gemäß Figur 72 abgewandeltes Halbleiterbauelement. |
| Figuren 74 bis 85 | veranschaulichen mögliche Randabschlüsse für ein erfindungsgemäßes Halbleiterbau- element. |
| Figur 86 | zeigt einen Querschnitt durch ein als Schottky- Diode ausgebildetes Halbleiterbauelement, bei dem die Driftsteuerzonen einkristallin ausgebildet und kathodenseitig von der hochdotierten Anschlusszone des Diodengebietes elektrisch iso- liert sind. |
| Figur 87 | zeigt ein Diagramm mit dem Verlauf des Dioden- stroms der Schottky-Diode gemäß Figur 86, bei der die Driftsteuerzonen kathodenseitig hochohmig an die hoch dotierten Anschlusszone angeschlossen sind, im Vergleich zum Diodenstrom durch dieselbe Diode, jedoch bei kathodenseitigem Kurzschluss zwischen den Driftsteuerzonen und der Kathoden- elektrode, in linearer Darstellung. |
| Figur 88 | zeigt das Diagramm gemäß Figur 87, jedoch in lo- garithmischer Darstellung. |
| Figur 89 | zeigt die Elektronenverteilung der Schottky-Diode gemäß Figur 86 im Durchlassfall. |
| Figur 90 | zeigt eine Schottky-Diode mit einer Driftsteuer- zone, die über eine schwach und komplementär zu dieser dotierte erste Verbindungszone an die Ka- thodenelektrode der Schottky-Diode ange- schlossen ist. |
| Figur 91 | zeigt eine Schottky-Diode gemäß Figur 90, bei der die erste Verbindungszone nicht aus dotiertem, sondern aus intrinsischem Halbleitermaterial ge- bildet ist. |
| Figur 92 | zeigt eine Schottky-Diode mit einer Driftsteuer- zone, die über eine intrinsische erste Verbindungszone unmittelbar an der hoch dotierten An- schlusszone angeschlossen ist. |
| Figur 93 | zeigt eine Schottky-Diode, bei der zumindest eine der Driftsteuerzonen einen Fortsatz aufweist, der sich bis zur hochdotierten Anschlusszone er- streckt und diese kontaktiert. |
| Figur 94 | zeigt eine Schottky-Diode mit einer Driftsteuer- zone, die über eine hochohmige Widerstandsschicht an die hochdotierte Anschlusszone angeschlossen ist. |
| Figur 95 | zeigt eine Schottky-Diode mit einer Driftsteuer- zone, die kathodenseitig abschnittweise gegen- über der Kathodenelektrode der Schottky-Diode isoliert ist, und |
| Figur 96 | zeigt eine Schottky-Diode gemäß Figur 86, bei der die Driftsteuerzone mittels einer schwach p-dotierten Verbindungsschicht an das Anodenmetall des Schottky-Kontakts der Schottky-Diode ange- schlossen ist. |
| Figur 97 | zeigt eine Schottky-Diode, bei der die Driftsteu- erzone über einen Abschnitt einer Anschlusselek- trode an die hochdotierte Anschlusszone ange- schlossen ist. |
| Figur 98 | zeigt eine Schottky-Diode, bei der die Driftsteu- erzone über ein Tunneldielektrikum an eine die hochdotierte Anschlusszone kontaktierende An- schlusselektrode angeschlossen ist. |

| | |
|---|---|
| Figur 99 | zeigt eine gegenüber der Schottky-Diode in Figur 98 abgewandelte Schottky-Diode, die als "merged" pin-Schottky-Diode ausgebildet ist. |
| Figur 100 | zeigt eine gegenüber der Schottky-Diode in Figur 98 abgewandelte Schottky-Diode, bei der zwischen dem Tunneldielektrikum und der Anschlusselektrode eine einkristalline Halbleiterschicht angeordnet ist. |
| Figur 101 | zeigt ein als MOSFET ausgebildetes Halbleiterbau- element, bei dem die Driftsteuerzone an einer Seite unmittelbar an die Gateelektrode angrenzt und an einer anderen Seite über eine Diode an die Drainzone gekoppelt ist. |
| Figur 102 | zeigt ein gegenüber dem Bauelement in Figur 101 abgewandeltes Bauelement, bei dem die Diode als integrierte Diode realisiert ist. |
| Figur 103 | zeigt ein weiteres gegenüber dem Bauelement in Figur 101 abgewandeltes Bauelement. |
| Figur 104 | zeigt ein gegenüber dem Bauelement in Figur 102 abgewandeltes Bauelement, bei dem die Driftsteu- erzone über eine Kontaktelektrode an die Gatee- lektrode angeschlossen ist. |
| Figur 105 | zeigt ein gegenüber dem Bauelement in Figur 10142 abgewandeltes Bauelement, bei dem die Gatee- lektrode und die Driftsteuerzone gegeneinander isoliert sind und bei dem die Driftsteu- erzone an ein Steuerpotential anschließbar ist. |
| Figur 106 | veranschaulicht ein Verfahren zur Herstellung ei- nes als MOSFET ausgebildeten Halbleiterbauelements, bei dem die Driftsteuerzone sich unmittel- bar an die Gateelektrode anschließt, während ein- zelner Verfahrensschritte. |
| Figur 107 | veranschaulicht ein Verfahren zur Herstellung ei- nes weiteren als MOSFET ausgebildeten Halbleiter- bauelements, bei dem die Driftsteuerzone sich un- mittelbar an die Gateelektrode anschließt, wäh- rend einzelner Verfahrensschritte. |
| Figur 108 | veranschaulicht ein Verfahren zur Herstellung ei- nes weiteren als MOSFET ausgebildeten Halbleiter- bauelements, bei dem die Driftsteuerzone sich un- mittelbar an die Gateelektrode anschließt, wäh- rend einzelner Verfahrensschritte. |
| Figur 109 | zeigt ein als MOSFET ausgebildetes Halbleiterbau- element mit einer sich unmittelbar an die Gatee- lektrode anschließenden Driftsteuerzone und mit einem mehrschichtig aufgebauten Akkumulationsdie- lektrikum. |
| Figur 110 | zeigt ein gegenüber dem Bauelement in Figur 109 abgewandeltes Bauelement mit einem mehrschichtig aufgebauten Akkumulationsdielektrikum. |
| Figur 111 | zeigt ein als MOSFET ausgebildetes erfindungsge- mäßes laterales Leistungshalbleiterbauelement, das mehrere Driftsteuerzonen aufweist, die je- weils durch ein Akkumulationsdielektrikum gegen- über einer Driftzone isoliert sind, anhand ver- schiedener Schnittdarstellungen eines Halbleiter- körpers in dem bzw. auf dem das Bauelement integ- riert ist. |
| Figur 112 | zeigt ein als MOSFET ausgebildetes Leistungshalb- leiterbauelement, bei dem Driftsteuerzonen ab- schnittsweise durch Tunneldielektrika von der Driftzone getrennt sind. |
| Figur 113 | zeigt in perspektivischer Schnittdarstellung ei- nen auf einem SOI-Substrat basierenden lateralen Leistungs-MOSFET mit einer Driftzone und einer Driftsteuerzone. |
| Figur 114 | zeigt ein als MOSFET ausgebildete laterales Leis- tungshalbleiterbauelement, bei dem sich Drift- steuerzonen in einer lateralen Richtung über die gesamte Länge jeweils benachbarter Driftzonen erstrecken. |
| Figur 115 | zeigt ein gegenüber dem Bauelement gemäß Figur 114 abgewandeltes Bauelement, bei dem |

eine Drift- steuerzone abschnittsweise benachbart zu einer Bodyzone des Leistungs-MOSFET angeordnet ist.

| | |
|---|---|
| Figur 116 | zeigt ein weiteres gegenüber dem Bauelement gemäß Figur 114 abgewandeltes Bauelement, bei der eine Gateelektrode als durchgehende streifenförmige Elektrode realisiert ist. |
| Figur 117 | zeigt ein gegenüber dem Bauelement gemäß Figur 114 abgewandeltes Bauelement, das auf Basis eines SOI-Substrates realisiert ist. |
| Figur 118 | zeigt ausschnittsweise ein als Leistungs-MOSFET realisiertes Bauelement, bei dem die Driftsteuer- zone über eine erste Diode an eine Drainelektrode und über eine integrierte zweite Diode an eine Sourceelektrode gekoppelt ist. |
| Figur 119 | zeigt ausschnittsweise einen Leistungs-MOSFET, bei dem die Driftsteuerzone unmittelbar an die Drainelektrode und über eine Diode an die Sour- ceelektrode gekoppelt ist. |
| Figur 120 | zeigt ausschnittsweise einen Leistungs-MOSFET, bei dem eine Kapazität und eine integrierte Diode zwischen die Driftsteuerzone und die Sourcee- lektrode geschaltet sind. |
| Figur 121 | zeigt ein gegenüber dem Bauelement in Figur 120 abgewandeltes Bauelement mit externer Diode. |
| Figur 122 | zeigt ein gegenüber dem Bauelement in Figur 120 abgewandeltes Bauelement, bei dem eine weitere Diode zwischen die Driftsteuerzone und eine Ga- teelektrode geschaltet ist. |
| Figur 123 | zeigt ausschnittsweise ein Halbleiterbauelement mit einer Driftzone und einer Driftsteuerzone, bei dem eine Kapazität im Bereich eines Halblei- terkörpers integriert ist. |
| Figuren 124 bis 126 | veranschaulichen gegenüber dem Bauele- ment gemäß Figur 123 abgewandelte Halbleiterbauelemente. |
| Figur 127 | zeigt ein als MOSFET realisiertes laterales Leis- tungshalbleiterbauelement, bei dem eine Gate-elektrode in einem Graben angeordnet ist und bei dem ein durch die Gateelektrode gesteuerter In- versionskanal in einer vertikalen Richtung ver- läuft. |
| Figur 128 | zeigt einen gegenüber dem MOSFET in Figur 127 ab- gewandelten Leistungs-MOSFET, bei dem ein durch die Gateelektrode gesteuerter Inversionskanal in einer lateralen Richtung verläuft. |
| Figur 129 | zeigt einen lateralen Leistungs-MOSFET, der meh- rere Gateelektrodenabschnitte aufweist, die in lateraler Richtung jeweils in Verlängerung einer Driftsteuerzone angeordnet sind. |
| Figur 130 | zeigt ein erstes Ausführungsbeispiel eines auf einem SOI-Substrat basierenden lateralen Leistungs-MOSFET, dessen Bodyzone an ein Halblei- tersubstrat angeschlossen ist. |
| Figur 131 | zeigt ein zweites Ausführungsbeispiel eines auf einem SOI-Substrat basierenden lateralen Leistungs-MOSFET, dessen Bodyzone an ein Halblei- tersubstrat angeschlossen ist. |
| Figur 132 | veranschaulicht ein mögliches Verfahren zur Her- stellung einer mittels eines Akkumulationsdie- lektrikums von einer Driftzone getrennten Drift- steuerzone. |
| Figur 133 | zeigt in perspektivischer Darstellung ein als Schottky-Diode realisiertes laterales Leistungs- halbleiterbauelement. |
| Figur 134 | zeigt einen lateralen Leistungs-MOSFET mit einer parallel zu einer Vorderseite eines Halbleiter-körpers verlaufenden Driftsteuerzone und einer oberhalb der Vorderseite angeordneten Gate-elektrode. |
| Figur 135 | zeigt ein gegenüber dem Bauelement in Figur 134 abgewandeltes Bauelement, bei dem die |

Gatee- lektrode in einem Graben angeordnet ist.

| Figur 136 | zeigt ein gegenüber dem Bauelement in Figur 135 abgewandeltes Bauelement, bei dem die Gatee- lektrode mehrere Gateelektrodenabschnitte auf- weist, die jeweils in Verlängerung einer Drift- steuerzone angeordnet sind. |
|---|---|
| Figur 137 | veranschaulicht ein Verfahren zur Herstellung ei- nes Anschlusskontakts, der vergrabene Halbleiter- zonen kontaktiert. |
| Figur 138 | zeigt ausschnittsweise eine Driftzone eines Leis- tungshalbleiterbauelements mit darin ange- ordneten streifenförmigen Driftsteuerzonen. |
| Figur 139 | zeigt eine gegenüber der Anordnung in Figur 138 abgewandelte Anordnung. |
| Figur 140 | zeigt eine weitere gegenüber der Anordnung in Fi- gur 138 abgewandelte Anordnung. |
| Figur 141 | zeigt ausschnittsweise eine Driftsteuerzone eines Leistungshalbleiterbauelements mit darin angeord- neten streifenförmigen Driftzonen. |
| Figur 142 | zeigt ausschnittsweise eine Driftzone eines Leis- tungshalbleiterbauelements mit darin ange- ordneten balkenförmigen Driftsteuerzonen. |
| Figur 143 | zeigt ausschnittsweise eine Driftsteuerzone eines Leistungshalbleiterbauelements mit darin angeord- neten balkenförmigen Driftzonen. |
| Figur 145 | zeigt ausschnittsweise eine Driftzone eines Leis- tungshalbleiterbauelements mit einer darin ange- ordneten Driftsteuerzone, die einen mäanderförmi- gen Umfang aufweist. |
| Figur 145 | zeigt ausschnittsweise eine Driftsteuerzone eines Leistungshalbleiterbauelements mit einer darin angeordneten Driftzone, die einen mäanderförmigen Umfang aufweist. |

## DETAILLIERTE BESCHREIBUNG DER FIGUREN

In den Figuren bezeichnen, sofern nicht anders angegeben, gleiche Bezugszeichen gleiche Bauelementbereiche mit gleicher Bedeutung.

Bei dem erfindungsgemäßen Bauelement sind bei einer Ausführungsform eine Driftzone und eine Driftsteuer- zone wenigstens abschnittsweise benachbart zueinander in einem Halbleiterkörper angeordnet und durch eine Dielektrikumsschicht voneinander getrennt. Der Bereich dieser Dielektrikumsschicht, der die Driftzone und die Driftsteuerzone trennt, wird nachfolgend als "Akkumulationsdielektrikum" bezeichnet.

Die Begriffe "Driftzone" oder "Driftstrecke" bezeichnen bei einem Leistungshalbleiterbauelement ein Halbleitergebiet, in dem bei Anlegen einer Sperrspannung an das Bauelement die Sperrspannung abgebaut wird, in der sich also eine Raumladungszone mit zunehmender Sperrspannung ausbreitet. Die Begriffe "Driftzone" und "Driftstrecke" werden insbesondere bei unipolaren Leistungshalbleiterbauelementen, wie beispielsweise bei Leistungs-MOSFET oder Leistungs-Schottky-Dioden verwendet, während bei bipolaren Bauelementen je nach Dotierungsart der die Sperrspannung aufnehmenden Halbleiterzone die Begriffe "n-Basis" oder "p-Basis" üblich sind. Für die nachfolgende Erläuterung werden für die die Sperrspannung eines Leistungshalbleiterbauelements aufnehmende Zone, ohne Einschränkung der Erfindung auf unipolare Bauelement durchgängig die Begriffe "Driftzone" oder "Driftstrecke" verwendet.

Die Dotierung der Driftsteuerzone ist beispielsweise so gewählt, dass diese wenigstens einen Halbleiterabschnitt aufweist, der in einer Richtung senkrecht zu dem Akkumulationsdielektrikum vollständig ausräumbar ist. Dies ist gleichbedeutend damit, dass die in diesem Halbleiterabschnitt vorhandenen Dotierstoffatome bei Anliegen eines elektrischen Feldes in einer Richtung senkrecht zu dem Akkumulationsdielektrikum vollständig ionisierbar sind, ohne dass ein Avalanche-Durchbruch eintritt. Die Driftsteuerzone dient bei leitend angesteuertem Bauelement zur Steuerung eines Akkumulationskanals, d. h. eines Bereiches mit lokal stark erhöhter Ladungsträgerdichte, in der Driftzone entlang des Akkumulationsdielektrikums. Zur Ausbildung dieses Kanals ist eine Potentialdifferenz zwischen der Driftsteuerzone und der Driftzone erforderlich. Die Art der Ladungsträger, also Elektronen oder Löcher, die sich entlang des Akkumulationsdielektrikums akkumulieren, ist dabei von der Polung der Potentialdifferenz, nicht jedoch von der Grunddotierung der Driftzone, die auch als undotierte bzw. intrinsische Zone realisiert sein kann, abhängig.

Das Vorhandensein eines solchen Akkumulationskanals führt zu einer erheblichen Reduktion des Einschaltwiderstandes des Leistungshalbleiterbauelements im Vergleich zu Bauelementen, die keine solche Driftsteuerzone aufweisen. Bei gleichem Einschaltwiderstand kann die Grunddotierung der Driftzone des erfindungsgemäßen Bauelements im Vergleich zur Grunddotierung der Driftzone herkömmlicher Bauelemente reduziert werden, woraus eine höhere Spannungsfestigkeit des erfindungsgemäßen Bauelements im Vergleich zu herkömmlichen Bauelementen resultiert.

Die Driftzone ist über das Akkumulationsdielektrikum kapazitiv mit der Driftsteuerzone gekoppelt, wodurch die Ausbildung des Akkumulationskanals bei leitend angesteuertem Bauelement möglich wird. Diese kapazitive Kopplung und die Einhaltung der oben angegebenen Dotierungsbedingung für die Driftsteuerzone führen dazu, dass sich bei sperrendem Bauelement, also dann, wenn sich eine Raumladungszone in der Driftzone ausbreitet, in der Driftsteuerzone ebenfalls eine Raumladungszone ausbreitet. Diese sich in der Driftsteuerzone ausbreitende Raumladungszone führt dazu, dass der Potentialverlauf in der Driftsteuerzone dem Potentialverlauf in der Driftzone folgt. Eine Potentialdifferenz bzw. eine elektrische Spannung zwischen der Driftzone und der Driftsteuerzone wird dadurch begrenzt. Diese Spannungsbegrenzung ermöglicht die Verwendung eines dünnen Akkumulationsdielektrikums, was den Vorteil einer verbesserten kapazitiven Kopplung zwischen der Driftsteuerzone und der Driftzone mit sich bringt.

Im Anschluss an die Driftzone kann ein Bauelementübergang, z. B. ein pn-Übergang oder ein Schottky-Übergang, vorgesehen sein, von dem ausgehend sich bei Anlegen einer Sperrspannung zwischen der Driftzone und einer ersten Bauelementzone eine Raumladungszone in der Driftzone ausbreitet.

Bei dem erfindungsgemäßen Halbleiterbauelement handelt es sich insbesondere um ein unipolares Leistungshalbleiterbauelement, wie beispielsweise einen Leistungs-MOSFET oder eine Leistungs-Schottky-Diode. Eine aus einem dotierten oder undotierten Halbleitermaterial bestehende, durch ein Akkumulationsdielektrikum gegenüber einer Driftzone isolierte Driftsteuerzone, die die oben angegebene Dotierungsbedingung erfüllt, kann jedoch auch bei bipolaren Bauelementen, wie Dioden oder IGBTs, vorgesehen werden.

Bei einem MOSFET, einem IGBT oder einer Diode ist der Bauelementübergang zwischen der ersten und zweiten Bauelementzone ein pn-Übergang. Die erste Bauelementzone bildet bei einem MOSFET oder IGBT dessen Bodyzone, bei einer Diode eine der p-oder n-Emitterzonen. Die zweite Bauelementzone bildet bei einem MOSFET dessen Drainzone, bei einem IGBT oder bei einer Diode die Emitterzone.

Bei einer Schottky-Diode ist der Bauelementübergang zwischen der ersten Bauelementzone und der Driftzone ein Schottky-Kontakt, und die erste Bauelementzone besteht aus einem Schottky-Metall. Die erste Bauelementzone ist bei einer Schottky-Diode deren aus einem Schottky-Metall bestehende Anodenzone.

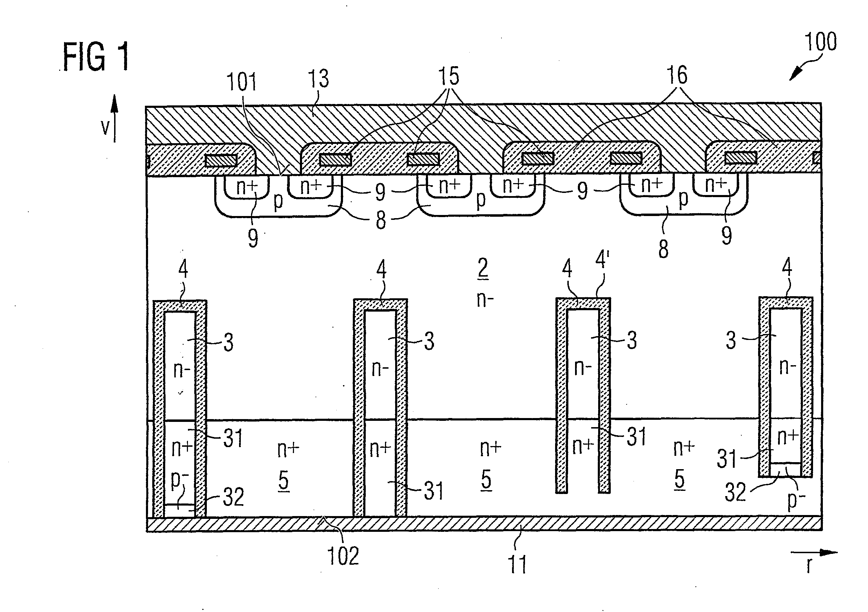

Figur 1 zeigt einen Querschnitt durch einen Abschnitt eines Ausführungsbeispiels eines erfindungsgemäßen Leistungshalbleiterbauelements. Das dargestellte Bauelement ist als planarer MOSFET ausgebildet und weist eine Driftzone 2, eine Sourcezone 9, sowie eine zwischen der Sourcezone 9 und der Driftzone 2 angeordnete, komplementär zu der Sourcezone 9 dotierte Bodyzone 8 auf. Zur Steuerung eines Inversionskanals in der Bodyzone 8 zwischen der Sourcezone 9 und der Driftzone 2 ist eine Gateelektrode 15 vorhanden, die durch ein Gatedielektrikum 16 dielektrisch gegenüber dem Halbleiterkörper isoliert ist. Die Gateelektrode ist in dem dargestellten Beispiel oberhalb einer Vorderseite 101 des Halbleiterkörpers 100 angeordnet und erstreckt sich in einer lateralen Richtung r des Halbleiterkörpers 100 von der Sourcezone 9 bis zur Driftzone 2, die abschnittsweise bis an die Vorderseite 101 reicht. Das Bauelement umfasst außerdem eine Drainzone 5, die sich an die Driftzone 2 anschließt, die höher als die Driftzone dotiert ist und die durch eine Drainelektrode 11 kontaktiert ist.

Die Drainzone 5 des dargestellten Bauelements kann beispielsweise durch ein Halbleitersubstrat realisiert sein, auf das eine Epitaxieschicht mit einer Grunddotierung aufgebracht ist. Abschnitte der Epitaxieschicht, die die Grunddotierung aufweisen, bilden hierbei die Driftzone 2. Es sei darauf hingewiesen, dass die Abmessungen des Halbleitersubstrats und der Epitaxieschicht in Figur 1 nicht maßstäblich wiedergegeben sind.

Der dargestellte MOSFET ist n-leitend, die Sourcezone 9, die Driftzone 2 und die Drainzone 5 sind hierbei n-dotiert, während die Bodyzone p-dotiert ist. Die Erfindung ist selbstverständlich auch auf einen p-leitenden MOSFET anwendbar, dessen Bauelementzonen komplementär zu denen eines n-leitenden MOSFET dotiert sind.

Der in Figur 1 dargestellte MOSFET ist als vertikaler MOSFET realisiert. Die Sourcezone 9, die Bodyzone 8, die Driftzone 2 und die Drainzone 5 dieses Bauelements sind in einer vertikalen Richtung v des Halbleiterkörpers 100 aufeinanderfolgend angeordnet. Bei leitend angesteuertem Bauelement, d.h. bei Anlegen einer positiven Spannung zwischen Drain und Source und Anlegen eines geeigneten Ansteuerpotentials an die Gateelektrode 15 fließt ein Strom in vertikaler Richtung durch die Driftzone zwischen Source und Drain. Die Bodyzone 8 und die Drainzone 5 bilden bei diesem Bauelement erste und zweite Bauelementzonen zwischen denen die Driftzone 2 angeordnet ist, wobei sich bei Anlegen einer Sperrspannung zwischen der Bodyzone 8 und der Drainzone 5 eine Raumladungszone in der Driftzone 2 ausgehend von dem Halbleiterübergang zwischen der Bodyzone 8 und der Driftzone 2 ausbreitet.

Wenigstens abschnittsweise benachbart zu der Driftzone 2 ist bei dem Bauelement wenigstens eine Driftsteuerzone 3 ausgebildet. Bei dem in Figur 1 dargestellten Bauelement sind mehrere solcher Driftsteuerzonen 3 vorgesehen, die in einer lateralen Richtung r des Halbleiterkörpers 1 beabstandet zueinander angeordnet sind. Zwischen jeder dieser Driftsteuerzonen 3 und der Driftzone 2 ist eine Dielektrikumsschicht 4 angeordnet, die als "Akkumulationsdielektrikum" bezeichnet wird. Unter dem Akkumulationsdielektrikum ist zu Zwecken der nachfolgenden Erläuterung dabei nur der Abschnitt der Dielektrikumsschicht 4 zu verstehen, der unmittelbar zwischen der Driftzone 2 und der Driftsteuerzone 3 angeordnet ist, an den sich an einer Seite also unmittelbar die Driftzone 2 und an der anderen Seite unmittelbar die Driftsteuerzone 3 anschließt.

Die Driftsteuerzonen 3 sind an eines der Lastanschlusspotentiale des MOSFET gekoppelt, die während des Betriebs an Drain 5 und / oder Source 9 anliegen. In dem Beispiel sind die Driftsteuerzonen 3 hierzu an die Drainzone 5 angeschlossen. Das Anschließen der Driftsteuerzonen 3 an diese Drainzone 5 kann auf unterschiedliche Weise erfolgen. In Figur 1 sind hierzu vier unterschiedliche Möglichkeiten dargestellt.

Zum einen kann die Driftsteuerzone 3 über eine hochdotierte erste Anschlusszone 31 desselben Leitungstyps wie die Driftsteuerzone an die Drainelektrode 11 angeschlossen werden. Die Dielektrikumsschicht 4 reicht in diesem Fall bis an die Drainelektrode 11 und isoliert dadurch die erste Anschlusszone 31 und die Drainzone 5 dielektrisch gegeneinander.

Optional kann zwischen der hochdotierten ersten Anschlusszone 31 und der Drainelektrode 11 eine komplementär zu der ersten Anschlusszone dotierte zweite Anschlusszone 32 angeordnet sein, die schwächer als die erste Anschlusszone 31 dotiert ist.

Weiterhin besteht die Möglichkeit, dass die Drainzone 5 bis unter die Driftsteuerzone 3 bzw. die sich an die Driftsteuerzone 3 anschließende erste Anschlusszone 31 reicht. Auch hierbei kann optional eine komplementär dotierte zweite Anschlusszone 32 vorhanden sein, die dann zwischen der ersten Anschlusszone 31 und dem Abschnitt der Drainzone 5, der sich bis unter die Driftsteuerzone 3 erstreckt, angeordnet ist.

Das Bauelement gemäß Figur 1 ist zellenartig aufgebaut und besitzt eine Anzahl gleichartiger Transistorzellen, die jeweils eine Source- und eine Bodyzone 9, 8 aufweisen. Die einzelnen Transistorzellen sind parallel geschaltet, indem deren Sourcezonen 9 an eine gemeinsame Sourceelektrode 13 und indem deren Gateelektroden 15 an einen gemeinsamen Gateanschluss (nicht dargestellt) angeschlossen sind. Die Driftzone 2 ist bei dem dargestellten Bauelement allen Transistorzellen gemeinsam. Die Drainzone 5 kann - abhängig von der Realisierung der Driftsteuerzonen 3 - als zusammenhängendes, allen Transistorzellen gemeinsames Halbleitergebiet realisiert sein, oder mehrere getrennte Halbleiterabschnitte aufweisen, die durch die Drainelektrode 11 miteinander verbunden sind.

Jede einzelne der Driftsteuerzonen 3 besteht aus einem Halbleitermaterial, das einkristallin sein kann. Jede der Driftsteuerzonen 3 ist derart dotiert, dass sie wenigstens einen Halbleiterabschnitt aufweist, der in einer Richtung senkrecht zu dem Akkumulationsdielektrikum 4 vollständig ausräumbar ist. Betrachtet werden hierbei insbesondere solche Abschnitte des Akkumulationsdielektrikums 4, die sich längs der Stromflussrichtung, im vorliegenden Fall also in vertikaler Richtung v des Halbleiterkörpers, erstrecken. Die Driftsteuerzonen weisen dann wenigstens einen Abschnitt auf, der sich in einer Richtung senkrecht zu der Stromflussrichtung über die gesamte Abmessung der Driftsteuerzone erstreckt und der in dieser Richtung durch ein elektrisches Feld vollständig ausräumbar ist. Dies ist gleichbedeutend damit, dass bei Anliegen eines elektrischen Feldes quer zur Stromflussrichtung - im dargestellten Beispiel also in lateraler Richtung r des Halbleiterkörpers 100 - die Dotierstoffe des wenigstens einen Abschnitts der Driftsteuerzone vollständig ionisierbar sind, ohne dass ein Avalanche-Durchbruch auftritt. Diese Bedingung ist dann erfüllt, wenn die in diesem Halbleiterabschnitt vorhandene Netto-Dotierstoffladung bezogen auf die Fläche des Abschnitts des Akkumulationsdielektrikums 4, durch den der Halbleiterabschnitt gegenüber der Driftzone 2 dielektrisch isoliert ist, kleiner ist als die Durchbruchsladung des für die Driftsteuerzone verwendeten Halbleitermaterials.

Die Driftsteuerzone 3 kann insbesondere so dotiert sein, dass sie nicht nur abschnittsweise sondern vollständig in einer Richtung senkrecht bzw. quer zur Stromflussrichtung ausräumbar ist. Der Quotient aus der in der Driftsteuerzone vorhandenen Netto-Dotierstoffladung und der Fläche des sich in Stromflussrichtung zwischen der Driftzone 2 und der Driftsteuerzone 3 erstreckenden Akkumulationsdielektrikums 4 ist dann kleiner als die Durchbruchsladung des für die Driftsteuerzone 3 verwendeten Halbleitermaterials.

Zur Erläuterung sei nachfolgend eine der in Figur 1 dargestellten Driftsteuerzonen betrachtet, die nach zwei Seiten und nach oben hin von der Dielektrikumsschicht 4 begrenzt sind. Zu Zwecken der Erläuterung sei nachfolgend außerdem der Spezialfall angenommen, dass die Driftsteuerzonen 3 jeweils homogen dotiert sind. Für diesen Spezialfall ist die zuvor angegebene Dotiervorschrift gleichbedeutend damit, dass das Integral der ionisierten Dotierstoffkonzentration der Driftsteuerzone 3 in einer Richtung r senkrecht zu dem Akkumulationsdielektrikum 4 und betrachtet über die gesamte "Breite" der Driftsteuerzone 3 kleiner ist als der zweifache Wert der Durchbruchsladung des Halbleitermaterials der Driftsteuerzone 3. Für Silizium als Halbleitermaterial beträgt diese Durchbruchsladung etwa $1{,}2 \cdot 10^{12}$ e/cm$^2$, wobei e die Elementarladung bezeichnet.

Betrachtet man eine nicht näher dargestellte homogen dotierte Driftsteuerzone, an die sich nur an einer Seite eine Driftzone anschließt, die durch eine Dielektrikumsschicht von der Driftsteuerzone getrennt ist, so gilt für diese Driftsteuerzone, dass das Integral der Dotierstoffkonzentration in Richtung senkrecht zu der Dielektrikumsschicht kleiner ist als die Durchbruchsladung. Eine solche Driftsteuerzone ist dann durch ein elektrisches Feld, das über das Akkumulationsdielektrikum 4 anliegt, vollständig ausräumbar.

Der zuvor erläuterten Dotiervorschrift für die Driftsteuerzone 3 liegt die Überlegung zu Grunde, die Driftsteuerzone so gering zu dotieren, dass sich in der Driftsteuerzone 3 in Richtung der Dielektrikumsschicht 4 unabhängig von einem in der Driftzone 2 vorhandenen elektrischen Potential kein elektrisches Feld aufbauen kann, welches die Durchbruchsfeldstärke des Halbleitermaterials der Driftsteuerzone 3 erreicht.

Die Driftsteuerzonen 3 können aus demselben Halbleitermaterial wie die Driftzone 2 bestehen und die gleiche Dotierungskonzentration wie die Driftzone besitzen. Die Abmessungen der Driftsteuerzonen sind in der Richtung quer zur Stromflussrichtung, in dem Beispiel also in der lateralen Richtung r, so gewählt, dass die oben angegebene Bedingung bezüglich der Netto-Dotierstoffladung bezogen auf die Fläche des Dielektrikums 4 erfüllt ist.

Um einen guten Akkumulationseffekt von Ladungsträgern in der Driftzone 2 entlang des Akkumulationsdielektrikums zu erreichen ist es vorteilhaft, das Dielektrikum 4 sehr dünn auszubilden, so dass das elektrische Feld in der Driftsteuerzone 3 möglichst gut auf die Driftzone 2 durchgreifen kann. Die minimale Dicke des Dielektrikums 4 ist dabei durch die zwischen Driftsteuerzone 3 und Driftzone 2 anliegende Potentialdifferenz und die maximal zulässige dauerhafte Feldstärkebelastung des Akkumulationsdielektrikums gegeben. Bei typischen dauerhaften Potentialdifferenzen von deutlich unter etwa 100V, vorzugsweise von 5V bis 20V zwischen Driftsteuerzone 3 und Driftzone 2 und die Verwendung von thermischem Siliziumdioxid als Dielektrikum ergeben sich typische Dicken unter etwa 500nm, vorzugsweise von etwa 25nm bis etwa 150nm.

Das Akkumulationsdielektrikum 4, kann die Driftsteuerzone 3 vollständig von der Driftzone 2 trennen und zwischen der Driftsteuerzone 3 und der Driftzone 2 somit eine vollständig geschlossene Fläche bilden. Dabei besteht insbesondere die Möglichkeit, die das Akkumulationsdielektrikum 4 bildende Dielektrikumsschicht abschnittsweise als sogenanntes Tunneldielektrikum, insbesondere als Tunneloxid auszubilden. Dies ist in Figur 1 für eine der Driftsteuerzonen 3 dargestellt, bei der das Dielektrikum oberhalb der Driftsteuerzone 3 als Tunneldielektrikum 4' ausgebildet ist. Die Funktion dieses Tunneldielektrikums wird nachfolgend noch erläutert werden.

Die Driftsteuerzone 3 weist in Stromflussrichtung, in dem Beispiel also in vertikaler Richtung v, vorzugsweise denselben Dotierungsverlauf auf, wie der quer zur Stromflussrichtung benachbart zu der Driftsteuerzone 3 angeordnete Abschnitt der Driftzone 2, der sich in der Stromflussrichtung (vertikaler Richtung v) über denselben Bereich wie die Driftsteuerzone 3 erstreckt.

In dem Beispiel gemäß Figur 1 sind die Driftsteuerzonen 3 an das Raster des im Bereich der Vorderseite 101 angeordneten Zellenfeldes angepasst, wobei die Driftsteuerzonen 3 in lateraler Richtung des Halbleiterkörpers 1 jeweils zwischen zwei benachbarten Bodyzonen 8 angeordnet sind. Eine solche Anpassung an das Raster des Zellenfeldes ist allerdings nicht erforderlich. So kann insbesondere ein anderes Raster für die Driftsteuerzonen 3 als für das Zellenfeld gewählt werden, insbesondere können die Driftsteuerzonen 3 auch unter den Bodyzonen 8 angeordnet sein (nicht dargestellt).

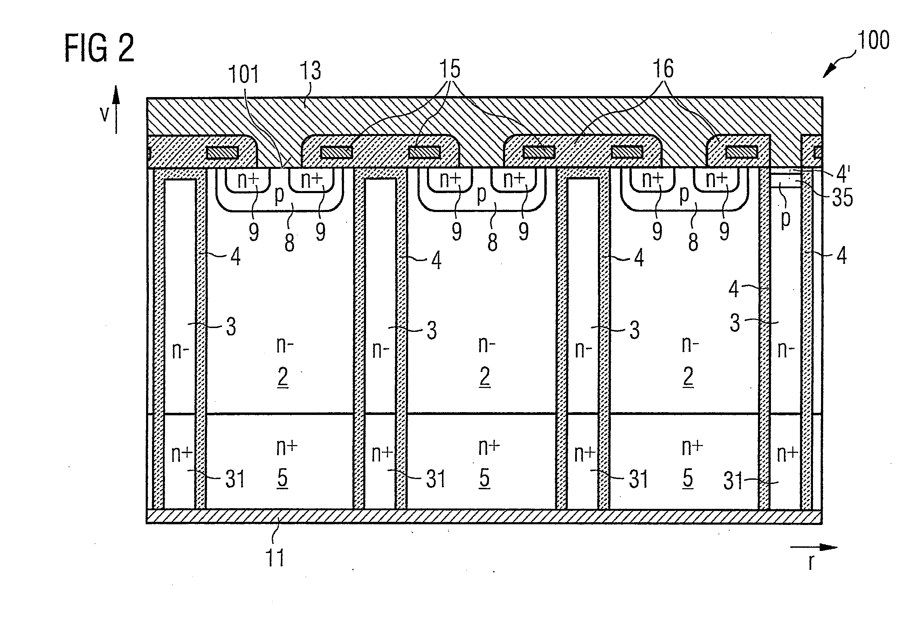

Ein weiteres Ausführungsbeispiel eines als MOSFET ausgebildeten erfindungsgemäßen Bauelements zeigt Figur 2. Dieses Bauelement unterscheidet sich von dem Bauelement gemäß Figur 1 dadurch, dass sich die Driftsteuerzonen 3 bis an die Vorderseite 101 des Halbleiterkörpers 1 erstrecken. Die Driftsteuerzonen 3 sind in dem Beispiel im Bereich der Vorderseite ebenfalls von der das Akkumulationsdielektrikum 4 bildenden Dielektrikumsschicht 4 bzw. dem Tunneldielektrikum 4' bedeckt.

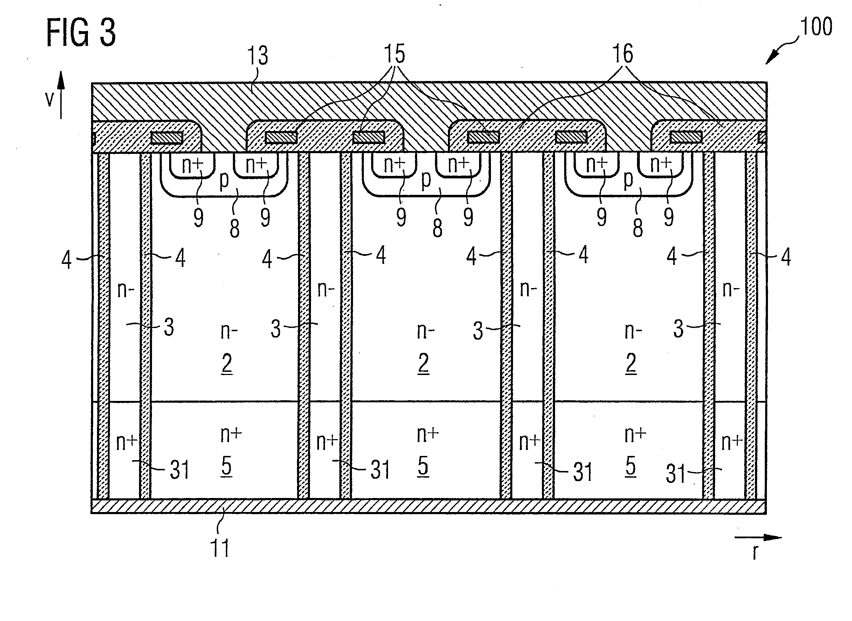

Figur 3 zeigt ein weiteres Ausführungsbeispiel, bei dem die das Akkumulationsdielektrikum 4 bildende Dielektrikumsschicht nur in lateraler Richtung an die Driftsteuerzone 3 angrenzt. Dies ist dann möglich, wenn auf die Vorderseite des Halbleiterkörpers 1 im Bereich der Driftsteuerzone 3 ein Dielektrikum bzw. ein Isolator aufgebracht ist, der die Driftsteuerzone überdeckt. In dem Beispiel ist die Driftsteuerzone 3 durch das Gatedielektrikum 16 überdeckt. Die Driftsteuerzone 3 jeder Zelle ist dadurch im Bereich der Vorderseite des Halbleiterkörpers 1 (Source-seitig) gegenüber den Gateelektroden 15 und der Sourceelektrode 13 elektrisch isoliert.

Alternativ besteht bei den Bauelementen der Figuren 2 und 3, bei denen die Driftsteuerzonen 3 bis an die Vorderseite des Halbleiterkörpers reichen, auch die Möglichkeit, die Driftsteuerzone 3 über eine komplementär zu der Driftsteuerzone 3 dotierte Anschlusszone 35 und ein Tunneldielektrikum 4' an die Sourceelektrode 13 anzuschließen, wie dies für die Driftsteuerzone 3 gezeigt ist, die in Figur 2 ganz rechts dargestellt ist.

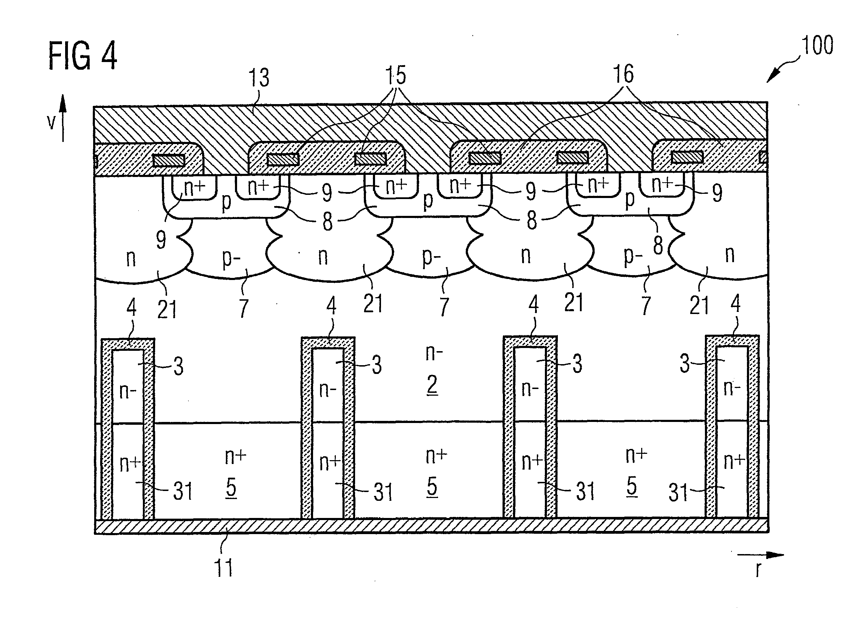

Bezugnehmend auf Figur 4 können in der Driftzone 2 des MOSFET Kompensationszonen 7 vorgesehen sein, die denselben Leitungstyp aufweisen wie die Bodyzonen 8 der einzelnen Zellen, jedoch schwächer als diese dotiert sind. Vorzugsweise kontaktieren die Kompensationszonen 7 jeweils eine der Bodyzonen 8. Bei dem dargestellten Beispiel sind in der Driftzone 2 außerdem zwischen benachbarten Body- und Kompensationszonen 8, 7 höher als andere Bereiche der Driftzone 2 dotierte Zwischenzonen 21 angeordnet, deren Dotierung komplementär zu den Kompensationszonen 7 ist.

Bei dem Ausführungsbeispiel gemäß Figur 4 sind die Driftsteuerzonen 3 jeweils zwischen den Zwischenzonen 21 und der Drainelektrode 11 angeordnet. Bei diesem Ausführungsbeispiel enden die in dem Halbleiterkörper von dem Dielektrikum 4 umgebenen Driftsteuerzonen 3 in vertikaler Richtung beabstandet zu den Zwischenzonen 21.

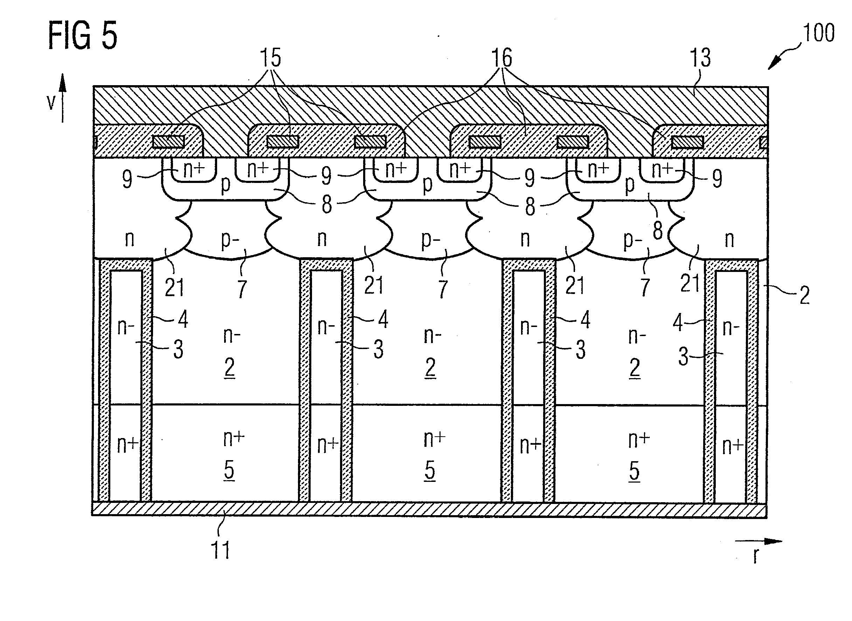

Bezugnehmend auf Figur 5 können die Driftsteuerzonen 3 mit dem sie umgebenden Dielektrikum 4 auch bis an die Zwischenzonen 21 heranreichen oder sich bis in die Zwischenzonen 21 hinein erstrecken. Die Driftsteuerzonen 3 können sich dabei auch bis an die Vorderseite des Halbleiterkörpers erstrecken (nicht dargestellt).

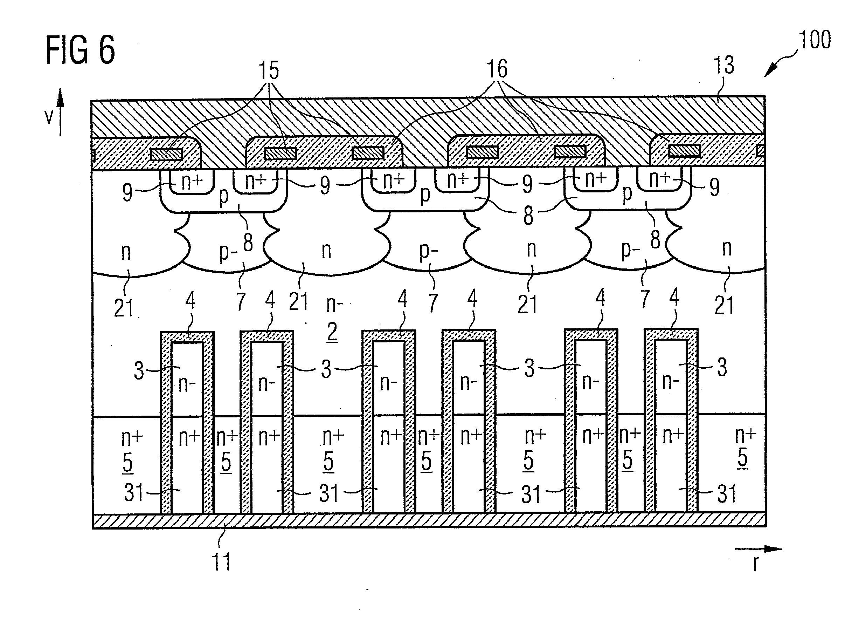

Ein weiteres Ausführungsbeispiel eines MOSFETs mit Driftsteuerzonen 3 zeigt Figur 6. Hierbei sind mehrere Driftsteuerzonen 3, die an die Drainzone gekoppelt sind in lateraler Richtung ungleichmäßig im Halbleiterkörper 100 angeordnet. Dabei ist der Abstand benachbarter Driftsteuerzonen 3 im Bereich der Kompensationszonen 7 geringer gewählt als in anderen Bereichen.

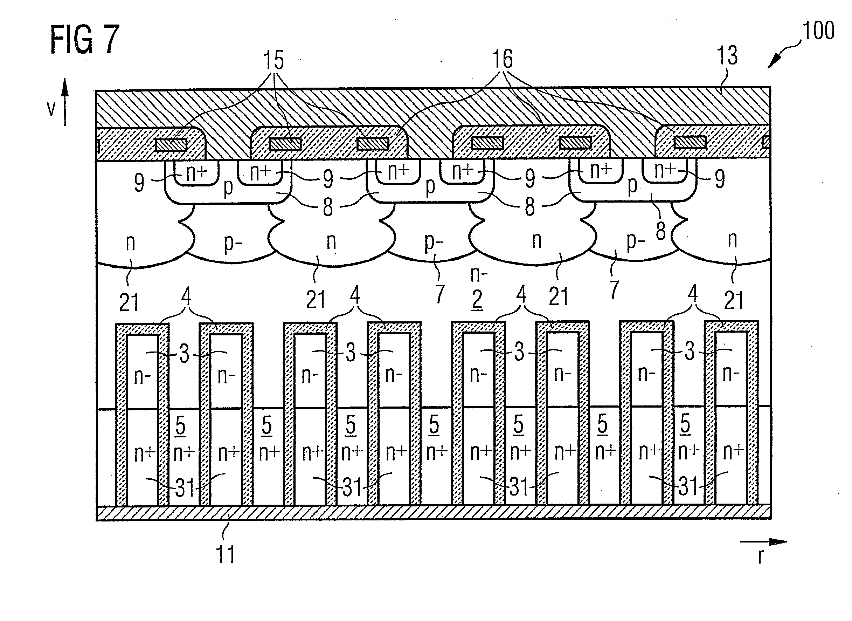

Bezugnehmend auf Figur 7 können die Driftsteuerzonen 3 in der lateralen Richtung des Halbleiterkörpers 1 äquidistant zueinander beabstandet sein.

Die Ausführungsbeispiele gemäß der Figuren 1 bis 7 zeigen MOSFETs mit planaren Gateelektroden. Das Konzept der vorliegenden Erfindung, eine Driftsteuerzone 3 vorzusehen, die aus einem Halbleitermaterial besteht, die durch ein Akkumulationsdielektrikum 4 gegenüber einer Driftzone 2 isoliert ist und deren auf die Fläche des Dielektrikums 4 bezogene Netto-Dotierstoffladung kleiner ist als die Durchbruchsladung, kann selbstverständlich auch auf Trench-MOSFETs mit einer vertikalen in einem Graben angeordneten Gateelektrode 15 angewendet werden.

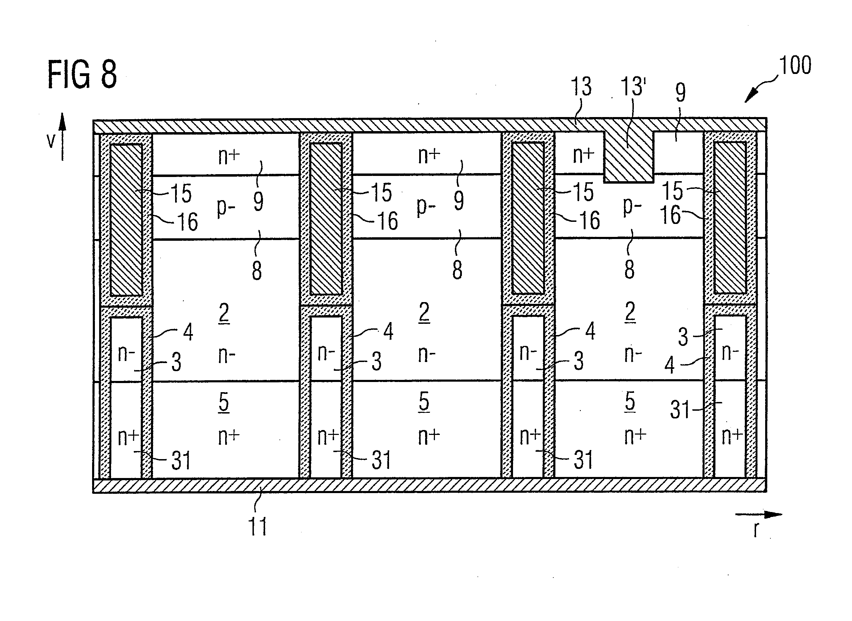

Figur 8 zeigt einen solchen Trench-MOSFET mit mehreren Driftsteuerzonen 3. Bei diesem Bauelement sind ausgehend von der Sourceelektrode 13 hin zur Drainelektrode 11 die Sourcezone 9, die komplementär zu der Sourcezone dotierte Bodyzone 8, die Driftzone 2 und die stark n-dotierte Anschlusszone bzw. Drainzone 5 unmittelbar aufeinanderfolgend angeordnet.

Der Trench-MOSFET weist elektrisch leitfähige Gateelektroden 15 auf, die beispielsweise aus einem Metall oder einem hochdotierten polykristallinen Halbleitermaterial, z. B. Polysilizium, bestehen, die mittels eines Gatedielektrikums 16, beispielsweise einem Halbleiteroxid, gegenüber den anderen Bereichen des Halbleiterkörpers 100 sowie gegenüber der Sourceelektrode 13 elektrisch isoliert sind.

Die Gateelektrode 15 ist in Gräben angeordnet, die sich durch die Sourcezonen 9 und Bodyzonen 8 bis in die Driftzone erstrecken.

Vorzugsweise ist die Sourceelektrode 13 derart ausgestaltet, dass sie die Sourcezone 9 und die Bodyzone 8 kurzschließt, um dadurch in bekannter Weise einen durch die Sourcezone 8, die Bodyzone 9 und die Driftzone 2 gebildeten parasitären Bipolartransistor zu eliminieren. In dem Beispiel weist die Sourceelektrode 13 hierzu einen Elektrodenabschnitt 13' auf, der sich in vertikaler Richtung durch die Sourcezone 9 bis in die Bodyzone 8 erstreckt, wie dies für die Transistorzellen im rechten Teil der Figur 8 dargestellt ist.

Die Driftsteuerzone 3 ist wie bei den vorangehenden Ausführungsbeispielen mittels einer stark n-dotierten ersten Verbindungszone 31 an die Drainelektrode 11 und damit an die Drainzone 5 angeschlossen.

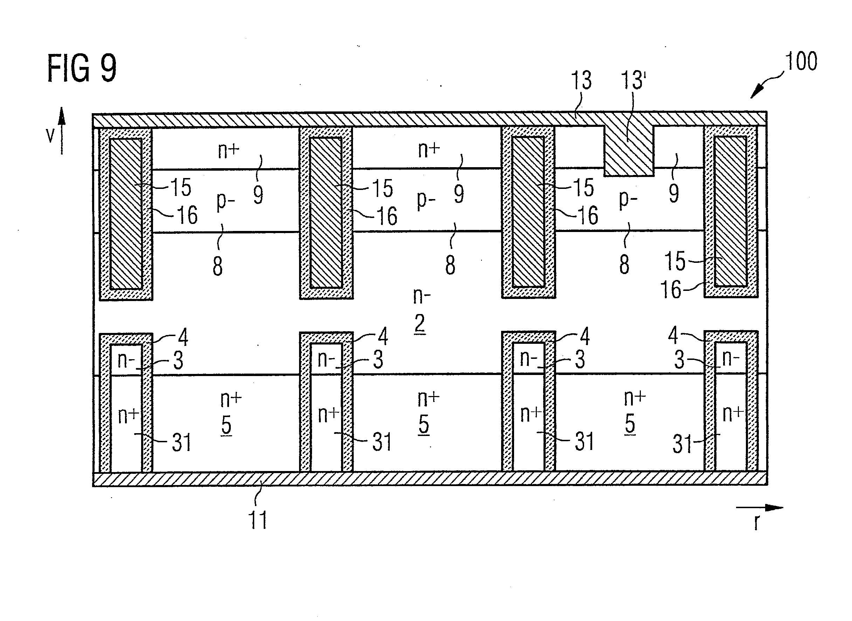

Die Driftsteuerzonen 3 sind hierbei jeweils unmittelbar unterhalb der Gräben mit den Gateelektroden 15 angeordnet und durch das Dielektrikum 4 gegenüber der Driftzone 2 isoliert. Die Driftsteuerzonen 3 mit dem Dielektrikum 4 erstrecken sich hierbei bis an die Gräben mit den Gateelektroden 15. Bezugnehmend auf Figur 9 können die Driftsteuerzonen 3 mit dem Akkumulationsdielektrikum 4 allerdings auch beabstandet zu den Gräben mit den Gateelektroden 15 enden.

Während bei den Ausführungsbeispielen gemäß der Figuren 8 und 9 die Driftsteuerzonen 3 jeweils zwischen einer Gateelektrode 15 und der Drainelektrode 11 angeordnet sind, können alternativ oder zusätzlich weitere Driftsteuerzonen vorgesehen sein, die in lateraler Richtung zwischen benachbarten Gateelektroden 15 angeordnet sind.

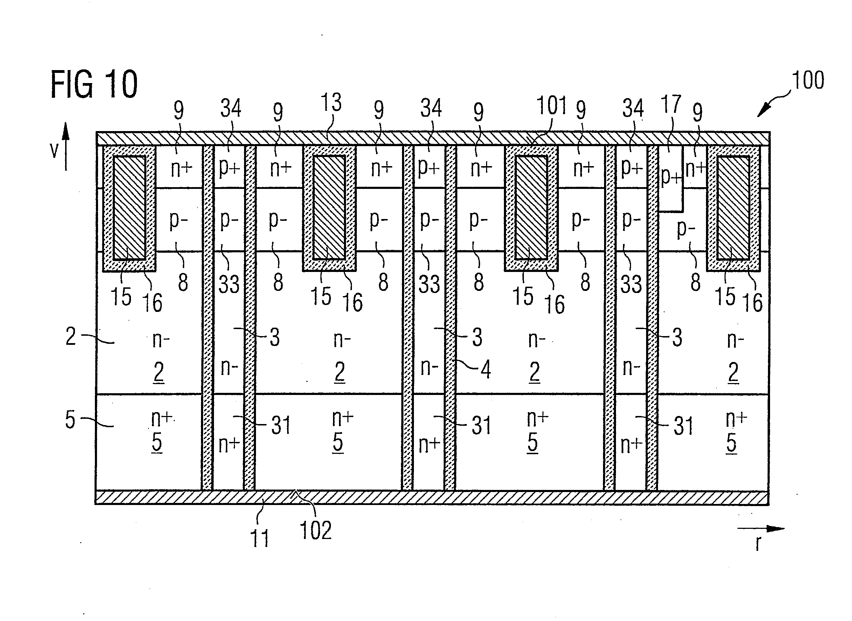

Im letztgenannten Fall, der in Figur 10 gezeigt ist, kann sich das Akkumulationsdielektrikum 4 von der Drainseitigen Oberfläche 102 des Halbleiterkörpers 100 bis zu dessen Source-seitiger Oberfläche 101 erstrecken.

Die Driftsteuerzone 3 ist in dem dargestellten Ausführungsbeispiel sowohl an die Drainzone 5, und zwar über die Drainelektrode 11, als auch an die Sourcezone 9, und zwar über die Sourceelektrode 13, angeschlossen. Der Anschluss an die Drainelektrode 11 erfolgt hierbei über die erste Anschlusszone 31, während der Anschluss an die Sourceelektrode 13 über eine schwach p-dotierte dritte Verbindungszone 33 sowie eine stark p-dotierte vierte Verbindungszone 34 erfolgt. Die vierte Verbindungszone 34 kontaktiert hierbei die Sourceelektrode 13 oder ist mit dieser zumindest elektrisch leitend verbunden.

Bezugnehmend auf Figur 10 können sich die Driftsteuerzonen 3 in der vertikalen Richtung v über denselben Bereich wie die Driftzone 2 erstrecken. Die dritte Verbindungszone 33 erstreckt sich hierbei in der vertikalen Richtung v über denselben Bereich wie die Bodyzone 8, die vierte Verbindungszone 34 über denselben vertikalen Bereich wie die Sourcezone und die erste Anschlusszone 31 über denselben vertikalen Bereich wie die Drainzone 5.

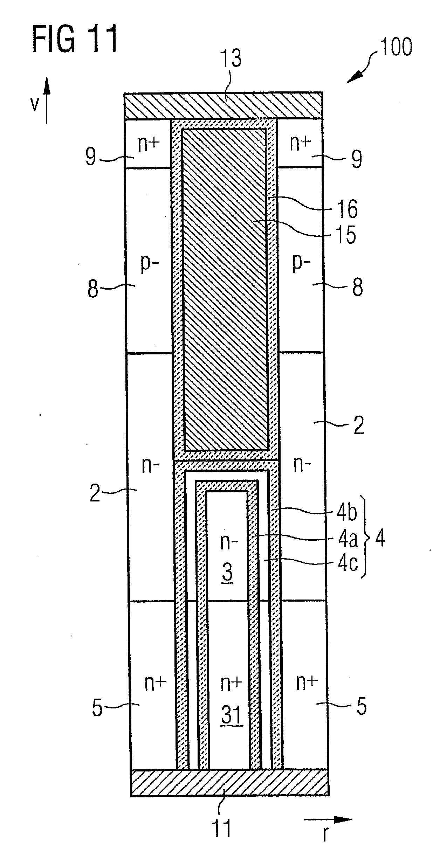

Bei dem Beispiel gemäß Figur 10 ist die Driftsteuerzone 3 mittels der stark n-dotierten ersten Verbindungszone 31 an die Drainelektrode 11 und damit an die Drainzone 5 angeschlossen. In diesem Zusammenhang sei darauf hingewiesen, dass die verschiedenen, anhand von Figur 1 erläuterten Möglichkeiten, die Driftsteuerzone 3 elektrisch an die Drainzone 5 anzuschließen, auch auf das Bauelement gemäß Figur 10, auf die Bauelemente der zuvor erläuterten Figuren 2 bis 9 sowie auf das nachfolgend noch erläuterte Bauelement gemäß Figur 11 anwendbar sind.

Benachbart zu der das Akkumulationsdielektrikum 4 bildenden Dielektrikumsschicht kann in der Bodyzone 9 und abschnittsweise in der Sourcezone 8 eine stark p-dotierte Halbleiterzone 17 angeordnet sein, wie dies für eine der Transistorzellen im rechten Teil der Figur 10 dargestellt ist. Diese Zone 17, die nachfolgend als Bypass-Zone bezeichnet wird, bildet einen sehr niederohmigen Bypass für Löcher zur Sourceelektrode 13 und beugt damit einem frühen Latchen der Zelle insbesondere in den Betriebsfällen "Avalanche" und "Kommutierung" des Leistungshalbleiterbauelements vor. Diese Zone 17 verhindert außerdem, dass ein durch die Driftsteuerzone 3 steuerbarer Kanal zwischen der Sourcezone 9 und der Driftzone 2 vorhanden ist. Darüber bewirkt diese Halbleiterzone 17 einen niederohmigen Anschluss der Sourceelektrode 13 an die Bodyzone 8. Außerdem bewirkt diese Zone 17 einen niederohmigen Anschluss der Sourceelektrode 13 an die Bodyzone 8.

Figur 11 zeigt eine Möglichkeit, die Empfindlichkeit des Halbleiterkörpers 1 gegenüber mechanischen Spannungen zu reduzieren, die durch Herstellen der Driftsteuerzonen 3 mit dem sie umgebenden Akkumulationsdielektrikum 4 entstehen können. Hierzu ist das Dielektrikum 4 aus dielektrischen Teilschichten 4a, 4b gebildet, zwischen denen sich ein Zwischenraum 4c befindet, der mit einem komprimierbaren Medium wie einem Gas, beispielsweise Luft, gefüllt ist.

Die Teilschichten 4a, 4b des Dielektrikums 4 können dabei Source-seitig aneinander anliegen oder dort einstückig ausgebildet sein. Weiterhin können zur Stabilisierung zwischen den Teilschichten 4a, 4b Stege vorgesehen sein, die aus demselben Material bestehen können wie die Teilschichten 4a, 4b.

Der zuvor anhand verschiedener Beispiele erläuterte MOSFET wird leitend angesteuert durch Anlegen eines geeigneten Ansteuerpotentials an die Gateelektrode 15 und durch Anlegen einer positiven Spannung zwischen Drainzone 5 und Sourcezone 9 bzw. zwischen Drainelektrode 11 und Sourceelektrode 13. Das elektrische Potential der Driftsteuerzonen 3 folgt dabei dem elektrischen Potential der Drainzone 5, wobei das Potential der Driftsteuerzone 3 um den Wert der Durchlassspannung eines pn-Übergangs geringer sein kann als das Potential der Drainzone 5, wenn die Driftsteuerzone 3 über einen pn-Übergang (32, 31 in Figur 1) an die Drainzone 5 angeschlossen ist. Bedingt durch einen unvermeidlich vorhandenen elektrischen Widerstand der Driftzone 2 nimmt das elektrische Potential in der Driftzone 2 in Richtung der Bodyzone 8 ab. Die Driftsteuerzone 3 liegt dadurch auf einem höheren Potential als die Driftzone 2, wobei diese Potentialdifferenz mit zunehmendem Abstand von der Drainzone 5 in Richtung der Bodyzone 8 zunimmt. Diese Potentialdifferenz bewirkt, dass in der Driftzone 2 benachbart zu dem Akkumulationsdielektrikum 4 eine Akkumulationszone entsteht, in der Ladungsträger, im vorliegenden Fall Elektronen, akkumuliert werden. Diese Akkumulationszone bewirkt eine Reduktion des Einschaltwiderstandes des Bauelements im Vergleich zu herkömmlichen Bauelementen.

Der MOSFET sperrt, wenn kein geeignetes Ansteuerpotential an der Gateelektrode 15 anliegt und wenn eine positive Drain-Source-Spannung anliegt. Der pn-Übergang zwischen der Driftzone 2 und der Bodyzone 8 ist dadurch in Sperrrichtung gepolt, so dass sich in der Driftzone 2 ausgehend von diesem pn-Übergang in Richtung der Drainzone eine Raumladungszone ausbildet. Die anliegende Sperrspannung wird dabei in der Driftzone 2 abgebaut, d.h. die über der Driftzone 2 anliegende Spannung entspricht der anliegenden Sperrspannung.

In der Driftsteuerzone 3 baut sich im Sperrfall in vertikaler Richtung ebenfalls eine Raumladungszone aus, die daraus resultiert, dass der Spannungsabfall an dem Akkumulationsdielektrikum 4 bedingt durch die geringe Dotierung der Driftsteuerzone 3 auf einen oberen Maximalwert begrenzt ist. Das Akkumulationsdielektrikum 4 bildet zusammen mit der Driftsteuerzone 3 und Driftzone 2 eine Kapazität, für deren Kapazitätsbelag C' gilt:

$$C' = \varepsilon_0 \varepsilon_r / d_{Akku} \qquad (1)$$

$\varepsilon_0$ bezeichnet dabei die Dielektrizitätskonstante für das Vakuum und $\varepsilon_r$ bezeichnet die relative Dielektrizitätskonstante des verwendeten Dielektrikums, die für Siliziumdioxid ($SiO_2$) etwa 4 beträgt.

Die Spannung über dem Dielektrikum ist in bekannter Weise gemäß

$$U = Q'/C' \qquad (2)$$

abhängig von der gespeicherten Ladung, wobei Q' die auf die Fläche des Dielektrikums bezogene gespeicherte Ladung bezeichnet.

Im Sperrfall ist die über dem Akkumulationsdielektrikum 4 anliegende Spannung U durch die Netto-Dotierstoffladung der Driftsteuerzone 3 begrenzt. Unter der Annahme, dass die auf die Fläche des Dielektrikums bezogene Netto-Dotierstoffladung der Driftsteuerzone 3 kleiner ist als die Durchbruchsladung $Q_{Br}$ gilt für die über dem Dielektrikum 4 anliegende Spannung U:

$$U = \frac{Q'}{C'} \le \frac{Q_{Br}}{\varepsilon_0 \varepsilon_r} \cdot d_{Akku} \qquad (3)$$

Die maximale anliegende Spannung über dem Akkumulationsdielektrikum 4 steigt also mit dessen Dicke $d_{Akku}$ linear und damit in erster Näherung etwa genauso stark an, wie seine Spannungsfestigkeit. Für SiO$_2$ mit einem Er von etwa 4 und 100nm Dicke ergibt sich eine maximale Spannungsbelastung U von 6,8V, die deutlich unter der zulässigen Dauerbelastung eines solchen Oxids von etwa 20V liegt. Die Durchbruchsladung liegt dabei etwa bei $1,2 \cdot 10^{12}$/cm$^2$.

Im Sperrfall baut sich in der Driftsteuerzone 3 damit eine Raumladungszone auf, deren Potentialverlauf sich von dem Potentialverlauf der Driftzone 2 maximal um den Wert der über dem Dielektrikum 4 anliegenden, durch die niedrige Dotierung der Driftsteuerzone 3 begrenzten Spannung unterscheiden kann. Die Spannung über dem Akkumulationsdielektrikum 4 ist dabei stets geringer als dessen Durchbruchsspannung.

Zu Zwecken der Erläuterung ist die Driftsteuerzone 3 bei den zuvor erläuterten Bauelementen als Zone des gleichen Leitungstyps wie die Driftzone 2 dargestellt. Abweichend von dieser bisherigen Darstellung kann die Driftsteuerzone 3 jedoch auch als eine komplementär zu der Driftzone 2 dotierte Halbleiterzone oder als intrinsische Halbleiterzone dotiert sein.

Die bislang erläuterten und die nachfolgend noch erläuterten Halbleiterbauelemente sind n-leitende Bauelemente, die in der Driftzone 2 bei leitend angesteuertem Bauelement fließenden Majoritätsladungsträger sind hierbei Elektronen. Das Erfindungskonzept ist jedoch nicht auf n-leitende Bauelemente beschränkt, sondern auch auf p-leitende Bauelemente anwendbar, wobei die Halbleiterzonen eines p-leitenden Bauelements komplementär zu den Halbleiterzonen der bisher erläuterten n-leitenden Bauelemente zu dotieren sind.

Bei den zuvor anhand der Figuren 1 bis 9 und 11 erläuterten Bauelementen sind die Driftsteuerzonen 3 ausschließlich an die Drainzone 5 angeschlossen. Bei sperrendem Bauelement können in den Driftsteuerzonen 3 hierbei Löcher akkumuliert werden, die durch eine thermische Generation von Elektronen-Loch-Paaren entstehen und die nicht abfließen können. Über der Zeit kann diese Ladungsmenge so weit ansteigen, dass die maximal zulässige Feldstärke des Akkumulationsdielektrikums 4 erreicht wird und das Dielektrikum 4 durchbricht. Ein solcher Durchbruch kann bezugnehmend auf Figur 1 dadurch vermieden werden, dass die das Akkumulationsdielektrikum bildende Dielektrikumsschicht 4 abschnittsweise als Tunneldielektrikum 4' ausgebildet ist. Dieses Tunneldielektrikum ermöglicht einen Abfluss der akkumulierten Ladungsträger in die Driftzone 2 sobald die Durchbruchfeldstärke des Tunneldielektrikums 4' erreicht ist und noch bevor die Durchbruchfeldstärke des Akkumulationsdielektrikums 4 erreicht ist.

Als Tunneldielektrika eignen sich beispielsweise Schichten aus Siliziumoxid (SiO$_2$) oder Siliziumnitrid (Si$_3$N$_4$) oder auch mehrlagige Schichten aus Siliziumoxid und Siliziumnitrid. Ebenfalls möglich sind Misch-Dielektrika aus Silizium, Sauerstoff und Stickstoff. Typische Tunnelfeldstärken liegen im Bereich von 1...2V/nm. Für ein Tunneloxid 4' mit einer Dicke von 13nm ergeben sich dadurch maximale Spannungen von 13...26V, die oberhalb der während des normalen Sperrbetriebs an dem Dielektrikum 4 anliegenden Spannung liegt und die von einem Dielektrikum 4 aus Siliziumoxid mit einer Dicke von beispielsweise 100nm problemlos ausgehalten wird.

Bei dem in Figur 1 dargestellten Ausführungsbeispiel ist das Tunneldielektrikum am oberen Ende der Driftsteuerzone 3 angeordnet. Besonders vorteilhaft ist, dass die akkumulierten Löcher das Einschalten des Bauelements unterstützen, weil sie so lange die Erzeugung einer Akkumulationszone in der Driftzone 2 unterstützen, bis die Differenz zwischen dem Potential der Driftzone 2 und der Drainzone 5 unter den Wert der Tunnelspannung abgesunken ist. Danach fließen überzählige Löcher aus der Driftsteuerzone 3 in Richtung der Drainzone 5 bzw. Drainelektrode 11 ab.

Das Tunneldielektrikum 4' in Figur 2, das zwischen der Driftsteuerzone 3 und der Sourceelektrode 13 angeordnet ist, dient ebenfalls dazu, einen durch thermische Ladungsträgergeneration erzeugten Leckstrom abzuführen. Der pn-Übergang zwischen der Driftsteuerzone 3 und der komplementär dotierten Zwischenzone 35 nimmt eine zwischen der Driftsteuerzone 3 und der Sourceelektrode anliegende Sperrspannung auf. Das Tunneldielektrikum kann sich auch an die Sourcezone 9 anschließen (nicht dargestellt).

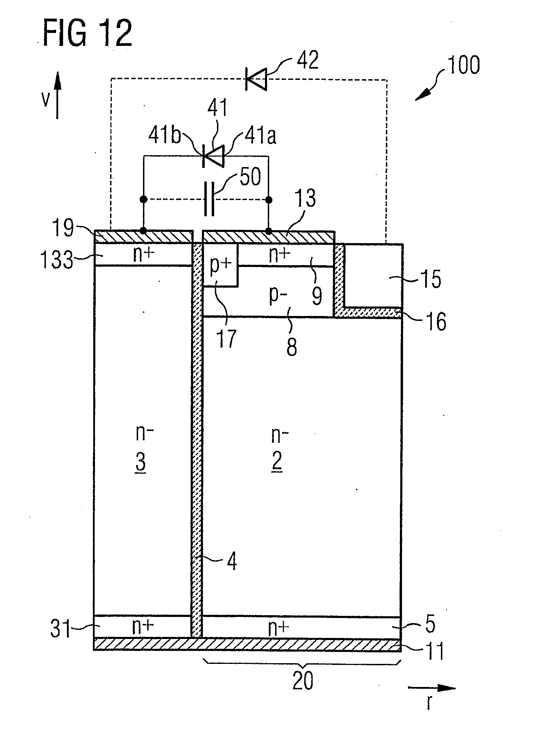

Figur 12 zeigt ausschnittsweise ein weiteres Ausführungsbeispiel eines erfindungsgemäßen Bauelements, das als n-leitender Trench-MOSFET ausgebildet ist. Dargestellt ist in Seitenansicht im Querschnitt eine von einer Vielzahl gleicher Transistorzellen des Bauelements. Das Bauelement weist eine Bauelementstruktur eines herkömmlichen vertikalen Trench-MOSFETs 20 mit einer Sourcezone 9, einer Bodyzone 8, einer Driftzone 2 und einer Drainzone 5 sowie einer in einem Graben angeordneten Gateelektrode 15 auf. Die Sourcezone 9 ist dabei durch eine Sourceelektrode 13 kontaktiert und die Drainzone 5 ist durch eine Drainelektrode 11 kontaktiert.

Die p-dotierte Bodyzone 8 wird dabei über die stark p-dotierte Bypass-Zone 17 an die Sourceelektrode 13 angeschlossen, die einen sehr niederohmigen Bypass für Löcher zur Sourcezone 9 bildet und damit einem frühen Latchen der Zelle insbesondere in den Betriebsfällen "Avalanche" und "Kommutierung" des Leistungshalbleiterbauelements vorbeugt. Diese Zone 17 verhindert außerdem, dass ein durch die Driftsteuerzone 3 steuerbarer Kanal zwischen der Sourcezone 9 und der Driftzone 2 vorhanden ist.

Benachbart zu der Driftzone 2 ist eine Driftsteuerzone 3 angeordnet, die mittels einer stark n-dotierten ersten Verbindungszone 31 an die rückseitige Drainelektrode 11 angeschlossen ist. Die Driftsteuerzone 3 erstreckt sich bei diesem Bauelement in vertikaler Richtung annähernd bis an die Vorderseite des Halbleiterkörpers 1 und ist damit abschnittsweise auch benachbart zu der Bodyzone 8 angeordnet. In Richtung der Vorderseite schließt sich an die Driftsteuerzone 3 eine stark n-dotierte weitere Verbindungszone 133, die eine auf dem Halbleiterkörper 1 angeordnete vierte Elektrode 19 kontaktiert. Diese vierte Elektrode 19 ist in dem Beispiel von der Sourceelektrode 13 getrennt.

Die Driftsteuerzone 3 bildet zusammen mit der ersten Verbindungszone 31 und der weiteren Verbindungszone 133 einen Sperrschicht-Feldeffekttransistor (JFET), dessen Gate die Bodyzone 8 bzw. Bypass-Zone 17 darstellt. Dieser Sperrschicht-Feldeffekttransistor 31, 3, 33 kann durch ein ausreichend hohes negatives Potential der Bodyzone 8 abgeschaltet werden. Bei konventionellen n-Kanal JFETs befindet sich zwischen dem p-dotierten Gate und dem n-dotierten Kanalgebiet kein Dielektrikum. Das hier vorliegende Dielektrikum 4 behindert die Abschnürwirkung aber nicht.

Die Dotierstoffkonzentration in der Driftsteuerzone 3 kann sehr niedrig sein und beispielsweise etwa $10^{14}$ cm$^{-3}$ betragen. Ein Abschnüren des Sperrschicht-Feldeffekttransistors 31, 3, 133 erfolgt dadurch bereits bei einer Spannungsdifferenz von wenigen Volt zwischen der Bodyzone 8 und der Driftsteuerzone 3.

Die Driftsteuerzone 3 ist bei dem dargestellten Bauelement über eine erste Diode 41 an die Sourcezone 9 bzw. Sourceelektrode 13 angeschlossen. Eine Anode 41a dieser Diode 41 ist hierbei über die Sourceelektrode 13 mit der Sourcezone 9 und eine Kathode 41b über die vierte Elektrode 19 mit der Driftsteuerzone 3 bzw. dem Sperrschicht-Feldeffekttransistor 31, 3, 133 elektrisch leitend verbunden. An die Diode 41 sind hinsichtlich des Leckstroms keine hohen Anforderungen zu stellen. Da der Sperrschicht-Feldeffekttransistor 31, 3, 133 im Sperrzustand des MOSFETs abgeschaltet ist und aus ihm kein Strom fließen kann, ist es unerheblich, wenn die erste Diode 41 einen hohen Leckstrom aufweist.

Die erste Diode 41 kann als externes Bauelement realisiert sein oder kann, beispielsweise monolithisch oder als Polysiliziumdiode, in dem Halbleiterkörper integriert werden. Darüber hinaus kann anstelle der ersten Diode 41 auch ein hochohmiger Widerstand oder ein als Diode verschalteter Transistor eingesetzt werden.

Es sei darauf hingewiesen, dass Figur 12 lediglich einen Abschnitt bzw. eine Zelle des gesamten Bauelements zeigt. Linksseitig schließt sich an diesen Abschnitt zunächst ein weiterer Abschnitt des Dielektrikums 4 gefolgt von einer weiteren Trench-MOSFET-Struktur (nicht dargestellt) an. Die dargestellte MOSFET-Struktur und die weitere MOSFET-Struktur sind zueinander spiegelsymmetrisch zu einer in der vertikalen Richtung v und senkrecht durch die Darstellungsebene verlaufenden Symmetrieebene ausgebildet.

Die Funktionsweise des dargestellten Bauelements wird nachfolgend erläutert:

Das Bauelement befindet sich in leitendem Zustand, wenn eine positive Betriebsspannung zwischen Drainelektrode 11 und Sourceelektrode 13 anliegt und wenn ein geeignetes Ansteuerpotential an der Gateelektrode 15 anliegt. Der Spannungsabfall zwischen Drain und Source ist bei leitend angesteuertem Bauelement geringer als die Sperrspannung der Diode 41, wodurch die Diode 41 sperrt und das Potential der Driftsteuerzone 3 in etwa dem Drain-Potential entspricht. Im Bereich der MOSFET-Struktur fällt diese Betriebsspannung über der Driftstrecke 2 ab, wodurch das Potential in der Driftstrecke mit zunehmendem Abstand von der Drainzone 5 abnimmt und wodurch die Spannung zwischen der Driftsteuerzone 3 und der Driftzone 2 mit zunehmendem Abstand von der Drainzone 5 gleichermaßen zunimmt. Das gegenüber dem Potential der Driftzone 2 positive Potential der Driftsteuerzone 3 sorgt in der Driftzone 2 entlang des Dielektrikums 4 für eine Akkumulation von Ladungsträgern, in dem Beispiel von Elektronen, was zu einer Verringerung des Einschaltwiderstandes des Bauelements führt.

Sperrt das Bauelement, indem die Gateelektrode 15 geeignet angesteuert wird, so breitet sich in der Driftzone 2 ausgehend von dem pn-Übergang eine Raumladungszone aus, und die Spannung über der Driftstrecke 2 steigt an. Das Potential der Driftsteuerzone 3 folgt dabei bedingt durch die sperrende Diode 41 zunächst dem Potential der Drainzone 5 bzw. Drainelektrode 11. Mit ansteigendem Potential der Driftsteuerzone 3 wird der durch die Driftsteuerzone 3, das Dielektrikum 4 und die Bodyzone 4 gebildete Sperrschicht-FET zunehmend abgeschnürt, bis er vollständig sperrt und das Potential in diesem Bereich benachbart zu der Bodyzone auf einem Wert festhält, der sich um den Wert der Sperrspannung des Sperrschicht-FET von dem Potential der Bodyzone 8 unterscheidet. Der im oberen Bereich der Driftsteuerzone gebildete Sperrschicht-FET schützt dabei die Diode 41 bei weiter ansteigendem Drain-Potential vor zu hohen Spannungen. Die Spannung für das vollständige Abschnüren des Sperrschicht-FET ist dabei so eingestellt, dass sie geringer ist als die Durchbruchspannung der Diode 41.

Bei weiter ansteigendem Drain-Potential nimmt der Spannungsabfall über der Driftsteuerzone 3 im unteren Bereich, d.h. in dem Bereich zwischen der hochdotierten Anschlusszone 31 und der Bodyzone 8 entsprechend dem Spannungsabfall über der Driftzone 2 zu, wodurch sich in der Driftsteuerzone 3 mit zunehmender Spannung eine Raumladungszone weiter in Richtung der hochdotierten Anschlusszone 31 ausbreitet. Diese sich in der Driftsteuerzone 3 ausbreitende Raumladungszone und die sich in der Driftzone 2 ausbreitende Raumladungszone begrenzen hierbei eine maximale zwischen der Driftsteuerzone 3 und der Driftzone 2 über dem Akkumulationsdielektrikum 4 anliegende Spannung. Bei gleichen Dotierungen der Driftzone 2 und der Driftsteuerzone 3 bzw. bei gleichen Dotierungsverläufen in Stromflussrichtung liegt diese Spannung in etwa im Bereich der Abschaltspannung des Sperrschicht-FET und beträgt üblicherweise einige Volt, so dass das Akkumulationsdielektrikum 4 keiner hohen Spannungsbelastung unterliegt und entsprechend dünn dimensioniert werden kann. Ein dünnes Dielektrikum 4 ist wiederum vorteilhaft bezüglich der Akkumulation von Ladungsträgern in der Driftzone 2 bei leitend angesteuertem Bauelement, wobei das Akkumulationsverhalten um so besser ist je dünner das Dielektrikum 4 bei einer gegebenen Potentialdifferenz zwischen Driftsteuerzone 3 und der Driftzone 2 ist.

Der Vorteil der Anordnung gemäß Figur 12 besteht darin, dass über die Diode 41 ein Strompfad zwischen den Anschlusselektroden bzw. Drain- und Sourceelektroden 11, 13 des Bauelements vorhanden ist, über welchen thermisch in der Driftsteuerzone 3 generierte Ladungsträger abfließen können, so dass es im Sperrfall nicht zu der zuvor erläuterten unerwünschten Akkumulation von Ladungsträgern in der Driftsteuerzone 3 bzw. am Dielektrikum 4 kommt.

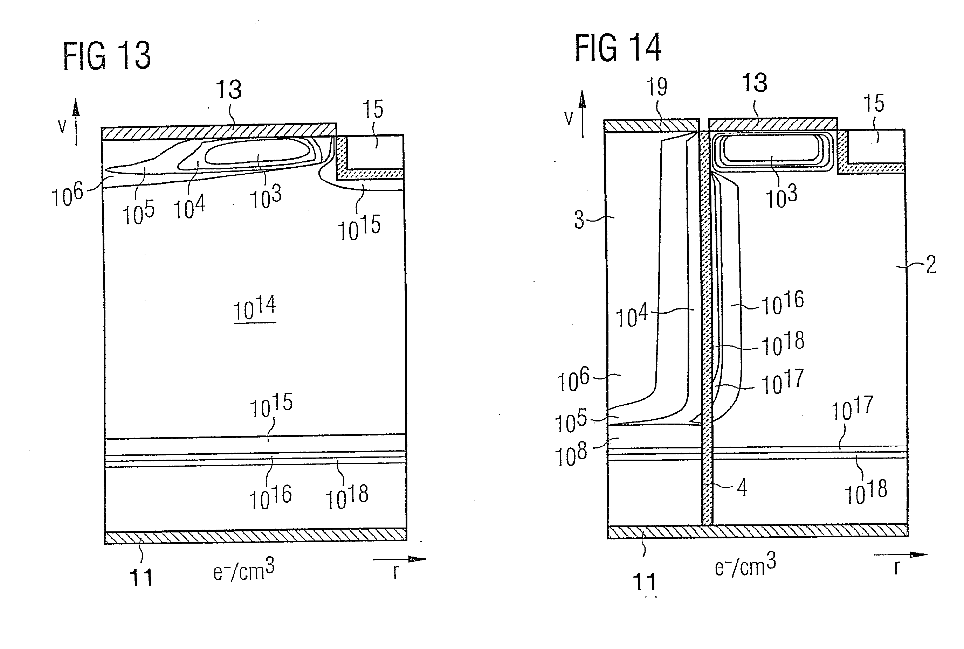

In den Figuren 13 und 14 sind die Elektronenverteilung eines herkömmlichen MOSFETs und des MOSFETs gemäß Figur 12 in leitend angesteuertem Zustand bei jeweils einer Gate-Spannung von 10 V und jeweils einer Drain-Source-Spannung von ebenfalls 10 V gegenübergestellt. Figur 13 zeigt die Elektronenverteilung des herkömmlichen MOSFETs, Figur 14 die Elektronenverteilung des MOSFETs aus Figur 12.

Die in die Diagramme eingetragenen Werte geben für die jeweiligen Bereiche die Elektronenkonzentration in Elektronen pro $cm^3$ an.

Dabei ist bei dem erfindungsgemäßen Bauelement gemäß Figur 14 zu erkennen, dass sich in dem an das Akkumulationsdielektrikum 4 angrenzenden Bereich der Driftzone 2 nahezu über deren gesamte Länge ein Gebiet mit erhöhter Elektronenkonzentration ausbildet, die wenigstens zwei Größenordnungen über der Elektronenkonzentration der Driftzone eines entsprechenden herkömmlichen Bauelements gemäß Figur 13 liegt. Diese erhöhte Elektronenkonzentration ist bedingt durch das Potential der Driftsteuerzone benachbart zu den Bereichen der Driftzonen 2, in denen die Elektronenkonzentration erhöht ist, und das höher ist als das Potential in der Driftzone.

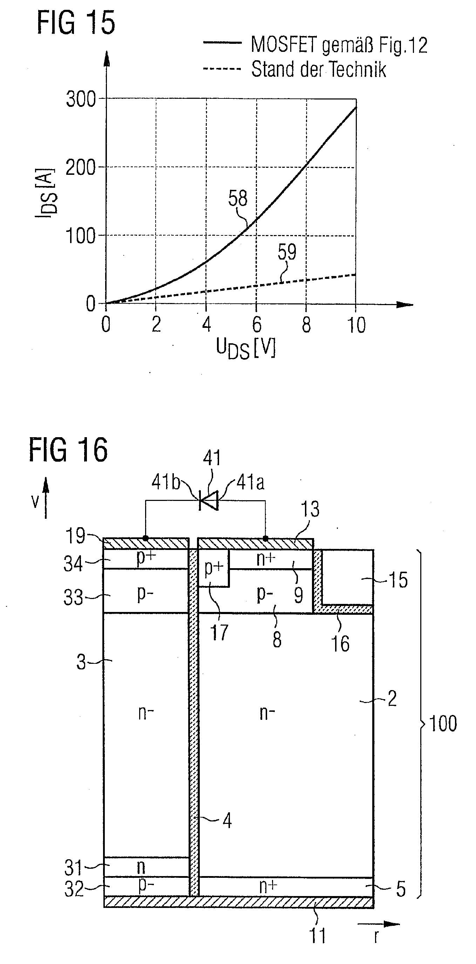

Figur 15 zeigt eine Kennlinie 59, die den Verlauf des Drain-Source-Stromes $I_{DS}$ eines MOSFETs gemäß dem Stand der Technik im Vergleich zur entsprechenden Kennlinie 58 eines erfindungsgemäßen MOSFETs gemäß Figur 12 in Abhängigkeit von der Drain-Source-Spannung $U_{DS}$ angibt.

Dabei ist zu erkennen, dass der Laststrom $I_{DS}$ des erfindungsgemäßen MOSFETs bei einer Drain-Source-Spannung von 4 V um einen Faktor 4, bei einer Drain-Source-Spannung von 10 V um einen Faktor 7 über dem Drain-Source-Strom $I_{DS}$ eines MOSFETs gemäß dem Stand der Technik liegt, obgleich der für den Stromfluss zur Verfügung stehende Querschnitt bei dem erfindungsgemäßen MOSFET in Folge des für die Driftsteuerzone erforderlichen Raumbedarfs gegenüber der Querschnittsfläche eines MOSFETs gemäß dem Stand der Technik deutlich reduziert ist.

Figur 16 zeigt einen Trench-MOSFET, der sich von dem MOSFET gemäß Figur 12 dadurch unterscheidet, dass die Driftsteuerzone 3 über eine schwach p-dotierte dritte Verbindungszone 33 sowie eine stark p-dotierte vierte Verbindungszone 34 mit der vierten Elektrode 19 elektrisch verbunden ist. Die zweistufige Ausgestaltung der p-dotierten Verbindungszone mit einer stärker dotierten Zone 34 und einer schwächer dotierten Zone 33 ist dabei optional. Aufgabe der höher dotierten Zone 34 ist es hierbei im Wesentlichen einen niederohmigen Anschluss der Anschlusselektrode 19 an die schwächer p-dotierte Zone 33, die mit der Driftsteuerzone 3 einen pn-Übergang bildet, zu erreichen.

Im leitenden Zustand funktioniert dieses Bauelement entsprechend dem zuvor anhand von Figur 12 erläuterten Bauelement, wobei bei dem Bauelement gemäß Figur 16 bereits der zwischen der Driftsteuerzone 3 und den p-dotierten Zonen 33, 34 gebildete pn-Übergang dafür sorgt, dass das Potential der Driftsteuerzone über das Source-Potential, d.h. das Potential der Sourceelektrode 13, ansteigen kann.

Es sei im Weiteren angenommen, dass sich der MOSFET im Sperrzustand befindet, bei dem eine Spannung von einigen 10V oder gar einigen 100V zwischen der Drain- und der Sourceelektrode 11, 13 bzw. über der Driftstrecke 2 der MOSFET-Struktur anliegt, und dass sich die Sourceelektrode 13 auf einem Bezugspotential, z.B. 0V befindet. Das Potential an der vierten Elektrode 19 liegt dann maximal in etwa um den Wert der Durchbruchspannung der ersten Diode 41, beispielsweise +15 V, über diesem Bezugspotential. Der verbleibende Teil der Sperrspannung, also die Differenz zwischen dem Drain-Potential und diesem Potential an der vierten Elektrode 19 wird im wesentlichen durch die niedrig dotierte Driftsteuerzone 3 aufgenommen, in der sich ausgehend von dem pn-Übergang zwischen der Driftsteuerzone und den p-dotierten Zonen 33, 34 eine Raumladungszone ausbildet. Die sich in der Driftzone 2 und in der Driftsteuerzone 3 ausbreitenden Raumladungszonen begrenzen hierbei die im Sperrfall über dem Akkumulationsdielektrikum 4 anliegende Spannung, da sich im Bereich der Raumladungszonen keine Akkumulations- oder Inversionsschichten am Akkumulationsdielektrikum 4 ausbilden können. Bei gleicher Dotierung der Driftzone 2 und der Driftsteuerzone 3 und unter der Annahme, dass die pn-Übergänge zwischen der Bodyzone 8 und der Driftzone 2 und zwischen der p-Zone 33 und der Driftsteuerzone 3 in Stromflussrichtung auf der gleichen Höhe liegen, entspricht diese Spannung maximal der Sperrspannung der Diode 41. Diese Diode 41 sorgt dafür, dass die p-Zone 33 im Sperrfall im Vergleich zu der Bodyzone auf einem höheren Potential liegt.

Die Dotierungen der Driftzone 2 und der Driftsteuerzone 3 können unterschiedlich sein, wobei dann die Spannungsbelastung des Akkumulationsdielektrikums im Vergleich zu einer gleichen Dotierung der beiden Zonen größer sein kann. Die Dotierung der Driftsteuerzone 3 sollte hierbei so auf die Dotierungsverhältnisse in der Driftzone 2, die Spannungsfestigkeit des Akkumulationsdielektrikums 4 und die gewünschte Spannungsfestigkeit des Bauelements abgestimmt sein, dass bei einer maximal zulässigen Sperrspannung kein Avalanche-Durchbruch in der Driftsteuerzone 3 auftritt und sich eine Raumladungszone in der Driftsteuerzone 3 so weit in der Stromflussrichtung ausbreitet, dass das sich aus den Feldstärkekomponenten in der Stromflussrichtung und senkrecht zu der Stromflussrichtung gebildete elektrische Feld die Durchbruchsfeldstärke des Halbleitermaterials nicht überschreitet. In den p-dotierten Halbleiterzonen 33, 34, die benachbart zu der Bodyzone 8 bzw. der hoch dotierten Kurzschlusszone 17 Oberhalb der Driftsteuerzone 3 angeordnet sind, werden bei sperrendem Bauelement, wenn das Potential dieser Zonen 33, 34 um den Wert der Durchbruchspannung der Diode 41 oberhalb des Potentials der Bodyzone 8 liegt, in den p-dotierten Zonen Löcher im Bereich des Dielektrikums 4 akkumuliert. Dieser Teil der Struktur entspricht bei sperrendem Bauelement einer auf die Durchbruchspannung der Diode aufgeladenen Kapazität, die nachfolgend als Speicherkapazität bezeichnet wird. Es sei darauf hingewiesen, dass die Diode 41 bei diesem Bauelement optional vorhanden ist. Diese Diode 41 unterstützt eine Ladungsspeicherung in der Driftsteuerzone 3 bei sperrendem Bauelement, so dass bei leitender Ansteuerung weniger Ladung nachgeliefert werden muss.

Beim Einschalten des MOSFETs sinkt der nahe der Bodyzone 8 angeordnete Bereich der Driftzone 2 schnell auf Potentiale unterhalb der Durchbruchspannung der ersten Diode 41 ab. Dadurch werden Löcher aus dem oberen, d.h. nahe der vierten Elektrode 19 gelegenen Bereich der Driftsteuerzone 3 abgezogen und in weiter unten, d.h. in Richtung der Drainelektrode 11, gelegene Bereiche verschoben. Dort bewirken die Löcher auf der gegenüberliegenden Seite des Dielektrikums 4, d.h. auf der der Driftsteuerzone 3 zugewandten Seite der Driftzone 2, eine Akkumulation von Elektronen. Die Ladung verschiebt sich also aus der Speicherkapazität in eine tiefer liegende "Akkumulationskapazität".

Die erste n-dotierte Verbindungszone 31 verhindert in Verbindung mit der zweiten p-dotierten Verbindungszone 32, dass die Löcher aus der Driftsteuerzone 3 während des leitenden Zustands zum Draingebiet 5 bzw. zum Drainanschluss 11 abfließen können. Die Driftzone 2 kann als Steuerelektrode für einen Löcherkanal an der der Driftzone 2 zugewandten Seite der hoch n-dotierten Verbindungszone 31 betrachtet werden. Dieser Löcherkanal muss unbedingt verhindert werden, um die notwendige Löcherakkumulation in der Driftsteuerzone 3 aufrecht zu erhalten. Um die Einsatzspannung des Kanals betragsmäßig zu erhöhen, ist vorzugsweise eine entsprechend hohe Donatorkonzentration in der hoch n-dotierten Verbindungszone 31 oder eine auf Höhe der Verbindungszone 31 lokale Erhöhung der Dicke des Dielektrikums 2 (nicht dargestellt) vorzusehen. Es genügt dabei, die Donatorkonzentration in der ersten Verbindungszone 31 in lateraler Richtung in dem Bereich besonders hoch zu wählen, der sich unmittelbar an das Dielektrikum 4 anschließt, um die Ausbildung eines Löcherkanals zu vermeiden; in den übrigen Bereichen der Verbindungszone 31 kann eine niedrigere Dotierung gewählt werden. Dabei kann es ausreichend sein, die Dotierung der Verbindungszone 31 in dem Bereich anschließend an das Dielektrikum 4 in vertikaler Richtung nicht über die gesamte Breite der Verbindungszone 31 sondern nur abschnittsweise zu erhöhen.

Die für die Bildung eines Elektronen-Akkumulationskanals auf der der Driftsteuerzone 3 zugewandten Seite der Driftzone 2 und damit für die niedrigen Durchlassverluste verantwortliche Löcherladung bleibt durch die entsprechend dimensionierten Verbindungszonen 31, 32 weitgehend erhalten. Man verliert nur einen relativ geringen Anteil durch den Leckstrom der ersten Diode 41 und durch den Unterschwellstrom durch die Schicht 31 entlang des Dielektrikums 4.

Während des Sperrfalls können über die Anordnung mit der ersten und zweiten Verbindungszone 31, 32 thermisch generierte Elektronen aus der Driftsteuerzone 3 abfließen.

Bei dem Bauelement gemäß Figur 16 werden die bei leitendem Bauelement in der Driftsteuerzone 3 benötigten Löcher somit nur zwischen dem unteren n-dotierten "Akkumulationsbereich" (gegenüber der Driftzone 2) und dem oberen p-dotierten "Speicherbereich" 33, 34 verschoben, so dass hier lediglich eine Ladungsverschiebung stattfindet und die Löcher nicht bei jedem Einschaltvorgang aus dem Drain-Source-Strom des Bauelements gespeist werden müssen. Die Schaltverluste des Bauelements werden dadurch minimiert.

Die in Figur 16 dargestellte Speicherkapazität muss nicht notwendiger Weise vollständig Bestandteil des Halbleiterkörpers 1 sein. So kann zusätzlich zu der durch die Bodyzone 8, die p-dotierten Zonen 33, 34 und das Dielektrikum gebildeten Speicherkapazität noch eine weitere Kapazität vorhanden sein, die auch außerhalb des Halbleiterkörpers angeordnet sein kann.

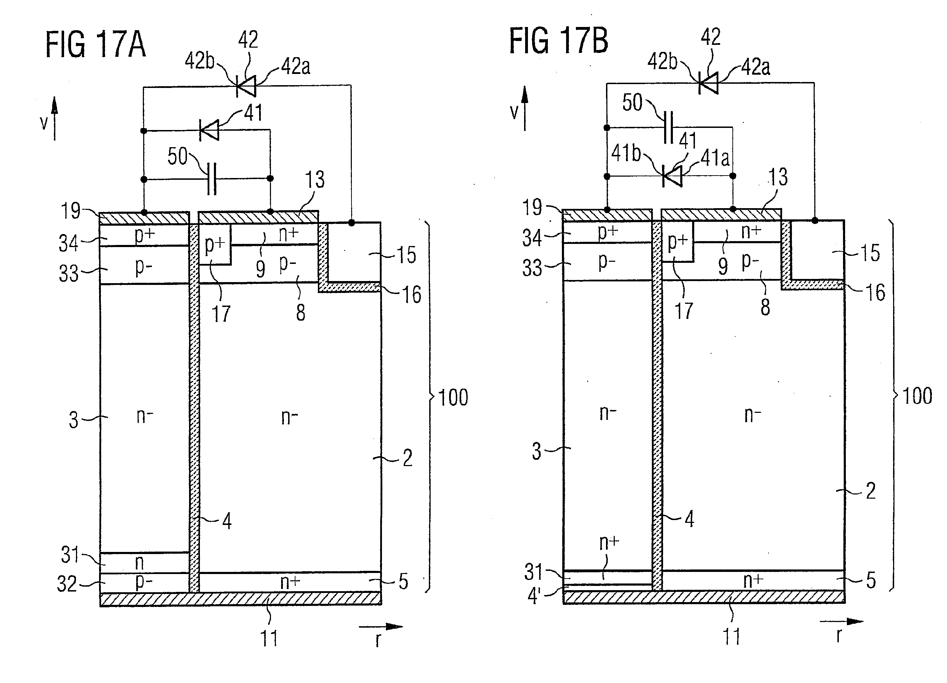

Eine Anordnung mit einer solchen zusätzlichen Kapazität 50 zeigt Figur 17A. Diese Kapazität ist hier schematisch als Kondensator dargestellt und wird nachfolgend als externe Kapazität bezeichnet, die auf beliebige Weise innerhalb oder außerhalb des Halbleiterkörpers realisiert werden kann. Diese weitere Kapazität 50 ist zwischen die Sourceelektrode 13 und die vierte Elektrode 34, und damit zwischen die Driftsteuerzone 3 und die Sourcezone 9, geschaltet.

Zwischen der Driftsteuerzone 3 und der vierten Anschlusselektrode 19 sind in dem Beispiel die komplementär zu der Driftsteuerzone 3 dotierten Anschlusszonen 33, 34 angeordnet, die eine interne Speicherkapazität bilden. Dieser p-dotierte Speicherbereich 33, 34 kann bei Vorsehen der externen Kapazität 50 entsprechend dem Bauelement gemäß Figur 12 durch eine stark n-dotierte Verbindungszone 33 ersetzt werden (nicht dargestellt). Vorteilhaft bei den p-dotierten Verbindungszonen 33, 34 ist ihr günstigeres Leckstromverhalten.

Um den vollen Grad der verbesserten Durchlassverluste des Bauelements im Vergleich zu herkömmlichen Bauelementen nutzen zu können sollte sichergestellt sein, dass die Speicherkapazität, sei es eine interne Kapazität wie in Figur 16 oder eine interne und externe Kapazität wie in Figur 17A, beim Einschalten des Bauelements geladen wird und dass die Ladungen, die durch Leckströme verloren gehen, wieder nachgeliefert werden.

Dies kann bezugnehmend auf Figur 17A dadurch erreicht werden, dass eine zweite Diode 42 vorgesehen ist, die zwischen die Gateelektrode 15 und die Driftsteuerzone 3 geschaltet ist. Eine Anode 42a der Diode 42 ist hierbei an die Gateelektrode 15 und eine Kathode 42b ist an die vierte Elektrode 19 und den der Sourceelektrode 13 abgewandten Anschluss der externen Kapazität angeschlossen. Damit die beim Einschalten verschobene Ladung in der Driftsteuerzone 3 in Form von Löchern in ausreichender Menge erhalten bleibt, sollte die p-dotierte Zone 34 oberhalb der Driftsteuerzone eine ausreichend hohe Dotierung aufweisen.

Eine externe Kapazität 50 und eine zweite Diode 42 können in entsprechender Weise auch bei dem Bauelement gemäß Figur 12 vorgesehen werden, wie dort gestrichelt dargestellt ist.

Beim ersten Einschalten des MOSFETs wird die Speicherkapazität, die bei den Bauelementen der Figuren 12 und 17A, 17B durch eine interne und/oder externe Kapazität gebildet ist, über die zweite Diode 42 aus dem Gatekreis geladen, sofern sie nicht bereits durch den thermisch Sperrstrom aus der Driftsteuerzone 3 geladen wurde. Im eingeschalteten Zustand des MOSFETs werden verloren gegangene Löcher unverzüglich aus dem Gatekreis nachgeliefert. Bei der dynamischen Umladung von Speicher- und Akkumulationskapazität wird dabei den externen Steueranschlüssen, d.h. der Gateelektrode 15, im eingeschwungenen Zustand kein bzw. nur sehr wenig Strom entzogen.

Um eine Entladung der Speicherkapazität zur Drainzone 5 hin zu verhindern, wenn das Drain-Potential unter das Potential der Driftsteuerzone 3 absinkt, kann ein pn-Übergang zwischen der Driftsteuerzone 3 und der Drainelektrode 11 vorgesehen sein, der bei dem Bauelement gemäß Figur 17A durch die n-dotierte erste Verbindungszone 31 im Anschluss an die Driftsteuerzone 3 und eine schwächer p-dotierte zweite Verbindungszone 32, die sich an die Drainelektrode 11 anschließt, ausgebildet ist.

Für die ordnungsgemäße Funktion des zuvor erläuterten Bauelements sollte die durch die erste und zweite Verbindungszone 31, 32 gebildete Diode eine Sperrspannung aufweisen, die höher ist als eine maximal zulässige Gatespannung, die zur leitenden Ansteuerung des Bauelements zwischen Gate und Source angelegt wird.

Figur 17B zeigt ein gegenüber Figur 17A abgewandeltes Bauelement, bei dem die Driftsteuerzone 3 über eine optionale hochdotierte erste Anschlusszone 31, deren Dotierung der Dotierung der Drainzone 5 entsprechen kann, und ein Tunneldielektrikum 4' an die Drainelektrode 11 angeschlossen ist. Das Tunneldielektrikum 4' verhindert im Durchlassfall, dass in der Driftsteuerzone 3 akkumulierte Löcher an die Drainelektrode 11 abfließen können und ermöglicht im Sperrfall das Abfließen eines thermisch generierten Leckstromes an die Drainelektrode 11. Die Spannungsfestigkeit des Tunneldielektrikums 4' muss dabei lediglich so hoch sein, dass es die Gatespannung sperren kann.

Bei dem Bauelement gemäß Figur 17B befindet sich oberhalb des Tunneldielektrikums 4' monokristallines Halbleitermaterial. Ein solches Bauelement kann dadurch hergestellt werden, dass das Halbleitermaterial epitaktisch auf das Tunneldielektrikum aufgewachsen wird. Dabei stellt die Drainzone 5 das Substrat dar, auf welches das Tunneloxid aufgebracht wird, auf welches anschließend die Epitaxieschicht aufgewachsen wird. In diesem Fall befindet sich - anders als bei dem Bauelement der Figur 17B - das Tunneldielektrikum 4' zwischen der Driftsteuerzone 3 und der hoch-n-dotierten Drainzone 5 (nicht gezeigt).

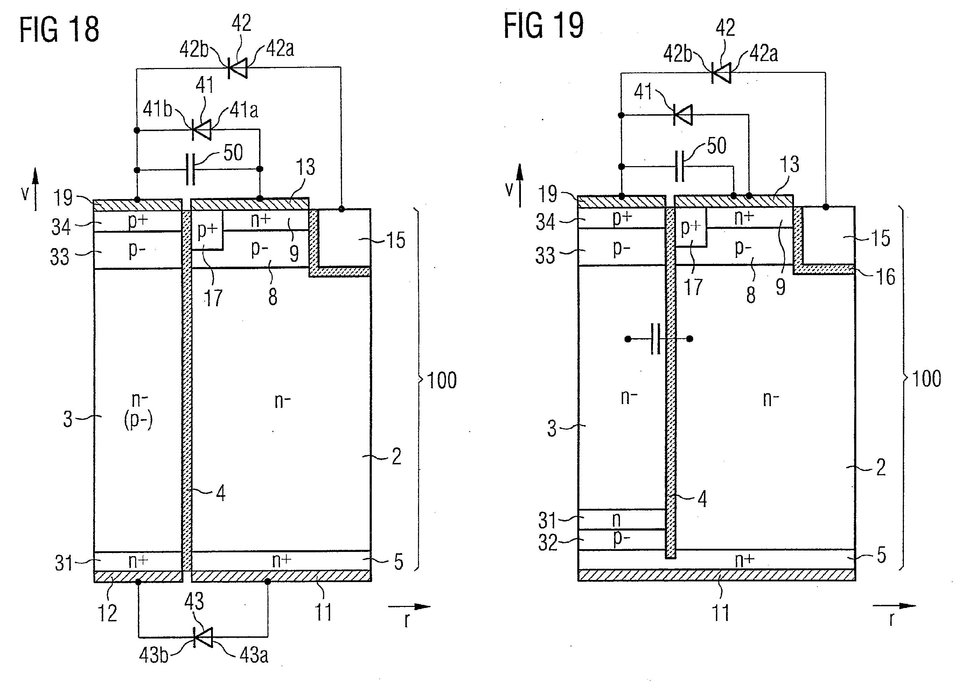

Figur 18 zeigt eine weitere Möglichkeit, wie eine Entladung der (Löcher-)Speicherkapazität in Richtung der Drainzone 5 verhindert werden kann. Hierbei ist die Driftsteuerzone 3 über eine hochdotierte Anschlusszone an eine von der Drainelektrode 11 getrennte zweite Elektrode 12 angeschlossen. Zwischen diese beiden Elektroden 11, 12 ist eine dritte Diode 43 geschaltet, die auch als externes Bauelement realisiert werden kann und deren Anode 43a an die Drainelektrode 11 und deren Kathode 43b an die zweite Elektrode 12 angeschlossen ist. Durch diese dritte Diode 43 wird die Entladung der Akkumulationskapazität zur Drainzone 5 hin verhindert. Dabei sollte das Sperrvermögen der dritten Diode 43 höher sein als die maximale Gate-Spannung zum Einschalten des MOSFETs und kann niedriger als die zulässige Potentialdifferenz über dem Akkumulationsdielektrikum 4 sein.

Beim ersten Einschalten des MOSFETs wird die Driftsteuerzone 3 aus dem Gatekreis auf eine maximale Gate-Spannung, beispielsweise auf 10 V, geladen. Beim Ausschalten des MOSFETs wird die Ladung aus der Akkumulationskapazität in die Speicherkapazität verschoben. Die Speicherkapazität sollte dabei so groß gewählt werden, dass die Sperrspannung der zweiten Diode 42, beispielsweise 15 V, nicht überschritten wird. Die Speicherkapazität beträgt vorzugsweise das 2- bis 3-fache der Akkumulationskapazität zwischen der Driftsteuerzone 3 und der Driftzone 2 und besteht aus der Summe der internen, durch die Verbindungszonen 33, 34 und die Bypass-Zone 17 gebildeten Kapazität sowie der optionalen externen Akkumulationskapazität 50.

Statt eine externe Speicherkapazität 50 außerhalb des Bauelements vorzusehen, kann eine solche Kapazität auch in das Bauelement, beispielsweise in den Halbleiterkörper 1 integriert werden. Insbesondere kann die Speicherkapazität zur Bypass-Zone 17 hin durch ein Dielektrikum 4 mit höherer Dielektrizitätskonstante und/oder durch Vergrößerung der Grenzfläche zwischen dem Löcher-Bypass 17 und dem Dielektrikum 4 erhöht werden (nicht dargestellt).

Bei der Anordnung gemäß Figur 18 kann auf die erste Diode 41 grundsätzlich auch verzichtet werden. Allerdings kann es dann dazu kommen, dass eventuelle Überschussladungen aus der Speicherkapazität in den Gatekreis abfließen. Derartige Überschussladungen können insbesondere dann entstehen, wenn sich die Speicherkapazität während einer länger dauernden Sperrphase durch den Leckstrom aus der Driftsteuerzone 3 bis auf die Sperrspannung der zweiten Diode 42 auflädt.

Abweichend von der bisherigen Darstellung besteht auch die Möglichkeit, die Driftsteuerzone 3 komplementär zu der Driftzone 2 zu dotieren, in dem Beispiel gemäß Figur 18 also eine p-dotierte Driftsteuerzone 3 vorzusehen. Bei sperrend angesteuertem Bauelement breitet sich in der Driftsteuerzone 3 dann eine Raumladungszone ausgehend von dem pn-Übergang zwischen der Driftsteuerzone 3 und der Anschlusszone 31 in Richtung der Vorderseite des Halbleiterkörpers 100 aus, während sich in der Driftzone 2 eine Raumladungszone ausgehend von dem pn-Übergang zwischen der Bodyzone 8 und der Driftzone 2 in Richtung der Rückseite ausbreitet. Diese sich aus unterschiedlichen Richtungen ausbreitenden Raumladungszonen bewirken einen Spannungsabfall über dem Akkumulationsdielektrikum, der bewirkt, dass sich Raumladungszonen bei diesem Bauelement auch in lateraler Richtung in der Driftzone 2 und der Driftsteuerzone 3 ausbreiten. Zusammenfassend ergibt sich hierbei ein Kompensationseffekt, der eine höhere Grunddotierung der Driftzone 2 bei gleicher Spannungsfestigkeit ermöglicht.

Die Dotierung der Driftzone 2 und der Driftsteuerzone 3 bei gleichem Dotierungstyp liegt beispielsweise im Bereich von $10^{14}$ cm$^{-3}$, während bei einer komplementären Dotierung von Driftzone 2 und Driftsteuerzone 3 Dotierungen im Bereich von $10^{15}$ cm$^{-3}$ bis $10^{16}$ cm$^{-3}$ möglich sind.

Figur 19 zeigt eine weitere Möglichkeit zur Anbindung der Driftsteuerzone 3 an die Drainzone 5. Hierbei ist die Driftsteuerzone 3 über die komplementär zueinander dotierten Verbindungszonen 31, 32 unmittelbar und ohne Zwischenschaltung der Drainelektrode 11 mit der Drainzone 5 verbunden. Dies wird dadurch erreicht, dass die das Akkumulationsdielektrikum 4 bildende Dielektrikumsschicht beabstandet zu der Drainelektrode 5 beginnt und dass die Drainzone 5 in lateraler Richtung bis unter die Driftsteuerzone 3 reicht.

Wie bei Halbleiterbauelementen, insbesondere bei Leistungshalbleiterbauelementen üblich, können mehrere Einzelzellen, im vorliegenden Fall mehrere MOSFET-Zellen, im selben Halbleiterkörper angeordnet und parallel zueinander verschaltet sein. Bei dem erfindungsgemäßen Bauelement können dabei zwei benachbarte Zellen des Bauelements eine dazwischen liegende, gemeinsame Driftsteuerzone 3 nutzen.

Zur Erfassung einer zwischen Lastanschlüssen eines Leistungshalbleiterbauelements anliegenden Spannung ist es bekannt, einen kapazitiven Spannungsteiler zwischen die Lastanschlüsse des Leistungsbauelementes zu schalten und ein Spannungssignal an diesem kapazitiven Spannungsteiler abzugreifen. Der Wert dieses Spannungssignals ist hierbei von der anliegenden Laststreckenspannung abhängig. Bei dem zuvor anhand von Beispielen erläuterten erfindungsgemäßen Leistungshalbleiterbauelement ist ein solcher kapazitiver Spannungsteiler, der parallel zur Laststrecke, im vorliegenden Fall parallel zur Drain-Source-Strecke, geschaltet ist, bereits vorhanden. Eine erste Kapazität wird bei diesem Bauelement durch die Driftzone 2 und die Driftsteuerzone 3, die durch das Akkumulationsdielektrikum 4 voneinander getrennt sind, gebildet. Diese Kapazität ist in Figur 19 schematisch eingezeichnet. Ein Anschluss dieser Kapazität ist dabei an die Drainzone 5 angeschlossen. Eine an die Sourcezone 9 angeschlossene Kapazität ist entweder die in Figur 19 als externes Bauelement eingezeichnete Kapazität 50 oder eine interne Kapazität, die durch die hochdotierte Anschlusszone 34, die hochdotierte Anschlusszone 17 der Bodyzone 8 und das dazwischen liegenden Dielektrikum gebildet ist. Ein Mittenabgriff des durch diese beiden Kapazitäten gebildeten kapazitiven Spannungsteilers bildet die Anschlusselektrode 19 der Driftsteuerzone 3. An diesem Anschluss 19 der Driftsteuerzone 3 kann somit unmittelbar ein Signal abgegriffen werden, das zu der Laststreckenspannung des Leistungshalbleiterbauelements in Beziehung steht.

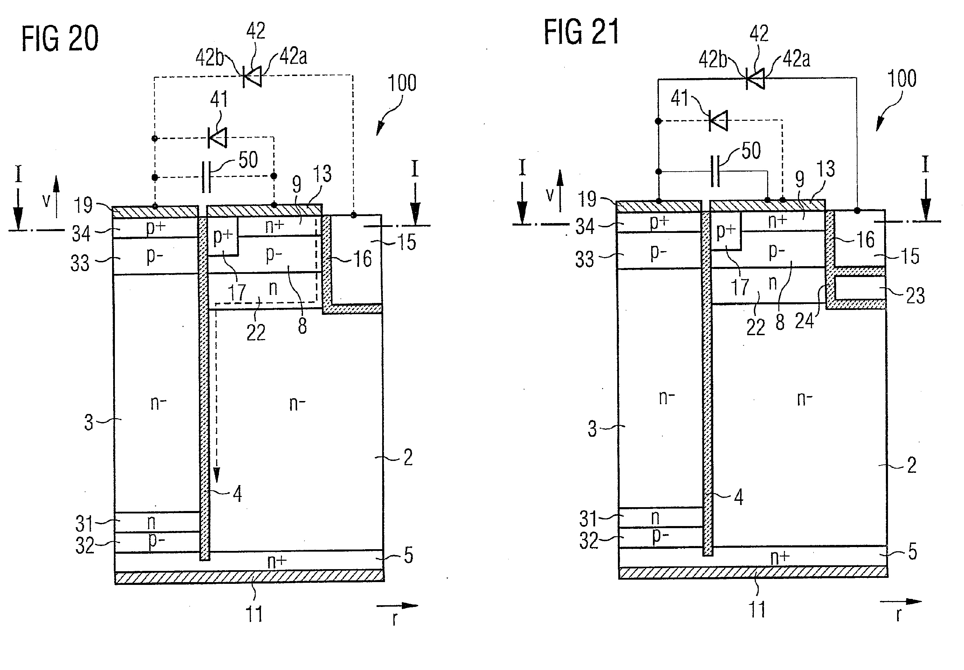

Zur Auswertung dieser Laststreckenspannung kann entweder der Absolutwert eines elektrischen Potentials an diesem Anschluss 19 ausgewertet werden. Es kann jedoch auch das dynamische Verhalten des Potentials an diesem Anschluss 19 ausgewertet werden, wobei ein Anstieg dieses Potentials zu einem Anstieg der Laststreckenspannung und ein Abfallen dieses Potentials zu einem Abfallen der Laststreckenspannung korrespondiert. Figur 20 zeigt eine Abwandlung des in Figur 19 dargestellten vertikalen Leistungsbauelements. Bei diesem Bauelement ist zwischen der Bodyzone 8 und der Driftzone 2 eine höher als die Driftzone 2 dotierte Zwischenzone 22 des gleichen Leitungstyps wie die Driftzone 2 vorhanden. Diese Zwischenzone 22 erstreckt sich in lateraler Richtung r des Halbleiterkörpers 100 von dem Gatedielektrikum 16 bis an das Akkumulationsdielektrikum 4. Aufgabe dieser Zwischenzone 22 ist es, bei leitend angesteuertem Bauelement die Querleitfähigkeit zwischen dem Inversionskanal, der sich in der Bodyzone 8 entlang des Gatedielektrikums 16 ausbildet, und dem Akkumulationskanal, der sich entlang des Akkumulationsdielektrikums 4 in der Driftzone 2 ausbildet, zu erhöhen, bzw. den elektrischen widerstand zwischen dem in lateraler Richtung des Halbleiterkörpers r beabstandet zu dem Akkumulationskanal angeordneten Inversionskanal zu verringern. Der Weg der Ladungsträger durch das Bauelement zwischen der Sourcezone 9 und der Drainzone 5 ist in Figur 20 gestrichelt veranschaulicht. Die Dotierungskonzentration dieser Zwischenzone 22 liegt beispielsweise im Bereich zwischen $10^{15}$ cm$^{-3}$ und $10^{17}$ cm$^{-3}$ und damit ein bis zwei Größenordnungen über der Dotierungskonzentration der Driftzone 2.

Durch das Vorsehen der höher dotierten Zwischenzone 22 erhöht sich bei gleichbleibender Dotierungskonzentration der Driftzone 2 die Anzahl der Dotierstoffatome zwischen der Bodyzone 8 und der Drainzone 5, was grundsätzlich zu einer Verringerung der Spannungsfestigkeit des Bauelements führt. Um eine solche Verringerung der Spannungsfestigkeit zu vermeiden, kann bei Vorsehen einer höher dotierten Zwischenzone 22 die Dotierungskonzentration der Driftzone 2 verringert werden.

Um einer Verringerung der Spannungsfestigkeit bei Vorsehen der höher dotierten Zwischenzone 22 vorzubeugen, kann alternativ oder zusätzlich zu einer Absenkung der Dotierungskonzentration der Driftzone 2 Bezug nehmend auf Figur 21 eine Feldelektrode 23 vorgesehen werden, die benachbart zu der höher dotierten Zwischenschicht 22 angeordnet ist und die durch eine Dielektrikumsschicht 24 dielektrisch gegenüber der Zwischenzone 22 und der Driftzone 2 isoliert ist. Die Feldelektrode 23 ist in dem dargestellten Ausführungsbeispiel in vertikaler Richtung v des Halbleiterkörpers 100 unmittelbar benachbart zu der Gateelektrode 15 angeordnet. Die Feldelektrode 23 ist beispielsweise elektrisch an die Sourceelektrode 13 angeschlossen und liegt damit auf Source-Potential des Halbleiterbauelements. Aufgabe dieser Feldelektrode 23 ist es, bei sperrend angesteuertem Halbleiterbauelement, also dann wenn sich eine Raumladungszone ausgehend von dem pn-Übergang zwischen der Bodyzone 8 und der höher dotierten Zwischenzone 22 ausbildet, wenigstens einen Teil der in der Zwischenzone 22 vorhandenen Dotierstoffladung zu kompensieren. Die Zwischenzone 22 kann dadurch gegenüber einem Bauelement ohne Feldelektrode 23 bei gleicher Spannungsfestigkeit des Bauelements höher dotiert werden.

Bei den Bauelementen gemäß der Figuren 20 und 21 ist die Driftsteuerzone 3 über die bereits erläuterten Anschlusszonen 31, 32 an die Drainzone 5 und die ebenfalls bereits erläuterten Anschlusszonen 33, 34 an die Anschlusselektrode 19 angeschlossen. Es sei darauf hingewiesen, dass die Driftsteuerzone selbstverständlich auch entsprechend der Ausführungen zu den Figuren 12, 17 und 18 an die Drainzone 5 und die Anschlusselektrode 19 angeschlossen sein kann.

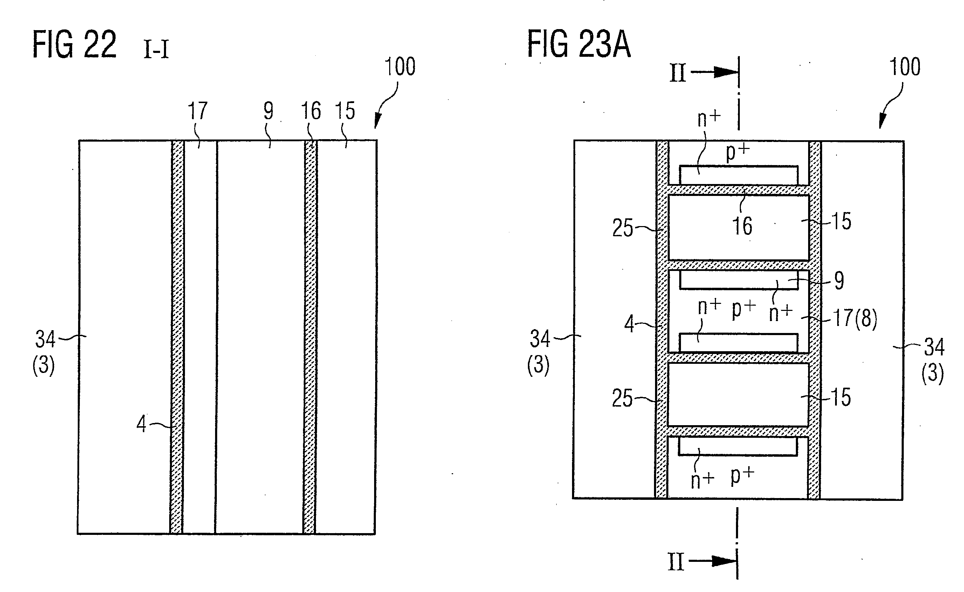

Figur 22 zeigt einen Querschnitt durch die in den Figuren 20 und 21 dargestellten Bauelemente in der Schnittebene I-I. Die Gateelektrode 15 verläuft bei diesen Bauelementen in lateraler Richtung des Halbleiterkörpers 100 im Wesentlichen parallel zu der Driftsteuerzone 3. Durch die in den Figuren 20 und 21 dargestellten höher dotierten Zwischenzonen 22 wird bei diesen Bauelementen die Querleitfähigkeit zwischen dem Inversionskanal entlang der Gateelektrode 15 und dem Akkumulationskanal entlang des Akkumulationsdielektrikums 4 erhöht.

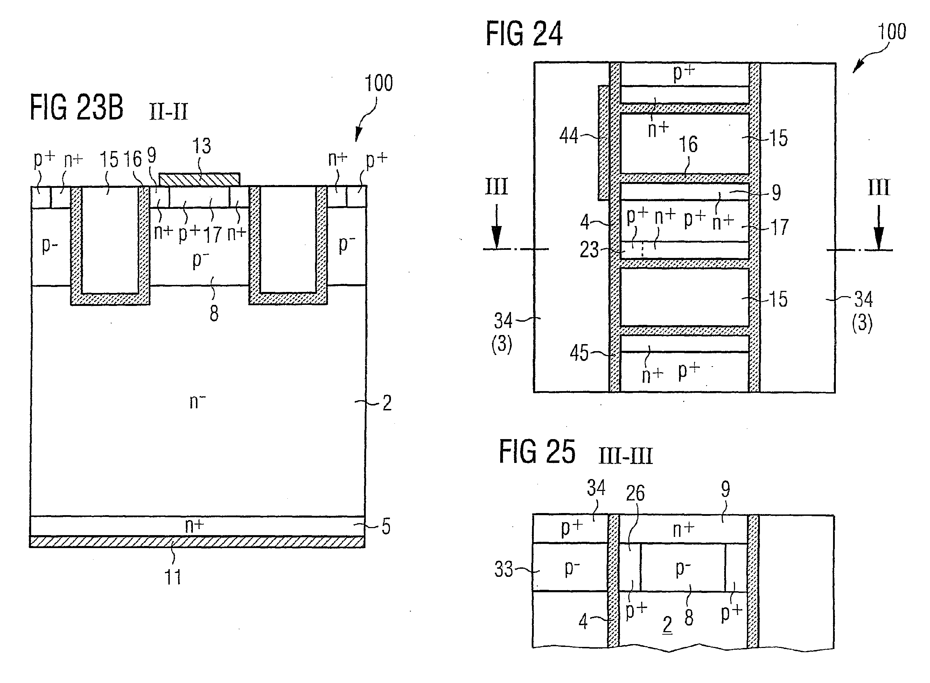

Figur 23A zeigt in einer der Schnittebene I-I entsprechenden Schnittebene ein gegenüber den Bauelementen der Figuren 20 und 21 abgewandeltes Bauelement. Ein Querschnitt durch dieses Bauelement in einer in Figur 23A dargestellten Schnittebene II-II ist in Figur 23B dargestellt. Zwischen zwei Driftsteuerzonen 3 sind bei diesem Bauelement abwechselnd Gateelektroden bzw. Abschnitte der Gateelektrode 15 und Bodyzonen bzw. Abschnitte der Bodyzone 8 angeordnet. Die Schnittdarstellung in Figur 23A zeigt die hochdotierten Anschlusszonen 17 und die Sourcezonen 9, die Bodyzonen 8 sind hierbei unterhalb dieser Anschlusszonen 17 und der Sourcezonen 9 angeordnet. Die Gateelektroden 15 sind durch das Gatedielektrikum 16 gegenüber den Bodyzonen isoliert und außerdem mittels einer Dielektrikumsschicht gegenüber der Driftsteuerzone 3 isoliert. Das Gatedielektrikum 16, das Akkumulationsdielektrikum 4 und das die Gateelektrode 15 gegenüber der Driftsteuerzone 3 isolierende Dielektrikum 25 können hierbei aus dem gleichen Material bzw. einem Material mit gleichen Dielektrizitätseigenschaften bestehen.

Bei dem anhand der Figuren 23A und 23B dargestellten Bauelement verlaufen eine Fläche des Gatedielektrikums 16, entlang dessen sich bei leitend angesteuertem Bauelement der Inversionskanal in der Bodyzone 8 ausbildet, und eine Fläche des Akkumulationsdielektrikums 4, entlang der sich der Akkumulationskanal in der Driftzone 2 ausbildet, senkrecht zueinander. Der sich im oberen Bereich des Halbleiterkörpers entlang des Gatedielektrikums 16 ausbildende Inversionskanal erstreckt sich bei diesem Bauelement in lateraler Richtung bis an den sich im unteren Bereich des Halbleiterkörpers 100 entlang des Akkumulationsdielektrikums 4 ausbildenden Akkumulationskanal.

Um zu vermeiden, dass sich ein nicht mehr abschaltbarer Kanal in dem an das Akkumulationsdielektrikum 4 angrenzenden Teil der Bodyzone 8 ausbildet, sind die Sourcezonen 9 derart angeordnet, dass sie sich in lateraler Richtung des Halbleiterkörpers 100 nicht bis an das Akkumulationsdielektrikum 4 erstrecken, was in Figur 23A dargestellt ist. Sofern sich die Sourcezonen 9 aus prozesstechnischen Gründen in lateraler Richtung des Halbleiterkörpers bis an das Akkumulationsdielektrikum 4 erstrecken sollen, bestehen verschiedene in Figur 24 dargestellte Möglichkeiten, die Ausbildung eines nicht mehr abschaltbaren Kanals zu verhindern. Eine Möglichkeit besteht darin, das Akkumulationsdielektrikum 4 in den Bereichen, in denen die Sourcezone 9 bis an das Akkumulationsdielektrikum 4 reicht, dicker als in übrigen Bereichen zu realisieren. Dies ist in Figur 24 durch das Vorsehen einer zusätzlichen Dielektrikumsschicht 44 unmittelbar anschließend an das Akkumulationsdielektrikum 4 veranschaulicht. Alternativ besteht die Möglichkeit, das Akkumulationsdielektrikum 4 so zu realisieren, dass dessen Dielektrizitätskonstante in den Bereichen, in denen die Sourcezone 9 bis an das Akkumulationsdielektrikum 4 reicht, geringer ist als in übrigen Bereichen, insbesondere als in solchen Bereichen, in denen sich entlang des Akkumulationsdielektrikums 4 in der Driftzone 2 bei leitend angesteuertem Bauelement ein Akkumulationskanal ausbilden soll. Alternativ besteht die Möglichkeit, in vertikaler Richtung des Halbleiterkörpers 100 zwischen der Sourcezone 9 und der Driftzone 2 eine Kanalstoppzone 26 entlang des Akkumulationsdielektrikums 4 benachbart zu der Bodyzone 8 vorzusehen. Diese Kanalstoppzone 26 ist komplementär zu der Sourcezone 9 und höher als die Bodyzone 8 dotiert und dient dazu, einen durch die Driftsteuerzone gesteuerten Kanal entlang des Akkumulationsdielektrikums 4 zwischen der Sourcezone 9 und der Driftzone 2 zu verhindern. Ein Querschnitt in einer Schnittebene III-III im Bereich dieser Kanalstoppzone 26 ist in Figur 25 dargestellt.

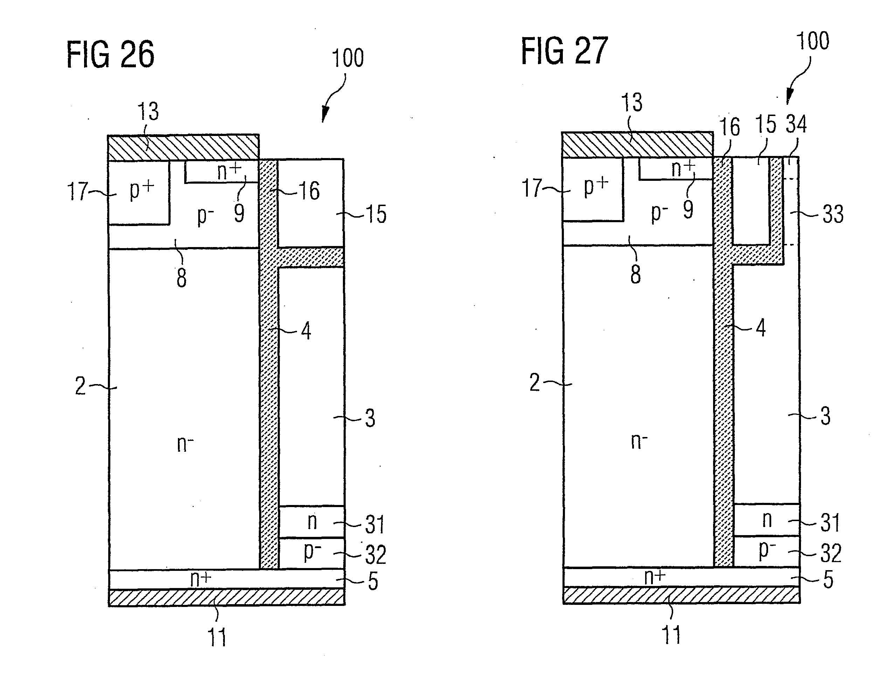

Auf besondere Maßnahmen zur Erhöhung der Querleitfähigkeit, wie sie zuvor anhand der Figuren 21 bis 25 erläutert wurden, kann Bezug nehmend auf die Figuren 26 und 27 verzichtet werden, wenn die Gateelektrode 15 derart in Verlängerung der Driftsteuerzone 3 angeordnet ist, dass bei leitend angesteuertem Bauelement ein sich entlang des Gatedielektrikums 16 ausbildender Inversionskanal unmittelbar in einen sich entlang des Akkumulationsdielektrikums 4 ausbildenden Akkumulationskanal übergeht. Bei den in den Figuren 26 und 27 dargestellten Bauelementen ist die Gateelektrode 15 in vertikaler Richtung des Halbleiterkörpers 100 oberhalb der Driftsteuerzone 3 angeordnet. Zur Realisierung des Gatedielektrikums 16 und des Akkumulationsdielektrikums 4 kann eine gemeinsame Dielektrikumsschicht vorgesehen sein, die in dem Bereich zwischen der Gateelektrode 15 und der Bodyzone 8 das Gatedielektrikum 16 und im Bereich zwischen der Driftsteuerzone 3 und der Driftzone das Akkumulationsdielektrikum 4 bildet. Die Gateelektrode 15 und die Driftsteuerzone 3 sind hierbei durch ein Dielektrikum gegeneinander dielektrisch isoliert, das hinsichtlich seiner Dielektrizitätseigenschaften dem Gatedielektrikum 16 und/oder dem Akkumulationsdielektrikum 4 entsprechen kann. Die Driftsteuerzone 3 kann entsprechend einer der zuvor anhand der Figuren 12 und 17 bis 19 erläuterten Möglichkeiten an die Sourceelektrode 13 oder die Gateelektrode 15 gekoppelt sein. Auf die Darstellung solcher elektrischer Verbindungen und gegebenenfalls zusätzlich erforderlicher Bauelemente, wie Dioden oder Kapazitäten, ist in den Figuren 26 und 27 aus Gründen der Übersichtlichkeit verzichtet.

Bei dem Bauelement gemäß Figur 26 überdeckt die Gateelektrode 15 abschnittsweise den Bereich oberhalb der Driftsteuerzone 3 vollständig, d. h. die Driftsteuerzone 3 reicht abschnittsweise nicht bis an die Vorderseite des Halbleiterkörpers 100. Bei diesem Bauelement sind in nicht näher dargestellter Weise Abschnitte vorhanden, in denen die Driftsteuerzone 3 bis an die Vorderseite des Halbleiterkörpers 100 reicht, um dort kontaktiert zu werden. Diese Abschnitte liegen in einer Richtung senkrecht zu der dargestellten Zeichenebene versetzt zu dem in Figur 26 dargestellten Abschnitt der Driftsteuerzone 3.

Bei dem in Figur 27 dargestellten Bauelement ist die Gateelektrode 15 in einer Richtung senkrecht zum Gatedielektrikum 16 schmaler ausgebildet als bei dem Halbleiterbauelement gemäß Figur 26, so dass die Driftsteuerzone 3 bei diesem Bauelement an der Gateelektrode 15 vorbei und durch eine Dielektrikumsschicht gegenüber der Gateelektrode 15 isoliert, bis an die Vorderseite 100 des Halbleiterkörpers reicht. In diesem Bereich können die bereits zuvor erläuterten Zwischenschichten bzw. Kontaktschichten 33, 34 vorgesehen sein, die in Figur 27 gestrichelt dargestellt sind.

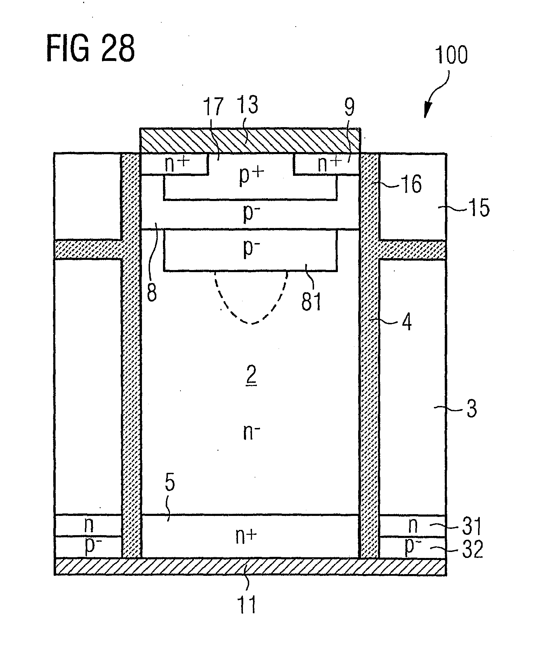

Bei dem anhand der Figuren 26 und 27 erläuterten Bauelement, bei dem die Gateelektrode 15 in unmittelbarer Verlängerung der Driftsteuerzone 3 vorgesehen ist, kann es bei sperrend angesteuertem Bauelement zu Spitzen des sich in der Driftzone 2 ausbreitenden elektrischen Feldes an dem Übergangsbereich zwischen der Gateelektrode 15 und der Driftsteuerzone 3 bzw. zwischen den Bereichen, in denen sich bei leitend angesteuertem Bauelement der Inversionskanal und der Akkumulationskanal ausbilden, kommen. Solche Spannungsspitzen können zu einem verfrühten Spannungsdurchbruch in diesem Bereich des Bauelements führen. Um einem solchen verfrühten Spannungsdurchbruch vorzubeugen, kann Bezug nehmend auf Figur 28 im Anschluss an die Bodyzone 8 eine Halbleiterzone 81 des gleichen Leitungstyps wie die Bodyzone 8 vorgesehen werden. Diese Halbleiterzone 81 wird nachfolgend als tieferliegende Bodyzone oder Body-Extension bezeichnet.

Diese tieferliegende Bodyzone 81 reicht in vertikaler Richtung des Halbleiterkörpers 100 bis auf Höhe der Driftsteuerzone 3, in lateraler Richtung des Halbleiterkörpers 100 jedoch nicht bis an das Akkumulationsdielektrikum 4 heran. Die tieferliegende Bodyzone beeinflusst dadurch die Ausbildung des Akkumulationskanals entlang des Akkumulationsdielektrikums 4 bei leitend angesteuertem Halbleiterbauelement nicht, schirmt jedoch im Sperrfall das elektrische Feld von dem zwischen der tieferliegenden Bodyzone 81 und dem Akkumulationsdielektrikum 4 liegenden Bereich der Driftzone 2 ab. Hierdurch wird das Auftreten von Feldspitzen in diesem Bereich der Driftzone 2 nahe des Akkumulationsdielektrikums 4 verhindert.

Bei einer ersten Ausgestaltung des in Figur 28 dargestellten Bauelements ist die tieferliegende Bodyzone vergleichsweise niedrig dotiert, d. h. beispielsweise entsprechend der Bodyzone 8 oder niedriger dotiert. Die tieferliegende Bodyzone liefert hierbei eine Kompensationsladung zu der komplementären Dotierstoffladung am oberen Ende der Driftzone 2, d. h. in dem Bereich der Driftzone 2, der unmittelbar benachbart zu der tieferliegenden Bodyzone 81 liegt. Bei sperrend angesteuertem Bauelement wird hierdurch die Spannungsaufnahme im Übergangsbereich zwischen der tieferliegenden Bodyzone 81 und der Driftzone 2 aufgrund eines geringeren Gradienten des elektrischen Feldes erhöht, so dass Feldspitzen vermieden werden.

Bei einer weiteren Ausgestaltung ist vorgesehen, die tieferliegende Bodyzone 81 so zu realisieren, dass bei sperrendem Bauelement gezielt Feldstärkespitzen im Bereich der tieferliegenden Bodyzone 81 generiert werden, um einen Spannungsdurchbruch auf die tieferliegende Bodyzone zu konzentrieren. Dies kann dadurch erreicht werden, dass ein pn-Übergang zwischen der tieferliegenden Bodyzone 81 und der Driftzone 2 vergleichsweise starke Kanten aufweist, wie dies beispielsweise für die tieferliegende Bodyzone 81 gemäß Figur 28 dargestellt ist. Darüber hinaus besteht die Möglichkeit, die tieferliegende Bodyzone 81 so zu realisieren, dass diese lokal besonders tief in die Driftzone 2 hineinreicht, wobei ein Spannungsdurchbruch dann in den tief in die Driftzone 2 hineinreichenden Bereichen des Halbleiterkörpers 100 auftritt. Ein solcher lokal besonders tiefer Verlauf der tieferliegenden Bodyzone 81 ist in Figur 28 gestrichelt dargestellt. In diesen Fällen ist die tieferliegende Bodyzone 81 vergleichsweise hoch dotiert, d. h. beispielsweise höher als die Bodyzone 8.

Eine anhand von Figur 28 erläuterte tieferliegende Bodyzone 81 kann sowohl bei n-leitenden Bauelementen mit einer n-dotierten Driftzone 2 (wie in Figur 28 dargestellt) verwendet werden, wie auch bei einem n-leitenden Bauelement mit p-dotierter Driftzone, das nachfolgend noch anhand der Figuren 41 bis 43 erläutert werden wird.

Bei den zuvor anhand der Figuren 16, 17 und 19 erläuterten Leistungsbauelementen ist die Drainzone 5 des Bauelements über ein Gleichrichterelement, im vorliegenden Fall eine Diode, oder ein Tunneldielektrikum an die Driftsteuerzone 3 angeschlossen. Diese Diode kann Bezug nehmend auf die Figuren 16, 17A und 19 durch einen pn-Übergang zwischen zwei komplementär zueinander dotierten Anschlusszonen 31, 32 gebildet sein, die in Richtung der Rückseite des Halbleiterkörpers 100 aufeinanderfolgend anschließend an die Driftsteuerzone 3 angeordnet sind.

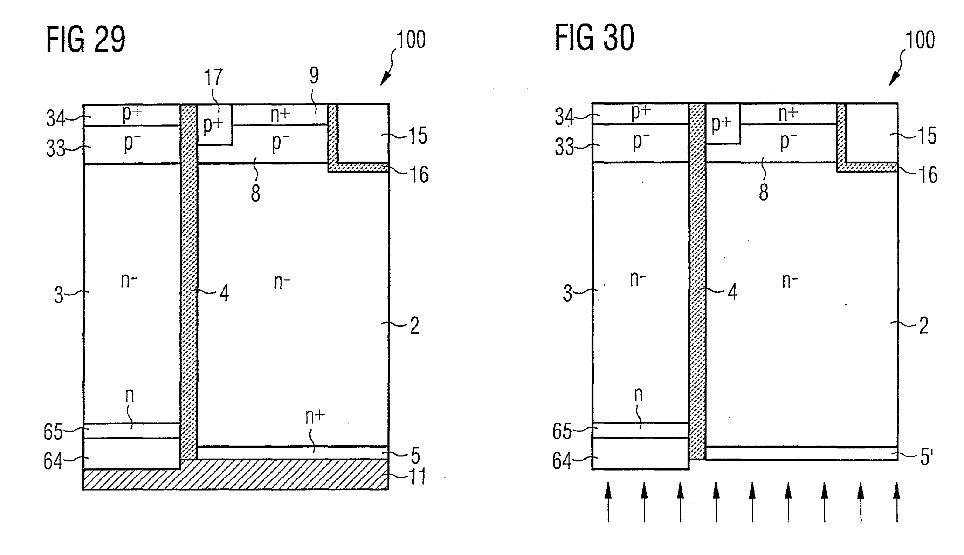

Ein solcher pn-Übergang zwischen der Drainzone 5 bzw. der Drainelektrode 11 und der Driftsteuerzone 3 kann Bezug nehmend auf Figur 29 durch einen Schottky-Übergang ersetzt werden. Bei dem dargestellten Bauelement ist ein Schottky-Kontakt zwischen einem Schottky-Metall 64, beispielsweise Platin, und einer höher als die Driftsteuerzone 3 dotierten Zwischenzone 65 vorhanden. Diese Zwischenzone 65 ist nicht zur Ausbildung eines Schottky-Kontakts erforderlich, sondern dient als Stoppzone, die ein Abfließen von Löchern aus der Driftsteuerzone 3 an die Drainelektrode 11 verhindert.

Figur 30 zeigt das Bauelement gemäß Figur 29 während eines möglichen Herstellungsverfahrens. Bei diesem Verfahren wird nach Herstellen der Löcherstoppzone 65 und dem Aufbringen des Schottky-Metalls 64 auf diese Löcherstoppzone 65 eine Ionenimplantation über die freiliegende Rückseite des Halbleiterkörpers 100 durchgeführt. Bei dieser Ionenimplantation werden n-Dotierstoffatome über die Rückseite des Halbleiterkörpers 100 in die Driftzone 2 implantiert. Das Schottky-Metall 64 wirkt hierbei als Maske, die eine Implantation der Dotierstoffatome in die Driftsteuerzone 3 verhindert. Ein Halbleiterbereich der Driftzone 2, in den die n-Dotierstoffatome implantiert werden, ist in Figur 30 mit dem Bezugszeichen 5' bezeichnet. Das Halbleiterbauelement wird vervollständigt durch Aufbringen einer rückseitigen Metallisierung, die die Drainelektrode 11 bildet, sowie einen Ausheilschritt, durch den der Halbleiterkörper 100 im rückseitigen Bereich aufgeheizt wird, um die in die Halbleiterzone 5' implantierten Dotierstoffatome elektrisch zu aktivieren und dadurch die hochdotierte Drainzone 5 zu bilden, die gleichzeitig einen niederohmigen elektrischen Kontakt zwischen der Drainelektrode 11 und der Driftzone 2 herstellt.

Die Herstellung der Löcherstoppzone 65 dieses Bauelements kann auf verschiedene Weise erfolgen:

Zum einen besteht die Möglichkeit, diese Löcherstoppzone 65 bereits bei Herstellung der Driftsteuerzone 3 herzustellen. Diese Driftsteuerzone 3 wird durch epitaktische Abscheidung eines Halbleitermaterials auf ein zunächst noch vorhandenes Halbleitersubstrat (nicht dargestellt) hergestellt. Die Anordnung mit der Löcherstoppzone 65 und der Driftsteuerzone 3 kann hergestellt werden, indem zu Beginn des Epitaxieverfahrens zunächst eine höher dotierte Schicht hergestellt wird, die die spätere Löcherstoppzone 65 bildet, und indem anschließend ein schwächer dotiertes Halbleitermaterial, das die spätere Driftsteuerzone 3 bildet, epitaktisch abgeschieden wird. Die epitaktische Abscheidung erfolgt hierbei in einem Graben, der zu den Seiten hin durch das Akkumulationsdielektrikum begrenzt ist. Nach Rückätzen, d.h. Entfernen des Substrats wird das Schottky-Metall durch Abscheiden eines Schottky-Metalls und geeignete Strukturierung hergestellt.

Alternativ besteht die Möglichkeit, die Löcherstoppzone 65 entsprechend der Drainzone 5 durch eine maskierte Ionenimplantation über die Rückseite des Halbleiterkörpers 100 herzustellen.

Die Aktivierung der zur Herstellung der Löcherstoppzone 65 und/oder Herstellung der Drainzone 5 implantierten Dotierstoffatome kann durch Aufheizung der Rückseite des Halbleiterkörpers 100 mittels eines Laserstrahls (Laser-Annealing) erfolgen.

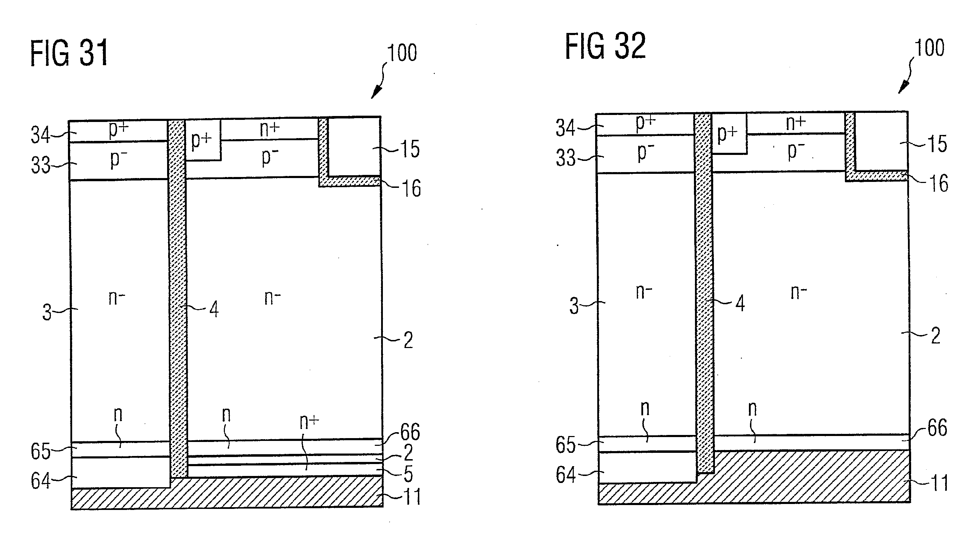

Figur 31 zeigt eine Variante des in Figur 29 dargestellten Halbleiterbauelements. Bei diesem Bauelement ist in der Driftzone 2, beispielsweise auf der gleichen Höhe wie die Löcherstoppzone 65, eine Feldstoppzone 66 vorhanden, die höher als die Driftzone 2 dotiert ist. Diese Feldstoppzone 66 kann beispielsweise vor Aufbringen der die Drainelektrode 11 bildenden rückseitigen Metallisierung mittels einer Ionenimplantation und eines nachfolgenden Ausheilprozesses hergestellt werden.

Bei einer in Figur 32 dargestellten Variante eines erfindungsgemäßen Halbleiterbauelements wird der Halbleiterkörper 100 im Bereich der Driftzone 2 vor dem Herstellen der die Drainelektrode 11 bildenden rückseitigen Metallisierung bis auf Höhe der höher dotierten Halbleiterzone 66, die bei dem Bauelement gemäß Figur 31 die Feldstoppzone bildet, zurückgeätzt. Die Rückseitenmetallisierung 11 kontaktiert bei diesem Bauelement die höher dotierte Halbleiterzone 66 unmittelbar, die hierbei für einen niederohmigen Kontakt zwischen der Rückseitenmetallisierung 11 und der Driftzone 2 sorgt.

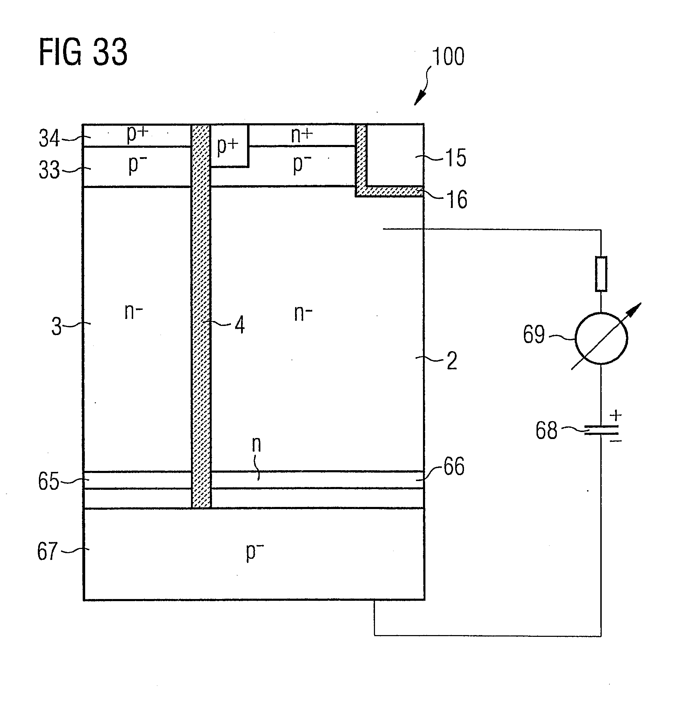

Die anhand der Figuren 29 bis 32 erläuterte Halbleiterstruktur mit der Driftsteuerzone 3, dem Akkumulationsdielektrikum 4 und der Driftzone 2 sowie mit den im Bereich der Vorderseite des Halbleiterkörpers angeordneten weiteren Bauelementstrukturen kann Bezug nehmend auf Figur 33 zunächst auf einem p-dotiertem Halbleitersubstrat hergestellt werden, das vor Herstellen des Schottky-Metalls (64 in den Figuren 29 bis 32) und der Rückseitenmetallisierung (11 in den Figuren 29 bis 32) zu entfernen ist. Das Entfernen dieses p-Substrats erfolgt beispielsweise mittels eines elektrochemischen Ätzverfahrens in einem basischen Ätzmedium, wie beispielsweise $NH_4OH$, NaOH, KOH in wässriger Lösung. Zwischen das Halbleitersubstrat 67 und die darauf aufgebrachte Epitaxieschicht wird mittels einer Spannungsquelle 68 dabei eine elektrische Spannung angelegt, wodurch das p-Substrat elektrochemisch zurückgeätzt wird. Während dieses Ätzprozesses wird durch eine Strommessanordnung 69 der von der Spannungsquelle 68 gelieferte Strom gemessen.

Man macht sich hierbei zu Nutze, dass der fließende Strom dann sprunghaft ansteigt, wenn das Substrat 67 vollständig zurückgeätzt wird und das Ätzmedium dann an der n-dotierten Epitaxieschicht angreift. Der fließende Strom dient bei diesem Verfahren als Ätzkontrolle, wobei das Ätzverfahren beendet wird, wenn der Strom bei Erreichen der n-dotierten Epitaxieschicht sprunghaft ansteigt.

Das erläuterte Verfahren, bei dem das p-Substrat 67 durch ein elektrochemisches Ätzverfahren entfernt wird, ist besser kontrollierbar als ein chemischer oder mechanischer Abtragprozess, wobei das erläuterte Verfahren mit einem solchen Prozess kombiniert werden kann, indem das Halbleitersubstrat 67 zunächst chemisch oder mechanisch gedünnt wird und indem erst anschließend das elektrochemische Verfahren, das eine exakte Endpunktkontrolle erlaubt, durchgeführt wird.

Figur 34 zeigt ein Ausführungsbeispiel eines erfindungsgemäßen Leistungsbauelements, das hinsichtlich seines Einschalt-, Ausschalt- und Überstromverhaltens gegenüber den bisher erläuterten Halbleiterbauelementen verbessert ist. Bei diesem Bauelement ist im Anschluss an die Driftzone 2 eine komplementär zu der Driftzone dotierte Halbleiterzone 27 vorhanden, die zusammen mit der Drainzone 5 an die Drainelektrode 11 angeschlossen ist. In lateraler Richtung erstreckt sich diese p-Zone 27 zwischen den Drainzonen 5 über die gesamte Breite der Driftzone 2 zwischen den Akkumulationsdielektrika 4 zweier sich zu beiden Seiten an die Driftzone 2 anschließender Driftsteuerzonen 3. Die Driftsteuerzone 3 ist bei diesem Bauelement über eine durch die Anschlusszonen 31, 32 gebildete Diode an die Drainelektrode 11 angeschlossen. Zum Anschluss der Driftsteuerzone 3 an die Drainelektrode 11 kann jedoch auch eine der anderen bislang erläuterten Möglichkeiten, insbesondere das Vorsehen einer Schottky-Diode, angewendet werden.

Die Funktionsweise bzw. die Auswirkungen der p-Zone 27 auf die Funktion des Halbleiterbauelements wird nachfolgend erläutert:

Zur Erläuterung wird zunächst von einem sperrenden Halbleiterbauelement ausgegangen. Wie erläutert breitet sich bei sperrendem Bauelement in der Driftzone 2 und in der Driftsteuerzone 3 gesteuert durch die Driftzone 2 eine Raumladungszone aus. Wird das Bauelement nachfolgend leitend angesteuert, so bildet sich zunächst ein Inversionskanal entlang des Gatedielektrikums 16 in der Bodyzone 8 aus, so dass Ladungsträger von der Sourcezone 9 über diesen Inversionskanal in die Driftzone 2 fließen. Zu Beginn des Ansteuervorgangs ist der Akkumulationskanal in der Driftzone 2 noch nicht ausgebildet, so dass die Ladungsträger annähernd homogen verteilt über die Driftzone in Richtung der Drainzone 5 fließen. Ein Akkumulationskanal in der Driftzone 2 bildet sich hierbei erst dann aus, wenn der Spannungsabfall über der Driftzone 2 so weit zurückgegangen ist, dass der Potentialunterschied zwischen der Driftsteuerzone 3 und der Driftzone 2 zur Ausbildung eines solchen Akkumulationskanals entlang des Akkumulationsdielektrikums 4 ausreichend ist. Die im Anschluss an die Driftzone 2 vorhandene p-Zone 27 unterstützt bei diesem Bauelement zu Beginn des Einschaltvorgangs ein Absinken der über der Driftzone 2 anliegenden Spannung und bewirkt so eine Beschleunigung der zur Ausbildung des Akkumulationskanals führenden Vorgangs. Dieser Effekt ist darauf zurückzuführen, dass die p-Zone 27 eine Überschwemmung der Driftzone 2 mit Ladungsträgern bewirkt. Der Akkumulationskanal entlang des Akkumulationsdielektrikums 4 erstreckt sich bei dem Bauelement gemäß Figur 34 auch durch die bis an das Akkumulationsdielektrikum 4 reichenden Abschnitte der p-Zone 27 bis an die Drainzone 5. In eingeschaltetem Zustand, d. h. nach Ausbilden des Akkumulationskanals ist somit ein Nebenschluss zu dem p-dotierten Gebiet 27 vorhanden. Der maßgebliche Teil der Ladungsträger fließt bei diesem Bauelement dann über den Inversionskanal entlang des Gatedielektrikums 16 und den Akkumulationskanal entlang des Akkumulationsdielektrikums 4 in die Drainzone 5. Der durch die p-Zone 27 gebildete rückseitige Emitter ist bei eingeschaltetem Bauelement somit nicht mehr wirksam. Die Höhe der p-Dotierung der p-Zone 27 kann über einen weiten Bereich variieren. Sie sollte mindestens ein oder mehrere $10^{17}$ cm$^{-3}$ betragen, kann aber auch höher dotiert sein. Die laterale Ausdehnung der p-Zone 27 sollte so ausgelegt sein, dass die vertikale Leitfähigkeit in der Drainzone 5 so groß bleibt, dass bei Nennstrom des Bauelements der Spannungsabfall in der Drainzone 5 kleiner ist als die Diodenschwelle des durch die p-Zone 27 und die Driftzone 2 gebildeten pn-Übergangs.. Die vertikale Ausdehnung von 27 ist relativ unbedeutend; sie sollte nur mindestens so groß sein, dass die p-Dosis in vertikaler Richtung für gute Emittereigenschaften ausreicht, beispielsweise etwa $10^{13}$ cm$^{-2}$, was bei einer p-Dotierung von $10^{17}$ cm$^{-3}$ einer vertikalen Abmessung von $1\mu$m entspricht.

Figur 35 zeigt eine Abwandlung des in Figur 34 dargestellten Halbleiterbauelements. Bei diesem Bauelement ist der p-Zone 27 eine Feldstoppzone 28 des gleichen Leitungstyps wie die Driftzone 2 vorgelagert. Diese Feldstoppzone 28, die höher dotiert ist als die Driftzone 2, erstreckt sich in lateraler Richtung zwischen den zwei die dargestellte Driftzone 2 in lateraler Richtung begrenzenden Akkumulationsdielektrika 4.

Eine weitere Variante des in Figur 34 dargestellten Halbleiterbauelements ist in Figur 36 dargestellt. Bei diesem Bauelement entsprechen die Abmessungen der p-Zone 27 in vertikaler Richtung des Halbleiterkörpers 100 den Abmessungen der Drainzone 5. Die p-Zone 27 reicht in lateraler Richtung des Halbleiterkörpers somit nicht bis an das Akkumulationsdielektrikum 4, so dass sich im Bereich des Akkumulationsdielektrikums 4 die Driftzone 2 unmittelbar an die Drainzone 5 anschließt.

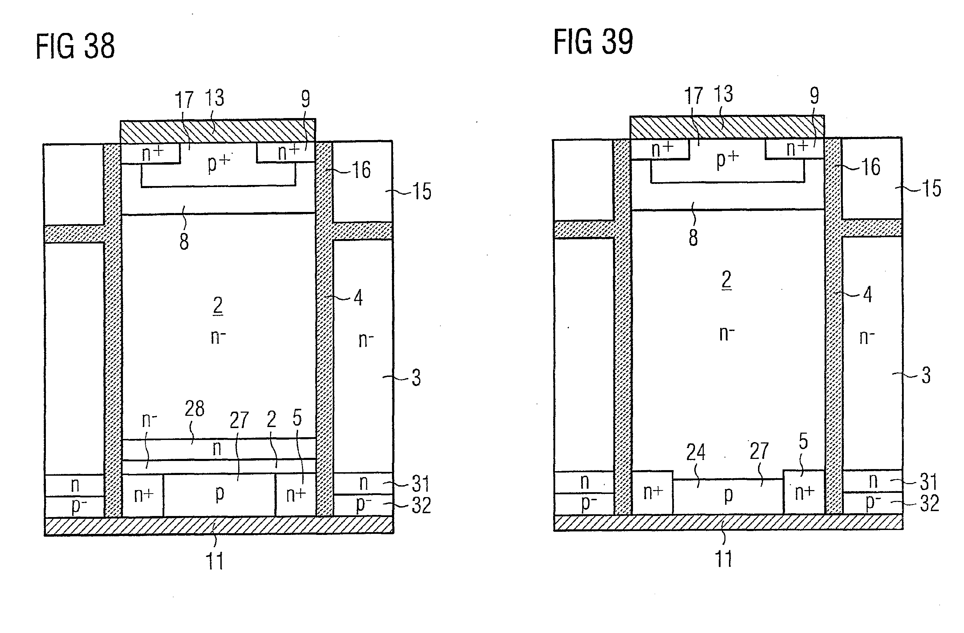

Bei einer in Figur 37 dargestellten Abwandlung des in Figur 36 dargestellten Bauelements schließt sich an die Drainzone 5 und die p-Zone 27 unmittelbar die Feldstoppzone 28 an. Alternativ kann diese Feldstoppzone 28 auch beabstandet zu der Drainzone 5 und der p-Zone 27 angeordnet sein, wie dies in Figur 38 dargestellt ist. Bei diesem Bauelement ist zwischen der Feldstoppzone 28 und der Drainzone 5 bzw. der p-Zone 27 ein Abschnitt der Driftzone 2 vorhanden.

Eine weitere Variante des in Figur 36 dargestellten Halbleiterbauelements ist in Figur 39 dargestellt. Bei diesem Bauelement sind die Abmessungen der p-Zone 27 in vertikaler Richtung im Vergleich zu den Abmessungen der Drainzone 5 geringer, so dass die p-Zone 27 in Richtung der Drainelektrode gegenüber der Drainzone 5 zurückgesetzt ist.

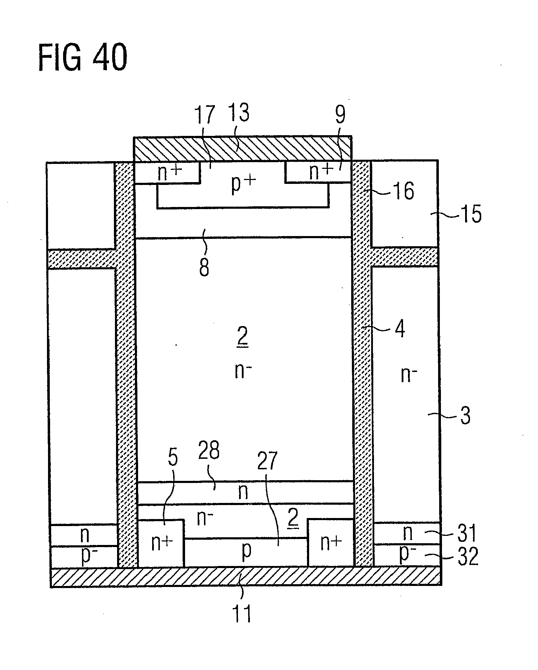

Figur 40 zeigt das Bauelement gemäß Figur 39 mit zusätzlicher, der Drainzone und der p-Zone 27 vorgelagerter Feldstoppzone 28.

Ein weiteres Ausführungsbeispiel eines erfindungsgemäßen Leistungshalbleiterbauelements mit einer Driftzone 2, einer Driftsteuerzone 3 und einem zwischen der Driftzone 2 und der Driftsteuerzone 3 angeordneten Akkumulationsdielektrikum 4 ist in Figur 41 dargestellt. Das dargestellte Bauelement ist als n-leitender MOSFET mit einer n-dotierten Sourcezone 9 und einer n-dotierten Drainzone 5, jedoch einer wenigstens abschnittsweise p-dotierten Driftzone 2 realisiert. Aus Gründen der Übersichtlichkeit ist in Figur 41 der Anschluss der Driftsteuerzone 3 an die Drainzone 5, die Sourcezone 9 und gegebenenfalls die Gateelektrode 15 nicht näher ausgeführt. Dieser Anschluss der Driftsteuerzone 3 an diese Halbleiterzonen kann unter Verwendung einer beliebigen der bislang erläuterten Möglichkeiten erfolgen.

Bei leitend angesteuertem Bauelement, d. h. bei Anlegen einer positiven Spannung zwischen Drainzone 5 und Sourcezone 9 und Anlegen eines geeigneten Ansteuerpotentials an die Gateelektrode 15 bildet sich bei dem dargestellten Bauelement in der p-dotierten Driftzone 2 ein Inversionskanal entlang des Akkumulationsdielektrikums 4 aus. Das Akkumulationsdielektrikum 4 hat bei diesem Bauelement somit die Funktion eines "Inversionsdielektrikums". Der Einfachheit halber wird im Vorliegenden jedoch der Begriff "Akkumulationsdielektrikum" auch für ein Dielektrikum verwendet, entlang dessen sich in einer p-dotierten Driftzone 2 ein Inversionskanal ausbildet.

Die Gateelektrode 15 ist bei dem dargestellten Bauelement in lateraler Richtung r des Halbleiterkörpers 100 beabstandet zu der Driftsteuerzone 3 angeordnet. Ein sich bei leitend angesteuertem Bauelement entlang des Gatedielektrikums 16 in der Bodyzone 8 ausbildender Inversionskanal und der sich entlang des Akkumulationsdielektrikums 4 in der p-Driftzone 2 ausbildende Inversionskanal sind somit in lateraler Richtung beabstandet zueinander angeordnet. Zur Überbrückung dieses Abstandes ist zwischen der Bodyzone 8 und der p-Driftzone 2 eine n-dotierte Zwischenzone 22 angeordnet, die die Querleitfähigkeit zwischen diesen beiden Kanälen erhöht, bzw. im vorliegenden Fall einen Elektronenfluss zwischen diesen beiden Kanälen erst ermöglicht.

Figur 42 zeigt eine Abwandlung des in Figur 41 dargestellten Bauelements. Bei diesem Bauelement ist die Gateelektrode 15 in vertikaler Richtung v des Halbleiterkörpers oberhalb der Driftsteuerzone 3 angeordnet. Die p-Driftzone 2 schließt sich bei diesem Bauelement unmittelbar an die p-dotierte Bodyzone 8 an. Auch bei dem in Figur 42 dargestellten Bauelement ist die Verschaltung der Driftsteuerzone 3 mit der Drainzone 5 und der Sourcezone 9 bzw. der Gateelektrode 15 nicht im Detail dargestellt. Diese Verschaltung kann auf beliebige, zuvor erläuterte Weise erfolgen. Die Dotierungskonzentration der p-Driftzone 2 liegt beispielsweise im Bereich von $10^{14}$ cm$^{-3}$ bis $5 \cdot 10^{15}$/cm$^{-3}$, und damit deutlich niedriger als die der Bodyzone 8.

Optional kann bei dem in Figur 41 dargestellten Bauelement zwischen der Driftzone 2 und der quer verlaufenden Zwischenzone 22 eine höher p-dotierte Zone 29 vorgesehen werden. Aufgabe dieser p-Zone 29 ist es, bei sperrend angesteuertem Bauelement die elektrische Feldstärke unterhalb der Bodyzone 8 und der Gateelektrode 15 zu reduzieren. Optional kann außerdem in der p-Driftzone 2 entlang des Akkumulationsdielektrikums 4 eine schwach n-dotierte Halbleiterzone 45 vorgesehen sein, in der sich bei leitend angesteuertem Bauelement ein Akkumulationskanal ausbildet. Die Dotierungskonzentration dieser Zone 45 liegt beispielsweise im Bereich von $10^{15}$ cm$^{-3}$ bis $5 \cdot 10^{16}$ cm$^{-3}$, die Breite/ Abmessung dieser Zone in lateraler Richtung liegt beispielsweise im Bereich zwischen $0,2 \mu m$ - $2 \mu m$.

Diese sehr dünne n-dotierte Halbleiterzone 45 beeinflusst das Sperrverhalten des Bauelements nur wenig, sorgt jedoch für ein verbessertes Einschaltverhalten, da entlang des Akkumulationsdielektrikums 4 stets ein leitender Kanal für Majoritätsladungsträger vorhanden ist. Diese n-Zone 45 erstreckt sich in vertikaler Richtung von der n-leitenden Zwischenzone 22 bis an die Drainzone 5. Eine solche n-Zone kann auch bei dem Bauelement gemäß Figur 42 vorgesehen werden. Bei diesem Bauelement erstreckt sich die n-Zone von der Bodyzone 8 bis an die Drainzone 5. Bei dem Bauelement gemäß Figur 42, bei dem die Gateelektrode 15 und die Driftsteuerzone 3 in vertikaler Richtung übereinander liegen, kann eine solche dünne und schwach n-dotierte Zone 45 auch derart dimensioniert sein, dass sie in vertikaler Richtung lediglich von der Gateelektrode 15 über das die Gateelektrode 15 und die Driftsteuerzone 3 trennende Dielektrikum bis auf Höhe der Driftsteuerzone 3 reicht, um dadurch in der p-Driftzone 2 den Abschnitt zwischen dem sich bei leitendem Bauelement ausbildenden Inversionskanal entlang des Gatedielektrikums 16 und dem sich entlang des Akkumulationsdielektrikums 4 ausbreitenden Akkumulationskanal zu überbrücken.

Figur 43 zeigt eine Abwandlung des in Figur 42 dargestellten Bauelements. Bei diesem Bauelement schließt sich an die p-Driftzone 2 eine höher p-dotierte Zone 29 an, deren Funktion es ist, die Feldstärkebelastung im oberen Bereich der Driftzone 2 zu reduzieren. Zwischen dieser höher p-dotierten Zone 29 und der Driftzone 8 ist eine schwach n-dotierte Zone 22 vorgesehen, die dazu dient, den Halbleiterbereich zwischen dem Gatedielektrikum 16, entlang dem sich bei leitend angesteuertem Bauelement in der Bodyzone 8 ein Inversionskanal ausbildet, und entlang des Akkumulationsdielektrikums 4, entlang dem sich bei leitend angesteuertem Bauelement ein Akkumulationskanal ausbildet, zu "überbrücken". Es sei darauf hingewiesen, dass die Dotierung der p-Zone 29 selbstverständlich nicht so hoch sein darf, dass der Kanal entlang des Akkumulationsdielektrikums 4 abgeschnürt wird.

Es sei darauf hingewiesen, dass die Driftsteuerzone 3 zur Realisierung eines n-leitenden Halbleiterbauelements nicht notwendiger Weise n-dotiert sein muss. Wie explizit in den Figuren 41 bis 43 dargestellt ist, kann die Driftsteuerzone 3 alternativ auch schwach p-dotiert oder intrinsisch sein. Dies gilt für alle bisher und nachfolgend noch erläuterten erfindungsgemäßen Leistungshalbleiterbauelemente.

Figur 44 zeigt ein weiteres Ausführungsbeispiel eines erfindungsgemäßen Leistungshalbleiterbauelements. Das dargestellte Bauelement ist als vertikaler n-leitender MOSFET realisiert.

Die Driftsteuerzone 3 ist bei diesem Bauelement nur abschnittsweise benachbart zu der Driftzone 2 angeordnet, erstreckt sich in vertikaler Richtung v des Halbleiterkörpers 100 also nicht vollständig entlang der Driftzone 2. Die Driftsteuerzone 3 ist bei dem dargestellten Bauelement beabstandet zu der Drainzone 5 im oberen Bereich des Halbleiterkörpers 100 angeordnet, wobei zwischen der Driftsteuerzone 3 und der Drainzone 5 ein Abschnitt der Driftzone 2 angeordnet ist. Die Driftsteuerzone 3 ist bei dem dargestellten Bauelement in lateraler Richtung r des Halbleiterkörpers durch das Akkumulationsdielektrikum 4 dielektrisch gegenüber der Driftzone 2 isoliert. In vertikaler Richtung des Halbleiterkörpers ist zwischen der Driftsteuerzone 3 und der Driftzone 2 ein Tunneldielektrikum 4' vorhanden, das dazu dient, sogenannte "Warmsperrströme" und "Verschiebeströme" aus der Driftsteuerzone 3 abführen zu können.

Die Driftsteuerzone 3 kann über eine hochdotierte Anschlusszone 34 sowie Dioden und eine Kapazität (gestrichelt dargestellt) in bereits erläuterter Weise an die Sourcezone 9 und gegebenenfalls die Gateelektrode 15 angeschlossen sein.

Das Bauelement gemäß Figur 44 basiert auf der Grundstruktur eines Trench-MOSFET wobei zusätzlich die Driftsteuerzone 3 entlang der Driftzone 2 vorhanden ist. Bei diesem Trench-MOSFET ist die Gateelektrode 15 in einem Graben angeordnet, der sich ausgehend von der Vorderseite 101 in den Halbleiterkörper erstreckt. Ein Inversionskanal in der Bodyzone 8 bildet sich bei diesem Bauelement in vertikaler Richtung zwischen der im Bereich der Vorderseite 101 angeordneten Sourcezone 9 und der sich in vertikaler Richtung an die Bodyzone 8 anschließenden Driftzone 2 aus.

Figur 45 zeigt eine Abwandlung des in Figur 44 dargestellten Bauelements. Das in Figur 45 dargestellte Bauelement basiert auf der Grundstruktur eines planaren MOSFET. Bei dem dargestellten Bauelement ist die Gateelektrode 15 oberhalb der Vorderseite 101 des Halbleiterkörpers 100 angeordnet und durch das Gatedielektrikum 16 gegenüber dem Halbleiterkörper 100 isoliert. In lateraler Richtung r des Halbleiterkörpers 100 reicht die Gateelektrode 15 bis an das sich in vertikaler Richtung v in den Halbleiterkörper 100 hineinerstreckende Akkumulationsdielektrikum 4 heran. Die Gateelektrode 15 kann in lateraler Richtung jedoch auch bereits vor dem Akkumulationsdielektrikum 4 enden (nicht dargestellt), sollte sich in lateraler Richtung jedoch von der Sourcezone 9 bis an einen sich bis an die Vorderseite 101 erstreckenden Abschnitt der Driftzone 2 erstrecken. Ein Inversionskanal bildet sich bei dem dargestellten Bauelement in leitendem Zustand in lateraler Richtung in der Bodyzone 8 zwischen der Sourcezone 9 und dem sich bis an die Vorderseite 101 erstreckenden Abschnitt der Driftzone 2 aus. Die Bodyzone 8 ist darüber hinaus so ausgebildet, dass sie die Sourcezone 9 in lateraler und vertikaler Richtung des Halbleiterkörpers 100 umschließt.

Figur 46 zeigt ein gegenüber dem Bauelement in Figur 45 abgewandeltes Bauelement. Bei diesem Bauelement umfasst die Driftzone 2 zwei unterschiedlich dotierte Halbleiterabschnitte, nämlich einen ersten schwächer dotierten Halbleiterabschnitt 91 benachbart zu dem Akkumulationsdielektrikum 4 und einen zweiten höher dotierten Halbleiterabschnitt 92 im Bereich zwischen der Driftsteuerzone 3 und der Drainzone 5. Zusätzlich sind bei diesem Bauelement komplementär zu der Driftzone 2 dotierte Kompensationszonen 93, 94 vorhanden. Eine erste 93 dieser Kompensationszonen ist in lateraler Richtung r des Halbleiterkörpers anschließend an den schwächer dotierten Driftzonenabschnitt 91, und eine zweite 94 dieser Kompensationszonen ist in lateraler Richtung r anschließend an den höher dotierten Driftzonenabschnitt 92 angeordnet. Die Dotierungskonzentration des ersten Kompensationszonenabschnitts 93 ist dabei geringer als die des zweiten Kompensationszonenabschnitts 94.

Die Driftzone 2 kann Bezug nehmend auf Figur 46 so realisiert sein, dass ein Abschnitt des höher dotierten Driftzonenabschnitts 92 zwischen dem Kompensationszonenabschnitt 94 und der Drainzone 5 angeordnet ist. Die Kompensationszonenabschnitte 93, 94 sind in vertikaler Richtung v des Halbleiterkörpers unmittelbar benachbart zueinander angeordnet. Der erste Kompensationszonenabschnitt 93 schließt sich in vertikaler Richtung v darüber hinaus unmittelbar an die Bodyzone 8 an.

Aufgabe der Kompensationszonenabschnitte 93, 94 ist es, bei sperrend angesteuertem Bauelement n-Dotierstoffatome der Driftzone 2 durch p-Dotierstoffatome in den Kompensationszonen 93, 94 zu kompensieren. Dieser Kompensationseffekt tritt insbesondere im unteren Bereich des Halbleiterkörpers, in dem der höher dotierte Driftzonenabschnitt 92 und der höher dotierte Kompensationszonenabschnitt 94 aneinander angrenzen, auf. Die erläuterte Kompensationswirkung ermöglicht es, bei gleicher Spannungsfestigkeit wie ein entsprechendes Bauelement ohne Kompensationszonen die Driftzone höher zu dotieren, woraus eine Verringerung des Einschaltwiderstandes resultiert.

Figur 47 zeigt eine Variante des in Figur 46 dargestellten Bauelements, bei der der schwächer dotierte Kompensationszonenabschnitt 93 in lateraler Richtung des Halbleiterkörpers geringere Abmessungen als der höher dotierte Kompensationszonenabschnitt 94 besitzt. Der niedriger dotierte Kompensationszonenabschnitt 93 dient bei diesem Bauelement weniger zur Kompensation der Dotierstoffatome in dem schwächer dotierten Driftzonenabschnitt 91, sondern im Wesentlichen zum Anschließen des höher dotierten Kompensationszonenabschnitts 94 an die Bodyzone 8.

Verfahrensschritte zur Herstellung einer für die Bauelemente gemäß der Figuren 44 bis 47 verwendeten Halbleiterstruktur, bei der eine Driftsteuerzone 3 nur abschnittsweise benachbart zu der Driftzone 2 angeordnet ist, werden nachfolgend anhand der Figuren 48A bis 48D erläutert.

Bei diesem Verfahren wird zunächst ein Halbleitersubstrat zur Verfügung gestellt, das die spätere Drainzone 5 des Halbleiterbauelements bildet und auf das anschließend mittels eines Epitaxieverfahrens eine Halbleiterschicht 2' aufgebracht wird, die einen Teil der späteren Driftzone 2 des Halbleiterbauelements bildet. Zur Realisierung eines n-leitenden Leistungsbauelements ist das Halbleitersubstrat 5 n-dotiert, die Epitaxieschicht 2' kann n-dotiert oder p-dotiert sein. Auf der Epitaxieschicht 2' wird anschließend abschnittsweise ein Tunneldielektrikum 4' aufgebracht, das zur späteren Trennung der Driftsteuerzone 3 und der Driftzone 2 dient. Die Herstellung dieses Tunneldielektrikums 4' kann beispielsweise durch ganzflächiges Abscheiden einer geeigneten Dielektrikumsschicht und anschließendes selektives Entfernen dieser Dielektrikumsschicht mittels eines Ätzverfahrens erfolgen. Das Ergebnis dieser zuvor erläuterten Verfahrensschritte ist in Figur 48A dargestellt.

Bezug nehmend auf Figur 48B wird anschließend eine weitere Epitaxieschicht 2" auf die erste Epitaxieschicht 2' und das Tunneldielektrikum 4' aufgebracht. Das Tunneldielektrikum 4' wird somit epitaktisch durch die weitere Epitaxieschicht 2" überwachsen.

Bezug nehmend auf Figur 48C wird ausgehend von einer Vorderseite 101 des nach Abscheiden der zweiten Epitaxieschicht 2" vorhandenen Halbleiterkörpers 100 ein Graben 110 geätzt, der in vertikaler Richtung bis auf Höhe des Tunneldielektrikums 4' reicht und der in lateraler Richtung bis an das Tunneldielektrikum 4' heranreicht. Dieser Graben wird anschließend mit einem zur Realisierung des Akkumulationsdielektrikums 4 geeigneten Material aufgefüllt, was im Ergebnis in Figur 48D dargestellt ist. Das Akkumulationsdielektrikum kann beispielsweise ein thermisches Halbleiteroxid - z.B. Siliziumoxid bei einem aus Silizium bestehenden Halbleiterkörper 100 - das durch ein Aufheizen des Halbleiterkörpers 100 hergestellt werden kann.

Ein in lateraler Richtung durch zwei Gräben 110, von denen in Figur 48C nur einer dargestellt ist, und in vertikaler Richtung durch das Tunneldielektrikum 4' begrenzter Abschnitt der zweiten Epitaxieschicht 2" bildet bei dieser Halbleiterstruktur die spätere Driftsteuerzone 3, während übrige Bereiche dieser zweiten Epitaxieschicht 2" einen Teil der späteren Driftzone 2 bilden. An die anhand der Figuren 48A bis 48D erläuterten Verfahrensschritte zur Herstellung der Halbleiterstruktur mit der Driftzone 2, der Driftsteuerzone 3 und dem Akkumulationsdielektrikum 4 können sich grundsätzlich bekannte weitere Verfahrensschritte zur Realisierung der Transistorstruktur im Bereich der Vorderseite 101 des Halbleiterkörpers, d. h. Verfahrensschritte zur Herstellung der Sourcezone 9, der Bodyzone 8, der Gateelektrode 15 und des Gatedielektrikums 16, anschließen.

Die zuvor erläuterten Epitaxieschichten 2', 2" können unterschiedlich stark dotiert sein, um auf diese Weise die unterschiedlich stark dotierten Driftzonenabschnitte 91, 92 herzustellen. Die Kompensationszonenabschnitte 93, 94 können bereits während des Epitaxieverfahrens hergestellt werden, indem jeweils nach epitaktischem Abscheiden einer Schicht einer bestimmten Dicke lokal p-Dotierstoffatome in die epitaktisch abgeschiedene Schicht eingebracht werden. Diese eingebrachten Dotierstoffatome werden abschließend mittels eines Diffusionsverfahrens in den Halbleiterkörper eindiffundiert und bilden dann die zusammenhängenden Kompensationszonen 93, 94.

Wie anhand der Figuren 17 bis 20 erläutert wurde, kann zwischen der Driftsteuerzone 3 und der Sourcezone 9 ein Kondensator 50 vorgesehen werden, der bei sperrend angesteuertem Bauelement zur Zwischenspeicherung der Ladungsträger dient, die bei leitend angesteuertem Bauelement in der Driftsteuerzone 3 zur Ausbildung eines Akkumulationskanals entlang des Akkumulationsdielektrikums 4 benötigt werden. Eine Möglichkeit zur Realisierung dieses Kondensators 50 wird nachfolgend anhand der Figuren 49A und 49B erläutert.

Figur 49A zeigt dabei einen Ausschnitt des Halbleiterbauelements in Seitenansicht im Querschnitt. Figur 49B zeigt einen Querschnitt durch das Bauelement in zwei in Figur 49A dargestellten Schnittebenen III-III und IV-IV. Die Bauelementstrukturen der Schnittebene III-III sind in Figur 49B in durchgezogenen Linien, die Bauelementstrukturen der Schnittebene IV-IV sind in gestrichelten Linien dargestellt. Die Ziffern in Klammern bezeichnen hierbei die Bezugszeichen der Bauelementstrukturen der Schnittebene IV-IV.

Der Kondensator 50 umfasst bei dem dargestellten Bauelement eine Dielektrikumsschicht 121, die zwischen zwei Metallisierungsschichten 122, 124 angeordnet ist. Eine erste 122 dieser Metallisierungsschichten ist in Bezug auf den Halbleiterkörper 100 unterhalb der Kondensatordielektrikumsschicht 121, d.h. zwischen der Kondensatordielektrikumsschicht 121 und dem Halbleiterkörper 100 angeordnet. Diese erste Metallisierungsschicht 122 ist hierbei an die Driftsteuerzone 3 entweder unmittelbar oder, wie in Figur 49A dargestellt, über wenigstens eine der zuvor erläuterten Anschlusszonen 33, 34, angeschlossen. Die erste Metallisierungsschicht 122 weist hierbei Metallisierungsabschnitte auf, die sich abschnittsweise bis an die Vorderseite 101 des Halbleiterkörpers erstrecken, um dort mittelbar oder unmittelbar die Driftsteuerzone 3 zu kontaktieren. Der sich in Richtung der Vorderseite 101 erstreckende Abschnitt der ersten Metallisierungsschicht 122 bildet hierbei den anhand der Figuren 17 bis 19 erläuterten Anschlusskontakt 19 der Driftsteuerzone 3. Die zweite 124 der Metallisierungsschichten ist oberhalb des Kondensatordielektrikums 121 angeordnet und somit durch das Kondensatordielektrikum 121 von der ersten Metallisierungsschicht 121 dielektrisch isoliert.

Das Kondensatordielektrikum 121 und die erste Metallisierungsschicht 122 weisen Aussparungen 125 auf, durch welche sich die Metallisierungsschicht 124 bis an die Vorderseite 101 des Halbleiterkörpers erstreckt und dort die Sourcezone 9 und über eine hochdotierte Anschlusszone 17 die Bodyzone 8 kontaktiert. Innerhalb dieser Aussparung 125 ist die zweite Metallisierungsschicht 124 mittels einer Isolationsschicht 127, beispielsweise einem Oxid, gegenüber der ersten Metallisierungsschicht 122 isoliert. Die zweite Metallisierungsschicht 124 bildet bei diesem Bauelement gleichzeitig die Sourceelektrode 13 des Bauelements.

Der in den Figuren 49A und 49B dargestellte Transistor ist als Trench-Transistor realisiert, dessen Gateelektrode 15 in einem Graben angeordnet ist, der sich ausgehend von der Vorderseite 101 in den Halbleiterkörper hinein erstreckt. Die Gateelektrode 15 ist bei diesem Bauelement in vertikaler Richtung v oberhalb der Driftsteuerzone 3 angeordnet, wobei die Driftsteuerzone 3, wie dies im linken Teil der Figuren 49A und 49B dargestellt ist, abschnittsweise bis an die Vorderseite 101 reicht und dort an die Anschlusselektrode 19 angeschlossen ist. Zwischen der Gateelektrode 15, die in dem dargestellten Beispiel bis über die Vorderseite 101 des Halbleiterkörpers hinausreicht, und der ersten Metallisierungsschicht 122 ist eine weitere Isolationsschicht 123, beispielsweise eine Oxidschicht angeordnet.

In nicht näher dargestellter Weise kann die Gateelektrode 15 selbstverständlich auch in lateraler Richtung beabstandet zu der Driftsteuerzone 3 angeordnet sein. In diesem Fall kann die Driftsteuerzone 3 auf ihrer ganzen Länge direkt oder indirekt über Anschlusszonen 33, 34 an die Vorderseite 101 des Halbleiterkörpers angrenzen.

Einzelne Verfahrensschritte zur Herstellung des in den Figuren 49A und 49B dargestellten Bauelements werden nachfolgend kurz erläutert:

Nach Herstellung der Transistorstrukturen in dem Halbleiterkörper 100, d. h. nach Herstellung der Sourcezone 9, der Bodyzone 8 und der hochdotierten Anschlusszone 17 sowie nach Herstellung der Driftsteuerzone 3 und der Grabenstruktur zur Realisierung der Gateelektrode 15 wird eine leitfähige Schicht (z.B. dotiertes Polysilizium) auf eine Isolationsschicht oberhalb der Vorderseite 101 des Halbleiterkörpers aufgebracht. Die Isolationsschicht kann hierbei durch dieselbe Isolationsschicht gebildet sein, die innerhalb des Halbleiterkörpers das Gatedielektrikum 16 und das Akkumulationsdielektrikum 4 bildet. Diese leitfähige Schicht, die einen für die Gateelektrode 15 vorgesehenen Graben auffüllt, bildet die Gateelektrode 15 des Bauelements. Auf diese leitfähige Schicht wird anschließend die Isolationsschicht 123 aufgebracht. In dieser Isolationsschicht 123 und der die Gateelektrode 15 bildenden leitfähige Schicht wird anschließend oberhalb der Driftsteuerzone 3 ein Kontaktloch hergestellt, an dessen Seitenwänden die Isolationsschichten 126 erzeugt werden. Anschließend wird die erste Metallisierungsschicht 122 des Kondensators auf die Isolationsschicht 123 und in das Kontaktloch abgeschieden. Nachfolgend wird das Kondensatordielektrikum 121 auf die erste Metallisierungsschicht 122 aufgebracht und oberhalb der Sourcezonen 9 werden Kontaktlöcher hergestellt, die durch das Kondensatordielektrikum 121, die Isolationsschicht 123, die die Gateelektrode 15 bildende leitfähige Schicht und die unmittelbar auf die Vorderseite 101 aufgebrachte Isolationsschicht reichen. An den Seitenwänden dieser Kontaktlöcher werden dann die Isolationsschichten 127 wenigstens auf freiliegenden Bereichen der ersten Metallisierungsschicht 122 hergestellt. Anschließend wird die zweite Metallisierungsschicht 124 oberhalb des Kondensatordielektrikums 121 und in dem zuvor hergestellten Kontaktloch abgeschieden. Die Herstellung des Kondensatordielektrikums 121 kann hierbei sowohl vor als auch nach Herstellen des Kontaktloches oberhalb der Sourcezone 9 erfolgen. Bei Abscheiden des Kondensatordielektrikums 121 nach Herstellen des Kontaktloches ist das Kondensatordielektrikum jedoch wenigstens am Boden des Kontaktloches vor Herstellen der zweiten Metallisierungsschicht 124 wieder zu entfernen.

Weitere Realisierungsmöglichkeiten des Kondensators 50 zwischen der Sourcezone 9 und der Driftsteuerzone 3 werden nachfolgend anhand der Figuren 50 bis 56 erläutert.

Figur 50A zeigt ein Ausführungsbeispiel des erfindungsgemäßen Halbleiterbauelements ausschnittsweise in perspektivischer Darstellung. Figur 12-01B zeigt eine Kondensatorstruktur des Bauelements in Draufsicht auf die Vorderseite 101 des Halbleiterkörpers 100.

Dieses Bauelement ist entsprechend des Bauelements in Figur 17A als Trench-MOSFET realisiert und unterscheidet sich von dem in Figur 17A dargestellten Bauelement dadurch, dass der Speicherkondensator 50 zwischen der Sourcezone 9 und der Driftsteuerzone 3 in dem Halbleiterkörper oberhalb der Driftsteuerzone 3 integriert ist. Der Kondensator 50 weist bei diesem Bauelement eine erste Kondensatorelektrode 128 auf, die in einem Graben oberhalb der Driftsteuerzone 3 in dem Halbleiterkörper 100 angeordnet ist. Dieser Graben ist in dem dargestellten Ausführungsbeispiel in einer lateralen Richtung durch die das Akkumulationsdielektrikum 4 bildende Dielektrikumsschicht 4 begrenzt. Die erste Kondensatorelektrode 128 ist gegenüber der Driftsteuerzone 3 sowie den gegebenenfalls sich an die Driftsteuerzone 3 anschließenden Anschlusszonen 33, 34 durch ein Kondensatordielektrikum 129 dielektrisch isoliert. Insbesondere die hochdotierte Anschlusszone 34 im Bereich der Vorderseite 101 des Halbleiterkörpers bildet bei diesem Bauelement die zweite Kondensatorelektrode. Um eine möglichst große Speicherkapazität dieses Speicherkondensators 50 zu erreichen, ist die Kondensatorelektrode 128 auf der der Akkumulationsdielektrikumsschicht 4 abgewandten Seite fingerförmig ausgebildet.

Die Sourceelektrode kann bei diesem Bauelement direkt an die erste Kondensatorelektrode 128 angeschlossen sein. Außerdem können die Sourceelektrode und die Gateelektrode 15 in der bereits anhand von Figur 17A erläuterten Weise über Dioden an die Driftsteuerzone 3 bzw. deren Anschlusszone 34 angeschlossen sein.

Figur 51 zeigt in Draufsicht eine Variante der bereits erläuterten, in dem Halbleiterkörper 100 integrierten Kondensatorstruktur. Bei dieser Kondensatorstruktur weist die erste Kondensatorelektrode 128 abschnittsweise eine mäanderförmige Struktur auf, wodurch die Grenzfläche, und damit die Fläche des Kondensatordielektrikums 129 zwischen der ersten Kondenstorelektrode 128 und der zweiten Kondensatorelektrode 34 gegenüber der fingerförmigen Struktur gemäß Figur 50 weiter erhöht ist. Die erste Kondensatorelektrode 128 kann beispielsweise aus einem hochdotierten Polysilizium bestehen.

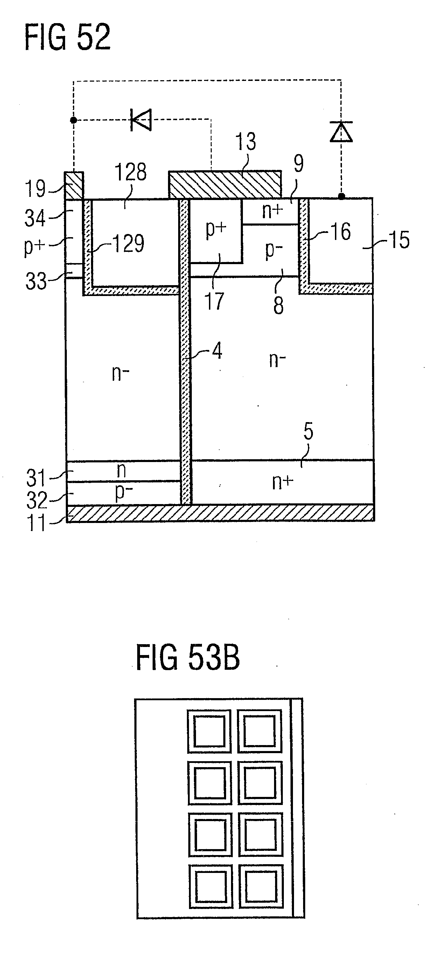

Bezug nehmend auf Figur 52 kann ein unmittelbares Anschließen der Sourcezone 9 an die erste Kondensatorelektrode 128 mittels der Sourceelektrode 13 erfolgen. Die Sourceelektrode 13 erstreckt sich hierbei in lateraler Richtung r des Halbleiterkörpers 100 von der Sourcezone 9 über die hochdotierte Body-Anschlusszone 17 bis an die erste Kondensatorelektrode 128.

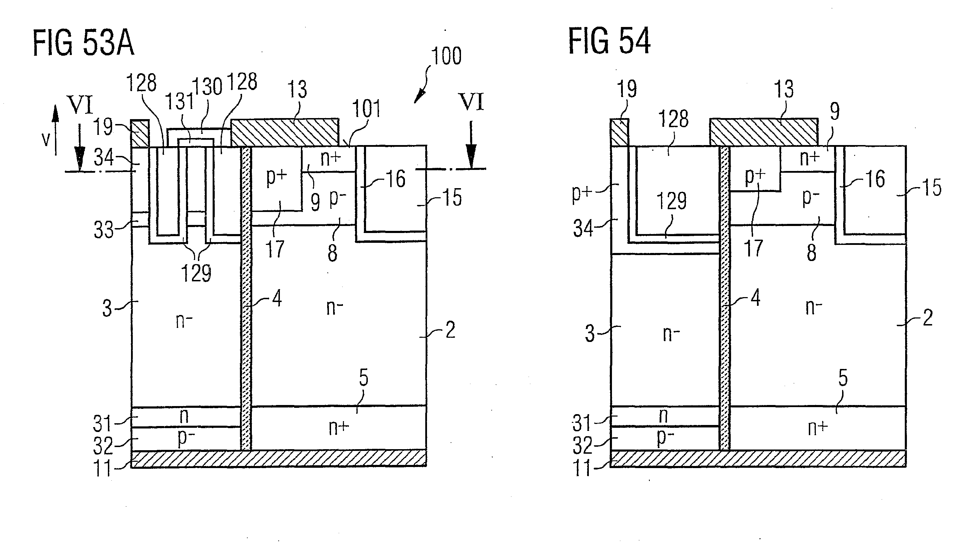

Eine weitere Variante zur Realisierung des Speicherkondensators 50 ist den Figuren 53A und 53B dargestellt. Figur 53A zeigt hierbei einen Ausschnitt eines Ausführungsbeispiels des erfindungsgemäßen Halbleiterbauelements in Seitenansicht im Querschnitt. Figur 53B zeigt einen Querschnitt durch das Halbleiterbauelement im Bereich der Kondensatorstruktur in einer in Figur 53A dargestellten Schnittebene VI-VI. Die Kondensatorstruktur umfasst bei diesem Bauelement eine Anzahl säulenförmiger Elektrodenabschnitte, die sich ausgehend von der Vorderseite 101 in vertikaler Richtung v in den Halbleiterkörper hinein erstrecken und die jeweils durch das Kondensatordielektrikum gegenüber umliegenden Bereichen isoliert sind. Ein Teil dieser säulenförmigen Elektrodenabschnitte, die gemeinsam die erste Kondensatorelektrode 128 bilden, schließt sich in dem Beispiel an die Akkumulationsdielektrikumsschicht 4 an und ist abschnittsweise durch diese Akkumulationsdielektrikumsschicht 4 gegenüber dem Halbleiterkörper 100 isoliert. Die einzelnen Elektrodenabschnitte sind durch eine Verbindungselektrode 130, die oberhalb des Halbleiterkörpers 100 angeordnet und durch eine Isolationsschicht 131 gegenüber Halbleiterbereichen des Halbleiterkörpers 100 isoliert ist, elektrisch leitend miteinander verbunden. Die elektrische Anbindung der Sourcezone 9 an diese Kondensatorstruktur erfolgt entsprechend des anhand von Figur 52 erläuterten Ausführungsbeispiels durch die Sourceelektrode 13, die sich in lateraler Richtung bis über die Kondensatorstruktur erstreckt.

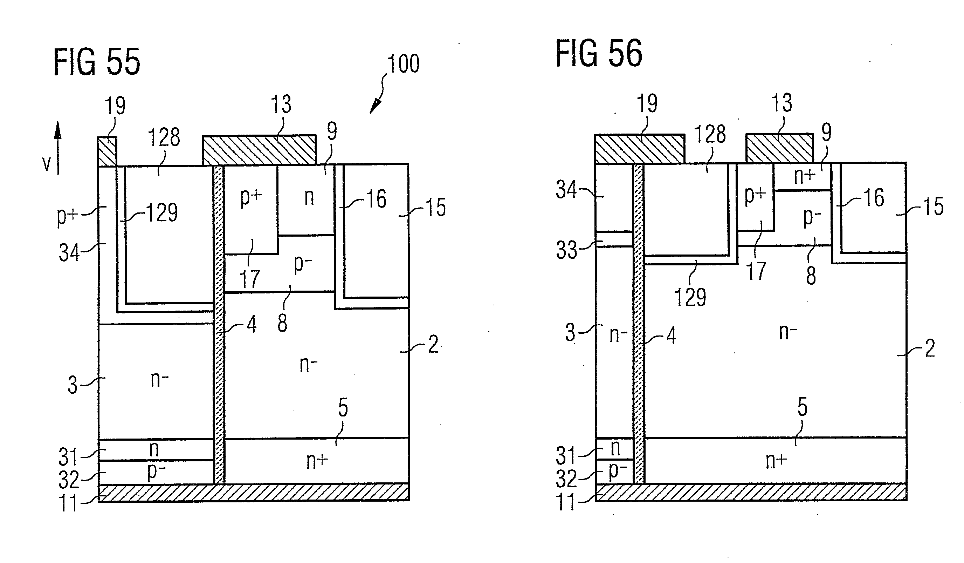

Figur 54 zeigt in Seitenansicht im Querschnitt ein Ausführungsbeispiel eines Halbleiterbauelements, bei dem zur Erhöhung der Kapazität der Kondensatorstruktur die die zweite Kondensatorelektrode bildende dotierte Halbleiterzone 34 tiefer in den Halbleiterkörper hineinreicht als bei den Ausführungsbeispielen gemäß der Figuren 50 bis 53. In dem dargestellten Ausführungsbeispiel reicht die hochdotierte Zone 34 in vertikaler Richtung des Halbleiterkörpers bis unterhalb der Bodyzone 8. Auch die erste Kondensatorelektrode 128 erstreckt sich bei diesem Bauelement in vertikaler Richtung v des Halbleiterkörpers bis unterhalb der Bodyzone 8. Um die Spannungsfestigkeit des Bauelements nicht zu gefährden, sollte die sich an die Driftsteuerzone 3 anschließende höher dotierte Anschlusszone 34, die die zweite Kondensatorelektrode bildet, die auf der anderen Seite des Akkumulationsdielektrikums 4 liegende Driftzone 2 jedoch nicht zu weit überlappen. Um die Kapazität der Kondensatorstruktur weiter zu erhöhen, ist daher bei dem Ausführungsbeispiel gemäß Figur 55 vorgesehen, die Anschlusszone 34, die Bodyzone 8 und entsprechend die Gateelektrode 15 so zu realisieren, dass diese ausgehend von der Vorderseite 101 tiefer in den Halbleiterkörper hineinreichen. Die Geometrien der in den Figuren 54 und 55 dargestellten Kondensatorstrukturen können der anhand der Figuren 50B und 51 erläuterten Kondensatorstrukturen entsprechen. Alternativ kann auch eine anhand von Figur 53B erläuterte Kondensatorstruktur realisiert werden.

Figur 56 zeigt ein Ausführungsbeispiel des erfindungsgemäßen Leistungshalbleiterbauelements, bei dem eine integrierte Kondensatorstruktur vorhanden ist, die anders als bei den anhand der Figuren 50 bis 55 erläuterten Ausführungsbeispielen oberhalb der Driftzone 2 in dem Halbleiterkörper realisiert ist. Geometrisch geht diese in Figur 56 dargestellte Kondensatorstruktur aus den anhand der Figuren 50 bis 55 erläuterten Kondensatorstrukturen durch Spiegelung an der Akkumulationsdielektrikumsschicht 4 hervor. Die erste Kondensatorelektrode 128 kann entsprechend fingerförmig, mäanderförmig oder säulenförmig mit mehreren Säulen realisiert sein.

Die zweite Kondensatorelektrode wird bei diesem Ausführungsbeispiel durch die hochdotierte Anschlusszone 17 gebildet, die dazu dient, die Sourceelektrode 13 niederohmig an die Bodyzone 8 anzuschließen. Diese Anschlusszone 17 schließt sich in lateraler Richtung r unmittelbar an das Kondensatordielektrikum 129 an. Auf der der Anschlusszone 17 gegenüberliegenden Seite ist die Kondensatorstruktur durch das Akkumulationsdielektrikum 4 begrenzt. Der Anschluss des Kondensators an die Driftsteuerzone 3 erfolgt durch die Anschlusselektrode 19 der Driftsteuerzone, die in lateraler Richtung über das Akkumulationsdielektrikum 4 bis über die erste Anschlusselektrode 128 der Kondensatorstruktur reicht.

Wie bereits erläutert, insbesondere anhand der Figuren 16, 17A, 18 und 19 kann zwischen der Drainzone 5 bzw. zwischen der Drainelektrode 11 und der Driftsteuerzone 3 des erfindungsgemäßen Halbleiterbauelements eine Diode vorgesehen werden, die verhindert, dass die in der Driftsteuerzone 3 bei leitendem Bauelement vorhandenen Ladungsträger, die dazu dienen, entlang des Akkumulationsdielektrikums 4 einen Akkumulationskanal in der Driftzone zu steuern, in Richtung der Drainzone 5 bzw. der Drainelektrode 11 abfließen. Bezug nehmend auf die Figuren 16, 17A und 19 kann diese Diode in dem Halbleiterkörper dadurch realisiert werden, dass zwischen der Driftsteuerzone 3 und der Drainzone 5 oder der Driftsteuerzone 3 und der Drainelektrode 11 zwei komplementär zueinander dotierte Anschlusszonen 31, 32 vorgesehen werden, die einen pn-Übergang bilden und damit eine Diodenfunktion bereitstellen. Die Realisierung der gewünschten Diodenfunktion auf diese Weise ist jedoch aufwendig, da innerhalb des Zellenfeldes, d. h. innerhalb des Bereiches des Halbleiterkörpers 100 in dem mehrere gleichartige der erläuterten Transistorstrukturen angeordnet sind, eine geeignete Strukturierung zur Realisierung der komplementär dotierten Halbleiterzonen 31, 32 erforderlich ist. Bei Vorsehen einer externen Diode ist diese Diode bei den bisher erläuterten Ausführungsbeispielen unmittelbar unterhalb des Zellenfeldes an die Driftsteuerzone angeschlossen.

Figur 57 zeigt ein Ausführungsbeispiel eines erfindungsgemäßen Leistungshalbleiterbauelements, bei dem die Diode zwischen der Drainzone 5 und der Driftsteuerzone 3, die nachfolgend als Drain-Driftsteuerzonen-Diode bezeichnet wird, in einer lateralen Richtung beabstandet zu dem Zellenfeld an den Halbleiterkörper 100 angeschlossen ist. Das Zellenfeld mit der MOSFET-Struktur und der benachbart zu der Driftzone der MOSFET-Struktur Driftsteuerzone 3 ist in Figur 57 lediglich links im Bild schematisch durch die Sourcezone 9, die Sourceelektrode 13 und einen Abschnitt der die Sourcezonen 9 in lateralen Richtung umschließenden Bodyzone 8 dargestellt. Die Sourcezone 9 ist durch die Sourceelektrode 13, eine Anschlusszone 34 der Driftsteuerzone 3 durch die Driftsteuerzonenanschlusselektrode 19 kontaktiert. Die MOSFET-Struktur mit der Driftsteuerzone 3 kann in einer in Figur 57 dargestellten Schnittebene VII-VII eine beliebige der zuvor erläuterten Transistorstrukturen besitzen. Der MOS-Transistor kann insbesondere als planarer Transistor oder als Trench-Transistor realisiert sein. Auf die Darstellung einer Gateelektrode des MOS-Transistors ist in Figur 57 aus Gründen der Übersichtlichkeit verzichtet.

Zwischen der Driftsteuerzone 3 und der Drainzone 5, die in dem Beispiel als Halbleitersubstrat realisiert ist, ist in dem Beispiel eine Isolationsschicht 134 angeordnet. Der Anschluss der Diode 43 erfolgt an der Vorderseite 101 des Halbleiterkörpers, wobei die Kathode der Diode 43 über einen Driftsteuerzonen-Anschlusskontakt 132 an die Driftsteuerzone 3 und eine Anode der Diode 43 an die Drainelektrode 11 angeschlossen ist. Optional ist bei diesem Bauelement zwischen der Driftsteuerzone 3 und der Isolationsschicht 134 eine höher als die Driftsteuerzone 3 dotierte Halbleiterzone 131 des gleichen Leitungstyps vorhanden. Diese Zone 131 soll sicherstellen, dass ein im Sperrfall in der Driftsteuerzone 3 generierter Sperrstrom zu der Diode 43 gelangt. Dieses Verhalten kann noch dadurch verbessert werden, dass die höher dotierte Zone 131 so realisiert wird, dass sie im Randbereich des Bauelements bis an die Diode 43 bzw. die Anschlusszone 132 reicht (nicht dargestellt).

Figur 58 zeigt eine Abwandlung des in Figur 57 dargestellten Halbleiterbauelements. Bei diesem Bauelement ist die Diode in dem Halbleiterkörper integriert und umfasst eine p-dotierte Anschlusszone 133 unterhalb des Driftsteuerzonen-Anschlusskontakts 132. Diese p-Zone 133 bildet mit der Driftsteuerzone 3 einen pn-Übergang, der die Diode 43 bildet.

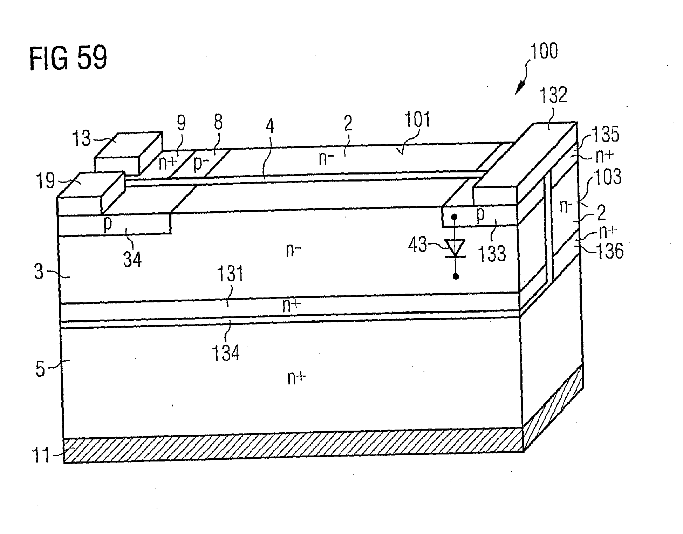

Figur 59 zeigt eine Abwandlung des Bauelements gemäß Figur 58. Bei diesem Bauelement erfolgt ein Anschluss der Diode 43 an das Drain-Potential über die Vorderseite 101 des Halbleiterkörpers. In der Driftzone 2 ist hierbei in lateraler Richtung beabstandet zu dem Zellenfeld eine Anschlusszone 135 vom gleichen Leitungstyp wie die Driftzone 2 vorgesehen, an welche die Driftsteuerzonen-Anschlusselektrode 132 5960angeschlossen ist.

Optional ist bei diesem Bauelement unterhalb der Driftzone 2 und auf Höhe der sich an die Driftsteuerzone 3 anschließenden Zone 131 eine höher als die Driftzone 2 dotierte Halbleiterzone 136 des gleichen Leitungstyps wie die Driftzone 2 vorhanden. Diese Halbleiterzone 136 begrenzt im Sperrfall eine sich ausbreitende Raumladungszone in vertikaler Richtung auf die gleiche Tiefe wie die Zone 131 unterhalb der Driftsteuerzone 3. Das vermeidet Feldstärkespitzen.

Die Driftsteuerzonen-Anschlusselektrode 132 sowie die hochdotierte Zone 135 sind bei dem Bauelement gemäß Figur 59 im Randbereich des Halbleiterkörpers 100 angeordnet. Man macht sich hierbei zu Nutze, dass im Randbereich des Halbleiterkörpers auch die Vorderseite 101 des Halbleiterkörpers auf Drain-Potential liegt, so dass dieses Drain-Potential über die hochdotierte Anschlusszone 135 der Driftsteuerzone 2 abgegriffen werden kann.

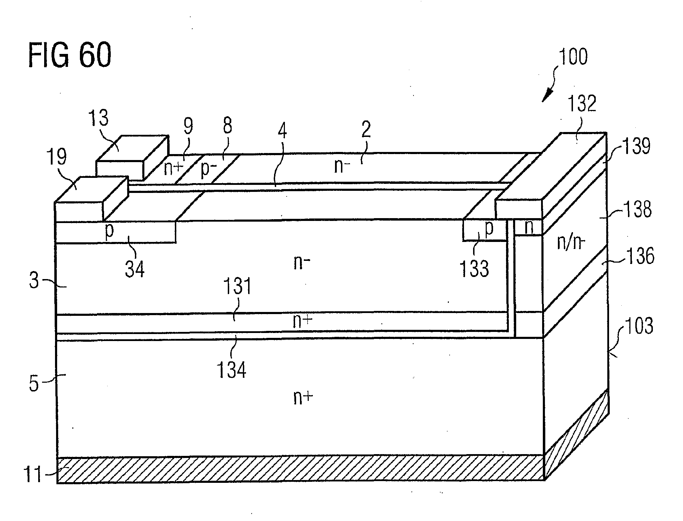

Bei dem Bauelement gemäß Figur 59 reicht der pn-Übergang zur Realisierung der Diode 43 unmittelbar an den Rand 103 des Halbleiterkörpers. Bei der in Figur 60 dargestellten Abwandlung dieses Bauelements ist zwischen dem Rand 103 des Halbleiterkörpers 100 und diesem pn-Übergang eine n-dotierte Halbleiterzone 138, 139 vorhanden, die ebenfalls durch die Driftsteuerzonen-Anschlusselektrode 132 kontaktiert ist. Durch Vorsehen dieser n-Zone, durch die der pn-Übergang nicht bis an den Rand 103 des Halbleiterkörpers reicht, werden Leckströme im Bereich des pn-Übergangs reduziert. Zwischen der Driftsteuerzone 3 und der Halbleiterzone 133, die mit der Driftsteuerzone 3 den pn-Übergang bildet, und der n-Zone 138, 139 ist eine Dielektrikumsschicht vorhanden. Die n-Zone 138, 139 kann zwei unterschiedlich dotierte Halbleiterzonen, eine höher dotierte Zone im Anschluss an die Driftsteuerzonen-Anschlusselektrode 132 und eine darunter liegende niedriger dotierte Halbleiterzone 138 umfassen.

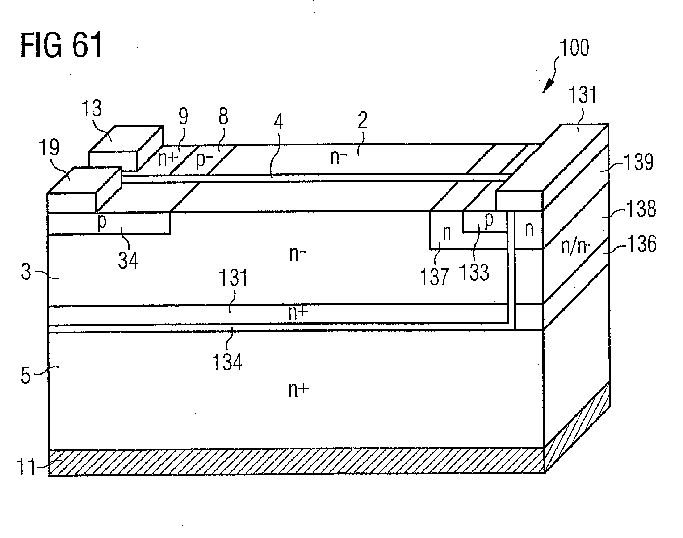

Die Sperrfähigkeit der Diode und die Langzeitstabilität des Bauelements kann Bezug nehmend auf Figur 61 dadurch verbessert werden, dass zwischen der p-Zone 133 und der Driftsteuerzone 3 eine höher dotierte Zone 137 des gleichen Leitungstyps wie die Driftsteuerzone 3 angeordnet ist, die die Ausbildung eines parasitären p-Kanals durch Ladungen an der Halbleiteroberfläche verhindert.

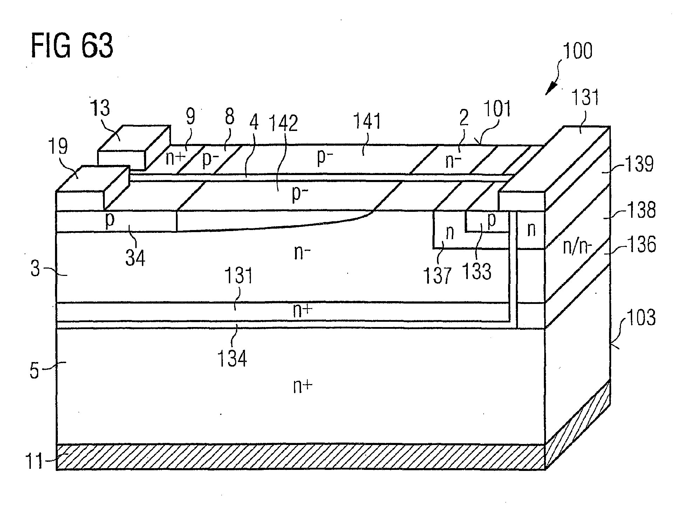

Wie bereits erläutert, liegt im Randbereich 103 des Halbleiterkörpers 100 auch die Vorderseite 101 auf Drain-Potential. Die in lateraler Richtung beabstandet zu dem Randbereich 103 angeordneten Source- und Bodyzonen 9, 8 sowie die Anschlusszone 34 der Driftsteuerzone 3 können während des Betriebs des Bauelements jedoch auf Source-Potential liegen. Um die Spannungsdifferenz zwischen Drain-Potential und Source-Potential aufnehmen zu können, können Bezug nehmend auf Figur 63 im Bereich der Vorderseite 101 des Halbleiterkörpers zwischen dem Zellenfeld und dem Rand 103 des Halbleiterkörpers sogenannte VLD-Zonen (VLD = Variation of Lateral Doping) 141, 142 vorgesehen werden. Diese VLD-Zonen sind dotierte Halbleiterzonen, die komplementär zu der Driftzone 2 und der Driftsteu-erzone 3 dotiert sind und deren Dotierungskonzentration ausgehend von dem Zellenfeld in Richtung des Randes 103 abnimmt.

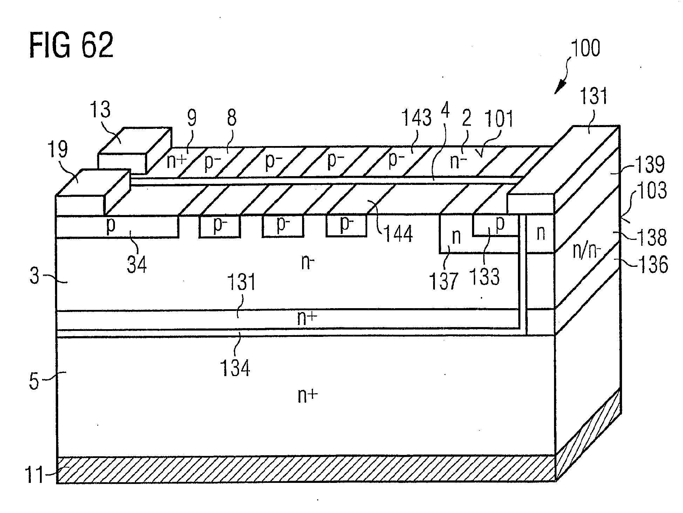

Bei einer p-dotierten Driftzone und einer p-dotierten Driftsteuerzone (in den Figuren 62 und 63 nicht dargestellt), übernimmt die p-Dotierung der p-Driftzone 2 und der p-Driftsteuerzone 3 die VLD-Zonen-Funktion, so dass diese Zonen nicht erforderlich sind. Am Rand des Bauelements 103 sollte dann allerdings eine in vertikaler Richtung durchgehende n-dotierte Halbleiterzone vorhanden sein.

Eine weitere Variante zum Abbau der Spannungsdifferenz zwischen dem Rand 103 und dem Zellenfeld besteht im Vorsehen sogenannter Feldringstrukturen 143, 144. Diese Feldringstrukturen umgeben das Zellenfeld des Leistungshalbleiterbauelements ringförmig. Bei dem Bauelement gemäß Figur 62 sind drei solcher Feldringe vorgesehen, die in lateraler Richtung des Halbleiterkörpers 100 beabstandet zueinander angeordnet sind und die jeweils komplementär zu der Driftzone 2 und der Driftsteuerzone 3 dotiert sind.

Figur 64 zeigt einen Querschnitt durch einen Abschnitt eines erfindungsgemäßen, als MOSFET ausgebildeten, Bauelements mit mehreren MOSFET-Zellen 61, 62, 63. Jede der MOSFET-Zellen 61, 62, 63 weist eine Sourcezone 9, eine Bodyzone 8, eine Driftzone 2, eine Bypass-Zone 17, eine Gateelektrode 15, eine Gate-Isolierung 16 und eine Sourceelektrode 13 auf. Die Drainzone 5 und die Drainelektrode 11 sind dabei allen MOSFET-Zellen 61, 62, 63 gemeinsam.

Zwischen jeweils zwei benachbarten MOSFET-Zellen 61, 62, 63 ist jeweils eine Driftsteuerzone 3 angeordnet, die Drain-seitig über eine aus der ersten und zweiten Verbindungszone 31, 32 gebildete Diode 31, 32 an die Drainzone 5 angeschlossen ist. Die das Akkumulationsdielektrikum bildende Dielektrikumsschicht sollte dabei mindestens bis zur dritten Verbindungszone 32 reichen, wie dies im linken Teil von Figur 64 dargestellt ist, oder kann in die dritte Verbin-dungszone 32 reichen, wie dies im rechten Teil von Figur 64 dargestellt ist. Darüber hinaus kann das Dielektrikum auch so hergestellt werden, dass es in vertikaler Richtung erst in der Drainzone 5 endet (nicht dargestellt).

Source-seitig ist jede der Driftsteuerzonen 3 über eine stark p-dotierte vierte Verbindungszone 34 an eine vierte Elektrode 19 angeschlossen. Die Speicherkapazität ist hierbei überwiegend durch eine externe Kapazität 50 gebildet. Optional kann auch hier zwischen der vierten Verbindungszone 34 und der Driftsteuerzone 3 noch die dritte Verbin-dungszone 33 ausgebildet sein.

Zur Parallelschaltung der einzelnen MOSFET-Zellen 61, 62, 63 sind die Sourceelektroden 13, die Gateelektroden 15 sowie die vierten Elektroden 19 der einzelnen Zelle jeweils untereinander verbunden. Die elektrische Verbindung erfolgt vorzugsweise durch wenigstens eine, in Figur 64 nicht dargestellte strukturierte Metallisierungsschicht, die oberhalb der Vorderseite bzw. Source-Seite des Halbleiterkörpers 1 angeordnet ist.

Zwischen benachbarten Drift- und Driftsteuerzonen 2, 3 ist zumindest abschnittweise ein Dielektrikum 4 an-geordnet. Bevorzugt ist das Dielektrikum 4 zwischen jeweils benachbarten Drift- und Driftsteuerzonen 2, 3 vollflächig geschlossen ausgebildet. Das Dielektrikum 4 erstreckt sich Drain-seitig vorzugsweise wenigstens bis zur Drainzone 5. Es kann sich jedoch auch bis zur Drain-seitigen Oberfläche des Halbleiterkörpers 1 erstrecken.

Die Driftzonen 2 und die Driftsteuerzonen 3 können in dem Bereich, in dem sie sich in der vertikalen Richtung v gemeinsam erstrecken, dasselbe Dotierungsprofil aufweisen, wodurch im Sperrfall eine ähnliche Potentialverteilung in der Driftsteuerzone und der Driftzone erreicht wird, so dass die Spannungsbelastung des Dielektrikums 4 gering ist.

Die Drain-seitigen sperrenden pn-Übergänge 31, 32 zum Anschluss der Driftsteuerzonen 3 an die Drainzone 5 sind bei dem Ausführungsbeispiel gemäß Figur 64 in der vertikalen Richtung v innerhalb der Drainzone 5 angeordnet.

Alternativ ist bei dem in Figur 65 dargestellten MOSFET die erste Verbindungszone 31 in der vertikalen Richtung v im Bereich der Driftzonen 2 und die zweite Verbindungszone 32 in der vertikalen Richtung v im Bereich der Drainzone 5 angeordnet.

Die einzelnen Zellen können eine Vielzahl unterschiedlicher Geometrien besitzen. In den Figuren 66, 67, 68, 69 sind Horizontalschnitte durch Bauelemente mit unterschiedlicher Zellengeometrie gezeigt.

Figur 66 zeigt einen zur vertikalen Richtung v senkrecht verlaufenden Querschnitt in einer Ebene E-E' durch einen MOSFET gemäß Figur 65 dessen Transistorzellen als Streifenzellen realisiert sind. Die einzelnen Bereiche der MOSFET-Zellen 61, 62 sind dabei in einer ersten lateralen Richtung r im Querschnitt streifenartig ausgebildet und in einer zweiten lateralen Richtung r' beabstandet voneinander angeordnet, wobei zwischen zwei benachbarten MOSFET-Zellen 61, 62 jeweils eine Driftsteuerzone 3 mit den zugehörigen Akkumulationsdielektrika 4 angeordnet ist.

Figur 67 zeigt einen Querschnitt durch einen MOSFET mit einer rechteckigen Zellenstruktur. Zwischen benachbarten MOSFET-Zellen 61, 62, 63 angeordnete Driftsteuerzonen 3 sind dabei zusammenhängend ausgebildet. Alternativ dazu können die einzelnen, zwischen zwei benachbarten MOSFET-Zellen angeordneten Driftsteuerzonen 3 jedoch auch nicht-zusammenhängend ausgebildet sein.

Figur 68 zeigt einen Querschnitt durch einen MOSFET, dessen MOSFET-Zellen im Querschnitt nicht wie bei Figur 67 rechteckig, sondern rund ausgebildet sind.

Eine Abwandlung des streifenförmigen Layouts gemäß Figur 66 ist in Figur 69 dargestellt. Bei dieser im Querschnitt mäanderartigen Zellstruktur sind die einzelnen Bereiche der MOSFET-Zellen länglich ausgebildet, weisen jedoch in bestimmten Abständen mäanderartige Ausbuchtungen auf.

Das erfindungsgemäße Halbleiterbauelement wurde bislang anhand von Ausführungsbeispielen erläutert, die selbstsperrende MOS-Transistoren betreffen. Diese Transistoren sperren, wenn kein zur Ausbildung eines Inversionskanals in der Bodyzone 8 ausreichendes Ansteuerpotential an der Gateelektrode 15 anliegt. Diese selbstsperrenden Transistoren leiten erst dann, wenn an der Gateelektrode 15 ein geeignetes Ansteuerpotential anliegt, durch welches sich ein Inversionskanal in der Bodyzone 8 entlang des Gatedielektrikums 16 ausbildet. Das Vorsehen einer Driftsteuerzone 3 benachbart zu einer Driftzone und eines Akkumulationsdielektrikums zwischen der Driftzone und der Driftsteuerzone ist jedoch nicht auf selbstsperrende MOS-Transistoren beschränkt.

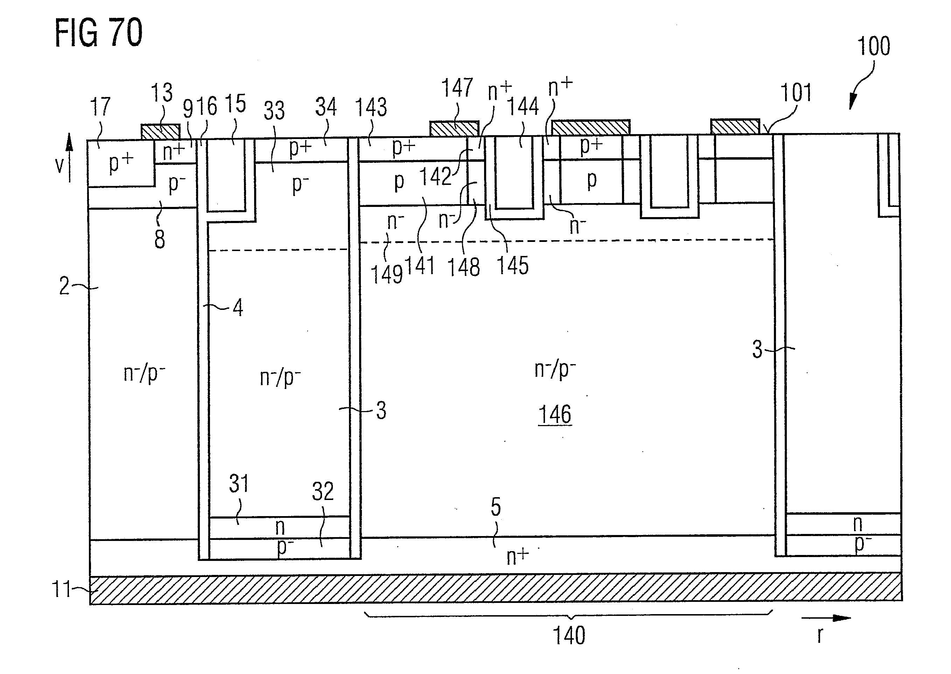

Bezug nehmend auf Figur 70 ist dieses Konzept auch auf selbstleitende Transistoren (Depletion-Transistoren, Normally-On-Transistoren) anwendbar. Mit dem Bezugszeichen 140 ist in Figur 70 ein Halbleiterbereich innerhalb des Halbleiterkörpers 100 bezeichnet, in dem Transistorzellen eines solchen selbstleitenden Transistors integriert sind. Diese Transistorzellen sind als Trench-Transistorzellen realisiert und besitzen jeweils eine Gateelektrode 144, die sich ausgehend von der Vorderseite 101 in vertikaler Richtung v in den Halbleiterkörper hinein erstreckt und die mittels eines Gatedielektrikums 145 gegenüber dem Halbleiterkörper isoliert ist. Der in Figur 70 dargestellte Depletion-Transistor ist als n-leitender Transistor realisiert und besitzt eine n-dotierte Sourcezone 142, eine p-dotierte Bodyzone 141 und eine Driftzone 146. Die Bodyzone 141 ist hierbei zwischen der Sourcezone 142 und der Driftzone 146 angeordnet, wobei in der Bodyzone 141 entlang des Gatedielektrikums 145 eine dünne Kanalzone 148 des gleichen Leitungstyps wie die Sourcezone 142, jedoch mit schwächerer Dotierung, realisiert ist. Diese Kanalzone 148 entlang des Gatedielektrikums 145 ermöglicht eine leitende Verbindung zwischen der Sourcezone 142 und der Driftzone 146 selbst bei nicht angesteuerter Gateelektrode 144. Zur sperrenden Ansteuerung dieses Bauelements ist an die Gateelektrode 144 ein geeignetes Ansteuerpotential anzulegen, durch welches die Kanalzone 148 an Ladungsträgern verarmt. Dieses Potential ist bei einem n-leitenden Transistor ein gegenüber dem Potential der Sourcezone 142 negatives Potential.

In lateraler Richtung r des Halbleiterkörpers 100 benachbart zu der Driftzone 146 ist eine Driftsteuerzone 3 vorgesehen, die durch ein Akkumulationsdielektrikum 4 gegenüber der Driftzone 146 dielektrisch isoliert ist. Die Driftsteuerzone 3 ist entsprechend der bisherigen Ausführungen realisiert und kann unter Verwendung einer der zuvor erläuterten Anschlussmöglichkeiten an die Drainzone 5 angeschlossen sein. Die Driftsteuerzone 3 kann in nicht näher dargestellter Weise darüber hinaus an die Sourceelektrode 147 des Depletion-Transistors angeschlossen sein.

In demselben Halbleiterkörper 100 wie der Depletion-Transistor sind bei dem in Figur 70 dargestellten Bauelement auch Transistorzellen eines selbstsperrenden Transistors realisiert. Die Transistorstruktur dieses selbstsperrenden Transistors kann einer der bereits erläuterten Transistorstrukturen des selbstsperrenden Transistors entsprechen. Der in Figur 70 dargestellte selbstsperrende Transistor ist so realisiert, dass dessen Gateelektrode in demselben Graben wie die Driftsteuerzone 3 oberhalb der Driftsteuerzone 3 angeordnet ist.

Hinsichtlich der Dotierungsarten der Driftzone 2 des selbstsperrenden Transistors, der Driftzone 146 des selbstleitenden Transistors und der Driftsteuerzone 3 sind beliebige Kombinationen denkbar. Die Driftzone 2 des selbstsperrenden Transistors kann unabhängig von der Dotierungsart der Driftsteuerzone 3 und der Dotierungsart der Driftzone 146 des selbstleitenden Transistors p-dotiert oder n-dotiert sein. Entsprechend kann die Driftsteuerzone 3 unabhängig von den Dotierungen der Driftzonen 2 und 146 p-dotiert oder n-dotiert sein. Ebenso kann die Driftzone 146 zur Realisierung eines n-leitenden Depletion-Transistors p- oder n-dotiert sein. Bei einer p-Dotierung der Driftzone 146 ist in dem dargestellten Beispiel zwischen der Driftzone 146 und der Bodyzone 141 eine n-dotierte Halbleiterzone 149 vorzusehen, die einen Ladungsträgerfluss von der Kanalzone 148 in lateraler Richtung r bis an das Akkumulationsdielektrikum 4 ermöglicht. Auf die in Figur 70 dargestellte schwach p-dotierte Anschlusszone 33 der Driftsteuerzone 3 kann verzichtet werden, wenn die Driftsteuerzone 3 p-dotiert ist.

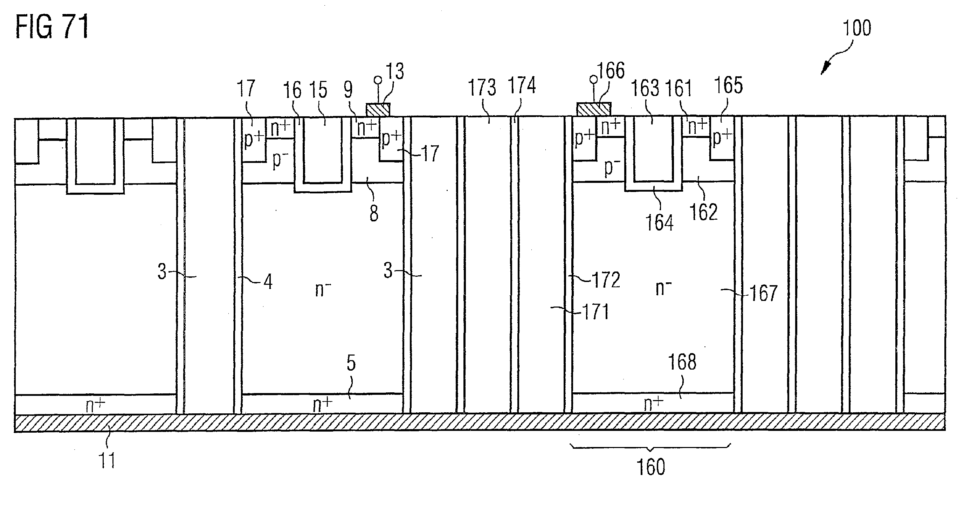

Wie bereits erläutert, kann das erfindungsgemäße Halbleiterbauelement zellenartig mit einer Vielzahl gleichartiger Bauelementstrukturen, beispielsweise Transistorstrukturen, realisiert sein. Bezug nehmend auf Figur 71 kann das Zellenfeld des Bauelements dabei so modifiziert werden, dass einzelne Transistorzellen, in dem Beispiel eine Transistorzelle 160 separat, d. h. unabhängig von den übrigen Transistorzellen kontaktierbar ist. Eine Sourceelektrode 166 dieser Transistorzelle 160 und optional eine Gateelektrode 163 dieser Transistorzelle 160 sind hierbei unabhängig von den Gateelektroden 15 und den Sourceelektroden 13 der übrigen Transistorzellen kontaktierbar. Die Drainelektrode 11 ist in dem Beispiel allen Transistorzellen gemeinsam.

Eine solche separat kontaktierbare Transistorzelle 160 kann in bekannter Weise beispielsweise zur Strommessung durch das Bauelement genutzt werden. Diese Zelle, die nachfolgend als Messzelle bezeichnet wird, wird hierbei während des Betriebs des Bauelements im gleichen Arbeitspunkt wie die übrigen Transistorzellen betrieben, und der Strom durch diese Messzelle wird ermittelt. Selbstverständlich können dabei mehrere solcher Messzellen parallel geschaltet werden können. Der Strom durch die Messzelle bzw. die mehreren parallel geschalteten Messzellen ist dann proportional zu dem die übrigen Transistorzellen, die nachfolgend als Lastzellen bezeichnet werden, durchfließenden Strom. Der Proportionalitätsfaktor zwischen dem Messstrom und dem Laststrom entspricht hierbei dem Verhältnis zwischen der Anzahl der Messzellen und der Lastzellen.

Die dargestellte Messzelle ist als selbstsperrende Transistorzelle realisiert, und weist eine Sourcezone 161, eine Driftzone 167, eine zwischen der Sourcezone 161 und der Driftzone 167 angeordnete, komplementär zu der Sourcezone 161 dotierte Bodyzone 162 auf. Die Gateelektrode 163, die durch eine Gatedielektrikum 164 gegenüber den Halbleiterbereichen des Bauelements isoliert ist, dient zur Steuerung eines Inversionskanals in der Bodyzone 162 zwischen der Sourcezone 161 und der Driftzone 167. Die Messzelle weist außerdem eine Driftsteuerzone 171 auf, die durch ein Akkumulationsdielektrikum 172 von der Driftzone 167 getrennt ist. Diese Driftsteuerzone 171 kann in bereits erläuterter Weise an die Drainzone 5 sowie die Sourcezone 161 und gegebenenfalls an die Gateelektrode 163 angeschlossen sein. Die Verbindung zwischen dieser Driftsteuerzone 171 und den übrigen Bauelementzonen der Transistorstruktur ist in Figur 71 aus Gründen der Übersichtlichkeit jedoch nicht näher dargestellt.

Zur Entkopplung der Messzelle von den Lastzellen kann zwischen der Driftsteuerzone 171 der Messzelle und der Driftsteuerzone 3 der benachbarten Lastzelle eine Zwischenzone 173 vorgesehen sein. 71 Diese Zwischenzone kann insbesondere eine "totgelegte" Transistorzelle sein, d.h. eine Transistorzelle, die keine Sourcezone und keine Sourcemetallisierung, und evtl. auch kein Gate, aufweist. Auf eine solche Zwischenzone kann allerdings dann verzichtet werden, wenn die Messzelle komplett von einer Driftsteuerzone umgeben ist.

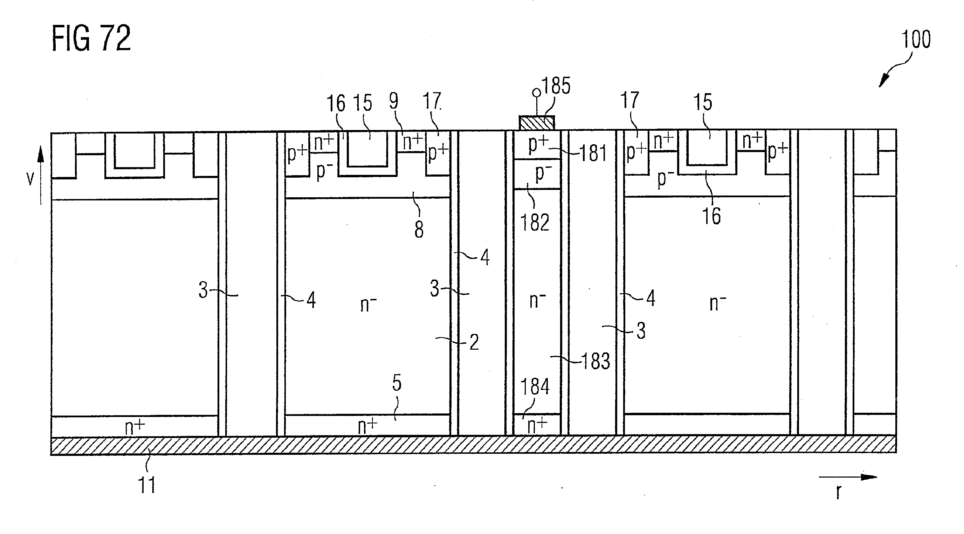

Figur 72 zeigt ein erfindungsgemäßes Leistungshalbleiterbauelement, bei dem zwischen zwei Transistorzellen, in dem Beispiel selbstsperrenden Transistorzellen, ein Temperatursensor integriert ist. Der Temperatursensor ist als Diode mit einem p-Emitter 181, 182, einer n-Basis 183 und einem n-Emitter 184 realisiert. Diese Bauelementzonen sind in vertikaler Richtung v des Halbleiterkörpers 100 benachbart zueinander angeordnet. Der p-Emitter umfasst in dem dargestellten Beispiel eine stark p-dotierte Zone, an die eine Anschlusselektrode 185 angeschlossen ist, sowie optional eine sich an die stark dotierte Zone in Richtung der n-Basis 183 anschließende schwächer p-dotierte Zone 182. Eine Spannungsversorgung des Sensors erfolgt über die rückseitige Drainelektrode 11, an welche der n-Emitter 184 angeschlossen ist. Das Temperatursignal ist als Messstrom an der Anschlusselektrode 185 abgreifbar. Man macht sich hierbei zu Nutze, dass der eine Diode in Sperrrichtung durchfließende Sperrstrom von der Temperatur abhängig ist.

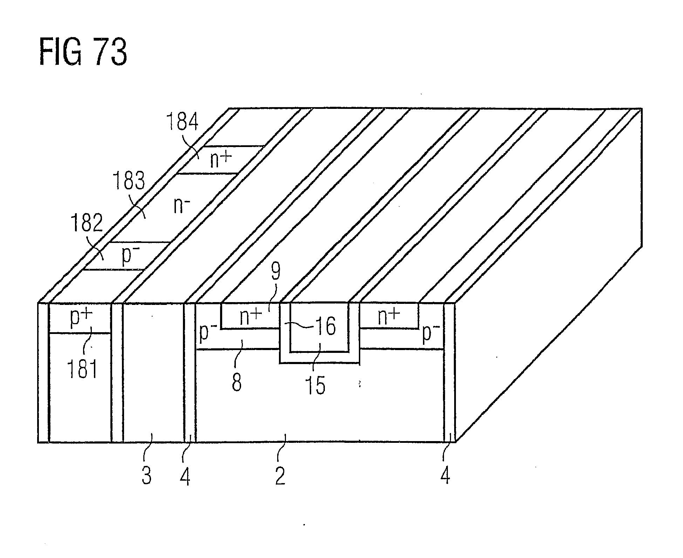

Bezug nehmend auf Figur 73, die ausschnittsweise ein Ausführungsbeispiel eines erfindungsgemäßen Leistungshalbleiterbauelements zeigt, kann der Temperatursensor auch in lateraler Richtung in dem Halbleiterleiter integriert werden. Die Bauelementzonen 181-184 des Temperatursensors sind hierbei in lateraler Richtung r benachbart zueinander angeordnet.

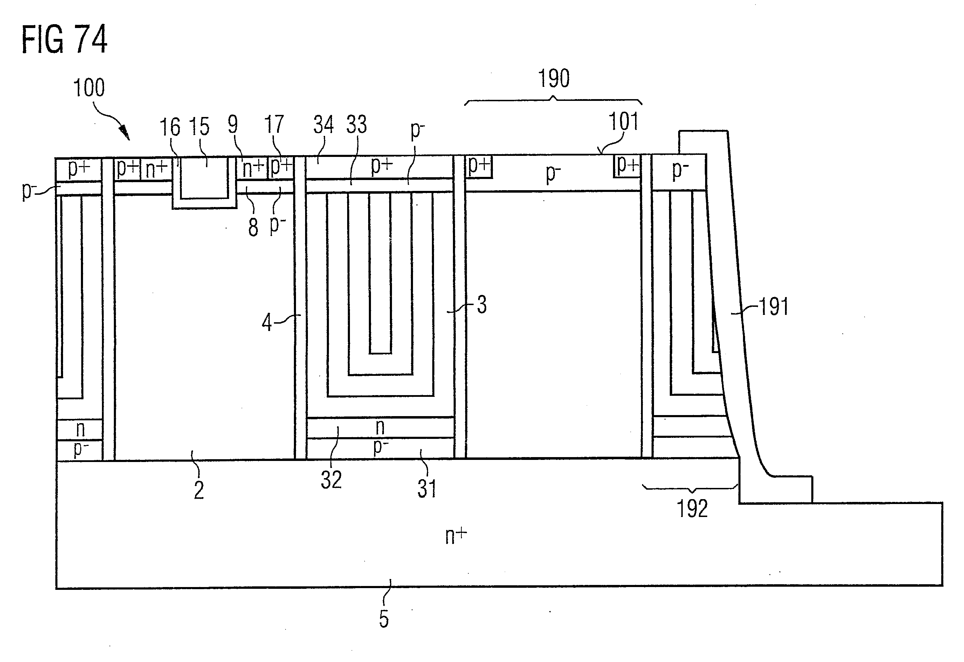

Anhand der Figuren 74 bis 85 werden nachfolgend verschiedene mögliche Randstrukturen für ein erfindungsgemäßes Halbleiterbauelements erläutert. Solche Randstrukturen dienen in grundsätzlich bekannter Weise dazu, eine ausreichende Spannungsfestigkeit des Halbleiterbauelements im Randbereich des Halbleiterchips bzw. im Randbereich des Zellenfeldes zu erreichen.

Figur 74 zeigt ein Beispiel eines erfindungsgemäßen Leistungshalbleiterbauelements mit einer Randstruktur gemäß einer ersten Ausführungsform. Das Bauelement umfasst ein Halbleitersubstrat 5, das die Drainzone des in dem Beispiel als Transistor realisierten Bauelements bildet. Oberhalb dieses Halbleitersubstrats ist eine Halbleiterschicht, beispielsweise eine Epitaxieschicht aufgebracht, in der die aktiven Bauelementstrukturen, d. h. die Transistorstrukturen und die Driftsteuerzonen 3 realisiert sind. Die Randstruktur dieses Bauelements ist dadurch realisiert, dass im Randbereich des Halbleiterkörpers oder des Zellenfeldes ausgehend von der Vorderseite 101 die auf dem Substrat 5 angeordnete Halbleiterschicht bis zum Halbleitersubstrat 5 zurückgeätzt ist. Auf die nach dem Ätzen vorhandene freiliegende Kante ist eine Passivierungsschicht 191 aufgebracht, die von der Vorderseite 101 bis auf das Halbleitersubstrat 5 reicht. Die Ätzung zur Herstellung des Randes erfolgt hierbei im Bereich einer Bauelementstruktur, die innerhalb des Zellenfeldes der Driftsteuerzone 3 entspricht. Diese Bauelementstruktur ist in Figur 74 mit dem Bezugszeichen 192 bezeichnet. Zwischen dieser Halbleiterstruktur 192 und einer ersten aktiven Driftsteuerzone, d. h. einer Driftsteuerzone einer ersten aktiven Transistorzelle ausgehend vom Rand ist eine nicht aktive Transistorstruktur 190, in dem Beispiel eine Transistorstruktur, die keine Gateelektrode und keine Sourcezone aufweist, vorhanden.

Die Driftsteuerzone 3 umfasst bei dem dargestellten Bauelement mehrere Halbleiterschichten, die während des Herstellungsprozesses epitaktisch aufeinanderfolgend in einem durch das Akkumulationsdielektrikum 4 begrenzten Graben abgeschieden werden, bis der Graben aufgefüllt ist. Diese Schichten können p-dotiert sein, können aber auch schwach n-dotiert sein, wobei über die Art der Dotierung der Verlauf des elektrischen Feldes an der Oberfläche gezielt moduliert werden kann.

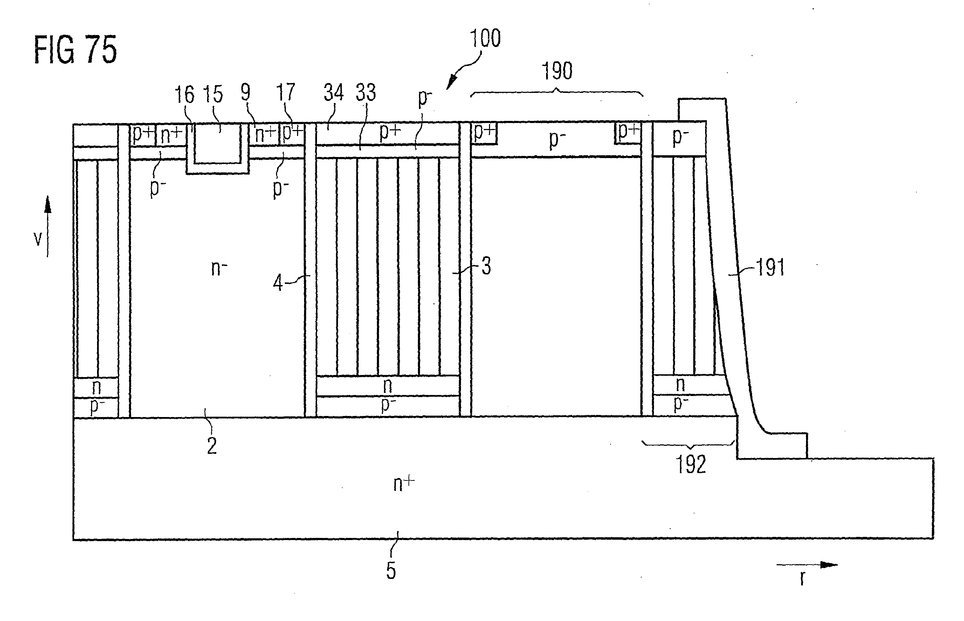

Figur 75 zeigt ein gegenüber dem Bauelement in Figur 74 abgewandeltes Bauelement. Bei diesem Bauelement ist die Driftsteuerzone 3 ebenfalls mehrschichtig realisiert, wobei die einzelnen Schichten in dem Beispiel ausschließlich in lateraler Richtung benachbart zueinander angeordnet sind. Eine solche Struktur wird dadurch erreicht, dass jeweils nach Abscheiden einer Halbleiterschicht in einen durch das Akkumulationsdielektrikum 4 begrenzten Graben die abgeschiedene Schicht am Boden des Grabens anisotrop zurückgeätzt wird.

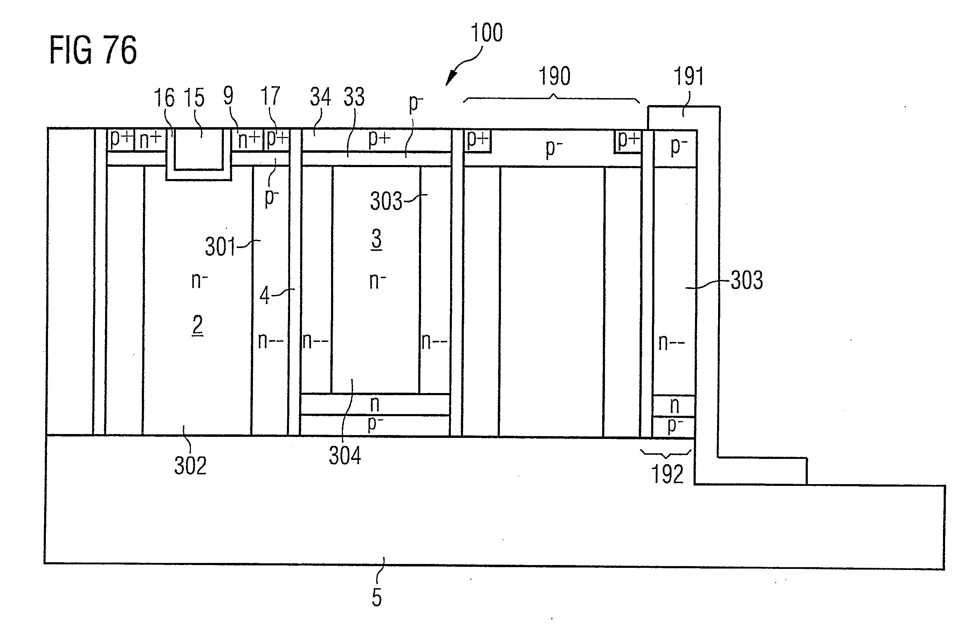

Figur 76 zeigt ein weiteres Ausführungsbeispiel eines erfindungsgemäßen Leistungshalbleiterbauelements mit einer Randstruktur. Bei diesem Bauelement weist die Driftzone 2 in einer lateralen Richtung r des Halbleiterkörpers unterschiedlich dotierte Halbleiterschichten, nämlich eine schwächer dotierte Halbleiterschicht 301 anschließend an das Akkumulationsdielektrikum 4 und eine höher dotierte Halbleiterschicht 302 anschließend an die schwächer dotierte Halbleiterschicht 301 auf. In entsprechender Weise weist auch die Driftsteuerzone 3 eine schwächer dotierte Halbleiterschicht 303 anschließend an das Akkumulationsdielektrikum 4 und eine höher dotierte Halbleiterschicht 304 anschließend an die schwächer dotierte Halbleiterschicht 303 auf. Diese niedriger dotierten Halbleiterschichten 301, 303 im Anschluss an das Akkumulationsdielektrikum 4 verhindern bei sperrend angesteuertem Bauelement einen Spannungsdurchbruch am Akkumulationsdielektrikum 4. Bei dem in Figur 76 dargestellten Halbleiterbauelement ist in lateraler Richtung zwischen der nicht aktiven Transistorzelle 190 und der Passivierungsschicht 191 ein Teil einer solchen Driftsteuerzone mit einer schwach dotierten Halbleiterzone 303 angeordnet.

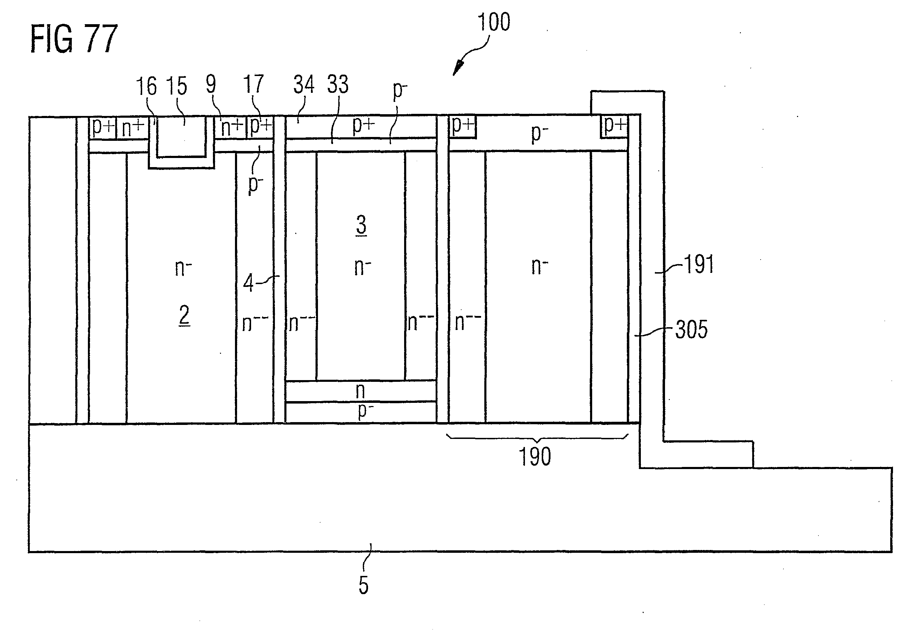

Figur 77 zeigt eine Variante des Bauelements gemäß 76. Bei diesem Bauelement ist die Passivierungsschicht 191 unmittelbar auf die nicht aktive Transistorzelle 190 aufgebracht, wobei zwischen der Passivierung und dieser Transistorzelle eine Dielektrikumsschicht 305 angeordnet sein kann, die im Zellenfeld dem Akkumulationsdielektrikum 4 entspricht.

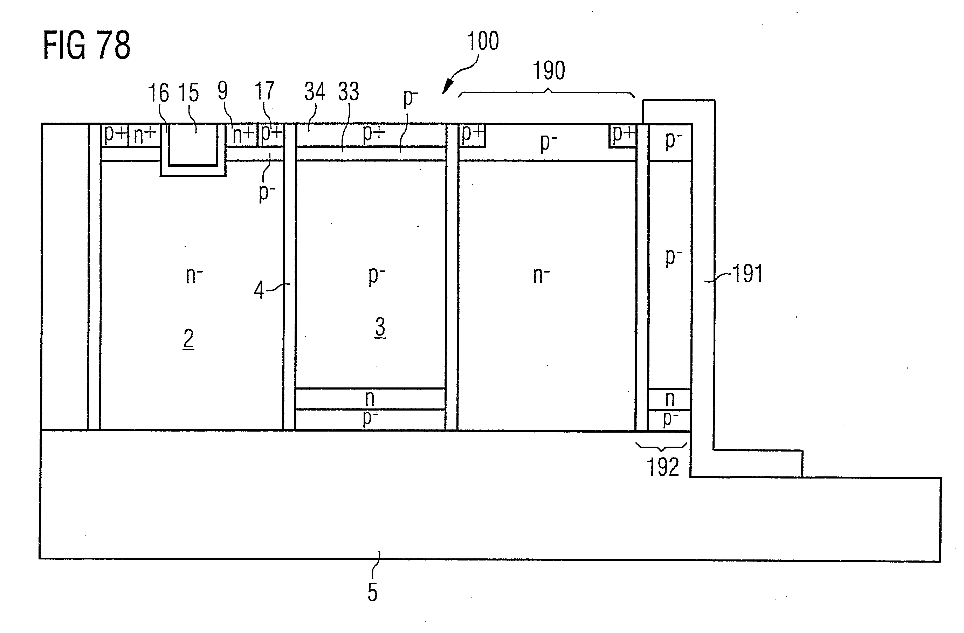

Figur 78 zeigt ein weiteres Ausführungsbeispiel eines erfindungsgemäßen Halbleiterbauelements mit Randstruktur. Bei diesem Bauelement ist die Driftsteuerzone 3 p-dotiert. Entsprechend ist zwischen der nicht aktiven Transistorzelle 190 und der Passivierungsschicht 191 ein p-dotierter Halbleiterabschnitt vorhanden, der durch teilweises Ätzen einer Driftsteuerzonenstruktur im Randbereich entstanden ist.

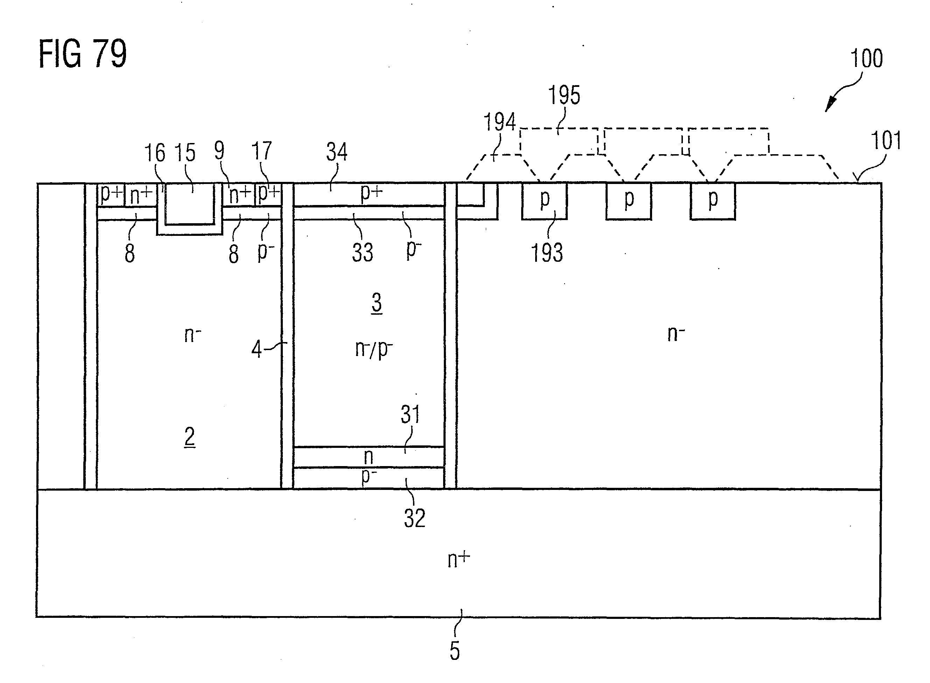

Die zuvor anhand der Figuren 74 bis 78 erläuterten Randstrukturen erfordern ein Zurückätzen der Epitaxieschicht bis auf das Halbleitersubstrat 5. Bezug nehmend auf Figur 79 kann auf ein solches Zurückätzen der Epitaxieschicht verzichtet werden. Bei dem in Figur 79 dargestellten Bauelement ist ein Randabschluss durch Feldringe 193 gebildet, die in lateraler Richtung beabstandet zueinander unterhalb der Vorderseite 101 des Halbleiterkörpers angeordnet sind. Diese Feldringe sind komplementär dotiert zu einer Grunddotierung (im vorliegenden Fall einer n-Dotierung) der Epitaxieschicht. Optional können die Feldringe durch Feldelektroden 195 kontaktiert sein. Diese Feldelektroden bzw. Feldplatten 195 sind durch Isolationsschichten gegenüber grunddotierten Bereichen der Epitaxieschicht isoliert.

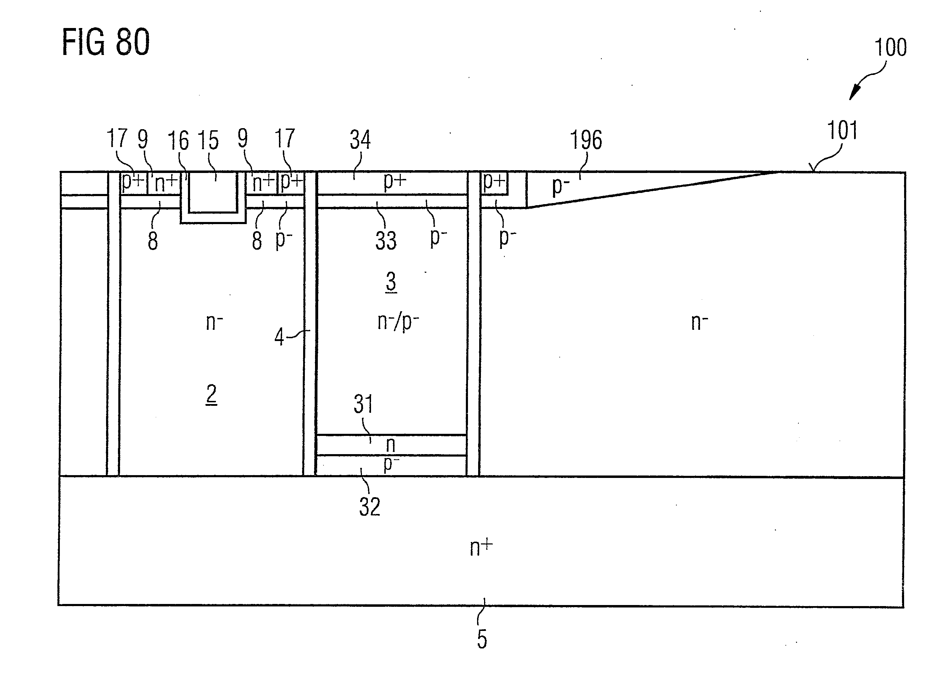

Anstelle von Feldringen kann Bezug nehmend auf Figur 80 auch eine VLD-Zone 196 im Randbereich des Halbleiterkörpers vorgesehen werden.

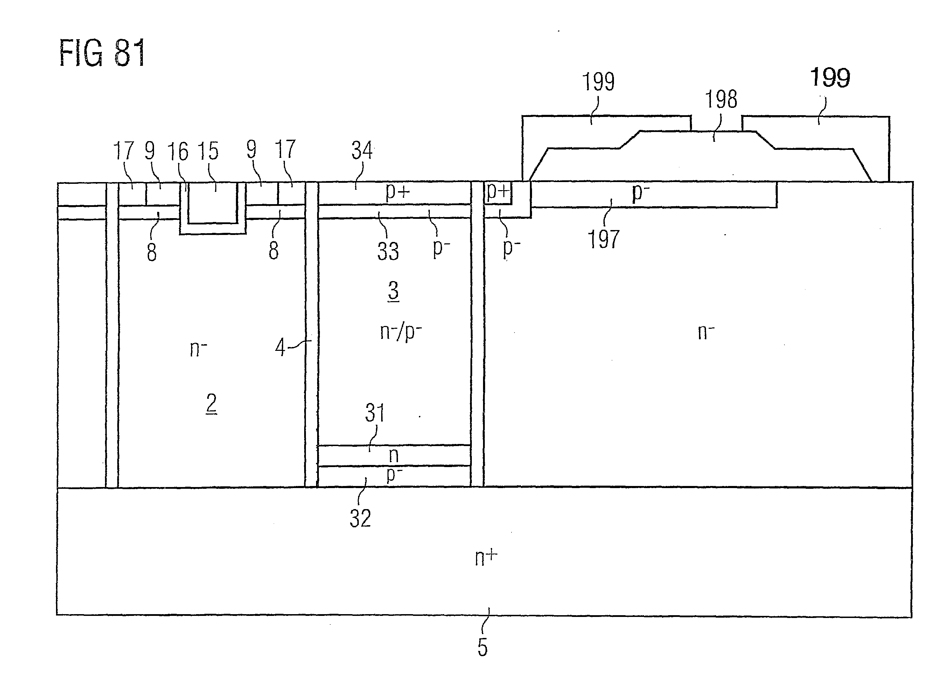

Bezug nehmend auf Figur 81 besteht auch die Möglichkeit, im Randbereich eine gleichmäßig dotierte Halbleiterzone 197, die komplementär zu der Grunddotierung der Epitaxieschicht dotiert ist, vorzusehen. Oberhalb dieser Halbleiterzone 197 sind Feldplatten 199 vorhanden, die zum einen an einen grunddotierten Abschnitt der Epitaxieschicht und zum anderen an die komplementär zu der Grunddotierung dotierte Halbleiterzone 197 angeschlossen sind.

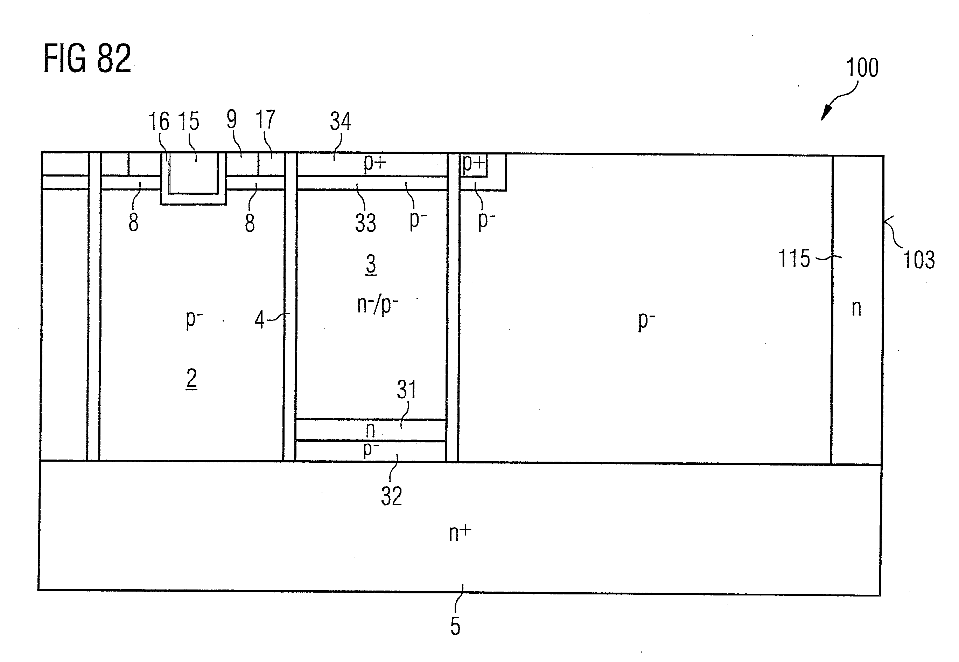

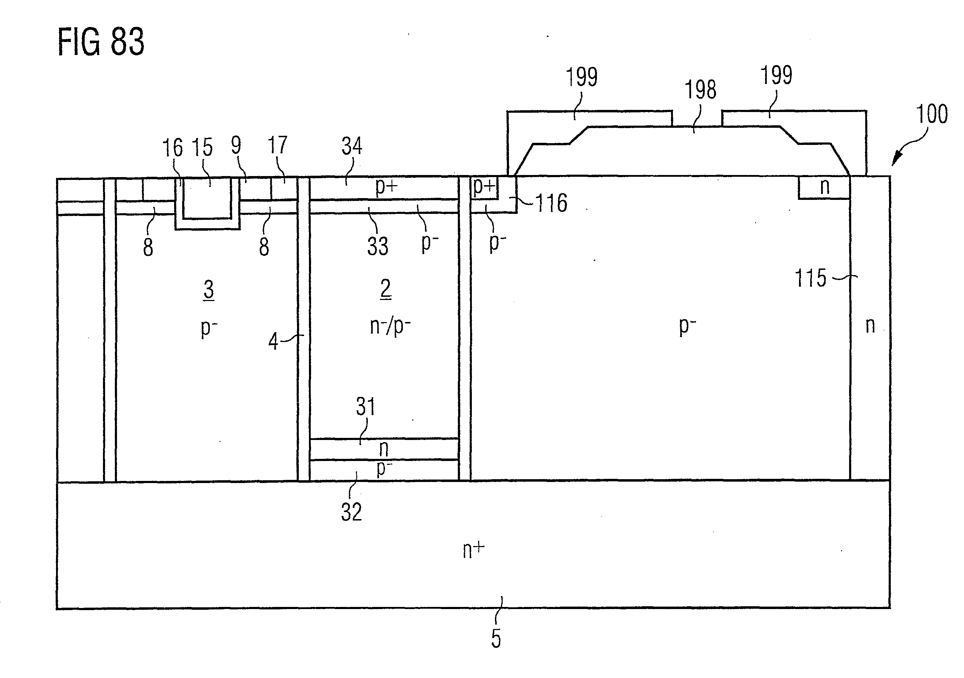

Figur 82 zeigt einen Randabschluss für ein n-leitendes Halbleiterbauelement mit einer p-dotierten Epitaxieschicht und damit einer p-dotierten Driftzone 2. Die Randstruktur umfasst bei diesem Bauelement eine n-dotierte Halbleiterzone 115 am Rand des Halbleiterkörpers 100. Bezug nehmend auf Figur 83 kann diese n-dotierte Halbleiterzone 115 mit einer Feldplattenstruktur 199 kombiniert werden, wobei eine der Feldplatten 199 an die n-Zone 115 und eine andere der Feldplatten 199 an einen grunddotierten Abschnitt der Epitaxieschicht angeschlossen ist. Das Anschließen dieser anderen Feldplatte an den grunddotierten Abschnitt kann über eine Anschlusszone 116 des gleichen Leitungstyps wie die Epitaxieschicht erfolgen.

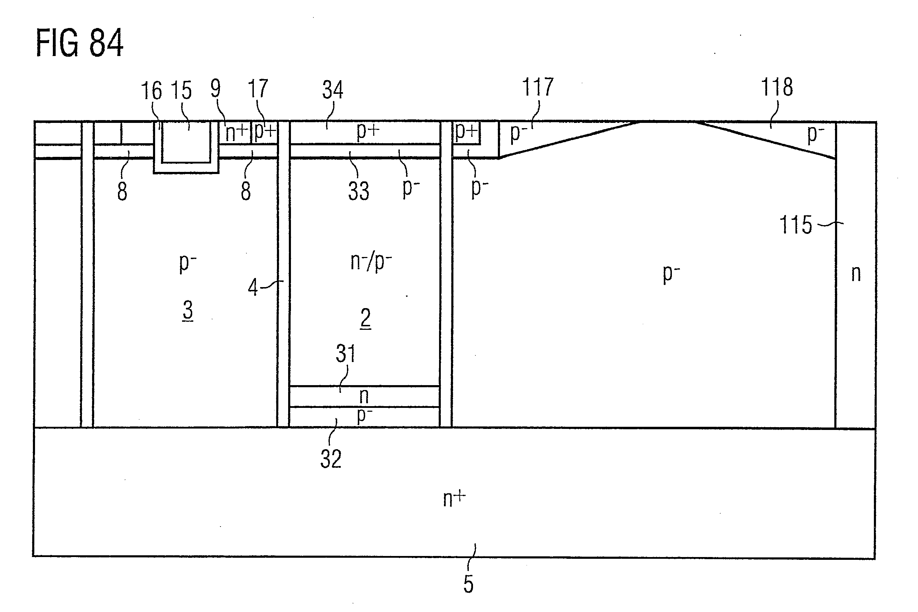

Bei einer weiteren, in Figur 84 dargestellten Ausführungsform einer Randstruktur sind zwei VLD-Gebiete 117, 118 vorhanden, von denen eines 117 sich von Richtung des Zellenfeldes in Richtung des Randes erstreckt und ein anderes 118 sich aus Richtung des Randes in Richtung des Zellenfeldes erstreckt. Die "Erstreckungsrichtung" bezeichnet hierbei die Richtung, in welcher die Dotierung der jeweiligen VLD-Zone abnimmt.

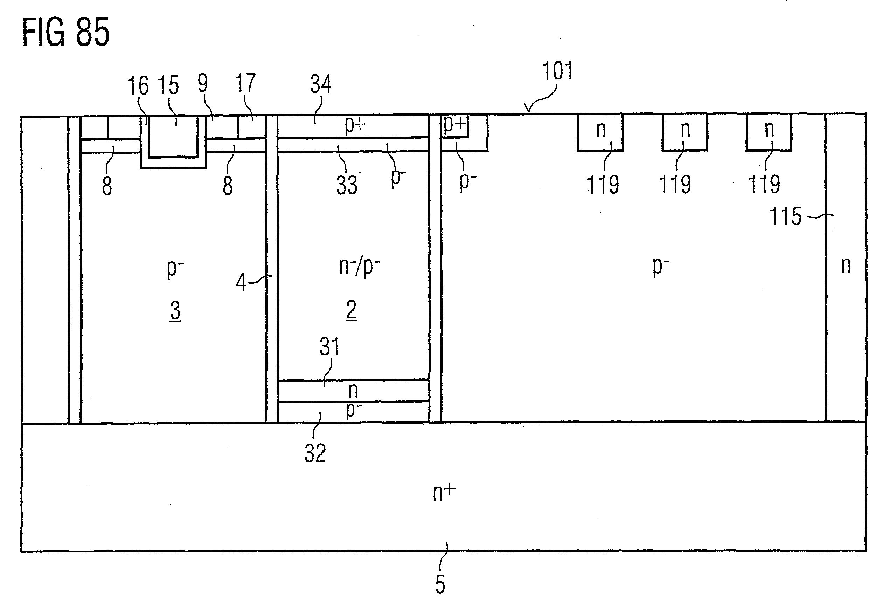

Bezug nehmend auf Figur 85 kann bei einer p-dotierten Epitaxieschicht die n-dotierte Randzone 115 auch mit n-dotierten Feldringen 119 kombiniert werden, die unterhalb der Vorderseite 101 des Halbleiterkörpers im Randbereich der p-Epitaxieschicht angeordnet sind.

Die vorliegende Erfindung ist nicht auf MOSFET beschränkt sondern kann auf beliebige Leistungshalbleiterbauelemente, insbesondere unipolare Leistungshalbleiterbauelemente angewendet werden. Die nachfolgenden Figuren veranschaulichen die Anwendung des erfindungsgemäßen Prinzips auf eine Schottky-Diode.

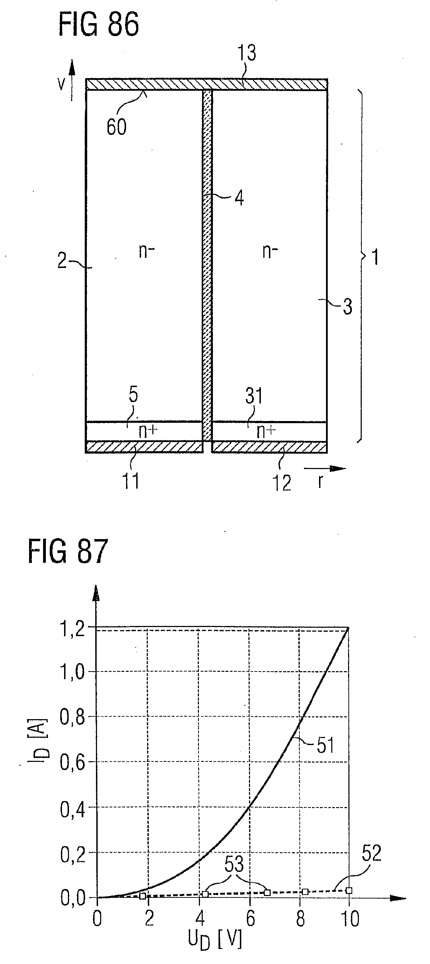

Figur 86 zeigt eine Schottky-Diode mit einer metallischen Anode 13, die eine schwach n-dotierte Driftzone 2 kontaktiert und die mit dieser einen Schottky-Übergang 60 bildet. Auf der dem Schottky-Übergang 60 abgewandten Seite der Driftzone 2 ist eine stark n-dotierte Anschlusszone 5 angeordnet, die eine Kathodenelektrode 11 kontaktiert.

Benachbart zu der Driftzone 2 ist eine schwach n-dotierte, einkristalline Driftsteuerzone 3 vorgesehen, die durch eine Dielektrikumsschicht 4 von der Driftzone getrennt ist. An die Driftsteuerzone 3 schließt sich bei dem Bauelement gemäß Figur 86 eine höher als die Driftsteuerzone 3 dotierte Verbindungszone 31 an, die die Driftsteuerzone 3 kathodenseitig elektrisch mit einer zweiten Elektrode 12 verbindet.

Gemäß einer bevorzugten Ausführungsform erstrecken sich die Driftzone 2 und die Driftsteuerzone 3 in der vertikalen Richtung v über denselben Bereich und weisen in der vertikalen Richtung v vorzugsweise dasselbe Dotierungsprofil auf. Ebenso erstrecken sich die Anschlusszone 5 und die erste Verbindungszone 31 in der vertikalen Richtung v über denselben Bereich und weisen in der vertikalen Richtung v vorzugsweise dasselbe Dotierungsprofil auf.

Die Kathodenelektrode 11 und die zweite Elektrode 12 sind elektrisch voneinander isoliert.

Bei Betrieb in Durchlassrichtung weist die Schottky-Diode gemäß Figur 86 zwischen der Anoden-Elektrode 13 und der Kathoden-Elektrode 11 einen Diodenstrom $I_D$ auf, der signifikant höher ist als der Diodenstrom $I_D$ desselben Bauelements, wenn die Kathoden-Elektrode 11 und die zweite Elektrode 12 kurzgeschlossen sind. Der letztgenannte Fall einer mit der zweiten Elektrode 12 kurzgeschlossenen Kathoden-Elektrode 11 entspricht - abgesehen von dem Akkumulationsdielektrikum 4 - dem einer herkömmlichen Schottky-Diode ohne Driftsteuerzone.

Für den Betrieb einer erfindungsgemäßen Schottky-Diode gemäß Figur 86 sollte die Driftsteuerzone 3 kathodenseitig, vorzugsweise hochohmig, an die Anschlusszone 5 angeschlossen werden, so dass sich in der Driftsteuerzone ein elektrischer Potentialverlauf einstellen kann, der zur Ausbildung eines Akkumulationskanals entlang des Akkumulationsdielektrikums in der Driftzone 2 führt.

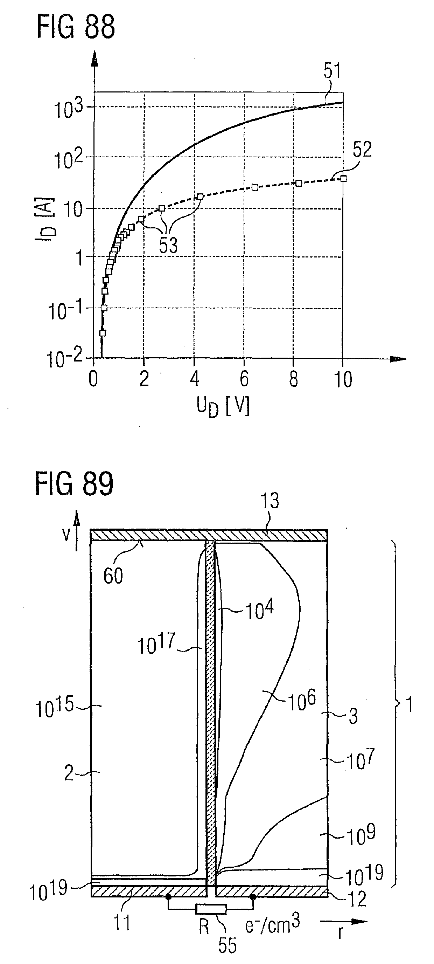

Die Figuren 87 und 88 zeigen den Diodenstrom $I_D$ in Abhängigkeit von der Diodenspannung $U_D$ in linearer bzw. logarithmischer Auftragung. Dabei stellt die Kennlinie 51 die Strom-Spannungs-Kennlinie der erfindungsgemäßen Diode gemäß Figur 86 dar, wobei die zweite Elektrode 12 hochohmig an die Kathodenelektrode 11 angeschlossen ist. Der Kennlinie 51 gegenüber gestellt ist die Strom-Spannungs-Kennlinie 52 derselben Diode für den Fall, dass die Kathoden-Elektrode 11 und die zweite Elektrode 12 kurzgeschlossen sind.

Die Arbeitspunkte 53 zeigen die Verhältnisse bei einer herkömmlichen Schottky-Diode ohne Driftsteuerzone und ohne Dielektrikum, deren Driftzone sich in lateraler Richtung auch über dem Bereich des Dielektrikums 4 und der Driftsteuerzone 3 der Schottky-Diode gemäß Figur 86 erstreckt und die damit eine größere Querschnittsfläche aufweist als die den stationären Strom führende Driftzone 2 der Schottky-Diode gemäß Figur 86.

Die Arbeitspunkte 53 liegen in sehr guter Näherung auf der Kennlinie 52 einer herkömmlichen Schottky-Diode. Daraus ist ersichtlich, dass durch den Kurzschluss zwischen der Kathoden-Elektrode 11 und der zweiten Elektrode 12 eine Schottky-Diode mit den Eigenschaften einer herkömmlichen Schottky-Diode gleicher Breite entsteht. Eine sich durch das zusätzlich vorhandene Dielektrikum 4 möglicherweise ergebende Abweichung der Arbeitspunkte 53 von der Kennlinie 52 ist wegen der geringen Abmessungen des Dielektrikums 4 vernachlässigbar.

Ursache für diesen stark unterschiedlichen Verlauf der Kennlinien 51, 52 ist eine stark inhomogene, kanalartige Elektronen-Verteilung in der Driftzone 2 der erfindungsgemäßen Schottky-Diode , die durch die hochohmige kathodenseitige Anbindung der Driftsteuerzone 3 an die Anschlusszone 5 bewirkt wird.

Figur 89 zeigt eine solche Elektronen-Verteilung bei einer zwischen der Kathoden-Elektrode 11 und der Anoden-Elektrode 13 anliegenden Spannung in Höhe von 5 V. Hieraus ist ersichtlich, dass sich auf der der Driftsteuerzone 3 zugewandten Seite der Driftzone 2 eine Zone mit erhöhter Elektronenkonzentration mit einer Elektronendichte von etwa $10^{17}$ Elektronen/cm$^3$ ausbildet. Ursache hierfür ist das elektrische Feld im Akkumulationsdielektrikum 4, das sich in Folge der hochohmigen Anbindung der Driftsteuerzone 3 an die Anschlusszone 5 etabliert.

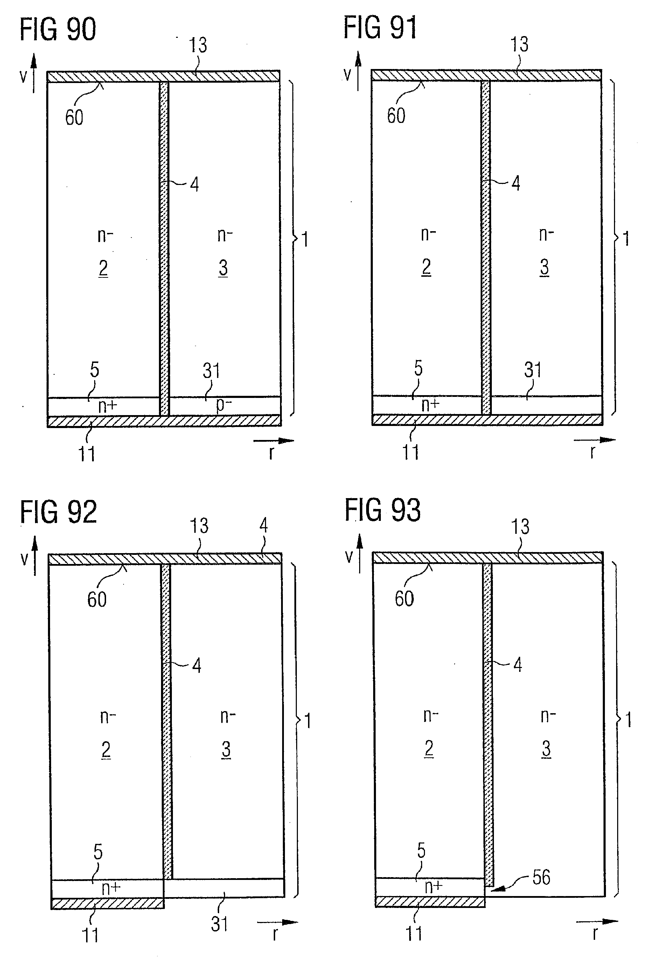

Die hochohmige Anschlusswiderstand zur Anbindung der Driftsteuerzone 3 an die Anschlusszone 5 sollte klein genug sein, um den Warm-Leckstrom aus dem Kathoden-Elektroden-nahen Bereich der Anschlusszone 5 bei sperrender Schottky-Diode ohne nennenswerten Spannungsabfall zur Kathoden-Elektrode 11 abzuführen. Andererseits muss der Anschlusswiderstand deutlich über dem Bahnwiderstand dieses elektrodennahen Gebietes der Anschlusszone 5 liegen, um bei in Durchlassrichtung geschalteter Schottky-Diode eine Akkumulation zu ermöglichen. Für eine Schottky-Diode mit einer Sperrspannungsfestigkeit von 600 V liegen sinnvolle Werte für den kathodenseitigen spezifischen Anschlusswiderstand zwischen der Anschlusszone 5 und der Driftsteuerzone 3 im Bereich von 1 bis zu $10^4$ Ω·cm$^2$. In den Figuren 90 bis 96 werden nachfolgend verschiedene Möglichkeiten aufgezeigt, mit denen ein solcher Anschlusswiderstand realisiert werden kann.

Bei der Schottky-Diode gemäß Figur 90 ist hierzu eine schwach p-dotierte erste Verbindungszone 31 vorgesehen, die die Driftsteuerzone 3 kathodenseitig über die Kathoden-Elektrode 11 und die stark n-dotierte Anschlusszone 5 mit der Driftzone 2 verbindet.

Die Schottky-Diode gemäß Figur 91 weist denselben Aufbau auf wie die Schottky-Diode gemäß Figur 90, mit dem Unterschied, dass die erste Verbindungszone 31 nicht schwach p-dotiert, sondern als intrinsisches, d.h. als undotiertes Halbleitergebiet oder als geringer als die Driftsteuerzone 3 ndotiertes Halbleitergebiet ausgebildet ist.

Bezugnehmend auf Figur 92 ist es nicht erforderlich, die Driftsteuerzone 3 unter Zwischenschaltung der Kathoden-Elektrode 11 an die Driftzone 2 anzukoppeln. Stattdessen kann beispielsweise die erste Verbindungszone 31 unter Umgehung der Kathoden-Elektrode 11 über die hochdotierte Anschlusszone 5 mit der Driftzone 2 gekoppelt sein.

Gemäß dieser Ausführungsform der Erfindung kontaktiert dabei die erste Verbindungszone 31 die hochdotierte Anschlusszone 5 unmittelbar. Um dies zu ermöglichen, ist das Dielektrikum 4 zumindest abschnittweise von der kathodenseitigen Oberfläche des Halbleiterkörpers 1 beabstandet. Das Dielektrikum 4 muss jedoch so ausgebildet sein, dass an keiner Stelle eine unmittelbare Verbindung zwischen der Driftzone 2 und der Driftsteuerzone 3 vorliegt.

Bei dem Ausführungsbeispiel gemäß Figur 93 ist vorgesehen, dass die Driftsteuerzone 3 die hochdotierte Anschlusszone 5 unmittelbar kontaktiert. Hierzu erstreckt sich das Dielektrikum 4 zumindest abschnittweise nicht zur kathodenseitigen Oberfläche des Halbleiterkörpers 1. In diesem Bereich zwischen dem Dielektrikum 4 und der kathodenseitigen Oberfläche des Halbleiterkörpers 1 erstreckt sich ein Abschnitt 56 der Driftsteuerzone 3 bis zu der hochdotierten Anschlusszone 5 und kontaktiert diese. Der elektrische Anbindungswiderstand zwischen der Driftsteuerzone 3 und der Driftzone 2 lässt sich insbesondere über die geometrischen Abmessungen dieses Fortsatzes 56 einstellen.

Statt eines Abschnittes 56 der Driftsteuerzone 3 kann jedoch auch ein anderes elektrisch resistives Material eingebracht werden, das die Driftsteuerzone 3 elektrisch mit der Anschlusszone 5 verbindet.

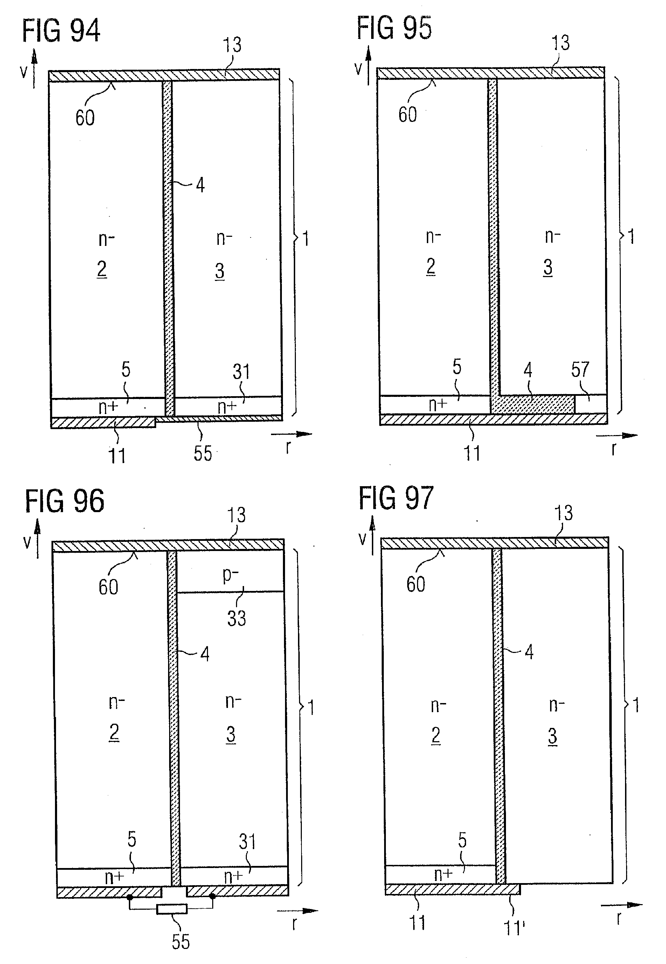

Bei dem Ausführungsbeispiel gemäß Figur 94 erfolgt die kathodenseitige Anbindung der Driftsteuerzone 3 an die Anschlusszone 5 mittels eines schichtartigen, kathodenseitig auf den Halbleiterkörper 1 aufgebrachten Widerstand 55. Der Widerstand 55 kontaktiert dabei sowohl eine erste stark n-dotierte Verbindungszone 31 als auch die hochdotierte Anschlusszone 5.

Bei dem Ausführungsbeispiel gemäß Figur 95 erstreckt sich das Dielektrikum 4 auch abschnittweise zwischen das kathodenseitige Ende der Driftsteuerzone 3 und die in lateraler Richtung sich bis unter die Driftsteuerzone 3 erstreckende Kathoden-Elektrode 11.

In dem Bereich zwischen der Driftsteuerzone 3 und der Kathoden-Elektrode 11 weist das Dielektrikum 4 eine oder mehrere Aussparungen 57 auf, die mit resistivem Material befüllt sind. In Abhängigkeit von Anzahl und Größe der Aussparungen 57 sowie von dem spezifischen Widerstand des darin eingebrachten resistiven Materials lässt sich der Anbindungswiderstand zwischen der Driftsteuerzone 3 und der Anschlusszone 5 gezielt einstellen. Als resistives Material eignet sich insbesondere auch n-dotiertes, p-dotiertes oder intrinsisches Halbleitermaterial.

Eine Besonderheit zeigt das Ausführungsbeispiel gemäß Figur 96. Hierbei ist die Driftsteuerzone 3 anodenseitig über eine schwach p-dotierte dritte Verbindungszone 33 an das Metall 13 des Schottky-Übergangs 60 angeschlossen. Durch diese schwach p-dotierten dritten Verbindungszone 33 kommt es in Folge des hochohmigen kathodenseitigen Anschlusses der Driftsteuerzone 3 an die Driftzone 2 zu keiner bipolaren Ladungsträgerinjektion.

Die schwach p-dotierte dritte Verbindungszone 33 wirkt ähnlich wie die entsprechenden p-dotierten Gebiete einer merged pin-Schottky-Diode feldabschirmend und reduziert damit die elektrische Feldstärke am Schottky-Übergang 60. Da jedoch im Bereich der Driftsteuerzone 3 kein nennenswerter Stromfluss vorliegt, kommt es hier nicht zu dem auch bei einer merged pin-Schottky-Diode unerwünschten Injektionsverhalten und somit zu einer unerwünschten Erhöhung der Abschaltverluste durch das Ausräumen injizierter Ladungsträger aus der Driftsteuerzone 3.

Bei dem Ausführungsbeispiel gemäß Figur 96 sind die Driftzone 2 und die Driftsteuerzone 3 kathodenseitig über einen symbolisch dargestellten Widerstand 55 elektrisch verbunden. Die Art und Weise der Realisierung dieses Widerstandes ist prinzipiell beliebig. Die elektrische Anbindung kann jedoch insbesondere entsprechend den in den Figuren 89 bis 95 sowie 97 bis 100 gezeigten Ausführungsbeispielen realisiert werden.

Figur 97 zeigt eine Ausführungsform, bei der die ohmsche Anbindung der Driftsteuerzone 3 an die Anschlusszone 5 dadurch erfolgt, dass die Kathodenelektrode 11 in einem Abschnitt 11' die Driftsteuerzone 3 abschnittsweise überlappt. Über die Weite der Kontaktfläche 11' kann dabei der Wert des Übergangswiderstands eingestellt werden.

Der auf unterschiedliche Weise realisierbare ohmsche Widerstand zwischen der Driftsteuerzone 3 und der Anschlusszone 5 kann durch ein Tunneldielektrikum, insbesondere ein Tunneloxid ersetzt werden, wie anhand der nachfolgenden Figuren erläutert wird.

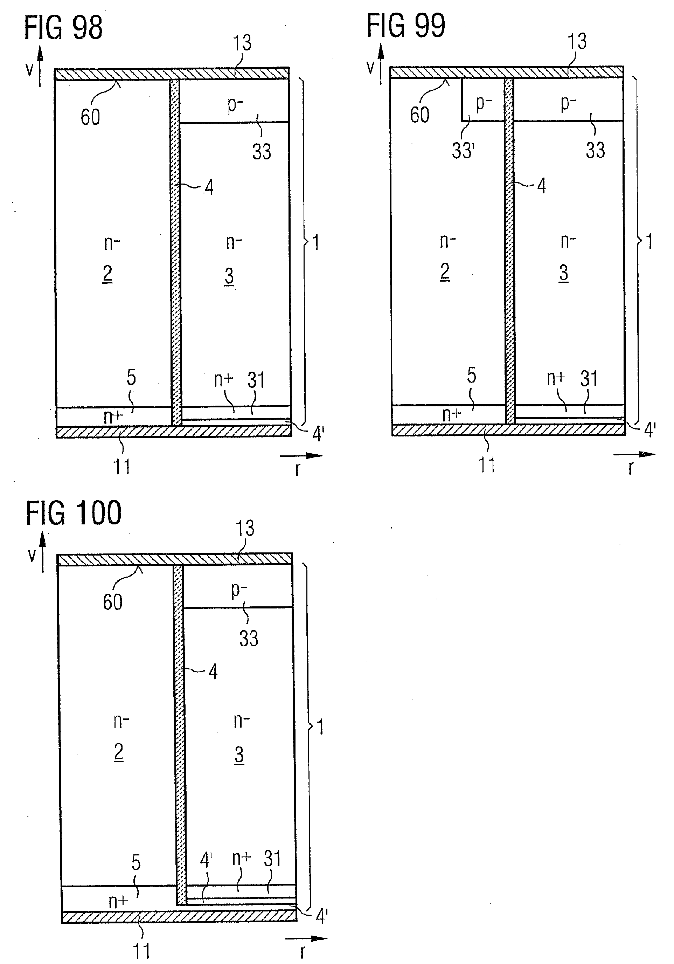

Bei der Schottky-Diode gemäß Figur 98 überdeckt die Anschlusselektrode 11 den Bereich der Driftsteuerzone 3 und der Driftzone 2 vollständig, wobei die Driftsteuerzone 3 über eine optionale hochdotierte Anschlusszone 31 und ein Tunneldielektrikum 4' an die Anschlusselektrode 11 angeschlossen ist. Optional ist die Driftsteuerzone 3 über die dritte Verbindungszone 33 an die Anoden-Elektrode 13 angeschlossen.

Das Bauelement gemäß Figur 99 ist als Merged-pin-Schottky-Diode ausgebildet und weist in der Driftzone 2 abschnittsweise eine p-dotierte Injektionszone 33' auf, die sich an die Anoden-Elektrode 13 anschließt. Die Injektionszone 33' kann dabei wie in Figur 99 dargestellt an das Dielektrikum 4 angrenzen oder auch lateral von diesem beabstandet sein. Letztere Variante (nicht dargestellt) erleichtert die Anbindung des Schottky-Übergangs 60 an den an der Grenze der Driftzone 2 zum Dielektrikum 4 ausgebildeten Akkumulationskanal.

Das Bauelement gemäß Figur 100 unterscheidet sich von dem Bauelement gemäß Figur 98 dadurch, dass das Dielektrikum 4 nicht bis an die Kathoden-Elektrode 11 reicht und dass sich die Anschlusszone 5 unter das Tunneldielektrikum 4' erstreckt, so dass die Driftsteuerzone 3 über die optionale hochdotierte Verbindungszone 31 und das Tunneldielektrikum 4' an die Anschlusszone 5 angeschlossen ist.

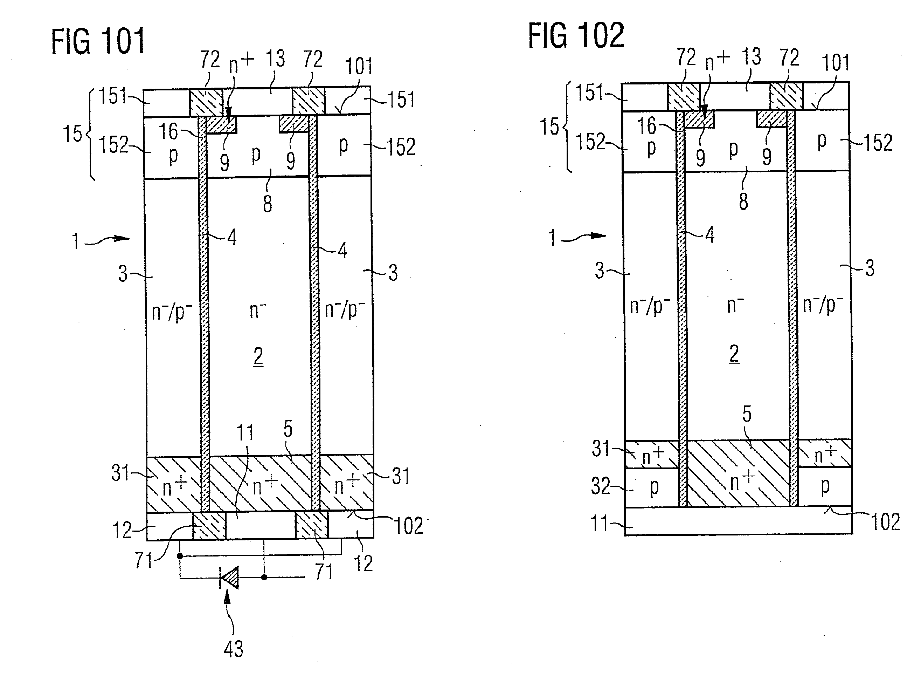

Figur 101 zeigt ein weiteres Ausführungsbeispiel eines als MOSFET ausgebildeten erfindungsgemäßen Leistungshalbleiterbauelements. Die Gateelektrode 15 und die Driftsteuerzone 3 sind bei diesem Bauelement in vertikaler Richtung des Halbleiterkörpers 1 benachbart zueinander angeordnet, wobei sich die Gateelektrode 15 unmittelbar an die Driftsteuerzone 3 anschließt. Die Gateelektrode 15 ist bei diesem Bauelement zweiteilig aufgebaut und umfasst eine Anschlusselektrode 151, die oberhalb der Vorderseite des Halbleiterkörpers 1 angeordnet ist und die mittels einer Isolationsschicht 72 gegenüber der Sourceelektrode 13 isoliert ist. An diese Anschlusselektrode 151 schließt sich in vertikaler Richtung ein p-dotierter Halbleiterabschnitt 152 an, der in lateraler Richtung des Halbleiterkörpers 1 benachbart zu der Bodyzone 8 angeordnet ist und der durch das Gatedielektrikum 16 von der Bodyzone 8 getrennt ist. Diese Halbleiterzone 152 erfüllt die eigentliche Funktion der Gateelektrode und dient bei Anlegen eines geeigneten Ansteuerpotentials dazu, in der Bodyzone 8 entlang des Gatedielektrikums 16 einen leitenden Kanal zwischen der Sourcezone 9 und der Driftzone 2 auszubilden.

Die Halbleiterzone 152 der Gateelektrode 15 ist bei dem in Figur 101 dargestellten n-leitenden MOSFET p-dotiert. Die sich an diese Halbleiterzone 152 unmittelbar anschließende Driftsteuerzone 3 ist entweder n-dotiert oder p-dotiert, wobei deren Dotierungskonzentration geringer ist als die Dotierungskonzentration der Halbleiterzone 152. Die Dotierung der Driftsteuerzone liegt beispielsweise im Bereich von $1 \cdot 10^{14}$ cm$^{-3}$ und kann der Dotierungskonzentration der Driftzone 2 entsprechen. Die Dotierungskonzentration der Halbleiterzone 152 kann hierbei der Dotierungskonzentration der Bodyzone 8 entsprechen.

Der in Figur 101 dargestellte n-MOSFET leitet, wenn eine positive Spannung zwischen der Drainzone 5 und der Sourcezone 9 anliegt, und wenn an der Gateelektrode 15 ein gegenüber dem Potential der Source- und Bodyzone 9, 8 höheres Ansteuerpotential anliegt. Dieses positive Ansteuerpotential der Gateelektrode 15 führt zur Ausbildung eines Inversionskanals in der Bodyzone 8 zwischen der Sourcezone 9 und der Driftzone 2. Die Driftsteuerzone 3 liegt bei leitend angesteuertem Bauelement in etwa auf dem Potential der Gateelektrode 15, was zur Ausbildung eines Akkumulationskanals in der Driftzone 2 entlang des Akkumulationsdielektrikums 4 führt. Bei vollständig leitend angesteuertem Bauelement ist das Potential der Drainzone 5 üblicherweise niedriger als das Potential der Gateelektrode 15, so dass sich der Akkumulationskanal in vertikaler Richtung vollständig entlang des Akkumulationsdielektrikums 4 zwischen der Bodyzone 8 und der Drainzone 5 ausbildet. Eine zwischen die Anschlusselektrode 12 der Driftsteuerzone 3 und die Drainzone 5 bzw. die Drainelektrode 11 geschaltete Diode 43 verhindert während dieses Schaltungszustandes, dass die in der Driftsteuerzone 3 vorhandenen, den Akkumulationskanal bewirkenden Löcher in Richtung der Drainzone 5 bzw. der Drainelektrode 11 abfließen.

Diese Diode 43, von der in Figur 101 lediglich das Schaltsymbol dargestellt ist, kann als externe Diode realisiert werden. Bezug nehmend auf Figur 102 besteht auch die Möglichkeit, diese Diode 43 in der Driftsteuerzone zu integrieren, indem zwischen der hochdotierten Anschlusszone 31 der Driftsteuerzone 3 und der Drainelektrode 11 eine komplementär zu der Anschlusszone 31 und komplementär zu der Drainzone 5 dotierte Halbleiterzone 32 vorgesehen ist. Aufgabe dieser Diode 43 ist es - wie bereits im Zusammenhang mit Figur 16 erläutert - zu verhindern, dass Löcher aus der Driftsteuerzone 3 an die Drainzone 5 abfließen.

Das Gatedielektrikum 16 und das Akkumulationsdielektrikum 4 können bei den in den Figuren 101 und 102 dargestellten Bauelementen als gemeinsame Dielektrikumsschicht realisiert werden, die sich in vertikaler Richtung des Halbleiterkörpers 100 erstrecken. Bei den in den Figuren 101 und 102 dargestellten Bauelementen verlaufen diese Dielektrikumsschichten in vertikaler Richtung jeweils über die gesamte Tiefe des Bauelements, d. h. diese Dielektrikumsschichten erstrecken sich von der Vorderseite bis an die Rückseite des Halbleiterkörpers 1.

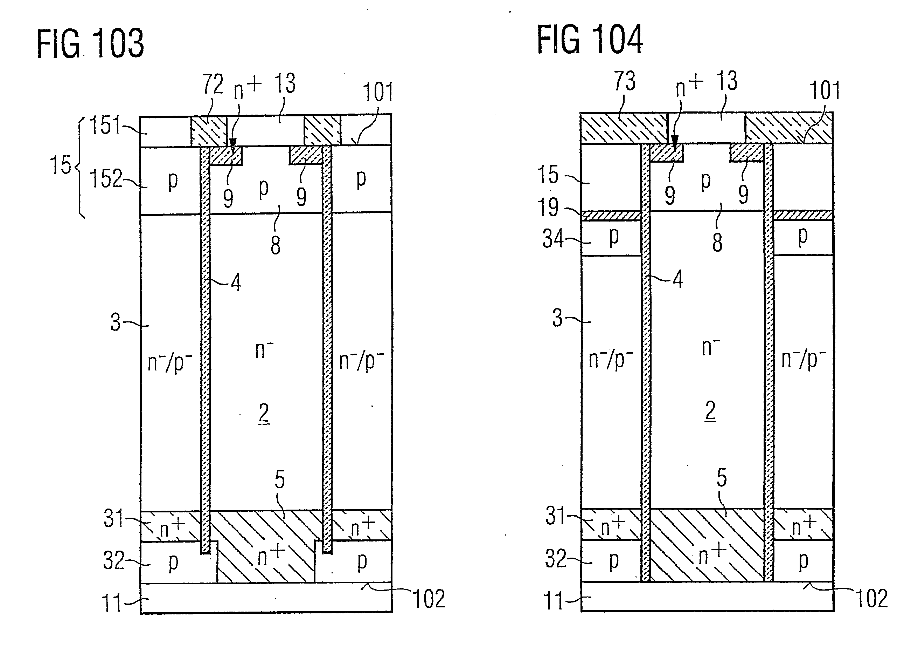

Figur 103 zeigt ein gegenüber dem Bauelement in Figur 102 abgewandeltes Bauelement, bei dem das Akkumulationsdielektrikum 4 vor der Rückseite 102 des Halbleiterkörpers 1 endet, so dass die Drainzone 5 und die p-dotierte Anschlusszone 32 in lateraler Richtung abschnittsweise aneinandergrenzen. Die n-dotierte Anschlusszone 31 und die Drainzone 5 sind durch das Akkumulationsdielektrikum 4 in lateraler Richtung des Halbleiterkörpers jedoch vollständig voneinander getrennt.

Figur 104 zeigt ein weiteres gegenüber dem Bauelement in Figur 102 abgewandeltes Bauelement. Die Driftsteuerzone 3 weist hierbei in Richtung der Gateelektrode 15 eine höher als die Driftsteuerzone 3 dotierte Anschlusszone 34 auf, die in dem Beispiel p-dotiert ist. Diese Anschlusszone 34 ist über eine Anschlusselektrode 19, die beispielsweise aus einem Silizid oder einem Metall besteht, an die Gateelektrode 15 angeschlossen. Die Gateelektrode 15 kann bei diesem Bauelement aus einem Metall oder einem hochdotierten Polysilizium bestehen.

Aufgabe der leitenden Anschlusselektrode 19 ist es, bei Verwendung von n-dotiertem Polysilizium für die Gateelektrode 15, die Gateelektrode 15 elektrisch leitend an die p-dotierte Anschlusszone 34 der Driftsteuerzone 3 anzuschließen. Ohne Vorhandensein dieser Anschlusselektrode 19 wäre sonst ein pn-Übergang zwischen der Gateelektrode 15 und der Driftsteuerzone 3 vorhanden, der den Ladungsträgertransport von der Gateelektrode 15 auf die Driftsteuerzone 3 behindern würde. Auf das Vorsehen der Anschlusselektrode 19 kann verzichtet werden, wenn die Gateelektrode 15 aus einem p-dotierten Polysilizium besteht.

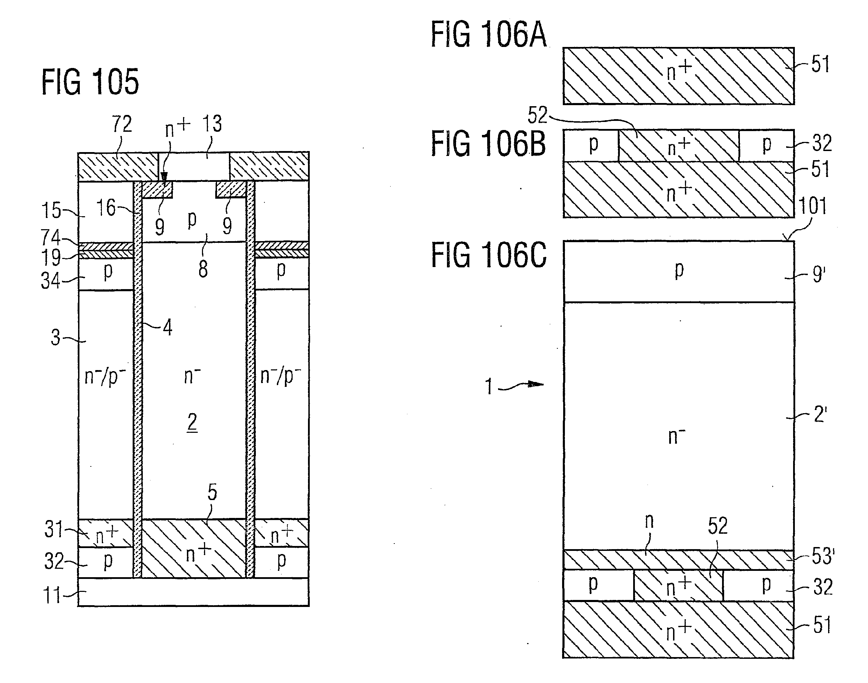

Figur 105 zeigt eine Abwandlung des in Figur 104 dargestellten MOSFET. Bei diesem Bauelement sind die Gateelektrode 15 und die Driftsteuerzone 3 durch Vorsehen einer weiteren Isolationsschicht 74 zwischen der Gateelektrode 15 und der Driftsteuerzone 3 voneinander isoliert. Die sich an die Isolationsschicht 74 anschließende Anschlusselektrode 19 der Driftsteuerzone 3 kann bei diesem Bauelement in nicht näher dargestellter Weise auf ein von dem Gate-Potential getrenntes Ansteuerpotential gelegt werden. Dieses Ansteuerpotential ist zur Ausbildung eines Akkumulationskanals in der Driftzone 2 so zu wählen, dass es zumindest größer als das Source-Potential, d. h. das Potential der Sourceelektrode 13 bzw. der Source- und Bodyzone 9, 8 ist. Dieses Ansteuerpotential kann dabei auch größer als das Drain-Potential, d. h. das Potential der Drainzone 5 sein, wodurch die Driftsteuerzone 3 bedingt durch die zwischen der Driftsteuerzone 3 und der Drainzone 5 in Sperrrichtung gepolte Diode 31, 32 auf einem gemeinsamen Potential liegt. Ist das Ansteuerpotential der Anschlusselektrode 19 kleiner als das Potential der Drainzone 5, so liegt ein Spannungsabfall über der Driftsteuerzone 3 in vertikaler Richtung vor, die Ausbildung eines Akkumulationskanals in der Driftzone 2 entlang des Akkumulationsdielektrikums 4 ist in diesem Fall nicht über die gesamte Länge des Akkumulationsdielektrikums 4, jedoch abschnittsweise in einem sich an die Bodyzone 8 anschließenden Bereich möglich, was zu einer Reduktion des Einschaltwiderstandes führt.

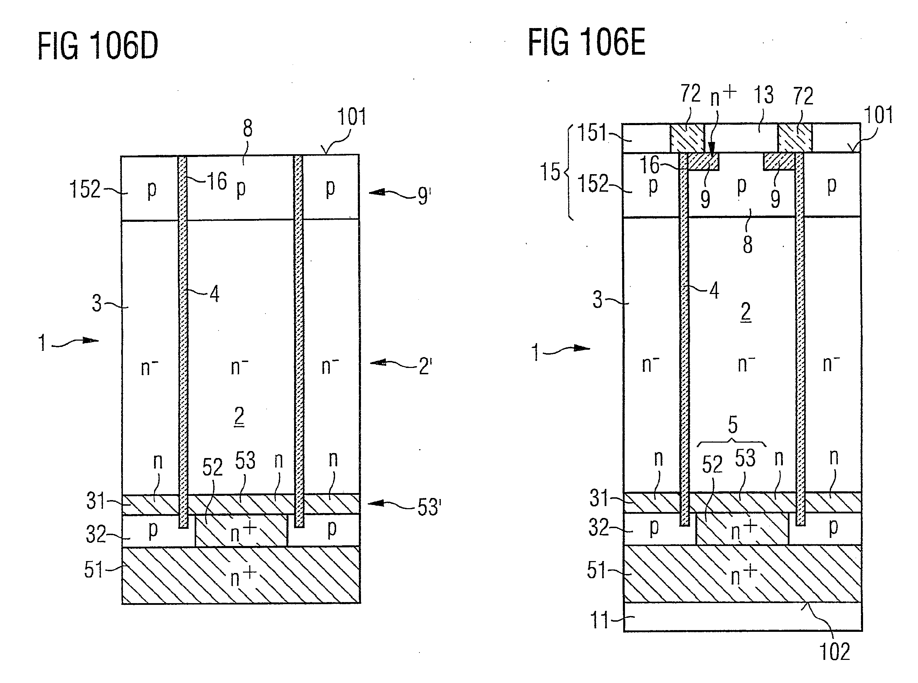

Figur 106E zeigt ein gegenüber dem Bauelement in Figur 103 abgewandeltes, als MOSFET ausgebildetes Halbleiterbauelement. Bei diesem Bauelement ist im Bereich der Rückseite 102 des Halbleiterkörpers 1 eine in lateraler Richtung durchgehend hochdotierte Halbleiterzone 51 vorhanden, die sich an die Drainelektrode 11 anschließt. Zwischen dieser Halbleiterzone 51 und der Driftsteuerzone 3 sind die komplementär zueinander dotierten, eine Diode bildenden Anschlusszonen 31, 32 der Driftsteuerzone 3 angeordnet, und zwischen dieser hochdotierten Halbleiterzone 51 und der Driftzone 2 ist eine n-dotierte Halbleiterzone ausgebildet, die die Drainzone des Bauelements bildet und die aus zwei übereinander angeordneten Halbleiterzonen 52, 53 besteht.

Ein Abschnitt 52 der Drainzone 5 grenzt bei diesem Bauelement in lateraler Richtung an die p-dotierte Anschlusszone 32 der Driftsteuerzone 3 an. Die Halbleiterzone 51 dient bei diesem Bauelement im Wesentlichen als Substrat für die darüber angeordneten Bauelementstrukturen und sorgt für eine niederohmige elektrisch leitende Verbindung zwischen der Drainelektrode 11 und der Drainzone 5.

Ein Verfahren zur Herstellung dieses Bauelements gemäß Figur 106E wird nachfolgend anhand der Figuren 106A bis 106D erläutert.

Ausgangspunkt dieses Verfahrens bildet Bezug nehmend auf Figur 106A die Bereitstellung eines Halbleitersubstrats 51, das beispielsweise ein hoch n-dotiertes Halbleitersubstrat ist. In diesem Zusammenhang sei angemerkt, dass die Abmessungen des Halbleitersubstrats in vertikaler Richtung und die Abmessungen der nachfolgend noch zu erläuternden Bauelementzonen des Halbleiterbauelements nicht maßstäblich dargestellt sind. Die Abmessungen des Substrats 51 in vertikaler Richtung sind üblicherweise wesentlich größer als die Abmessungen der weiteren noch zu erläuternden Bauelementzonen bzw. Halbleiterschichten.

Auf das Halbleitersubstrat 51 wird Bezug nehmend auf Figur 106B eine Halbleiterschicht aufgebracht, die in lateraler Richtung abwechselnd n-dotierte und p-dotierte Halbleiterzonen 52, 32 aufweist. Die p-dotierten Zonen bilden dabei einen Teil der späteren Diode, über welche die Driftsteuerzone 4 an die Drainzone bzw. Drainelektrode angeschlossen ist. Die n-dotierten Halbleiterzonen 52 bilden einen Teil der späteren Drainzone des Bauelements. Die auf das Halbleitersubstrat 51 aufgebrachte Halbleiterschicht wird beispielsweise mittels eines Epitaxieverfahrens als gleichmäßig dotierte Schicht eines Leitungstyps oder als intrinsisch dotierte Halbleiterschicht hergestellt. Die unterschiedliche Dotierung der Halbleiterzonen 32, 52 kann anschließend mittels eines Implantationsverfahrens, durch das Dotierstoffatome in die Halbleiterschicht eingebracht werden, erzeugt werden.

Auf diese Halbleiterschicht mit den komplementär zueinander dotierten Halbleiterzonen 32, 52 werden Bezug nehmend auf Figur 106C nachfolgend drei weitere Halbleiterschichten 53', 2', 9' abgeschieden, von denen eine erste Schicht 53' in dem Beispiel n-dotiert ist, eine zweite Schicht 2' schwächer als die erste Schicht 53' n-dotiert ist, und eine dritte Schicht 9' p-dotiert ist.

Die dritte Schicht 9' bildet eine Vorderseite 101 eines nach Abscheiden dieser Halbleiterschichten vorhandenen Halbleiterkörpers 1.

Bezug nehmend auf Figur 106D werden ausgehend von dieser Vorderseite 101 anschließend Gräben erzeugt, die in vertikaler Richtung des Halbleiterkörpers bis in die p-dotierten Halbleiterzonen 32 der zuerst abgeschiedenen Halbleiterschicht reichen. Diese Gräben werden anschließend mit einem Dielektrikumsmaterial, beispielsweise einem Halbleiteroxid, aufgefüllt, welches im Bereich der zweiten Schicht 2' das Akkumulationsdielektrikum 4 und im Bereich der dritten Schicht 9' das Gatedielektrikum 16 bildet.

Die Gräben mit dem darin angeordneten Dielektrikum unterteilen die drei Halbleiterschichten 53', 2', 9' in einzelne Halbleiterabschnitte. Die Halbleiterabschnitte dieser Halbleiterschichten 53', 2', 9' bilden in einem Bereich oberhalb der n-dotierten Halbleiterzonen 52 der ersten Halbleiterschicht einen Teil 53 der Drainzone 5, die Driftzone 2 sowie die Bodyzone 8. Oberhalb der p-dotierten Halbleiterzonen 32 der ersten Schicht bilden diese drei Halbleiterschichten einen Teil 31 der integrierten Diode, die Driftsteuerzone 3 sowie einen Teil 152 der Gateelektrode 15.

Bezug nehmend auf Figur 106E wird die Herstellung des Bauelements vervollständigt durch Herstellen der Sourcezone 9 in der Bodyzone. Hierzu werden in einem oberflächennahen Bereich der Bodyzone 8 Dotierstoffatome eines zu der Dotierung der Bodyzone komplementären Leitungstyps eingebracht. Abschließend werden oberhalb der Vorderseite 101 die Sourceelektrode 13 und Anschlusselektroden 151 der Gateelektrode 15 hergestellt. Die Herstellung dieser Elektroden 13, 151 kann durch Abscheiden einer Metallschicht oder hochdotierten Polysiliziumschicht und anschließendes Strukturieren dieser Schicht erfolgen. Die Strukturierung umfasst hierbei das Unterteilen dieser Halbleiterschicht in einzelne Elektrodenabschnitte und das Herstellen einer Isolationsschicht 72 zwischen den einzelnen Elektrodenabschnitten.

Die integrierte Diode, welche die Driftsteuerzone 3 an die Drainzone 5 anschließt, ist bei dem Bauelement gemäß Figur 106E durch die p-dotierten Abschnitte 32 der zuerst abgeschiedenen Halbleiterschicht sowie durch den Abschnitt 31 der darauffolgend abgeschiedenen n-dotierten Halbleiterschicht gebildet. Die Drainzone 5 wird bei diesem Bauelement durch die n-dotierten Abschnitte 52 der zuerst abgeschiedenen Halbleiterschicht und durch Abschnitte 53 der darauffolgend abgeschiedenen n-dotierten Halbleiterschicht gebildet.

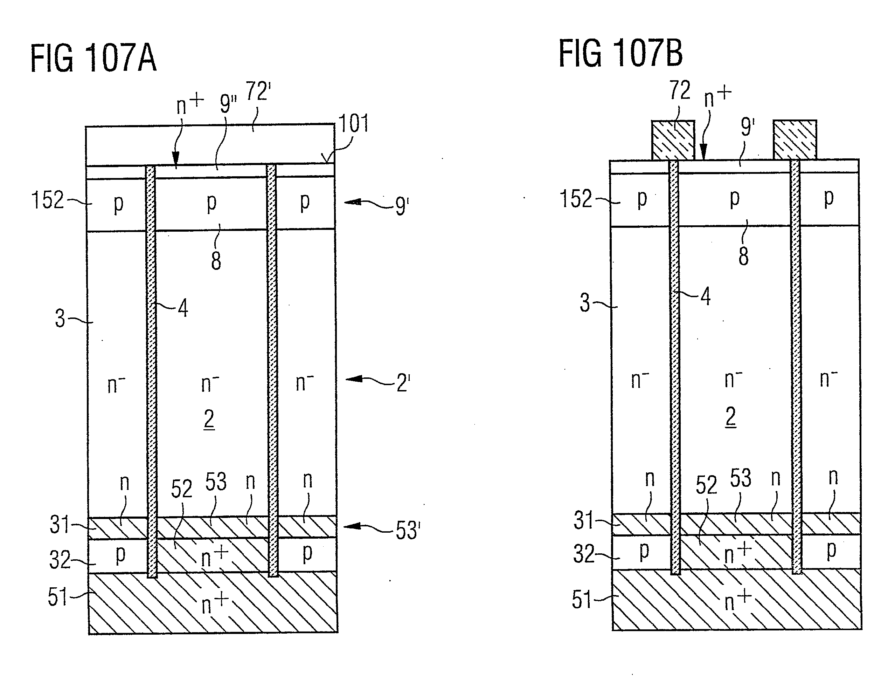

Ein gegenüber dem Verfahren der Figuren 106A bis 106E abgewandeltes Verfahrens wird nachfolgend anhand der Figuren 107A bis 107D erläutert.

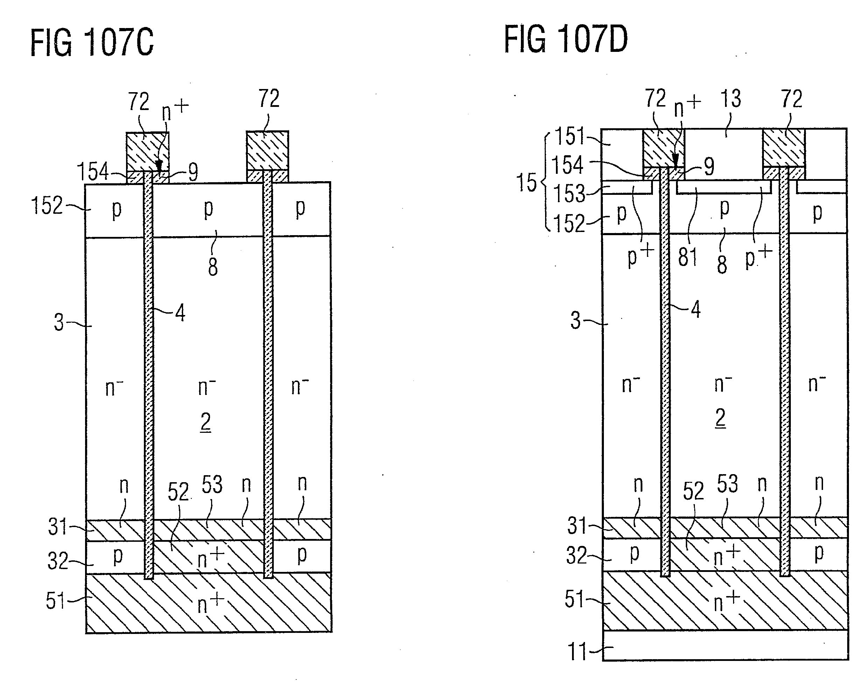

Dieses Verfahren unterscheidet sich von dem Verfahren gemäß Figur 106 durch die Verfahrensschritte zur Herstellung der Sourcezone des MOSFET. Ausgehend von der in Figur 106D dargestellten Anordnung wird bei dem abgewandelten Verfahren gemäß Figur 107 auf der dritten Halbleiterschicht 9' ausgehend von der Vorderseite 101 ganzflächig eine stark n-dotierte Halbleiterschicht 9" hergestellt, die abschnittsweise die spätere Sourcezone des Bauelements bildet. Das Herstellen dieser Halbleiterzone 9" erfolgt beispielsweise durch Ionenimplantation über die Vorderseite 101 des Halbleiterkörpers.

Bezug nehmend auf Figur 107B werden oberhalb der Gräben mit dem Dielektrikumsmaterial anschließend Isolationsbereiche 72 hergestellt. Das Herstellen dieser Isolationsbereiche kann durch Abscheiden einer Isolationsschicht und anschließendes Strukturieren dieser Isolationsschicht erfolgen. Aufgabe dieser Isolationsbereiche 72 ist es, in bereits erläuterter Weise die späteren Sourceelektroden und Gateelektroden des Bauelements elektrisch gegeneinander zu isolieren. Die Abmessungen der Isolationsbereiche 72 oberhalb der Gräben sind derart gewählt, dass diese Isolationsbereiche 72 in lateraler Richtung des Halbleiterkörpers die hochdotierte Halbleiterzone 9" auf beiden Seiten der Gräben jeweils abschnittsweise überlappt.

Bezug nehmend auf Figur 107C wird die hoch n-dotierte Halbleiterschicht 9" anschließend in den von den Isolationsabschnitten 72 nicht überdeckten Bereichen entfernt. Dies kann mittels eines anisotropen Ätzverfahrens erfolgen, bei dem ein Ätzmittel verwendet wird, welches die Halbleiterschicht 9" selektiv gegenüber den Isolationsabschnitten 72 ätzt. Nach Abschluss dieses Ätzverfahrens liegen die Bodyzonen 8 und die einen Teil der späteren Gateelektrode bildenden Halbleiterzonen 152 im Bereich der Vorderseite 101 des Halbleiterkörpers abschnittsweise frei. Beiderseits der Gräben mit dem Dielektrikumsmaterial verbleiben bei dem anhand der Figur 107 erläuterten Verfahren Abschnitte 9, 154 der hochdotierten Halbleiterschicht 9" unterhalb der Isolationsabschnitte 72. Die oberhalb der Bodyzone 8 verbliebenen n-dotierten Bereiche 9 bilden hierbei die Sourcezonen des späteren Bauelements. Die verbleibenden Abschnitte 154 der hochdotierten Schicht 9" haben keine elektrische Funktion und resultieren in dem Beispiel lediglich aus dem Herstellungsverfahren.

Bezug nehmend auf Figur 107D werden abschließend Sourceelektroden 13 oberhalb der Bodyzonen 8 und Anschlusszonen 151 der Gateelektroden 15 oberhalb der p-dotierten Halbleiterzonen der Gateelektroden 15 hergestellt. Optional werden vor Herstellen dieser Elektroden 13, 151 höher als die Bodyzonen 8 und die Halbleiterzonen 152 dotierte Halbleiterzonen 81, 153 in den Bodyzonen 8 und den Halbleiterzonen 152 hergestellt. Diese höher dotierten Zonen 81, 153 sorgen für einen niederohmigen Anschlusskontakt der Elektroden 13, 151 an die Bodyzonen 8 bzw. die p-Halbleiterzonen 152. Die Kontaktierung der Sourcezonen 9 durch die Sourceelektrode 13 erfolgt bei dem in Figur 107D dargestellten Halbleiterbauelement in Bereichen, in denen die Sourcezonen 9 sich in lateraler Richtung an die Sourceelektrode 13 anschließen.

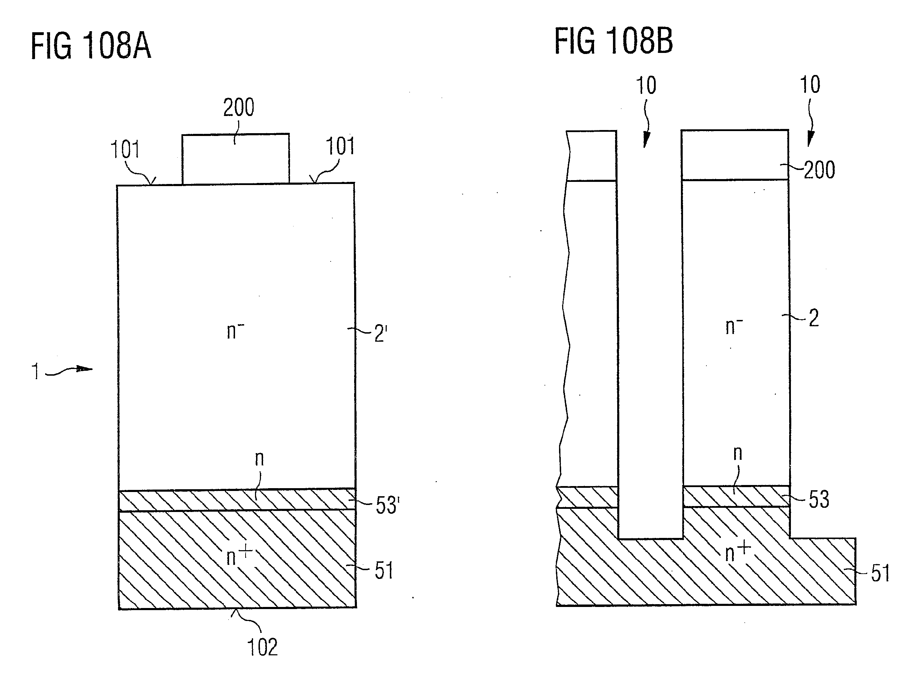

Ein weiteres Verfahren zur Herstellung eines in Figur 107D dargestellten Halbleiterbauelements wird nachfolgend anhand der Figuren 108A bis 108F erläutert. Bei diesem Verfahren wird zunächst ein Halbleiterkörper 100 zur Verfügung gestellt, dessen hochdotiertes Halbleitersubstrat 51, beispielsweise ein n-Substrat, und eine auf das Halbleitersubstrat aufgebrachte schwächer dotierte Halbleiterschicht 2' aufweist, die abschnittsweise die spätere Driftzone des Bauelements bildet. Optional wird vor Herstellen der schwächer dotierten Halbleiterschicht 2' eine stärker dotierte Halbleiterschicht 53' auf das Halbleitersubstrat 51 aufgebracht.

Ausgehend von der Vorderseite 101 des Halbleiterkörpers werden anschließend Gräben 10 hergestellt, die in vertikaler Richtung bis in das Halbleitersubstrat 51 reichen. Das Herstellen dieser Gräben erfolgt in grundsätzlich bekannter Weise durch Herstellen einer Maske 200 oberhalb der Vorderseite 101 und anschließendes selektives Ätzen des Halbleiterkörpers in durch die Maske 200 freiliegenden Bereichen.

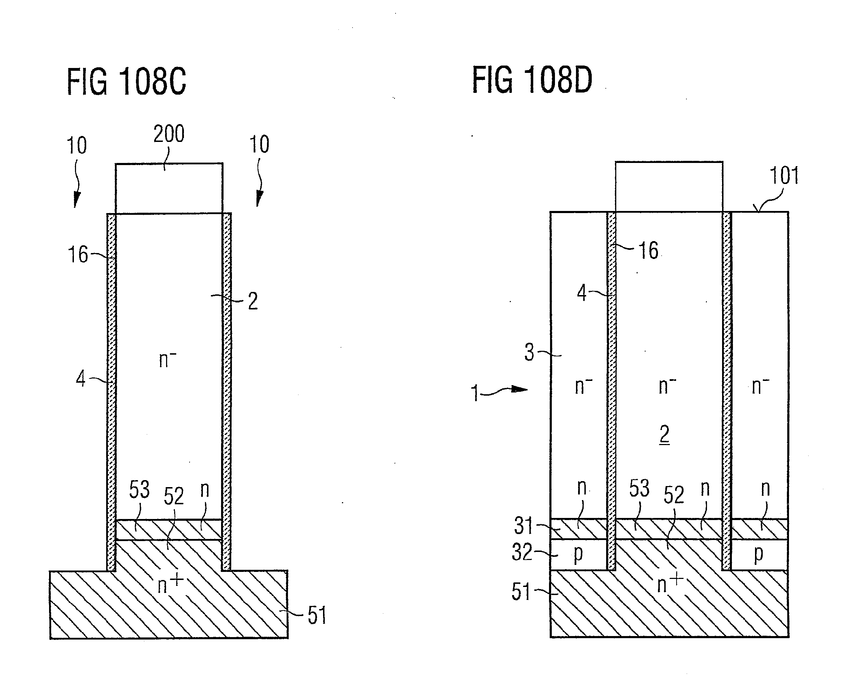

An Seitenwänden der so erzeugten Gräben 10 werden Bezug nehmend auf Figur 108C anschließend Dielektrika hergestellt, die später das Gatedielektrikum 16 und das Akkumulationsdielektrikum 4 bilden. Das Herstellen dieses Dielektrikums an den Seitenwänden der Gräben 10 erfolgt beispielsweise durch thermische Oxidation des Halbleiterkörpers und anschließendes Entfernen der dadurch entstehenden Oxidschicht vom Boden der Gräben 10. Das Entfernen der Oxidschicht bzw. Dielektrikumsschicht vom Boden der Gräben 10 kann mittels eines anisotropen Ätzverfahrens erfolgen.

Bezug nehmend auf Figur 108D wird in die Gräben anschließend ein einkristallines Halbleitermaterial eingebracht, das unterschiedlich dotierte Abschnitte umfasst. Das Herstellen dieses Halbleitermaterials kann mittels eines Epitaxieverfahrens erfolgen. Durch dieses Verfahren werden p-dotierte Halbleiterabschnitte 32 hergestellt, die sich unmittelbar an das Halbleitersubstrat 51 anschließen. Oberhalb der p-dotierten Abschnitte 32 wird ein schwach n-dotiertes Halbleitermaterial hergestellt, das abschnittsweise die spätere Driftsteuerzone 3 bildet. Optional kann zwischen den p-Zonen 32 und der Driftsteuerzone 3 eine stärker als die Driftsteuerzone 3 n-dotierte Halbleiterzone 31 hergestellt werden, die einen Teil der späteren integrierten Diode bildet.

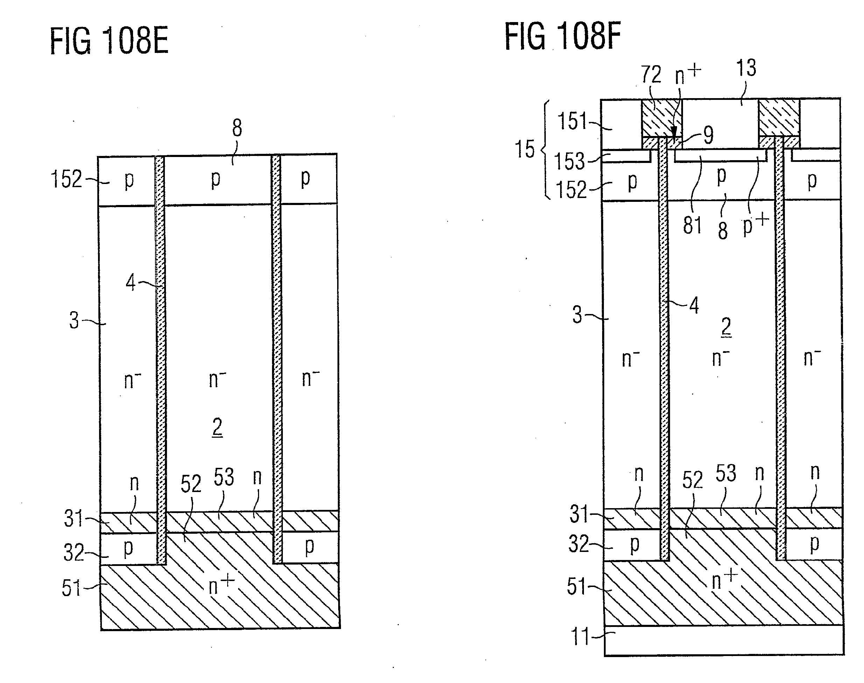

Bezug nehmend auf Figur 108E werden im Bereich der Vorderseite 101 des so entstandenen Halbleiterkörpers 1 p-dotierte Halbleiterzonen 8, 152 hergestellt, die in Bereich oberhalb der Driftzone 2 die Bodyzonen 8 und oberhalb der Driftsteuerzone 3 Teile der Gateelektroden des späteren MOSFET bilden. Die Herstellung dieser p-Zonen 8, 152 erfolgt beispielsweise durch Implantation von p-Dotierstoffatomen gefolgt von einem entsprechenden Ausheilschritt.

An die Herstellung dieser p-Zonen 8, 152 schließen sich die bereits anhand der Figuren 107A bis 107D erläuterten Verfahrensschritte zur Herstellung der Sourcezone 9 sowie zur Herstellung der Sourceelektroden 13 und zur Fertigstellung der Gateelektroden 15 an. Ein Querschnitt durch das fertiggestellte Bauelement ist in Figur 108F dargestellt.

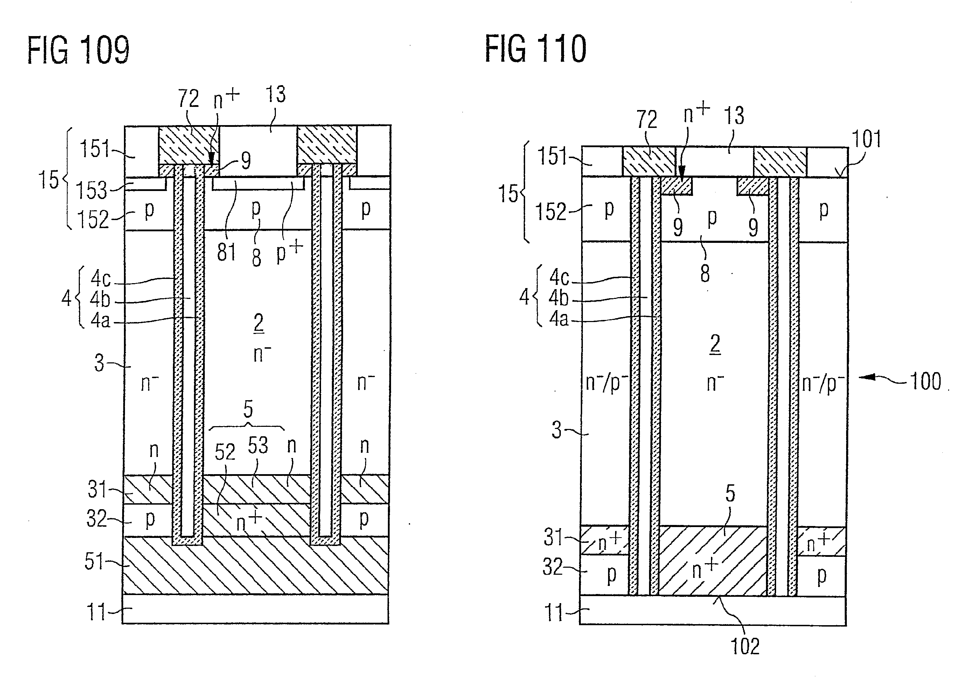

Figur 109 zeigt im Querschnitt eine Abwandlung des in Figur 107D dargestellten MOSFETs. Bei dem Bauelement gemäß Figur 109 ist die Dielektrikumsschicht, die im Bereich zwischen der Driftsteuerzone 3 und der Driftzone 2 das Akkumulationsdielektrikum 4 bildet und die im Bereich zwischen der Gateelektrode 15 und der Bodyzone 8 das Gatedielektrikum bildet, mehrschichtig aufgebaut. Dieser Schichtaufbau umfasst beispielsweise zwei Oxidschichten 4A, 4C die sich unmittelbar an die Driftzone 2 auf einer Seite des Grabens und die Driftsteuerzone 3 auf der anderen Seite des Grabens anschließen, sowie eine zwischen den Oxidschichten angeordnete Dielektrikumsschicht 4B, die vorzugsweise eine höhere Dielektrizitätskonstante als die beiden Oxidschichten 4A, 4C aufweist. Der Vorteil einer Realisierung der Dielektrikumsschicht als Schichtstapel mit mehreren Dielektrikumsschichten besteht darin, dass bei Verwendung eines dielektrischen Materials mit hoher Dielektrizitätskonstante, beispielsweise einer Dielektrizitätskonstante größer als 15, ein breiterer Graben für die Herstellung der Dielektrikumsschicht vorgesehen werden kann, als bei bloßer Verwendung einer Oxidschicht, ohne die kapazitive Kopplung zwischen der Driftsteuerzone 3 und der Driftzone 2 zu verschlechtern.

Figur 110 zeigt eine Abwandlung des in Figur 109 dargestellten Bauelements. Bei dem Bauelement gemäß Figur 110 reicht die mehrschichtige Dielektrikumsschicht von der Vorderseite 101 bis an die Rückseite 102 des Halbleiterkörpers 100.

Die Menge der in der Driftzone 2 akkumulierten Ladungsträger ist bei einer gegebenen Spannungsdifferenz zwischen der Driftsteuerzone 3 und der Driftzone 2 abhängig von der durch die Driftzone 2, die Driftsteuerzone 3 und das Akkumulationsdielektrikum 4 gebildeten Akkumulationskapazität. Die akkumulierte Ladung ist dabei umso größer, je größer diese Kapazität ist. Diese Kapazität ist bei einer gegebenen Dicke des Akkumulationsdielektrikums 4 umso größer, je größer die Dielektrizitätskonstante des Akkumulationsdielektrikums ist. bei einer gegebenen Akkumulationskapazität ist die erforderliche Dicke des Akkumulationsdielektrikums umso kleiner, je geringer die Dielektrizitätskonstante ist. Bei Verwendung von Siliziumdioxid ($SiO_2$) als Material für das Akkumulationsdielektrikum ist eine Dicke für das Akkumulationsdielektrikum von typischerweise 200 nm oder weniger erforderlich, um eine ausreichende Akkumulationswirkung zu erhalten. Derart dünne und darüber hinaus in die Tiefe reichende Dielektrikumsschichten sind schwierig herzustellen.

Bei einer Ausführungsform der Erfindung ist dabei vorgesehen, das Akkumulationsdielektrikum ganz oder teilweise aus einem Material mit mittlerer Dielektrizitätskonstante, einem sogenannten Medium-K-Material zu realisieren. Ein solches Material zeichnet sich durch eine relative Dielektrizitätskonstante bzw. Dielektrizitätszahl von etwa 7 bis 25 aus. Die Verwendung eines solchen Materials ermöglicht die Verwendung eines im Vergleich zu $SiO_2$ dickeren, und damit einfacher herzustellenden Akkumulationsdielektrikums. Geeignete Materialien sind beispielsweise Siliziumnitrid (SiN), dessen Dielektrizitätszahl mit 7,5 etwa doppelt so groß ist wie die von $SiO_2$ oder Siliziumkarbid (SiC), dessen Dielektrizitätszahl mit 9,7 etwa 2,5 mal so groß ist wie die von $SiO_2$. Anders als sogenannte hochdielelektrische Materialien (High-K-Materialien) lassen sich die zuvor genannten Medium-K-Materialien durch Prozesse herstellen, die Standardprozesse bei der Fertigung von Halbleiterbauelementen sind.

Bei den zuvor erläuterten Bauelementen kann das Akkumulationsdielektrikum 4 vollständig aus einem Medium-K-Material bestehen.

Bei den Bauelementen gemäß der Figuren 11, 109 und 110 kann beispielsweise die mittlere 4b der Dielektrikumsschichten aus einem Medium-K-Material und die beiden äußeren Schichten 4a, 4c können aus einem Material mit niedrigerer Dielektrizitätskonstante, beispielsweise aus $SiO_2$, bestehen. Die mittlere Schicht 4b kann dabei deutlich dicker, beispielsweise um einen Faktor 5 bis 10 dicker, als die äußeren Schichten 4a, 4c sein.

Darüber hinaus besteht auch die Möglichkeit, das Akkumulationsdielektrikum 4 zwischen der Driftzone 2 und der Driftsteuerzone 3 aus einem Medium-K-Material zu realisieren und ein Dielektrikum, das weitere Bereiche des Bauelements voneinander trennt, aus einem Material mit niedrigerer Dielektrizitätskonstante zu realisieren. Solche anderen Bereiche sind bei einem Bauelement gemäß Figur 19 beispielsweise die Bodyzone 8 und die Anschlusszone 33, die durch ein Dielektrikum mit einer niedrigeren Dielektrizitätskonstante getrennt sein können, oder bei dem Bauelement gemäß Figur 101 die Anschlusszone 31 und die Drainzone 5, die durch ein Dielektrikum mit einer niedrigeren Dielektrizitätskonstante getrennt sein können.

Bei einer weiteren Variante ist vorgesehen, bei einem Bauelement gemäß Figur 16 die Dielektrikumsschicht zwischen den p-dotierten Halbleiterzonen 33, 34 und der Bodyzone 8 und der Kurzschlusszone 17 durch ein Medium-K-Material zu realisieren, um dadurch die interne Speicherkapazität des Bauelements zu vergrößern. Das Akkumulationsdielektrikum 4 zwischen der Driftzone 2 und der Driftsteuerzone 3 besteht hierbei aus einem Material mit niedrigerer Dielektrizitätskonstante. Das Akkumulationsdielektrikum 4 könnte auch durch ein Medium-K-Material realisiert werden, zur Vergrößerung der internen Speicherkapazität wäre für die Dielektrikumsschicht zwischen den p-dotierten Halbleiterzonen 33, 34 und der Bodyzone 8 und der Kurzschlusszone 17 dann ein High-K-Material vorzusehen.

Das erfindungsgemäße Halbleiterbauelement wurde bislang anhand vertikaler Leistungsbauelemente erläutert, also anhand solcher Bauelemente, bei denen eine Stromflussrichtung in der Driftzone in einer vertikalen Richtung verläuft. Die Driftzone ist hierbei in einer vertikalen Richtung des Halbleiterkörpers 100 zwischen einer ersten Bauelementzone, die bei einem MOSFET der Sourcezone und bei einer Schottky-Diode dem Schottky-Metall entspricht, und einer zweiten Bauelementzone, die bei einem MOSFET der Drainzone und bei einer Schottky-Diode der Kathodenzone entspricht, angeordnet.

Wie nachfolgend erläutert wird, ist das erfindungsgemäße Konzept, ein Akkumulationsdielektrikum und eine Driftsteuerzone benachbart zu einer Driftzone eines Halbleiterbauelements vorzusehen, selbstverständlich auch auf laterale Bauelemente anwendbar.

Ausführungsbeispiele lateraler Halbleiterbauelemente werden nachfolgend anhand von Schnittdarstellungen eines Halbleiterkörpers 100 erläutert, der eine erste Seite 101, die nachfolgend als Vorderseite bezeichnet wird, und eine der ersten Seite gegenüberliegende zweite Seite 102, die nachfolgend als Rückseite bezeichnet wird, aufweist. Eine vertikale Richtung v dieser Halbleiterkörper verläuft senkrecht zu der Vorder-und Rückseite 101, 102 zwischen diesen beiden Seiten 101, 102. Laterale Richtungen der Halbleiterkörper verlaufen jeweils parallel zu der Vorder- und Rückseite 101, 102 und damit senkrecht zu der vertikalen Richtung v. Laterale Schnittebenen bezeichnen nachfolgend Schnittebenen parallel zu der Vorder- und Rückseite 101, 102, während vertikale Schnittebenen nachfolgend Schnittebenen senkrecht zu der Vorder- und Rückseite 101, 102 bezeichnen.

Als MOSFET ausgebildete Ausführungsbeispiele der erfindungsgemäßen Halbleiterbauelemente werden - ohne Beschränkung der Allgemeingültigkeit der Erfindung - nachfolgend anhand von n-Kanal-MOSFETs (n-MOSFETs) erläutert, die eine n-dotierte Driftzone 211, eine p-dotierte Bodyzone 212 und n-dotierte Source- und Drainzonen 213, 214 aufweisen. Die Driftzone 211 eines n-Kanal-MOSFET kann allerdings auch undotiert bzw. intrinsisch dotiert sein.

Die Erfindung ist selbstverständlich jedoch auch auf einen p-Kanal-MOSFET (p-MOSFET) anwendbar, wobei die nachfolgend für einen n-MOSFET erläuterten Bauelementzonen einschließlich des noch erläuterten Halbleitersubstrats 103 bei einem p-MOSFET komplementär zu dotieren sind.

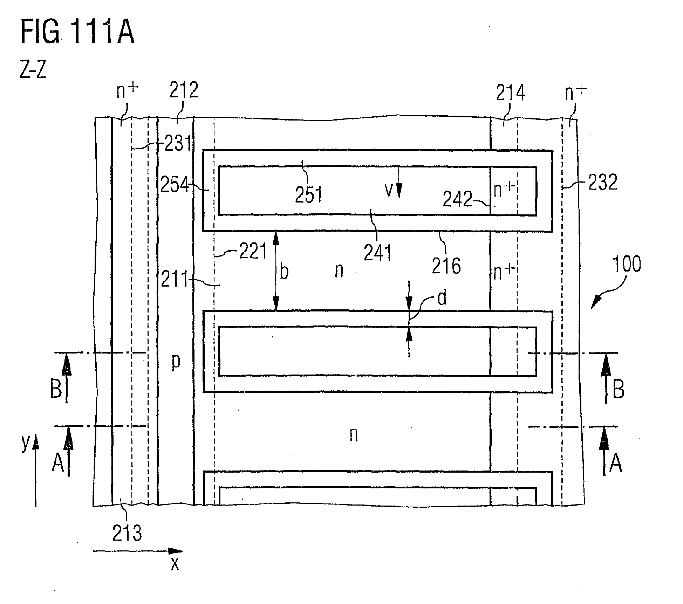

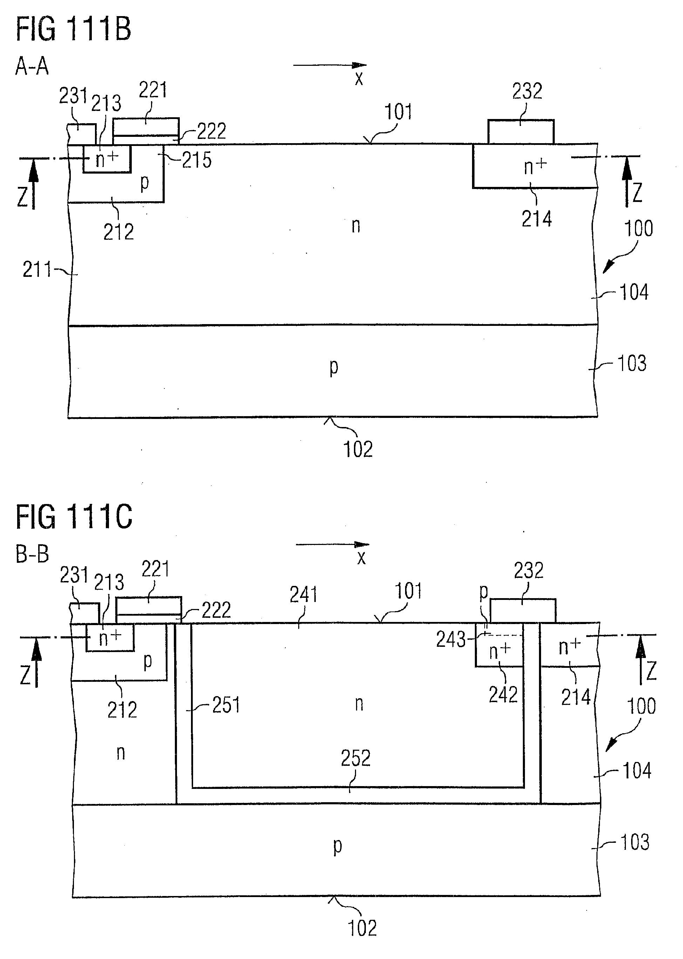

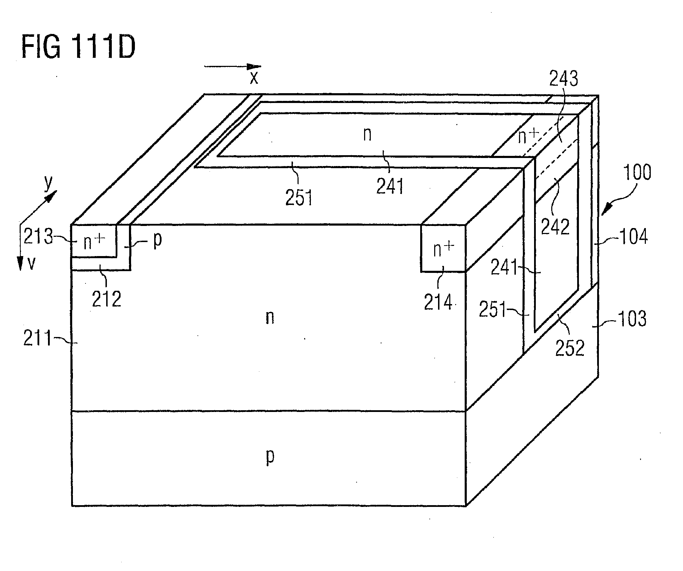

Die Figuren 111A bis 111D zeigen ein als MOSFET ausgebildetes Ausführungsbeispiel eines erfindungsgemäßen lateralen Leistungshalbleiterbauelements anhand verschiedener Querschnitte eines Halbleiterkörpers 100, in dem Bauelementstrukturen des MOSFETs integriert sind. Figur 111A zeigt den Halbleiterkörper 100 in einer lateralen Schnittebene Z-Z, die Figuren 111B und 111C zeigen den Halbleiterkörper 100 in unterschiedlichen vertikalen Schnittebenen A-A, B-B, deren laterale Position in Figur 111A dargestellt ist. Figur 111D zeigt ausschnittsweise eine perspektivische Schnittdarstellung des Halbleiterkörpers 100.

Der in Figur 111 dargestellte Leistungs-MOSFET weist eine Sourcezone 213 und eine Drainzone 214 auf, die in einer ersten lateralen Richtung x des Halbleiterkörpers 100 beabstandet zueinander angeordnet und die jeweils n-dotiert sind. An die Drainzone 214 schließt sich eine Driftzone 211 an, die in dem Beispiel vom gleichen Leitungstyp wie die Drainzone 214 ist, die jedoch schwächer als die Drainzone 214 dotiert ist, die allerdings auch undotiert sein kann. Zwischen der Sourcezone 212 und der Driftzone 211 ist eine komplementär zu der Sourcezone 213 und der Driftzone 211 dotierte Bodyzone 212 angeordnet, die mit der Driftzone 211 einen pn-Übergang bildet, ausgehend von dem sich bei sperrend angesteuertem Bauelement eine Raumladungszone (depletion zone, Verarmungszone) in der Driftzone 211 ausbreiten kann. Diese Bodyzone 212 ist ebenfalls in der ersten lateralen Richtung x beabstandet zu der Drainzone 214 angeordnet.

Zur Steuerung eines Inversionskanals 215 in der Bodyzone 212 zwischen der Sourcezone 213 und der Driftzone 211 ist eine Gateelektrode 221 vorhanden, die mittels eines Gatedielektrikums 222 isoliert gegenüber dem Halbleiterkörper 100 angeordnet ist. Diese Gateelektrode 221 ist benachbart zu der Bodyzone 212 angeordnet und erstreckt sich von der Sourcezone 213 bis zu der Driftzone 211. Bei Anlegen eines geeigneten Ansteuerpotentials an die Gateelektrode 221 bildet sich in der Bodyzone 212 ein Inversionskanal entlang des Gatedielektrikums 222 zwischen der Sourcezone 213 und der Driftzone 211 aus.

Die Gateelektrode 221 ist in dem dargestellten Beispiel oberhalb der Vorderseite 101 des Halbleiterkörpers 100 angeordnet, so dass der Inversionskanal 215 in der Bodyzone 212 in der ersten lateralen Richtung x entlang der Vorderseite 101 des Halbleiterkörpers 100 verläuft. Aus Gründen der Übersichtlichkeit ist diese Gateelektrode in der perspektivischen Darstellung in Figur 111D nicht eingezeichnet.

Die Sourcezone 213 ist durch eine Sourceelektrode 231 und die Drainzone 214 ist durch eine Drainelektrode 232 kontaktiert, die in dem Beispiel jeweils oberhalb der Vorderseite angeordnet sind und deren Position bezogen auf die einzelnen Halbleiterzonen in Figur 111A durch strichpunktierte Linien dargestellt ist. Die Sourceelektrode 231 kontaktiert dabei zusätzlich die Bodyzone 212, um dadurch die Sourcezone 213 und die Bodyzone 212 kurzzuschließen.

Die Sourcezone 213, die Bodyzone 212 und die Drainzone 214 sind in dem Beispiel in einer eine n-Grunddotierung aufweisenden Halbleiterschicht 104 angeordnet und erstrecken sich bezugnehmend auf Figur 111A streifenförmig in einer senkrecht zu der ersten lateralen Richtung x verlaufenden zweiten lateralen Richtung y. Die Gateelektrode 221 und die Source- und Drainelektroden 231, 232 verlaufen ebenfalls streifenförmig in der zweiten lateralen Richtung y.

Der Leistungs-MOSFET umfasst mehrere Driftsteuerzonen 241 aus einem dotierten oder undotierten Halbleitermaterial, die benachbart zu der Driftzone 211 in dem Halbleiterkörper 104 angeordnet sind und die durch eine erste Dielektrikumsschicht gegenüber der Driftzone 211 isoliert sind. Der Bereich dieser Dielektrikumsschicht, der unmittelbar zwischen der Driftzone 211 und der Driftsteuerzone 241 angeordnet ist, wird nachfolgend als Akkumulationsdielektrikum 251 bezeichnet. Die Driftsteuerzonen 241 sind jeweils solche Zonen, die sich in einer Richtung senkrecht zur Fläche des Akkumulationsdielektrikums 251 an das Akkumulationsdielektrikum 251 anschließen und die somit in einer noch zu erläuternden Weise geeignet sind, einen Akkumulationskanal in der Driftzone 211 zu steuern.

Die Driftsteuerzonen 241 sind an die Drainzone 214 gekoppelt, was in dem dargestellten Beispiel dadurch erreicht wird, dass die Driftsteuerzonen 241 über Anschlusszonen 242, die vom gleichen Leitungstyp wie die Driftsteuerzonen 241, jedoch höher als diese dotiert sind, an die Drainelektrode 232 angeschlossen sind. Die Anschlusszonen 242 bewirken hierbei einen niederohmigen Anschlusskontakt zwischen den Driftsteuerzonen 241 und der Drainelektrode 232.

In noch zu erläuternder Weise können die Driftsteuerzonen 241 auch jeweils über eine Diode an die Drainelektrode 232 angeschlossen sein. Diese Diode ist bei einem n-Kanal-MOSFET von der Drainelektrode 232 zu der Driftsteuerzone 241 in Flussrichtung gepolt und kann bezugnehmend auf Figur 111C durch einen pn-Übergang zwischen der Driftsteuerzone 241 und einer komplementär zu der Driftsteuerzone 241 dotierten Anschlusszone 243 gebildet sein. Die Drainelektrode 232 kontaktiert hierbei die komplementär dotierte Anschlusszone 243. Optional kann die komplementär dotierte Anschlusszone 243 in einer in Figur 111C dargestellten Weise in die Anschlusszone 242 desselben Leitungstyps wie die Driftsteuerzone eingebettet sein, wobei der pn-Übergang in diesem Fall zwischen den beiden Anschlusszonen 242, 243 gebildet ist.

Bei einer alternativen Ausführungsform ist die Driftsteuerzone 241 vom gleichen Leitungstyp wie die Bodyzone 212, aber niedriger als diese dotiert oder gar undotiert (intrinsisch).

Die Driftsteuerzonen 241 besitzen in dem Beispiel eine plattenförmige bzw. streifenförmige Geometrie und sind in der zweiten lateralen Richtung y beabstandet zueinander und jeweils benachbart zu Abschnitten der Driftzone 211 angeordnet. In der zweiten lateralen Richtung ist hierbei eine Schichtstruktur bzw. Plattenstruktur vorhanden, in der sich Driftzonen 211 und Driftsteuerzonen 241 jeweils getrennt durch ein Akkumulationsdielektrikum abwechseln.

In vertikaler Richtung v des Halbleiterkörpers 100 erstrecken sich die Driftsteuerzonen 214 ausgehend von der Vorderseite 101 in den Halbleiterkörper 100 hinein, und reichen in dem dargestellten Beispiel bis an das Halbleitersubstrat 103, gegenüber dem sie durch eine weitere Isolationsschicht 252, beispielsweise eine Oxidschicht, isoliert sind. Das Substrat 103 ist dabei von einem zum Leitfähigkeitstyp der Driftzone 211 komplementären Leitfähigkeitstyp. In der ersten lateralen Richtung x erstrecken sich die Driftsteuerzonen ausgehend von der Drainzone 214, an die sie elektrisch gekoppelt sind, in Richtung der Bodyzone 212. Die Driftsteuerzonen 241 können in der ersten lateralen Richtung x hierbei vor der Bodyzone 212 enden oder können sich in dieser Richtung bis in die Bodyzone 212 hinein erstrecken (nicht dargestellt).

In noch näher zu erläuternder Weise dienen die Driftsteuerzonen 214 bei leitend angesteuertem Bauelement zur Steuerung eines Akkumulationskanals in der Driftzone 211 entlang des Akkumulationsdielektrikums 251. Vorzugsweise sind die Driftsteuerzonen 241 so ausgebildet, dass sie möglichst nahe bis an den Bereich heranreichen, in dem der durch die Gateelektrode 221 gesteuerte Inversionskanal 215 (Figur 111B) der Bodyzone 212 in die Driftzone 211 übergeht. Dieser Inversionskanal 215 bildet sich bei dem Bauelement gemäß Figur 111 unterhalb der Vorderseite 101 des Halbleiterkörpers 100 aus, die Driftsteuerzonen reichen daher in vertikaler Richtung v bis an die Vorderseite 101 und in der ersten lateralen Richtung x annähernd bis an die Bodyzone 212.

Der Inversionskanal 215 und ein sich entlang des Akkumulationsdielektrikums 251 einer Driftsteuerzone 241 in der Driftzone 211 ausbildende Akkumulationskanal, der in Figur 111A mit dem Bezugszeichen 216 bezeichnet ist, verlaufen jeweils um 90° gegeneinander verdreht. Der Inversionskanal 215 breitet sich entlang der Vorderseite 101 des Halbleiterkörpers 100 aus, während sich die Akkumulationskanäle 216 entlang der in vertikaler Richtung verlaufenden "Seitenwände" der Driftsteuerzonen 241 an dem Akkumulationsdielektrikum in der Driftzone 211 ausbilden. Eine Stromflussrichtung entspricht bei diesem Bauelement der ersten lateralen Richtung x des Halbleiterkörpers.

Die Driftsteuerzonen 241 bestehen aus einem dotierten oder undotierten, vorzugsweise einkristallinen, Halbleitermaterial, das vom gleichen Leitungstyp wie die Dotierung der Driftzone 211 oder von einem zu dieser Dotierung komplementären Leitungstyp sein kann. Die Driftsteuerzone 241 weist in der Richtung, in der die Driftsteuerzone 241 und die Driftzone 211 parallel zueinander zwischen der Drainzone 214 und der Bodyzone 212 verlaufen - d.h. in Figur 111 in der ersten lateralen Richtung x - vorzugsweise denselben Dotierungsverlauf auf, wie der sich in dieser Richtung über denselben Bereich wie die Driftsteuerzone 241 erstreckende Abschnitt der Driftzone 211.

Die Driftsteuerzonen 241 sind derart dotiert, dass sie wenigstens einen Halbleiterabschnitt aufweisen, der sich in einer Richtung quer zu der Stromflussrichtung - in dem Beispiel also in der zweiten lateralen Richtung y - über die gesamte Breite der Driftsteuerzone 241 erstreckt und der durch ein elektrisches Feld in dieser Richtung vollständig ausräumbar ist.

Die Driftsteuerzonen 241 können insbesondere vollständig ausräumbar sein. Dies ist dann erfüllt, wenn ein Quotient aus der Netto-Dotierstoffladung der Driftsteuerzone 241 und aus der Fläche des Akkumulationsdielektrikums 251 kleiner ist als die Durchbruchsladung des Halbleitermaterials der Driftsteuerzone 241. Die Netto-Dotierstoffladung bezeichnet dabei das Integral der Netto-Dotierstoffkonzentration der Driftsteuerzone 241 bezogen auf das Volumen der Driftsteuerzone 241.

Für die Ermittlung dieses Quotienten ist dabei nur die Fläche des Akkumulationsdielektrikums 251 heranzuziehen, die unmittelbar zwischen der Driftsteuerzone 241 und der Driftzone 211 liegt, wobei für den in Figur 111 darge-stellten Fall, bei dem eine Driftsteuerzone 241 in der zweiten lateralen Richtung y von beiden Seiten - getrennt durch das Akkumulationsdielektrikum 251 - an die Driftzone 211 angrenzt, die Fläche des Akkumulationsdielektrikums 251 auf beiden Seiten der Driftsteuerzone 241 für die Ermittlung des Quotienten heranzuziehen ist.

Zur weiteren Erläuterung sei nachfolgend eine der in Figur 111 dargestellten Driftsteuerzonen 241 betrachtet, die in der zweiten lateralen Richtung y nach zwei Seiten und in Richtung der Bodyzone 212 von der das Akkumulationsdielektrikum bildenden Dielektrikumsschicht 251 begrenzt sind. Zu Zwecken der Erläuterung sei nachfolgend außerdem der Spezialfall angenommen, dass die Driftsteuerzonen 241 jeweils homogen dotiert und vom gleichen Leitungstyp wie die Drainzone 214 sind und dass die Fläche eines Abschnitts 254 der Dielektrikumsschicht 251, der die Driftsteuerzone 241 in Richtung der Bodyzone 212 begrenzt, klein ist im Vergleich zu "Seitenflächen" der Dielektrikumsschicht 251, die die Driftsteuerzone 241 in der zweiten lateralen Richtung y von der Driftzone 211 trennen. Für diesen Spezialfall ist die zuvor angegebene Dotiervorschrift gleichbedeutend damit, dass das Integral der ionisierten Dotierstoffkonzentration der Driftsteuerzone 241 in einer Richtung r (die in dem Beispiel der zweiten lateralen Richtung y entspricht) senkrecht zu der Dielektrikumsschicht 251 und betrachtet über die gesamte Abmessung der Driftsteuerzone 241 kleiner ist als der zweifache Wert der Durchbruchsladung des Halbleitermaterials der Driftsteuerzone 241. Für Silizium als Halbleitermaterial beträgt diese Durchbruchsladung etwa $1{,}2 \cdot 10^{12}$ e/cm$^2$, wobei e die Elementarladung bezeichnet.

Betrachtet man eine nicht näher dargestellte homogen dotierte Driftsteuerzone, an die sich nur an einer Seite eine Driftzone anschließt, die durch ein Akkumulationsdielektrikum von der Driftsteuerzone getrennt ist, so gilt für diese Driftsteuerzone, dass das Integral der Dotierstoffkonzentration in der Richtung senkrecht zu der Dielektrikumsschicht kleiner ist als der einfache Wert der Durchbruchsladung.

Die Einhaltung der zuvor erläuterten Dotiervorschrift für die Driftsteuerzone 241 bewirkt, dass sich in der Drift-steuerzone 241 in Richtung der Dielektrikumsschicht 251 unabhängig von einem in der Driftzone 211 vorhandenen elektrischen Potential ein elektrisches Feld aufbauen kann, dessen Feldstärke stets unter der Durchbruchsfeldstärke des Halbleitermaterials der Driftsteuerzone 241 liegt.

Vorzugsweise bestehen die Driftsteuerzonen 241 aus demselben Halbleitermaterial wie die Driftzone 211 und besitzen die gleiche Dotierungskonzentration, wobei deren Abmessungen insbesondere in der zweiten lateralen Richtung y so gewählt sind, dass die oben angegebene Bedingung bezüglich der Netto-Dotierstoffladung bezogen auf die Fläche der Dielektrikumsschicht 251 erfüllt ist.

Die Funktionsweise des erläuterten lateralen Leistungs-MOSFETs wird nachfolgend zunächst für eine leitende Ansteuerung und anschließend für eine sperrende Ansteuerung des Bauelements erläutert.

Der MOSFET ist leitend angesteuert bei Anlegen eines geeigneten Ansteuerpotentials an die Gateelektrode 221 und durch Anlegen einer geeigneten - im Fall eines n-Kanal-MOSFET positiven - Spannung zwischen Drainzone 214 und Sourcezone 212 bzw. zwischen Drainelektrode 232 und Sourceelektrode 231. Für einen p-Kanal-MOSFET sind die Spannungen bzw. Potentiale entsprechend zu invertieren. Das elektrische Potential der Driftsteuerzonen 241, die an die Drainelektrode 232 angeschlossen sind, folgt hierbei dem elektrischen Potential der Drainzone 214, wobei das elektrische Potential der Driftsteuerzone 241 um den Wert der Durchlassspannung eines pn-Übergangs geringer sein kann als das Potential der Drainzone 214, wenn die Driftsteuerzone 241 über einen pn-Übergang an die Drainzone 214 angeschlossen ist.

Bedingt durch einen unvermeidlich vorhandenen elektrischen Widerstand der Driftzone 211 nimmt bei leitend angesteuertem Bauelement das elektrische Potential in der Driftzone 211 in Richtung der Bodyzone 212 ab. Die an die Drainelektrode 232 angeschlossene Driftsteuerzone 241 liegt dadurch auf einem höheren Potential als die Driftzone 211, wobei die über dem Akkumulationsdielektrikum 251 anliegende Potentialdifferenz mit zunehmendem Abstand von der Drainzone 214 in Richtung der Bodyzone 212 zunimmt. Diese Potentialdifferenz bewirkt, dass in der Driftzone 211 benachbart zu dem Akkumulationsdielektrikum 251 eine Akkumulationszone bzw. ein Akkumulationskanal entsteht, in der/dem Ladungsträger akkumuliert werden. Diese Ladungsträger sind Elektronen, wenn die Driftsteuerzone 241 - wie in dem Beispiel - auf einem höheren elektrischen Potential als die Driftzone 211 liegt, und im umgekehrten Fall Löcher. Der Akkumulationskanal bewirkt eine Reduktion des Einschaltwiderstandes des Bauelements im Vergleich zu einem herkömmlichen Bauelement, das eine entsprechend der Driftzone 211 dotierte Driftzone, jedoch keine Driftsteuerzone aufweist.

Die bei dem Bauelement erreichte Akkumulationswirkung ist außer von der Spannungsdifferenz zwischen der Driftsteuerzone 241 und der Driftzone 211 von der Dicke (d in Figur 111A) des Akkumulationsdielektrikum 251 in der zweiten lateralen Richtung y und von dessen (relativer) Dielektrizitätskonstante abhängig. Die Akkumulationswirkung verstärkt sich hierbei mit abnehmender Dicke d dieses Akkumulationsdielektrikums 251 und mit zunehmender Dielektrizitätskonstante. Eine minimal mögliche Dicke dieses Dielektrikums ergibt sich bei leitend angesteuertem Bauelement aus einer maximal vorhandenen Potentialdifferenz zwischen der Driftsteuerzone 241 und der Driftzone 211 und damit aus der maximal zulässigen dauerhaften Feldstärkebelastung des Akkumulationsdielektrikums.

Als Material des Akkumulationsdielektrikums 251 eignet sich beispielsweise ein Halbleiteroxid des zur Realisierung der Driftzone 211 oder der Driftsteuerzone 241 verwendeten Halbleitermaterials, beispielsweise Silizium. Bei typischen dauerhaften Spannungsbelastungen des Akkumulationsdielektrikums 251 von deutlich unter etwa 100V, beispielsweise zwischen 5V bis 20V, und bei Verwendung von Siliziumoxid als Akkumulationsdielektrikum 251 ist die Dicke d des Dielektrikums 251 kleiner als etwa 500nm und liegt vorzugsweise im Bereich von etwa 25nm bis etwa 150nm.

Das Bauelement ist sperrend angesteuert, wenn kein geeignetes Ansteuerpotential an der Gateelektrode 221 anliegt und wenn eine - im Fall eines n-Kanal-MOSFET positive - Drain-Source-Spannung, d.h. eine - im Fall eines n-Kanal-MOSFET positive - Spannung zwischen der Drainzone 214 und Sourcezone 213 anliegt. Der pn-Übergang zwischen der Driftzone 211 und der Bodyzone 212 ist dadurch in Sperrrichtung gepolt, so dass sich in der Driftzone 211 ausgehend von diesem pn-Übergang in Richtung der Drainzone 214 eine Raumladungszone ausbildet. Die anliegende Sperrspannung wird dabei in der Driftzone 211 abgebaut, d.h. die über der Driftzone 211 anliegende Spannung entspricht annähernd der anliegenden Sperrspannung.

Bedingt durch die sich in der Driftzone 211 ausbreitende Raumladungszone breitet sich im Sperrfall auch in der Driftsteuerzone 241 des Bauelements eine Raumladungszone aus, die im wesentlichen durch die geringe Dotierungskonzentration der Driftsteuerzone bedingt ist, die sich bei Einhaltung der oben angegebenen Dotierungsvorschrift für die Driftsteuerzone 241 ergibt. Der Spannungsabfall an dem Akkumulationsdielektrikum 251 ist dabei auf einen oberen Maximalwert begrenzt, der nachfolgend hergeleitet wird.

Das Akkumulationsdielektrikum 251 mit seiner Dicke $d_{Akku}$ bildet zusammen mit der Driftsteuerzone 241 und der Driftzone 211 eine Kapazität, für deren flächenbezogenen Kapazitätsbetrag C' gilt:

$$C' = \varepsilon_0 \varepsilon_r / d_{Akku} \qquad (4)$$

$\varepsilon_0$ bezeichnet dabei die Dielektrizitätskonstante für das Vakuum und $\varepsilon_r$ bezeichnet die relative Dielektrizitätskonstante des verwendeten Dielektrikums, die für Siliziumoxid ($SiO_2$) etwa 4 beträgt.

Die Spannung über dem Dielektrikum 251 ist in bekannter Weise gemäß

$$U = Q'/C' \qquad (5)$$

abhängig von der gespeicherten Ladung, wobei Q' die auf die Fläche des Dielektrikums 251 bezogene gespeicherte Ladung bezeichnet.

Die durch diese Kapazität speicherbare Ladung ist durch die Netto-Dotierstoffladung der Driftsteuerzone 241 begrenzt. Unter der Annahme, dass die auf die Fläche des Dielektrikums bezogene Netto-Dotierstoffladung der Driftsteuerzone 241 kleiner ist als die Durchbruchsladung $Q_{Br}$ gilt für die über dem Dielektrikum 251 anliegende Spannung U:

$$U = \frac{Q'}{C'} \leq \frac{Q_{Br}}{\varepsilon_0 \varepsilon_r} \cdot d_{Akku} \qquad (6)$$

Die maximal über dem Dielektrikum 251 anliegende Spannung steigt also mit dessen Dicke $d_{Akku}$ linear und damit in erster Näherung etwa genauso stark an, wie seine Spannungsfestigkeit. Für $SiO_2$ mit einem $\varepsilon_r$ von etwa 4 und 100nm Dicke ergibt sich eine maximale Spannungsbelastung U von 6,8V, die deutlich unter der zulässigen Dauerbelastung eines solchen Oxids von etwa 20V liegt. Die Durchbruchsladung von Silizium liegt dabei etwa bei $1,2 \cdot 10^{12}$ /cm$_2$.

Im Sperrfall baut sich in der Driftsteuerzone 241 damit eine Raumladungszone auf, deren Potentialverlauf sich von dem Potentialverlauf der Driftzone 211 maximal um den Wert der über dem Dielektrikum 251 anliegenden, durch die niedrige Dotierung der Driftsteuerzone begrenzten Spannung unterscheiden kann. Die Spannung über dem Akkumulationsdielektrikum 251 ist dabei stets geringer als dessen Durchbruchsspannung.

Die Spannungsfestigkeit des Bauelements ist maßgeblich bestimmt durch die Dotierungskonzentration der Driftzone 211 und durch deren Abmessungen in der Richtung, in der sich die Raumladungszone ausbreitet, d.h. der ersten lateralen Richtung x bei dem Bauelement gemäß Figur 111. Diese Abmessung wird nachfolgend als "Länge" der Driftzone 211 bezeichnet. Die Spannungsfestigkeit ist hierbei bei genügend schwacher Dotierung um so größer, je größer diese Länge ist und ist annähernd linear von dieser Länge abhängig, wobei bei Verwendung von Silizium als Halbleitermaterial eine Länge von etwa $10\mu$m bei einer gewünschten Spannungsfestigkeit von 100V benötigt wird. Die Spannungsfestigkeit nimmt wiederum mit zunehmender Dotierung der Driftzone 211 ab.

Der Einschaltwiderstand des erfindungsgemäßen Bauelements ist von der Ausbildung des Akkumulationskanals abhängig und nur in geringem Maß von der Dotierungskonzentration der Driftzone 211 abhängig. Die Driftzone 211 kann bei dem erfindungsgemäßen Bauelement zugunsten einer hohen Spannungsfestigkeit niedrig dotiert werden, während ein niedriger Einschaltwiderstand dank des durch die Driftsteuerzone 241 gesteuerten Akkumulationskanals erreicht wird.

Die maximale Dotierstoffkonzentration N in der Driftzone 211 hängt dabei von der zu sperrenden Spannung $U_{max}$ und der kritischen elektrischen Feldstärke $E_{krit}$ ab, bei der im Halbleitermaterial im Sperrfall der Durchbruch wegen Lawinenmultiplikation (Avalanche-Durchbruch) einsetzt und welche bei Silizium etwa bei 200kV/cm liegt. Für einseitig abrupte pn-Übergänge gilt folgende Beziehung zwischen Dotierung und Sperrspannung:

$$N \le \frac{Q_{Br} \cdot E_{krit}}{2 \cdot e \cdot U_{max}} \qquad (7)$$

Für Silizium-Bauelemente mit 600V Sperrfähigkeit muss die Donator- bzw. Akzeptordotierung N der Driftzone 211 also unter etwa $2 \cdot 10^{14}$/cm$^3$ liegen.

Da die Spannungsbelastung des Akkumulationsdielektrikums 251 aus den zuvor erläuterten Gründen stets unter der maximal zulässigen Spannungsbelastung des Akkumulationsdielektrikums 251 liegt, begrenzt das Akkumulationsdielektrikum 251 bei den zuvor angegebenen typischen Dimensionierungen die Spannungsfestigkeit des Bauelements - anders als bei bekannten Feldplattenbauelementen - nicht.

Bei dem zuvor anhand der Figuren 111A bis 111D erläuterten Bauelement, sind die Driftsteuerzonen 241 ausschließlich an die Drainzone 214 angeschlossen. Bei sperrend angesteuertem Bauelement können in den Driftsteuerzonen 241, die in dem Beispiel n-dotiert sind, bedingt durch eine thermische Generation von Elektronen-Loch-Paaren Löcher akkumuliert werden, die nicht abfließen können. Über der Zeit kann eine dadurch akkumulierte Ladungsmenge so weit ansteigen, dass die maximal zulässige Feldstärke des Akkumulationsdielektrikums 251 erreicht wird und diese Dielektrikum 251 durchbricht.

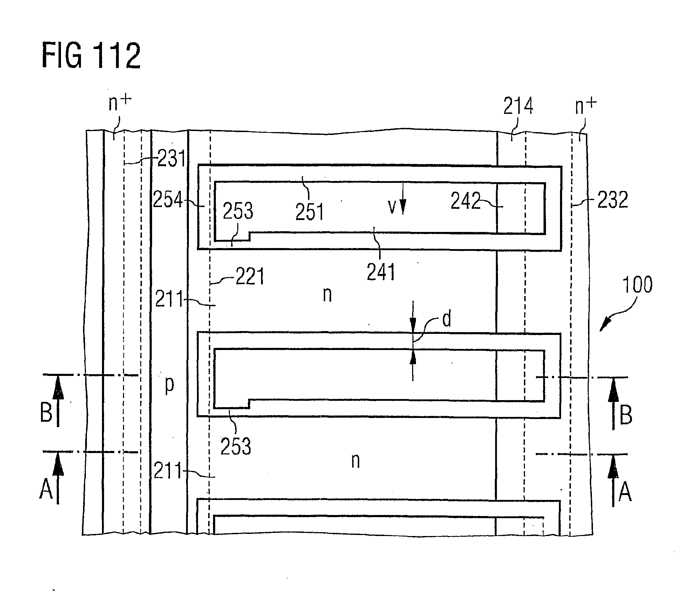

Bezugnehmend auf Figur 112, die eine Abwandlung des Bauelements gemäß Figur 111 zeigt, kann dies dadurch vermieden werden, dass das Akkumulationsdielektrikum 251 abschnittsweise als Tunneldielektrikum 253 ausgebildet ist, welches einen Abfluss der akkumulierten Ladungsträger in die Driftzone 211 ermöglicht, sobald die Durchbruchfeldstärke des Tunneldielektrikums 253 erreicht ist und noch bevor die Durchbruchfeldstärke des übrigen Akkumulationsdielektrikums 251 erreicht ist. Bei dem in Figur 112 dargestellten Ausführungsbeispiel ist das Tunneldielektrikum 253 im Bereich des der Bodyzone 212 zugewandten Endes der Driftsteuerzonen 241 angeordnet.

Als Tunneldielektrikum eignen sich beispielsweise Schichten aus Siliziumoxid ($SiO_2$) oder Siliziumnitrid ($Si_3N_4$) oder auch mehrlagige Schichten aus Siliziumoxid und Siliziumnitrid. Ebenfalls möglich sind Misch-Dielektrika aus Silizium, Sauerstoff und Stickstoff. Typische Tunnel-Durchbruchsfeldstärken liegen im Bereich von 1...2V/nm. Für ein Tunneloxid 253 mit einer Dicke von 13nm ergeben sich dadurch maximale Spannungen von 13...26V, die oberhalb der während des normalen Sperrbetriebs an dem Akkumulationsdielektrikum 251 anliegenden Spannung liegt und die von einem Akkumulationsdielektrikum 251 aus Siliziumoxid mit einer Dicke von beispielsweise 100nm problemlos ausgehalten wird.

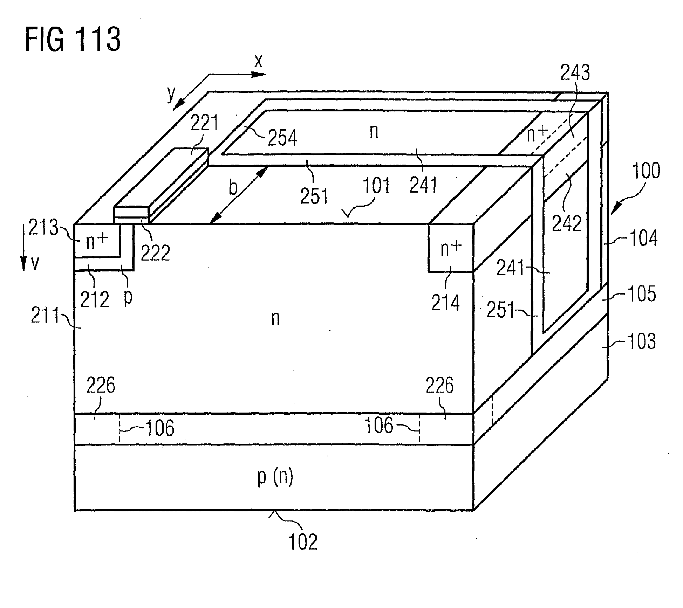

Figur 113 zeigt ein gegenüber dem Bauelement gemäß Figur 111 abgewandeltes Bauelement ausschnittsweise in perspektivischer Darstellung. Entsprechend der Darstellung in Figur 111D sind aus Gründen der Übersichtlichkeit die Drain- und Sourceelektroden, die die Drain- und Sourcezonen 214, 213 kontaktieren, bei dem Bauelement in Figur 113 nicht dargestellt.

Der Halbleiterkörper 100 ist bei diesem Bauelement als sogenanntes SOI-Substrat realisiert und umfasst zwischen dem Halbleitersubstrat 103 und der Halbleiterschicht 104, in der die Driftzone 211 und die Driftsteuerzone 241 sowie die Source- und Drainzonen 213, 214 integriert sind, eine durchgehende Isolationsschicht 105. Diese Isolationsschicht, die beispielsweise aus einem Halbleiteroxid besteht, isoliert hierbei sowohl die Driftzone 211 als auch die Driftsteuerzone 241 gegenüber dem Substrat 103. Das Halbleitersubstrat 103 kann vom selben Leitungstyp wie die Halbleiterschicht 104 oder von einem zu dem Leitungstyp der Halbleiterschicht 104 komplementären Leitungstyp sein.

Um im Sperrbetrieb eine unerwünschte Ladungsträgerakkumulation in dem Substrat 103 an der Grenzfläche zu der Isolationsschicht 105 zu verhindern, können unter der Sourcezone 213 und/oder unter der Drainzone 214 Aussparungen 106 in der Isolationsschicht 105 vorgesehen werden. Diese Aussparungen 106 sind mit einem dotierten oder undotierten Halbleitermaterial ausgefüllt, das eine Verbindungszone 226 zwischen der Driftzone 211 und dem Substrat 103 bildet. Die Verbindungszone 226 unter der Drainzone 214 bzw. Drainelektrode ist dabei geeignet, in dem Substrat 103 an der Grenzfläche zu der Isolationsschicht 105 akkumulierte Elektronen zur Drainzone 214 abzuführen. Im Falle von im Substrat 103 an der Grenzfläche zur Isolationsschicht 105 akkumulierten Löchern ist die Verbindungszone 226 unter der Sourcezone 213 geeignet, diese Löcher zur Sourcezone 213 abzuführen.

Die Gateelektrode 221 ist bei dem Bauelement gemäß Figur 113 entsprechend dem Bauelement in Figur 111 oberhalb der Vorderseite 101 des Halbleiterkörpers 100 angeordnet. Diese Gateelektrode 221 und das darunter liegende Gatedielektrikum sind streifenförmig ausgebildet und erstrecken sich in dem Beispiel in der zweiten lateralen Richtung y nur jeweils über die Breite b der einzelnen Abschnitte der Driftzone. Diese Breite b der Driftzone 211 ist gegeben durch den gegenseitigen Abstand zweier unmittelbar benachbarter Driftsteuerzonen 241. In nicht näher dargestellter Weise kann sich die Gateelektrode 221 in der zweiten lateralen Richtung y über den gesamten Bereich des Halbleiterkörpers 100 oder Teile davon erstrecken, in dem Driftsteuerzonen 241 und Abschnitte der Driftzone 211 angeordnet sind. In diesem Zusammenhang sei angemerkt, dass eine seitliche Überlappung der Gateelektrode 221 über Driftsteuerzone 241 erlaubt ist, genauso wie eine Realisierung der Gateelektrode 221 derart, dass diese in der zweiten lateralen Richtung y schmaler ist als die Driftzone 211 in dieser Richtung.

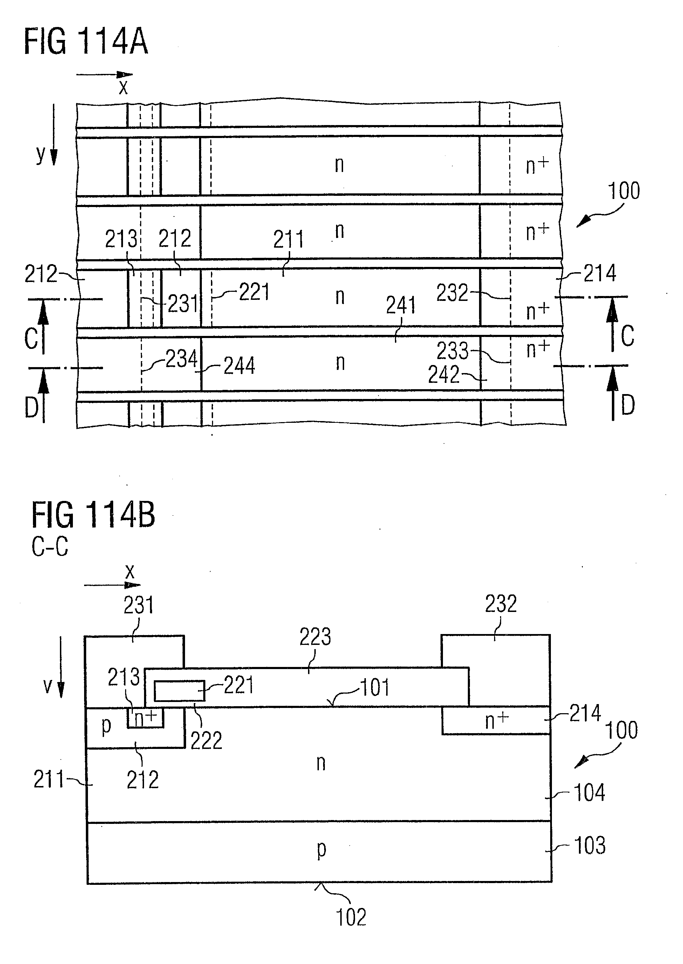

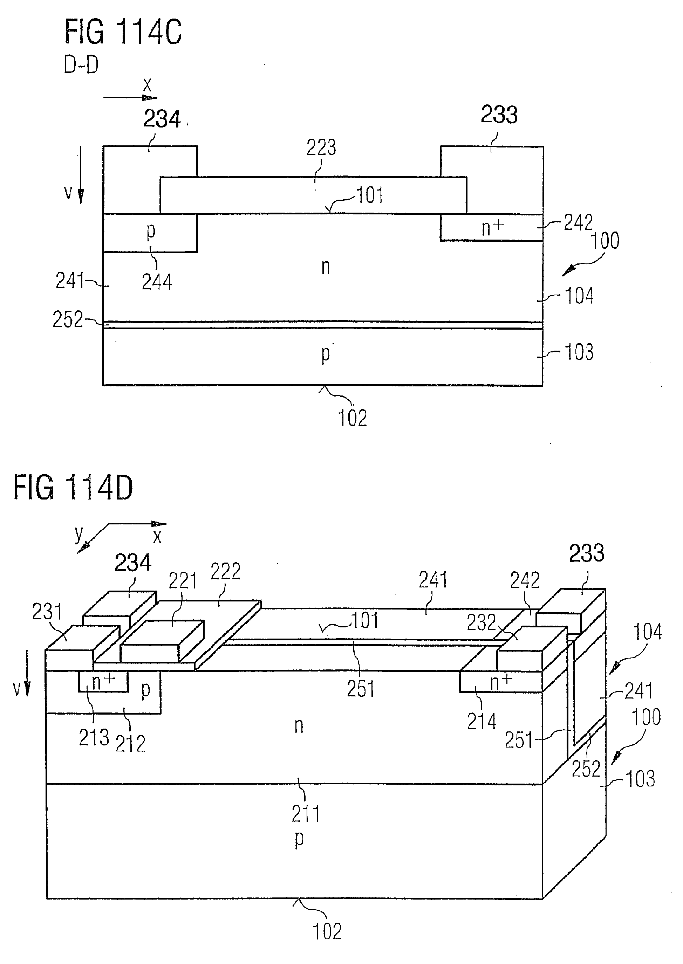

Die Figuren 114A bis 114D zeigen eine weitere Abwandlung des in Figur 111 dargestellten erfindungsgemäßen Leistungs-MOSFET. Entsprechend der Figuren 111A bis 111D zeigt Figur 114A das Bauelement in einer nahe der Vorderseite 101 gelegenen lateralen Schnittebene bzw. in Draufsicht auf die Vorderseite 101, die Figuren 114B und 114C zeigen das Bauelement in zwei unterschiedlichen vertikalen Schnittebenen C-C bzw. D-D, und Figur 114D zeigt das Bauelement in perspektivischer Schnittdarstellung.

Während die Driftsteuerzonen 241 bei dem Bauelement gemäß Figur 111 lediglich eine Anschlusszone 242 zum Anschließen an die Drainzone 214 bzw. die Drainelektrode 232 aufweist, weisen die Driftsteuerzonen 241 des Bauelements gemäß Figur 114 jeweils eine zweite Anschlusszone 244 auf, die in der ersten lateralen Richtung x beabstandet zu der ersten Anschlusszone 242 angeordnet ist. Diese zweiten Anschlusszonen 244 können in noch zu erläuternder Weise vom gleichen Leitungstyp wie die Dotierung der Driftsteuerzone 241 sein, die zweiten Anschlusszonen 244 können jedoch auch komplementär zu der Dotierung der Driftsteuerzone 241 dotiert sein. In dem dargestellten Beispiel stimmen die geometrischen Abmessungen der zweiten Anschlusszonen 244 mit den geometrischen Abmessungen der in der zweiten lateralen Richtung y jeweils benachbart angeordneten Bodyzonen 212 überein. Die zweiten Anschlusszonen 244 beginnen in der ersten lateralen Richtung x somit auf Höhe der Bodyzonen 212 und erstrecken sich in der vertikalen Richtung v genauso tief in den Halbleiterkörper 100 hinein, wie die Bodyzonen 212. Dies kann dadurch erreicht werden, dass die Bodyzonen 212 und die zweiten Anschlusszonen 244 durch gleiche Verfahrensschritte, d. h. gleiche Implantations- und/oder Diffusionsschritte, hergestellt werden.

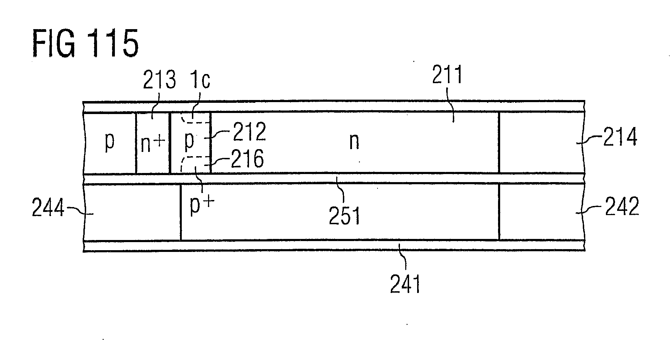

Es sei darauf hingewiesen, dass die Abmessungen der zweiten Anschlusszonen 244 in lateraler und vertikaler Richtung des Halbleiterkörpers 100 jedoch nicht mit den Abmessungen der Bodyzonen 212 übereinstimmen müssen. Insbesondere besteht die Möglichkeit, dass sich die Driftsteuerzone 241 und die Bodyzone 212 in der ersten lateralen Richtung x des Halbleiterkörpers 100 überlappen, wie dies in Figur 115 in einer der Schnittdarstellung gemäß Figur 114A entsprechenden Schnittdarstellung dargestellt ist. Um hierbei Auswirkungen der Driftsteuerzone 241 auf die Schalteigenschaften des Bauelements zu vermeiden, sind benachbart zu der Driftsteuerzone 241 in der Bodyzone 212 hochdotierte Halbleiterzonen 216 vorhanden, die vom gleichen Leitungstyp wie die Bodyzone 212 sind.

Die Grenzen der zweiten Anschlusszonen 244 und der hochdotierten Halbleiterzonen 216 können in der ersten lateralen Richtung x auch, anders als in Figur 115 dargestellt, gegeneinander versetzt sein.

Bei dem Bauelement gemäß Figur 114A sind die Sourcezone 213 und die Bodyzone 212 gemeinsam durch die Sourceelektrode 231 kontaktiert, während die Drainzone 214 bzw. die mehreren Drainzonenabschnitte durch eine Drainelektrode bzw. durch Drainelektrodenabschnitte 232 kontaktiert sind. Die ersten Anschlusszonen 242 der Driftsteuerzonen 241 sind in dem Beispiel jeweils an erste Anschlusselektroden 233 angeschlossen, deren Verschaltung mit den Drainelektroden 232 noch erläutert werden wird. Die zweiten Anschlusszonen 244 der Driftsteuerzonen 241 sind an zweite Anschlusselektroden der Driftsteuerzonen 241 angeschlossen, deren weitere Verschaltung ebenfalls noch erläutert werden wird.

Bei dem in den Figuren 114A bis 114D dargestellten Leistungs-MOSFET weist die Gateelektrode 221 mehrere Gateelektrodenabschnitte auf, die sich in der zweiten lateralen Richtung y jeweils nur über die Breite der einzelnen Driftzonen 211 erstrecken. Das Gatedielektrikum 222 kann Bezug nehmend auf Figur 114D dabei als durchgehende streifenförmige Dielektrikumsschicht ausgebildet sein. Das Bezugszeichen 223 bezeichnet in den Figuren 114B und 114C eine Isolations- bzw. Passivierungsschicht, welche die Gateelektrode 221 gegenüber der Sourceelektrode 231 isoliert und die die Driftzonen 211 und die Driftsteuerzonen 241 oberhalb der Vorderseite 101 des Halbleiterkörpers überdeckt.

In nicht näher dargestellter Weise können die Abmessungen der Gateelektroden 221 und / oder des Gatedielektrikums 222 in der zweiten lateralen Richtung y auch von den Abmessungen der Driftzonen 211 in dieser Richtung abweichen. So kann insbesondere eine gemeinsame Gateelektrode 221 vorgesehen sein, die - entsprechend des Gatedielektrikums 222 in Figur 114D als durchgehende Elektrodenschicht realisiert ist.

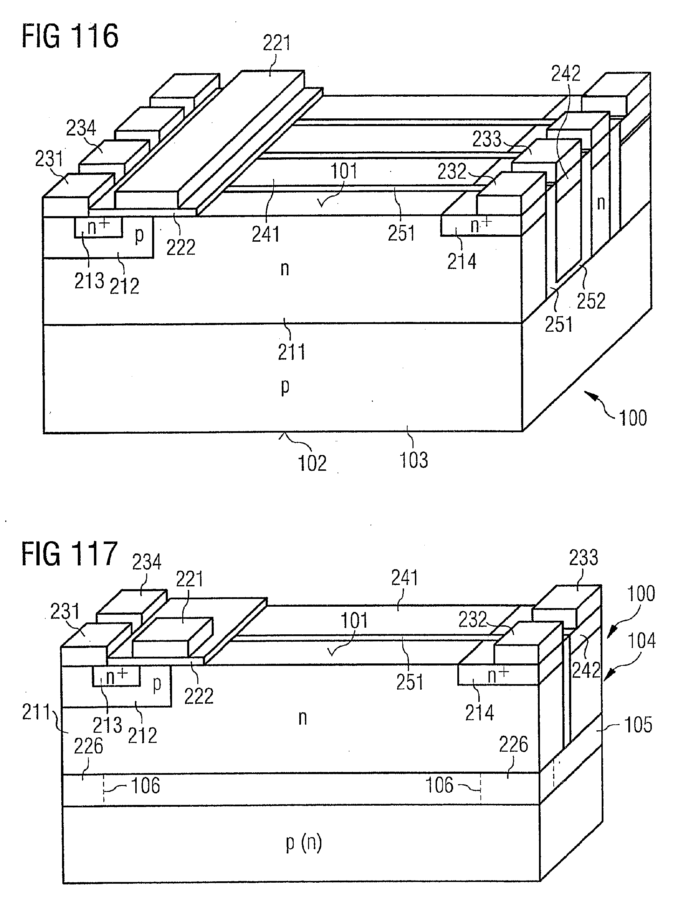

Bezug nehmend auf Figur 116, die ein gegenüber dem Bauelement gemäß Figur 114 abgewandeltes Bauelement zeigt, kann die Gateelektrode 221 in der zweiten lateralen Richtung y auch als durchgehende streifenförmige Elektrode 221 realisiert sein, die sich in dieser zweiten lateralen Richtung y somit sowohl über die Bodyzonen 212 als auch über die Driftsteuerzonen 241 bzw. deren zweite Anschlusszonen (in der Darstellung gemäß Figur 116 nicht sichtbar) verläuft.

Figur 117 zeigt eine weitere Abwandlung des in Figur 114 dargestellten Leistungs-MOSFET. Bei diesem Bauelement ist der Halbleiterkörper entsprechend dem Bauelement in Figur 113 als SOI-Substrat realisiert und weist ein Halbleitersubstrat 103, eine auf dem Halbleitersubstrat 103 angeordnete Isolationsschicht 105 sowie eine auf der Isolationsschicht angeordnete Halbleiterschicht 104 auf, in der die Driftzonen 211, die Driftsteuerzonen 241, die Sourcezonen 213, die Bodyzonen 212, die Drainzonen 214 sowie die Anschlusszonen 242, 244 der Driftsteuerzonen 241 angeordnet sind. Die Gateelektrode 221 erstreckt sich bei dem Bauelement gemäß Figur 117 jeweils nur über die Breite einer Driftzone 211, kann jedoch beliebig von der Breite der Driftzone 211 abweichen und kann entsprechend des Bauelements gemäß Figur 116 insbesondere auch als durchgehende streifenförmige Gateelektrode realisiert sein (nicht dargestellt).

Die Driftsteuerzone 241 bzw. deren erste und zweite Anschlusselektroden 233, 234 können auf unterschiedliche Weise kontaktiert werden, wie nachfolgend erläutert wird.

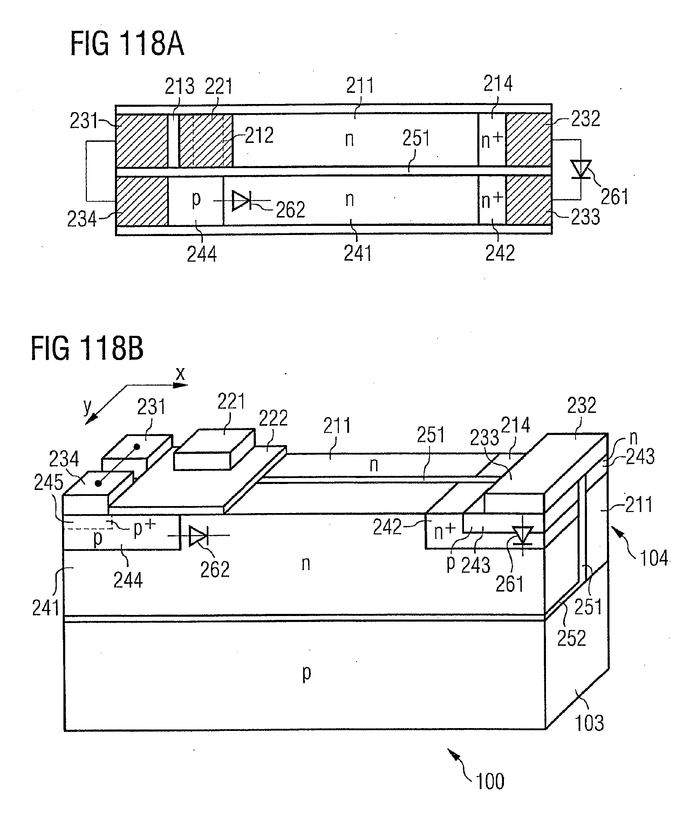

Bei einer ersten in den Figuren 118A und 118B dargestellten Ausführungsform ist vorgesehen, die Driftsteuerzone 241 an ihrem drainseitigen Ende über eine erste Diode 261 an die Drainzone 214 bzw. die Drainelektrode 232 und an ihrem sourceseitigen Ende über eine zweite Diode 262 an die Sourcezone bzw. die Sourceelektrode 231 anzuschließen. Diese beiden Dioden 261, 262 sind in dem Beispiel in dem Halbleiterkörper 100 integriert. Die erste Diode 261 ist durch die im Zusammenhang mit Figur 111 erläuterten Anschlusszonen 242, 243 gebildet, von denen eine 242 vom gleichen Leitungstyp wie die Driftsteuerzone 241 und eine 243 komplementär zu der Driftsteuerzone 241 dotiert ist. Die Drainelektrode 232 und die erste Anschlusselektrode 233 sind bei diesem Bauelement als gemeinsame Elektrode realisiert, die streifenförmig ausgebildet ist und die Driftzonen 214 und die komplementär zu den ersten Anschlusszonen 242 dotierten Anschlusszonen 243 kontaktiert.

Die erste Diode 261 kann auch als externe Diode (nicht dargestellt) zwischen der Drainelektrode 232 und der ersten Anschlusselektrode 234 realisiert sein.

Die zweite Diode 262 ist in dem Beispiel dadurch realisiert, dass die zweite Anschlusszone 244 der Driftsteuerzonen 241 als komplementär zu den Driftsteuerzonen 241 dotierte Halbleiterzonen realisiert ist. Die Sourceelektrode 231 und die zweite Anschlusselektrode 234 sind dabei elektrisch leitend miteinander verbunden und können entsprechend der in Figur 118B dargestellten Drainelektrode 232 als gemeinsame streifenförmige Elektrode realisiert sein (nicht dargestellt).

Zur Reduktion eines Kontaktwiderstandes zwischen der zweiten Anschlusselektrode 234 und der zweiten Anschlusszone 244 kann optional eine höher dotierte Halbleiterzone 245 innerhalb der zweiten Anschlusszone 244 vorhanden sein, die durch die zweite Anschlusselektrode 234 kontaktiert ist.

Die Funktionsweise des in den Figuren 118A und 118B dargestellten Bauelements wird nachfolgend erläutert.

Der dargestellte n-Kanal-MOSFET leitet bei Anlegen eines geeigneten Ansteuerpotentials an die Gateelektrode 221, durch das sich ein Inversionskanal in der Bodyzone 212 zwischen der Sourcezone 213 und der Driftzone 211 ausbreitet, und bei Anlegen einer positiven Drain-Source-Spannung zwischen der Drainelektrode 232 und der Sourceelektrode 231. Die erste Diode 261 ist während dieses Betriebszustandes in Flussrichtung gepolt, während die zweite Diode 262 in Sperrrichtung gepolt ist. Die zweite Diode 262 ist dabei so dimensioniert, dass deren Spannungsfestigkeit höher ist als die bei leitend angesteuertem Bauelement anliegende Drain-Source-Spannung. Bedingt durch die während des leitenden Betriebszustandes in Flussrichtung gepolte erste Diode 261 entspricht das elektrische Potential der Driftsteuerzone 241 dem Drain-Potential abzüglich der Durchlassspannung der ersten Diode 261. Dieses Potential der Driftsteuerzone 241 ist wegen des in der Driftzone 211 fließenden Laststroms und des dadurch in der Driftzone 211 erzeugten Bahnspannungsabfalls über weite Bereiche der Driftzone 211 größer als das elektrische Potential in der Driftzone 211, wodurch der über dem Akkumulationsdielektrikum 251 anliegende Spannungsabfall die Ausbildung des Akkumulationskanals entlang des Akkumulationsdielektrikums 251 in der Driftzone 211 bewirkt.

Bei sperrend angesteuertem Bauelement, also bei einer hohen positiven Drain-Source-Spannung, jedoch nicht vorhandenem Inversionskanal, breitet sich in der Driftsteuerzone 211 eine Raumladungszone aus. Die Spannung über dem Akkumulationsdielektrikum 251 ist in bereits erläuterter Weise durch die geringe Dotierstoffmenge in den Driftsteuerzonen 241 in der zweiten lateralen Richtung y nach oben hin begrenzt. Die zweite Diode 262 ist auch während dieses Betriebszustandes in Sperrrichtung gepolt, wobei die sich bei sperrendem Bauelement in der Driftsteuerzone 241 ausbreitende, durch die Driftzone 211 gesteuerte Raumladungszone, die zweite Diode 262 vor einem Spannungsdurchbruch schützt. Vorzugsweise besitzen die zweite Diode 262 gegen die Driftsteuerzone 241 und die Bodyzone 212 gegen die Driftzone 211 eine ähnlich hohe Sperrfähigkeit, insbesondere wenn die zweite Diode 262 und die Bodyzone 212 während der gleichen Prozess-Schritte hergestellt worden sind.

Die zweite Diode 262, über welche die Driftsteuerzone 241 an die Sourcezone bzw. Sourceelektrode 231 angeschlossen ist, ermöglicht bei dem in den Figuren 118A und 118B dargestellten Bauelement im Sperrbetriebsfall ein Abfließen thermisch generierter Ladungsträger aus der Driftsteuerzone 241, wodurch ein Spannungsdurchbruch des Akkumulationsdielektrikums 251 in Folge akkumulierter thermischer Ladungsträger verhindert wird.

Eine zweite Funktion (d.h. Einsperren der Ladung, siehe unten) tritt hier nicht ein, da generierte Löcher immer über das p-Gebiet abfließen können. Wenn - wie im dargestellten Fall - das p-Gebiet direkt mit der Source verbunden ist, kommt es zu keiner Ladungsspeicherung. Wenn das p-Gebiet jedoch über eine externe Diode oder mit einem Kondensator und ggf. einer weiteren Diode zur Begrenzung der Spannung über dem Kondensator mit der Source verbunden ist, tritt der beschriebene Effekt auf.

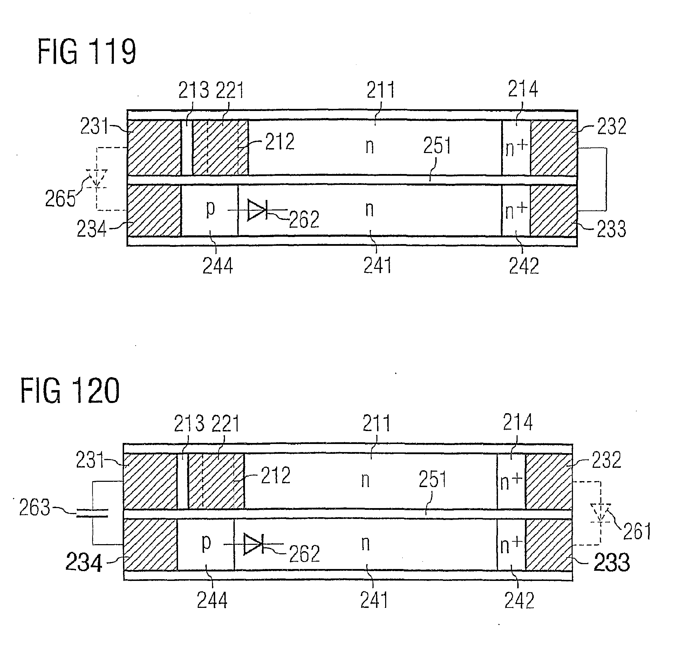

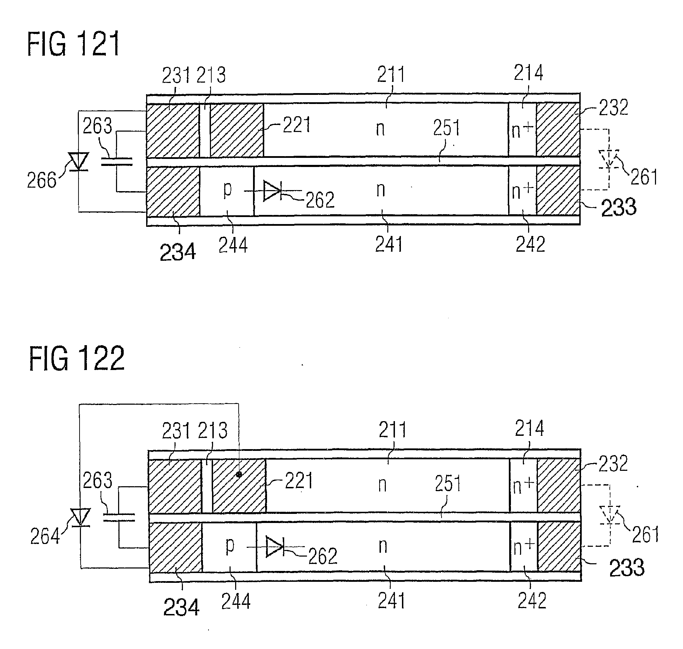

Ein "Einsperren" der Ladung in der Driftsteuerzone 241 funktioniert in noch erläuterter Weise dann, wenn eine Verschaltung entsprechend der Figuren 120 oder 121 vorliegt. Die Dioden 261 und/oder 266 können dabei sowohl integriert oder extern eingebaut werden. Im unteren bzw. rechten Teil der Driftsteuerzone 241 muss lediglich die $n^+$-dotierte Zone 242 vorhanden sein.

Die erste Diode 261 verhindert bei leitend angesteuertem Bauelement hierbei ein Abfließen der Löcher aus der Driftsteuerzone 241 an die Drainelektrode 232.

Bezug nehmend auf Figur 119 kann auf diese erste Diode 261 auch verzichtet werden. Die Folge hiervon sind jedoch erhöhte Durchlassverluste, da keine akkumulierte Löcherladung in der Driftsteuerzone 241 auftreten kann, sondern lediglich der Bahnspannungsabfall in der Driftzone und eine entsprechend erhöhte Drainspannung für die Ausbildung eines Kanals genutzt werden kann.

Optional besteht die Möglichkeit, zwischen die Sourceelektrode 231 und die Anschlusselektrode 234 eine weitere Diode 265 zu schalten, die in Figur 119 gestrichelt dargestellt ist. Diese weitere Diode 265 kann - entsprechend der Diode 261 - als internes oder externes Bauelement realisiert werden und ermöglicht, dass bei sperrend angesteuertem Bauelement in der komplementär zu der Driftsteuerzone 241 dotierten zweiten Anschlusszone 244 p-Ladungsträger, d. h. Löcher, in solchen Bereichen des Akkumulationsdielektrikums 251 akkumuliert werden, die benachbart zu der Bodyzone 212 (deren Position gestrichelt dargestellt ist) liegen. Diese Löcher werden bei einer nachfolgenden leitenden Ansteuerung des Bauelements in der Driftsteuerzone 241 benötigt, um den Akkumulationskanal in der Driftzone 211 entlang des Akkumulationsdielektrikums 251 zu steuern. Bei einem solchen Einschalten werden diese Löcher aus dem nahe der Bodyzone 212 gelegenen Bereich der Driftsteuerzone abgezogen und in Richtung der Drainzone 214 bzw. der ersten Anschlusszone 242 der Driftsteuerzone verschoben. Die Löcherladung aus der als Speicherkapazität bei sperrend angesteuertem Bauelement funktionierenden zweiten Diode 262 werden bei nachfolgend leitend angesteuertem Bauelement in die durch die Driftzone 211, das Akkumulationsdielektrikum 251 und die Driftsteuerzone 241 gebildete "Akkumulationskapazität" verschoben.

Der zuvor erläuterte Ladungsspeichereffekt kann bezug nehmend auf Figur 120 auch durch eine Kapazität 263 erreicht werden, die zwischen die Sourceelektrode 231 und die zweite Anschlusselektrode 233 geschaltet ist. Diese Kapazität, die in Figur 120 schematisch als Kondensator 263 dargestellt ist, kann auf beliebige Weise innerhalb oder außerhalb des Halbleiterkörpers realisiert werden.

Zur Begrenzung der Spannung über diesem Kondensator 263, der über den Leckstrom im Sperrfall geladen wird, kann bezugnehmend auf Figur 121 eine Diode 266 parallel zu dem Kondensator 263 vorgesehen werden, deren Durchbruchspannung an die Spannungsfestigkeit des Kondensators 263 angepasst ist.

Sowohl bei dem Bauelement gemäß Figur 120 als auch bei dem Bauelement gemäß Figur 121 ist die erste Diode 261 zwischen dem drainseitigen Ende der Driftsteuerzone 241 und der Drainzone 214 bzw. Drainelektrode 232 optional vorhanden und daher in den Figuren gestrichelt dargestellt. Diese Diode 261 kann insbesondere - wie die Diode 266 - über Leitbahnen mit den Anschlusselektroden 233 bzw. 234 verbunden werden und vorzugsweise als Diodenstruktur im monokristallinen Halbleitermaterial oder als sog. "Polysilizium-Diode" oberhalb des monokristallinen Halbleiterkörpers 100 angeordnet werden.

Bei einem weiteren, in Figur 122 dargestellten Ausführungsbeispiel ist vorgesehen, die externe Speicherkapazität 263 über eine weitere Diode 264 an die Gateelektrode 221 anzuschließen. Die Anode dieser weiteren Diode 264 ist dabei an die Gateelektrode 221 und die Kathode ist an die zweite Anschlusselektrode 233 bzw. an den dieser zweiten Anschlusselektrode 233 zugewandten Anschluss der Kapazität 263 angeschlossen. Die weitere Diode 264 bewirkt, dass p-Ladungsträger aus dem Gate-Ansteuerkreis nachgeliefert werden. Selbst bei Vorhandensein der ersten Diode 261, die ein Abfließen von Löchern aus der Driftsteuerzone 241 an die Drainelektrode 232 verhindert, gehen unvermeidlich p-Ladungsträger durch Rekombination oder über Leckströme verloren und müssen daher nachgeliefert werden. Die weitere Diode 264 bewirkt insbesondere, dass die Kapazität 263 beim ersten leitenden Ansteuern des MOSFETs aus dem Gatekreis aufgeladen wird, sofern sie nicht bereits vorher durch einen thermisch in der Driftsteuerzone 241 generierten Sperrstrom aufgeladen wurde. Die Spannungsbegrenzungs-Diode 265 kann hierbei optional parallel zu dem Kondensator 263 geschaltet sein.

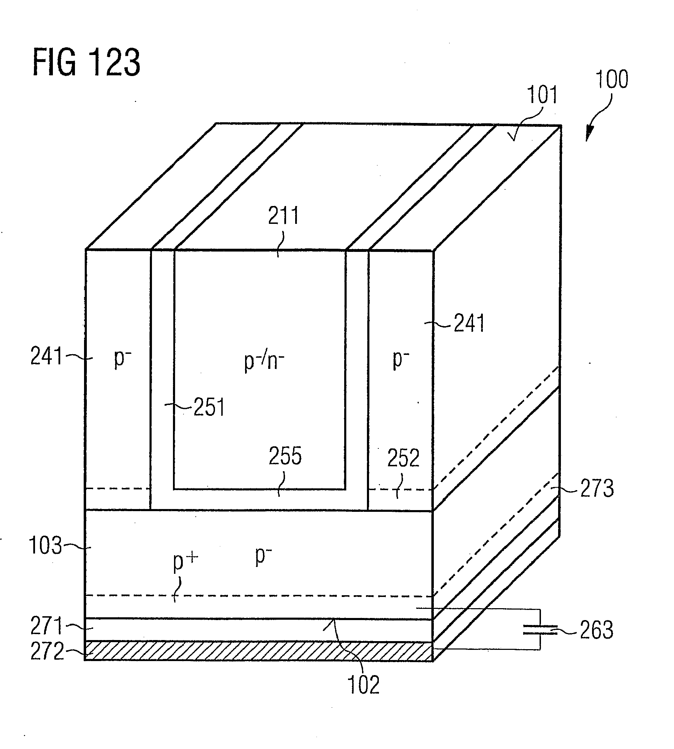

Verschiedene Möglichkeiten zur Integration der "externen" Kapazität 263 in dem Halbleiterkörper 100 werden nachfolgend anhand der Figuren 123 bis 126 erläutert.

Figur 123 zeigt ausschnittsweise einen perspektivischen Querschnitt durch einen Halbleiterkörper mit einer darin integrierten Transistorstruktur eines lateralen MOSFETs. Aus Gründen der Übersichtlichkeit sind hierbei nur eine lateral verlaufende Driftzone 211, eine lateral verlaufende Driftsteuerzone 241 und das zwischen der Driftzone 211 und der Driftsteuerzone 241 angeordnete Akkumulationsdielektrikum 251 dargestellt. Die Kapazität 263 ist hierbei durch eine auf die Rückseite 102 des Halbleiterkörpers 100 bzw. des Halbleitersubstrats 103 aufgebrachte Dielektrikumsschicht 271, das Halbleitersubstrat 103 und eine auf die Dielektrikumsschicht 271 aufgebrachte Elektrodenschicht 272 gebildet. Die Elektrodenschicht 272 ist hierbei in nicht näher dargestellter Weise an die Sourceelektrode des MOSFET angeschlossen, wodurch ein Anschluss der Kapazität 263 auf Source-Potential liegt. Das Halbleitersubstrat 103 kann unmittelbar an die Driftsteuerzone 241 angrenzen, wobei die Driftsteuerzone 241 und das Halbleitersubstrat 103 in diesem Fall vom gleichen Leitungstyp sind. Ein zweiter Anschluss der Kapazität ist dabei durch das Substrat 103 gebildet und unmittelbar an die Driftsteuerzone 241 angeschlossen.

Alternativ kann zwischen dem Halbleitersubstrat 103 und der Driftsteuerzone 241 eine Dielektrikumsschicht 252 angeordnet sein. In diesem Fall ist der zweite Anschluss der Kapazität über eine nicht näher dargestellte Verbindungsleitung an die Driftsteuerzone 241 anzuschließen.

Optional kann auf der Seite des Substrats 103 eine höher als das Substrat 103 dotierte Halbleiterschicht 273 vorhanden sein, die sich unmittelbar an das Akkumulationsdielektrikum 271 anschließt und die Ausdehnung einer Raumladungszone vom Dielektrikum 271 in das Substrat 103 verhindert und so eine gleich bleibend große Speicherkapazität gewährleistet. Die Dotierungskonzentration des Substrats 103 kann hierbei der Dotierungskonzentration der Driftsteuerzone 241 entsprechen. Sie muss auf jeden Fall so niedrig sein, dass unter dem Drainbereich des Transistors in etwa die ganze Sperrspannung des Bauelements aufgenommen werden kann. Alternativ besteht auch die Möglichkeit, das Halbleitersubstrat 103 etwas höher (im Rahmen der oben genannten Bedingung) als die Driftsteuerzone 241 zu dotieren. Auf die höher dotierte Zwischenzone 273 kann dann verzichtet werden. Darüber hinaus besteht auch die Möglichkeit, die Driftsteuerzone 241 komplementär zu dem Halbleitersubstrat zu dotieren.

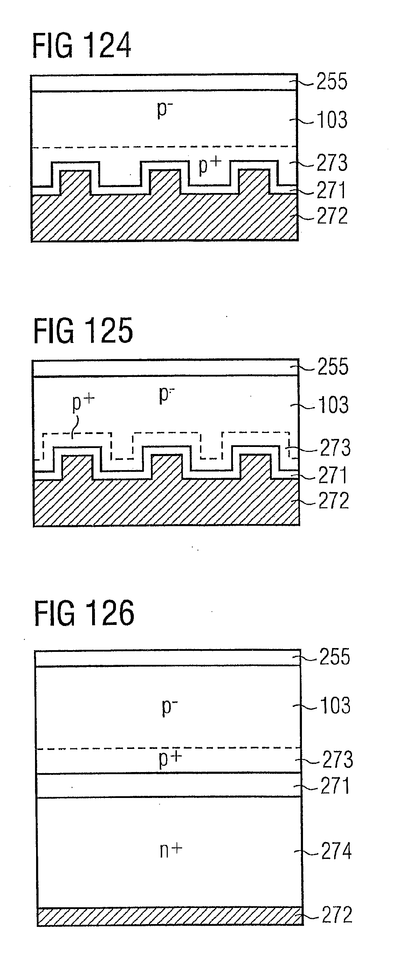

Zur Steigerung der Speicherkapazität besteht bezugnehmend auf die Figuren 124 und 125 die Möglichkeit, das Speicherdielektrikum 271 nicht planar sondern in der lateralen Ebene strukturiert, beispielsweise wellenförmig auszubilden. Die optional vorhandene höher dotierte Zone 273 kann hierbei der Struktur des Dielektrikums 271 folgen (Figur 125) oder so realisiert sein, dass eine im wesentlichen planare Grenzfläche zu dem Halbleitersubstrat 103 vorhanden ist.

Die externe Kapazität 263 kann bezugnehmend auf Figur 126 auch durch ein Waferbonding-Verfahren realisiert werden. Hierbei wird ein Halbleiterkörper, auf den eine Dielektrikumsschicht 271 aufgebracht ist, mittels eines Bonding-Verfahrens, das beispielsweise eine Temperaturbehandlung umfasst, auf die Rückseite des Halbleitersubstrats gebondet. Das Substrat kann hierbei im Bereich der Rückseite höher dotiert sein, um die höher dotierte Zwischenzone 273 zu erhalten. Eine Elektrodenschicht 272 auf der dem Substrat 103 abgewandten Seite des gebondeten Halbleiterkörpers gewährleistet einen guten elektrischen Anschluss der Speicherkapazität.

Bei den zuvor erläuterten Bauelementen, bei denen die Gateelektrode 221 oberhalb der Vorderseite 101 des Halbleiterkörpers angeordnet ist, verläuft der Inversionskanal in der Bodyzone 212 unterhalb des Gatedielektrikums 222 im Bereich der Vorderseite 101 des Halbleiterkörpers 100. Die effektive Kanalweite ist dabei in etwa bestimmt durch die gesamte Breite der Driftzone 211, d. h. die Summe der Breiten b (Figur 111A) der einzelnen zwischen zwei Driftsteuerzonen 241 liegenden Driftzonenabschnitte 211. Bei leitend angesteuertem Bauelement konzentriert sich ein Stromfluss innerhalb der Driftzone 211 in den Akkumulationskanälen, die sich in der Driftzone 211 entlang des Akkumulationsdielektrikums 251 ausbilden. Die Abmessungen dieser Akkumulationszone sind in einer Richtung senkrecht zu dem Akkumulationsdielektrikum 251, also in der zweiten lateralen Richtung y bei den zuvor erläuterten Bauelementen sehr gering, so dass bei dem erfindungsgemäßen Bauelement der gegenseitige Abstand zweier Driftsteuerzonen 214 bzw. die Breite b der einzelnen Driftzonenabschnitte 211 sehr gering gewählt und annähernd bis auf den zweifachen Wert der Abmessungen des Akkumulationskanals reduziert werden kann, ohne den Einschaltwiderstand des Bauelements wesentlich zu beeinflussen. Mit zunehmender Verringerung des Abstandes zweier Driftsteuerzonen 241, d. h. mit einer zunehmenden Verringerung der Breite b eines Driftzonenabschnitts 211 verringert sich bei den zuvor erläuterten Bauelementen auch die Kanalweite des für den jeweiligen Driftzonenabschnitt 211 wirksamen Inversionskanals der Bodyzone 212 und erhöhen so den Einschaltwiderstand. Die Abmessungen des Akkumulationskanals in der zweiten lateralen Richtung liegen beispielsweise im Bereich von weniger als 50 nm.

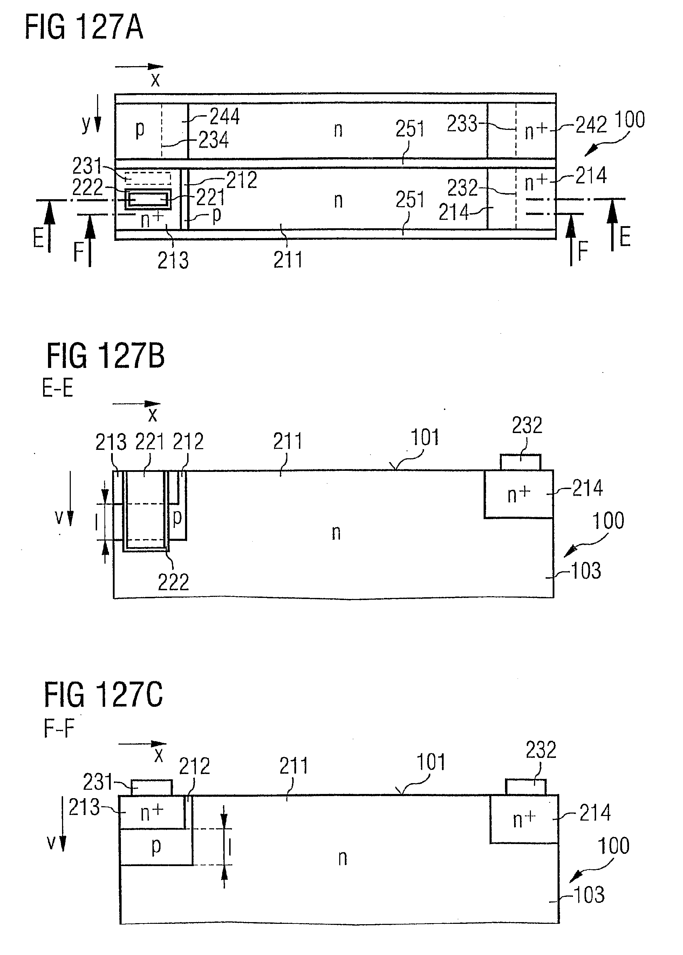

Dieses Problem wird bei den nachfolgend anhand der Figuren 127 bis 129 erläuterten Bauelementen vermieden, bei denen sich die Gateelektrode 221 ausgehend von der Vorderseite 101 des Halbleiterkörpers in vertikaler Richtung in den Halbleiterkörper 100 hinein erstreckt. Die Figuren 127A, 128A und 129A zeigen die Bauelemente dabei jeweils in Draufsicht auf die Vorderseite des Halbleiterkörpers 100, in dem sie jeweils integriert sind, während die Figuren 127B, 128B, 129B die Bauelemente in einer ersten vertikalen Schnittebene und die Figuren 127C, 128C, 129C die Bauelemente in einer zweiten vertikalen Schnittebene zeigen.

Bei dem Bauelement gemäß Figur 127 ist die Sourcezone 213 innerhalb der Bodyzone 212 angeordnet und die Gateelektrode 221 erstreckt sich in vertikaler Richtung durch die Sourcezone 213, die Bodyzone 212 bis in die Driftzone 211. Die Gateelektrode 221 ist dabei in der ersten lateralen Richtung x in Verlängerung der Driftzone 211 und in der zweiten lateralen Richtung y jeweils beabstandet zu dem Akkumulationsdielektrikum 251 angeordnet. Bei leitender Ansteuerung des Bauelements verläuft ein Inversionskanal in vertikaler Richtung entlang des Gatedielektrikums 221 von der Sourcezone 213 durch die Bodyzone 212 zu der Driftzone 211. Die Kanallänge dieses Inversionskanals ist hierbei bestimmt durch die Abmessungen der Bodyzone 212 in vertikaler Richtung v zwischen der Sourcezone 213 und der Driftzone 211. Diese Kanallänge ist in den Figuren 127B und 127C mit l bezeichnet. Figur 127B zeigt hierbei einen vertikalen Querschnitt durch den Halbleiterkörper 100 im Bereich der Gateelektrode 221, während Figur 127C einen Querschnitt durch den Halbleiterkörper 100 in einem Bereich zwischen der Gateelektrode 221 und dem Akkumulationsdielektrikum 251 zeigt.

Auf die Darstellung eines Querschnitts der Driftsteuerzone und deren Anschlusszonen 242, 244 ist in Figur 127 verzichtet. Dieser Querschnitt entspricht dem anhand von Figur 114C bereits erläuterten Querschnitt, wobei die Driftsteuerzone 241 in nicht näher dargestellter Weise entsprechend der Ausführungen zu den Figuren 118 bis 122 mit der Source- und Drainelektrode verschaltet sein kann oder entsprechend der Ausführungen zu Figur 111 nur an die Drainzone 214 angeschlossen sein kann.

Der Halbleiterkörper 100 des in Figur 127 dargestellten Bauelements kann in nicht näher dargestellter Weise entsprechend dem Halbleiterkörper in Figur 111 realisiert sein, bei dem eine Halbleiterschicht 104 unmittelbar auf ein Halbleitersubstrat 103 aufgebracht ist, während die Driftsteuerzone 241 durch eine weitere Isolationsschicht 252 gegenüber dem Halbleitersubstrat 103 isoliert ist. Darüber hinaus besteht die Möglichkeit, das Bauelement gemäß Figur 127 entsprechend dem Bauelement in Figur 113 in einem SOI-Substrat zu realisieren, bei dem zwischen einem Halbleitersubstrat 103 und einer Halbleiterschicht 104 eine durchgehende Isolationsschicht 105 vorhanden ist.

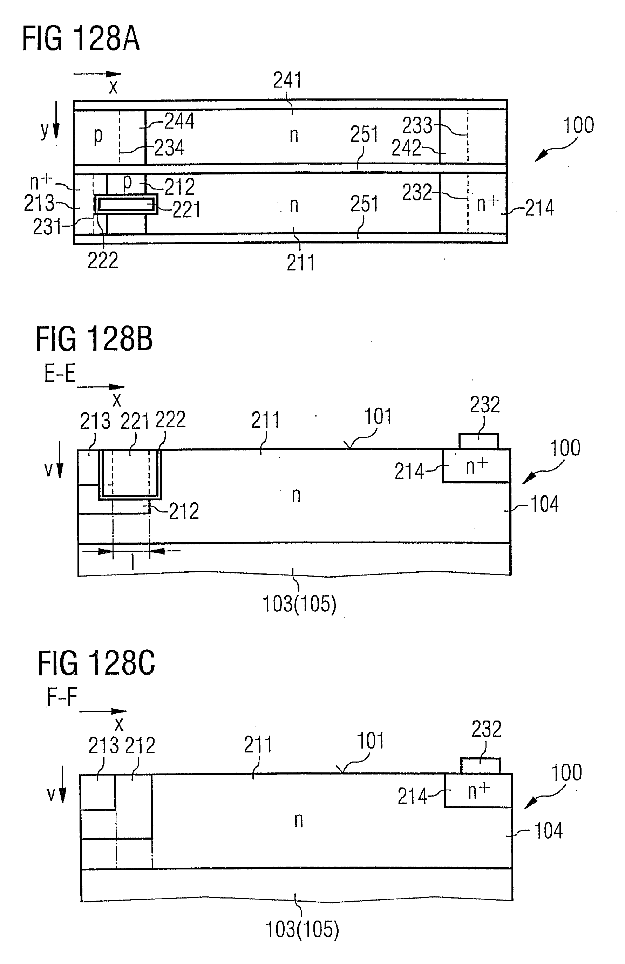

Figur 128 zeigt eine Abwandlung des in Figur 127 dargestellten, als Leistungs-MOSFET ausgebildeten Halbleiterbauelements. Bei dem in Figur 128 dargestellten Bauelement ist eine Länge des Inversionskanals bestimmt durch den Abstand zwischen der Sourcezone 213 und der Driftzone 211 in der ersten lateralen Richtung x. Die Gateelektrode 221 erstreckt sich bei diesem Bauelement in vertikaler Richtung v in den Halbleiterkörper hinein und ist so angeordnet, dass sie sich in der ersten lateralen Richtung x isoliert durch das Gatedielektrikum 222 von der Sourcezone 213 durch die Bodyzone 212 bis in die Driftzone 211 erstreckt. Bei leitend angesteuertem Bauelement verläuft der Inversionskanal, der eine Länge l aufweist, in der ersten lateralen Richtung x entlang des Gatedielektrikums 222.

Die Sourcezone 213 ist Bezug nehmend auf die Figuren 128B und 128C in der Bodyzone 212 angeordnet und somit sowohl in der ersten lateralen Richtung x als auch in der vertikalen Richtung v durch die Bodyzone 213 von der Driftzone 211 getrennt. Wie in den Figuren 128B und 128C strichpunktiert dargestellt ist, besteht auch die Möglichkeit, die Sourcezone 213 und die Bodyzone 212 jeweils so zu realisieren, dass sie sich in vertikaler Richtung v von der Vorderseite 101 des Halbleiterkörpers 100 bis an ein unter der Halbleiterschicht 104 angeordnetes Halbleitersubstrat 103 oder an eine Isolationsschicht 105, bei Verwendung eines SOI-Substrats, erstrecken.

Alternativ kann auch die Gateelektrode 221 analog zu einem Bauelement nach Figur 127 in vertikaler Richtung v tiefer reichen, als das Bodygebiet 212, so dass sich im eingeschalteten Zustand ein Inversionskanal sowohl in der ersten lateralen Richtung x, als auch in vertikaler Richtung v ausbilden kann.

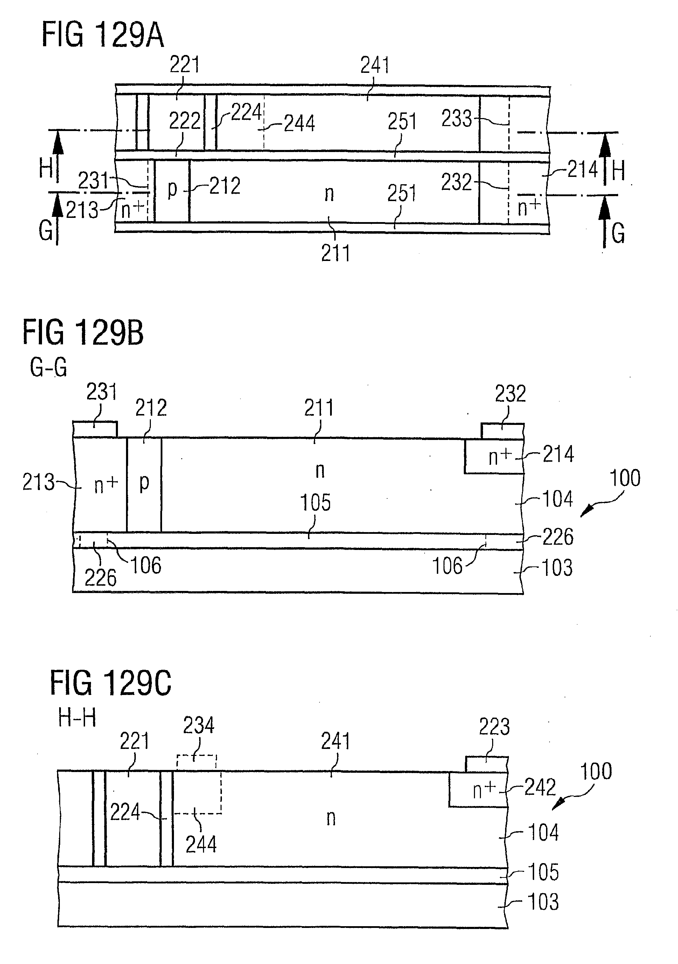

Figur 129 zeigt eine Abwandlung des in Figur 128 dargestellten Bauelements. Bei diesem Bauelement ist die Gateelektrode 221 in der ersten lateralen Richtung x in Verlängerung der Driftsteuerzone 241 und in der zweiten lateralen Richtung y benachbart zu der Bodyzone 212 angeordnet. Das Akkumulationsdielektrikum 251 und das Gatedielektrikum 222 werden bei diesem Bauelement durch eine gemeinsame Dielektrikumsschicht gebildet, die in der zweiten lateralen Richtung y die Driftzone 211 von der Driftsteuerzone 241 und die Bodyzone 212 sowie Abschnitte der Sourcezone 213 und der Driftzone 211 von der Gateelektrode 221 trennt. In der ersten lateralen Richtung x ist die Gateelektrode 221 durch eine weitere Dielektrikumsschicht bzw. Isolationsschicht 224 von der Driftsteuerzone 241 getrennt.

Bezug nehmend auf die Figuren 129B und 129C ist der Halbleiterkörper 100 dieses Bauelements als SOI-Substrat mit einem Halbleitersubstrat 103, einer Isolationsschicht 105 und einer Halbleiterschicht 104 realisiert. Bezug nehmend auf Figur 129B erstrecken sich die Body- und Sourcezonen 212, 213 in vertikaler Richtung v des Halbleiterkörpers 100 bis an die Isolationsschicht 105. Gleiches gilt für die Gateelektrode 221, die sich in vertikaler Richtung v ebenfalls bis an die Isolationsschicht 105 erstreckt. Ein Inversionskanal bildet sich bei diesem Bauelement in der ersten lateralen Richtung x in der Bodyzone 212 zwischen der Sourcezone 213 und der Driftzone 211 entlang des Gatedielektrikums 222 aus.

In nicht näher dargestellter Weise kann die Bodyzone 213 auch oberhalb der Isolationsschicht 105 enden und die Sourcezone 213 kann vollständig innerhalb der Bodyzone 212 angeordnet sein, um dadurch entsprechend dem Bauelement gemäß Figur 127 einen Leistungs-MOSFET mit einem sich in vertikaler Richtung v erstreckenden Inversionskanal zu erhalten.

Die Driftsteuerzone 241 des Bauelements gemäß Figur 129 kann entsprechend der Erläuterungen zu den Figuren 118 bis 122 verschaltet werden. Eine zweite Anschlusszone 244 der Driftsteuerzone 241 kann hierbei in der ersten lateralen Richtung x benachbart zu der weiteren Isolationsschicht 224 der Gateelektrode 221 in der Driftsteuerzone 241 angeordnet sein.

Die zweite Anschlusszone 244 kann sich in nicht näher dargestellter Weise in der vertikalen Richtung v über die gesamte Tiefe des Bodygebiets 212 erstrecken und/oder kann in dieser vertikalen Richtung bis zur Isolationsschicht 105 reichen.

Entsprechend der Ausführungen zu den Figuren 111 bis 113 besteht selbstverständlich auch die Möglichkeit, die Driftsteuerzone lediglich über die erste Anschlusselektrode 233 unter Zwischenschaltung oder ohne Zwischenschaltung einer Diode an das Drain-Potential zu koppeln.

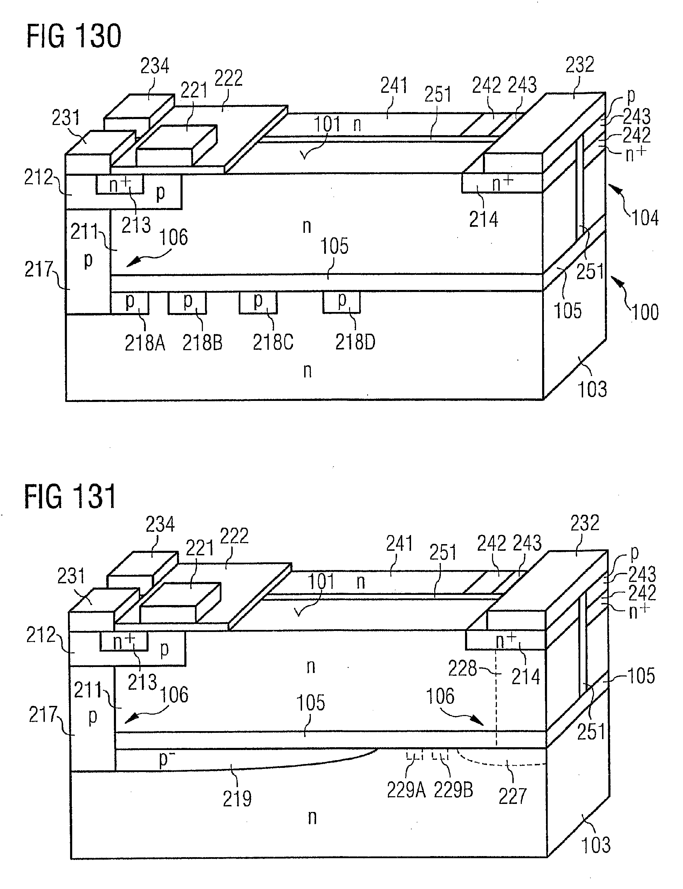

Die Figuren 130 und 131 zeigen weitere Ausführungsbeispiele eines auf einem SOI-Substrat basierenden lateralen Leistungs-MOSFET. Der Halbleiterkörper 100, in dem der MOSFET integriert ist, weist hierbei jeweils ein Halbleitersubstrat 103, eine auf dem Halbleitersubstrat 103 angeordnete Isolationsschicht 105 sowie eine oberhalb der Isolationsschicht 105 angeordnete Halbleiterschicht 104 auf, in der die aktiven Bauelementzonen des MOSFETs integriert sind.

Bei diesen Bauelementen gemäß der Figuren 130 und 131 weist diese Isolationsschicht 105 eine Aussparung 106 auf, durch welche sich eine an die Bodyzone 212 angrenzende Verbindungszone 217 durch die Isolationsschicht 105 bis in das Halbleitersubstrat 103 erstreckt. Diese Verbindungszone ist vom gleichen Leitungstyp wie die Bodyzone 212. Das Halbleitersubstrat 103 ist komplementär zu der Verbindungszone 217 dotiert.

Bei dem Bauelement gemäß Figur 130 sind in dem Halbleitersubstrat 103 komplementär zu dem Substrat dotierte Feldzonen 218A, 218B, 218C, 218D angeordnet, die in der ersten lateralen Richtung x beabstandet zueinander angeordnet sind und die sich unmittelbar an die Isolationsschicht 105 anschließen. In der zweiten lateralen Richtung y sind diese Feldzonen 218A-218D in nicht näher dargestellter Weise streifenförmig ausgebildet. Die zu der Verbindungszone 217 nächstliegende Feldzone 218A ist hierbei unmittelbar an die Verbindungszone 217 angeschlossen. Der laterale Abstand zweier benachbarter Feldzonen 218A-218D vergrößert sich vorzugsweise mit zunehmendem Abstand zu der Verbindungszone 217.

Die Feldzonen 218A-218D erfüllen die Funktion von Feldringen, wie sie von Randabschlüssen bei Leistungshalbleiterbauelementen bekannt sind und beeinflussen durch die dielektrische Isolationsschicht 105 hindurch die Feldverteilung in der Driftzone 211 mit dem Ziel einer Reduktion der Spannungsbelastung der Isolationsschicht 105 bei einem auf einem gegebenen Potential liegenden Halbleitersubstrat 103. Dieses Potential kann ein Masse-Potential bzw. Bezugspotential sein, kann jedoch auch dem Drain-Potential entsprechen.

Dasselbe Ziel wird bei dem Bauelement gemäß Figur 131 durch eine komplementär zu dem Halbleitersubstrat 103 dotierte Feldzone 219 erreicht, die so realisiert ist, dass deren in vertikaler Richtung v betrachtete Dotierstoffdosis mit zunehmendem Abstand zu der Verbindungszone 217 abnimmt. Eine solche Zone wird auch als VLD-Zone (VLD = Variation of Lateral Doping) bezeichnet.

Bezug nehmend auf Figur 131 kann in der Isolationsschicht 105 unterhalb der Drainzone 214 eine Aussparung 106 vorgesehen werden, durch die eine Verbindungszone 228 von der Drainzone 214 bis an das Halbleitersubstrat 103 reicht. Im Bereich der Aussparung ist optional eine Halbleiterzone 227 vorhanden, die in der ersten lateralen Richtung bis unter die Isolationsschicht 105 reicht und die durch die Verbindungszone 228 kontaktiert ist. Optional können in dem Substrat im Bereich unterhalb der Drainzone 214 Feldringe 229A, 229B vorgesehen sein, deren Funktion der Funktion der Feldringe in Figur 130 entspricht. Die Verbindungszone 228, die Halbleiterzone 227 in dem Substrat 227 und die Feldringe sind vorzugsweise vom gleichen Leitungstyp wie die Drainzone 214. Vorzugsweise sind diese Zonen höher dotiert als die Driftzone 211.

Bei den in den Figuren 130 und 131 dargestellten Bauelementen ist die Gateelektrode 221 als planare Elektrode oberhalb der Vorderseite 101 des Halbleiterkörpers angeordnet. Selbstverständlich kann diese Gateelektrode in nicht näher dargestellter Weise auch als Grabenelektrode entsprechend der Ausführungsbeispiele in den Figuren 127 bis 129 realisiert werden. Des Weiteren ist bei den Bauelementen gemäß der Figuren 130 und 131 die Driftsteuerzone 241 über eine Diode, die durch den pn-Übergang zwischen der ersten Anschlusszone 242 und der komplementär zu dieser dotierten Halbleiterzone 243 gebildet ist, an die Drainelektrode 232 angeschlossen. Die Driftsteuerzone 241 ist außerdem über die zweite Anschlusselektrode 234 kontaktiert. Die Verschaltung der Driftsteuerzone 241 kann auf beliebige, anhand der Figuren 118 bis 122 bereits erläuterte Weise erfolgen. Darüber hinaus besteht auch die Möglichkeit, die Driftsteuerzone 241 lediglich an Drain-Potential zu koppeln, wie dies für die Ausführungsbeispiele in den Figuren 111 bis 113 erläutert wurde.

Bei den zuvor erläuterten Bauelementen, die nicht auf einem SOI-Substrat basieren, bei denen die Driftzone 211 also unmittelbar an ein darunter liegendes, beispielsweise komplementär zu der Driftzone 211 dotiertes Halbleitersubstrat 103 angrenzt, ist in erläuterter Weise eine Isolationsschicht 252 erforderlich, die die Driftsteuerzone 241 gegenüber dem Halbleitersubstrat 103 isoliert (vgl. beispielsweise Figur 111D). Diese Bauelemente basieren auf einer Grundstruktur, die ein Halbleitersubstrat 103, auf dem Halbleitersubstrat 103 angeordnete Driftzonen 211 und in lateraler Richtung benachbart zu den Driftzonen 211 angeordnete Driftsteuerzonen 241 aufweist, wobei die Driftsteuerzonen durch ein Akkumulationsdielektrikum 251 von den Driftzonen 211 und durch eine weitere Isolations- bzw. Dielektrikumsschicht 252 gegenüber dem Halbleitersubstrat 103 isoliert sind.

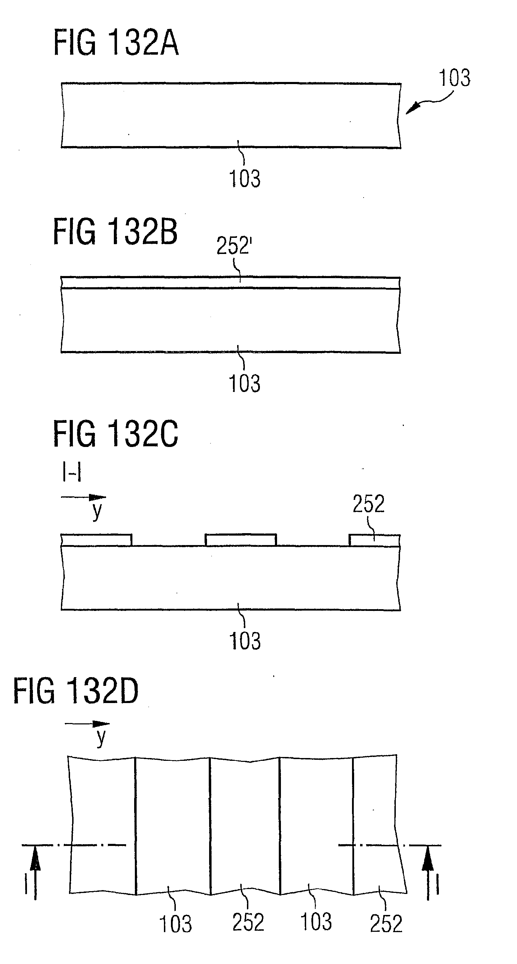

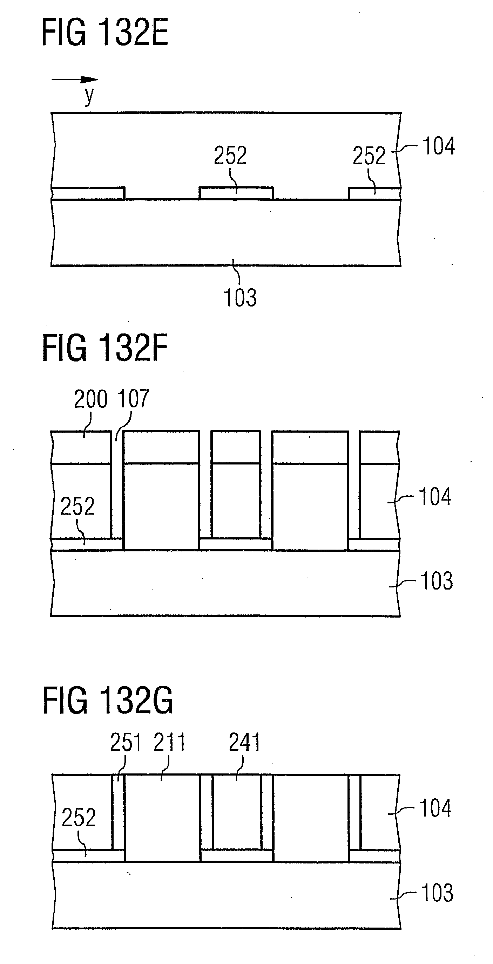

Ein mögliches Verfahren zur Herstellung einer solchen Bauelementgrundstruktur wird nachfolgend anhand von Figur 132 erläutert.

Bezug nehmend auf Figur 132A bildet den Ausgangspunkt des Verfahrens die Bereitstellung eines Halbleitersubstrats 103. Bezug nehmend auf Figur 132B wird auf einer der Seiten dieses Halbleitersubstrats 103 eine Isolationsschicht 252' hergestellt. Diese Isolationsschicht 252' ist beispielsweise eine Oxidschicht, die durch thermische Oxidation hergestellt werden kann, oder ein abgeschiedenes Oxid, wie beispielsweise TEOS (Tetraethylorthosilikat).

Die Isolationsschicht 252' wird anschließend durch Entfernen einzelner Abschnitte der Isolationsschicht 252' derart strukturiert, dass streifenförmige Isolationsschichten 252 entstehen, was im Ergebnis in den Figuren 132B und 132C dargestellt ist. Figur 132B zeigt dabei einen Querschnitt durch die Anordnung mit dem Halbleitersubstrat 103 und der strukturierten Isolationsschicht, während Figur 132C eine Draufsicht zeigt. Die einzelnen streifenförmigen Isolationsschichten 252 sind dabei in einer lateralen Richtung, die der zweiten lateralen Richtung y des späteren Bauelements entspricht, beabstandet zueinander angeordnet. Die Breite der verbleibenden Isolationsschichten 252 in dieser zweiten lateralen Richtung y legt die Breite der späteren Driftsteuerzonen fest, während der gegenseitige Abstand zweier solcher Isolationsschichten 252 die Breite der späteren Driftzonen 211 definiert.

Bezug nehmend auf Figur 132E wird anschließend mittels eines Epitaxieverfahrens eine Halbleiterschicht 104 auf dem Substrat 103 mit der strukturierten Isolationsschicht 252 abgeschieden, wobei die Isolationsschichten 252 hierbei epitaktisch überwachsen werden.

Je dicker die Halbleiterschicht 104 ausgeführt wird, desto niedriger ist der Einschaltwiderstand des fertigen Transistors. Die Dicke ist begrenzt durch die technischen Möglichkeiten der nachfolgenden Ätz- und Verfüllprozesse und deren Kosten. Typische Dicken liegen im Bereich von $2\mu m$ bis $40\mu m$.

Bezug nehmend auf Figur 132F werden anschließend unter Verwendung einer Ätzmaske 200 ausgehend von der Vorderseite 101 des aus dem Halbleitersubstrat 103 und der Halbleiterschicht 104 gebildeten Halbleiterkörpers 100 Gräben in den Halbleiterkörper 100 geätzt, die in der zweiten lateralen Richtung y beabstandet zueinander angeordnet sind und die derart positioniert sind, dass jeweils ein Graben im Bereich eines seitlichen Randes der Isolationsschichten 252 angeordnet ist. Das Ätzen erfolgt beispielsweise mittels eines Ätzmittels, welches die Halbleiterschicht 104 selektiv gegenüber dem Material der Isolationsschicht 252 ätzt, so dass die Isolationsschichten 252 beim Ätzen als Ätzstoppschichten dienen.

Die Breite der Gräben 107 ist durch die maximale Spannungsbelastung zwischen der späteren Driftzone 211 und Driftsteuerzone 241 gegeben sowie durch das Verfahren zur Erzeugung der Dielektrikumsschicht. Wird die Dielektrikumsschicht durch thermische Oxidation des Halbleitermaterials hergestellt, so ist der Verbrauch an Halbleitermaterial bei der Grabenbreite zu berücksichtigen. Typische Grabenbreiten liegen zwischen etwa 20nm und etwa 100nm bei thermisch oxidierten Dielektrikumsschichten sowie zwischen etwa 30nm und etwa 200nm bei dielektrischer Verfüllung der Gräben.

In diesen Gräben 107 wird anschließend eine Dielektrikumsschicht hergestellt. Diese Dielektrikumsschicht ist beispielsweise eine Oxidschicht und kann vor oder nach Entfernen der Ätzmaske 200 durch eine thermische Oxidation freiliegender Bereiche des Halbleiterkörpers 100 oder durch Abscheidung einer Isolatorschicht beispielsweise in einem CVD-Prozess oder einer Kombination beider Varianten erfolgen. Sofern die thermische Oxidation nach Entfernen der Ätzmaske 200 erfolgt, entsteht eine Oxidschicht auch oberhalb der Vorderseite 101 des Halbleiterkörpers 100, die dann - beispielsweise mittels eines anisotropen Ätzverfahrens - wieder zu entfernen ist.

Figur 132G zeigt den Halbleiterkörper 100 nach Durchführung dieser Verfahrensschritte. Basierend auf dieser in Figur 132G dargestellten Grundstruktur können die zuvor erläuterten Halbleiterbauelemente realisiert werden, indem mittels üblicher, hinlänglich bekannter Dotierverfahren, die beispielsweise Implantations- und/oder Diffusionsschritte umfassen, die Body-, Source- und Drainzonen 212, 213, 214 der MOSFET-Struktur sowie die Anschlusszonen 233, 234 der Driftsteuerzonen 241 hergestellt werden.

Die Verwendung einer niedrigdotierten Driftsteuerzone 241 zur Steuerung eines Akkumulationskanals in einer Driftzone 211 eines Leistungshalbleiterbauelements ist nicht auf Leistungs-MOSFET beschränkt, sondern auf beliebige, eine Driftzone aufweisende Leistungshalbleiterbauelemente anwendbar. Der Einsatz einer solchen Driftsteuerzone ist insbesondere anwendbar auf IGBT. Solche IGBT unterscheiden sich von den bisher anhand der Figuren erläuterten Leistungs-MOSFET dadurch, dass die Drainzone 214, die bei einem IGBT auch als Emitterzone bezeichnet wird, komplementär zu der Driftzone dotiert ist. Besondere Vorteile bietet die Verwendung einer niedrigdotierten Driftsteuerzone 241 zur Steuerung eines Akkumulationskanals in einer Driftzone 211 bei unipolaren Leistungshalbleitern.

Ein weiteres Anwendungsbeispiel für eine niedrigdotierte, benachbart zu einer Driftzone angeordnete Driftsteuerzone sind Leistungs-Schottky-Dioden. Derartige Schottky-Dioden unterscheiden sich von den bisher erläuterten Leistungs-MOSFET dadurch, dass anstelle der Bodyzone 212 eine Schottky-Metallzone vorhanden ist und dass darüber hinaus keine Gateelektrode vorhanden ist.

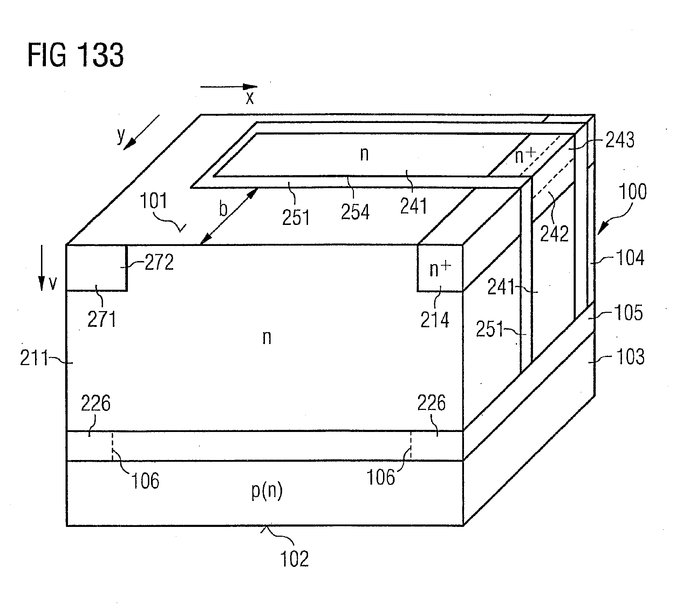

Figur 133 zeigt in Abwandlung des Ausführungsbeispiels gemäß Figur 113 ein Beispiel einer solchen Leistungs-Schottky-Diode. Das Bezugszeichen 271 bezeichnet hierbei die Schottky-Metallzone, die sich an die Driftzone 211 anschließt und die mit der Driftzone 211 einen Bauelementübergang 272 bildet, ausgehend von dem sich bei sperrendem Bauelement, eine Raumladungszone in der Driftzone 211 ausbreitet. Die Schottky-Metallzone 271 bildet bei diesem Bauelement eine Anodenzone, während die in der Driftzone 211 angeordnete hochdotierte Halbleiterzone 214, die bei einem MOSFET dessen Drainzone bildet, eine Kathodenzone der Schottky-Diode bildet. Diese Schottky-Diode sperrt, wenn eine positive Spannung zwischen der Kathodenzone 214 und der Anodenzone 261 anliegt.

Bei den bisher erläuterten erfindungsgemäßen Leistungsbauelementen sind die Driftzone 211 und die Driftsteuerzone 241 in der zweiten lateralen Richtung y des Halbleiterkörpers 100 benachbart zueinander und durch das Akkumulationsdielektrikum 251 voneinander getrennt angeordnet. Eine Fläche des Akkumulationsdielektrikums 251, entlang derer sich der Akkumulationskanal in der Driftzone 211 bei leitend angesteuertem Bauelement ausbreitet, verläuft hierbei senkrecht zu der Vorderseite 101 des Halbleiterkörpers.

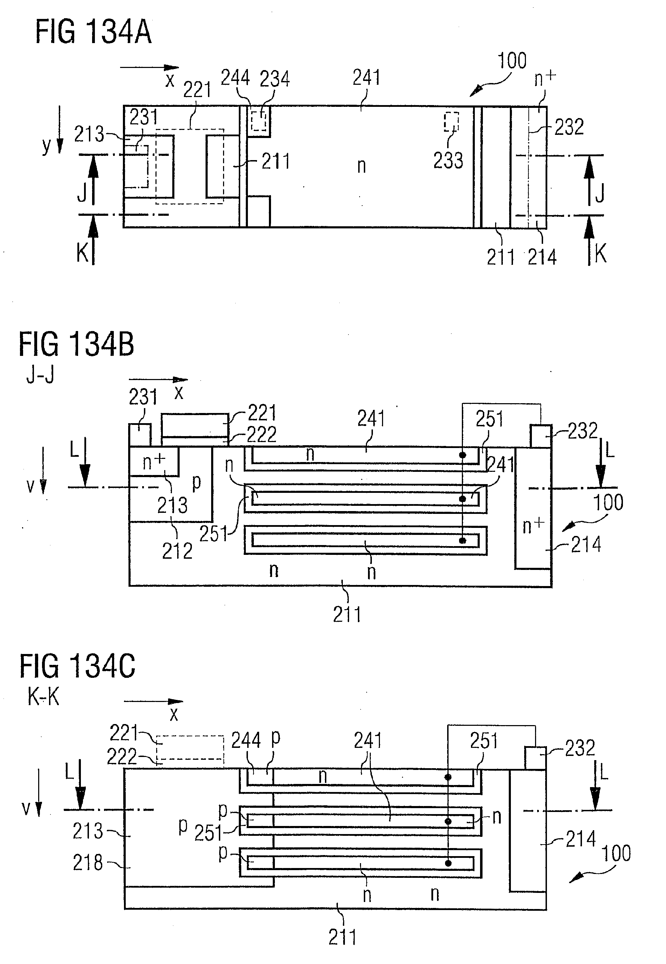

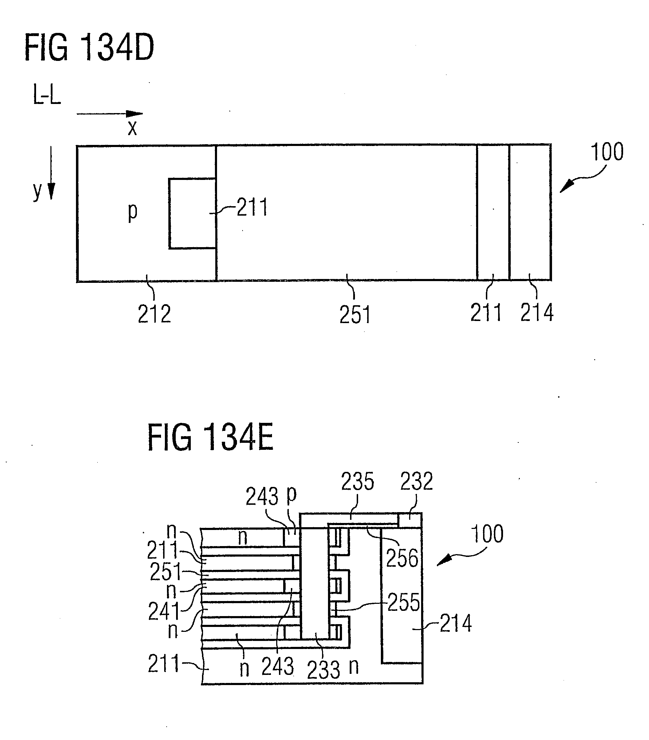

Die Figuren 134A bis 134D zeigen ein weiteres Ausführungsbeispiel eines erfindungsgemäßen lateralen Leistungshalbleiterbauelements. Driftsteuerzonen 241 sind bei diesem Bauelement in einer vertikalen Richtung v eines Halbleiterkörpers 100 benachbart zu einer Driftzone 211 bzw. zu einzelnen Abschnitten dieser Driftzone 211 angeordnet. Figur 134A zeigt dieses Halbleiterbauelement in Draufsicht auf eine Vorderseite 101 des Halbleiterkörpers 100, Figur 134B zeigt dieses Bauelement in einem vertikalen Querschnitt J-J, Figur 134C zeigt das Bauelement in einem weiteren vertikalen Querschnitt K-K und Figur 134D zeigt das Bauelement in einer parallel zur Vorderseite 101 verlaufenden lateralen Schnittebene L-L.

Die einzelnen Driftsteuerzonen 241 sind durch ein Akkumulationsdielektrikum 251 gegenüber der Driftzone 211 isoliert und sind elektrisch an die Drainzone 214 bzw. die Drainelektrode 232 gekoppelt, was in den Figuren 134B und 134C schematisch durch eine die einzelnen Driftsteuerzonen 241 und die Drainelektrode 232 kontaktierende Leitungsverbindung dargestellt ist.

Zur Kontaktierung der Driftsteuerzonen 241 ist eine erste Anschlusselektrode 233 vorhanden, die sich ausgehend von der Vorderseite 101 in vertikaler Richtung in den Halbleiterkörper hineinerstreckt und die jeweils die Driftsteuerzonen 241 kontaktiert, die gegenüber der Driftzone 211 jedoch isoliert ist. Figur 134E zeigt das Bauelement im Bereich dieses Anschlusskontakts 233 im Querschnitt. Der Anschlusskontakt 233 befindet sich dabei an dem der Drainzone 214 zugewandten Ende der Driftsteuerzonen 241. In der zweiten lateralen Richtung y kann dieser Anschlusskontakt an einer beliebigen Position angeordnet sein. In Figur 134A ist eine mögliche Position dieses Anschlusskontakts 233, der beispielsweise einen quadratischen Querschnitt besitzt, eingezeichnet.

Der Anschlusskontakt 233 ist oberhalb der Vorderseite 101 des Halbleiterkörpers mittels einer Anschlussverbindung 235 an die Drainelektrode 232 angeschlossen und oberhalb der Vorderseite mittels einer Isolationsschicht 256 zumindest gegenüber der Driftzone 211 isoliert. Das Bezugszeichen 255 in Figur 134E bezeichnet eine vertikale Isolationsschicht, welche die Driftzone 211 innerhalb des Halbleiterkörpers 100 gegenüber der sich in den Halbleiterkörper 100 hineinerstreckenden Anschlusselektrode 233 isoliert.

Um die Driftsteuerzonen 241 an ihrem der Bodyzone 212 bzw. der Sourcezone 213 zugewandten Ende kontaktieren zu können ist eine zu der erläuterten ersten Anschlusselektrode 233 entsprechende zweite Anschlusselektrode 234 vorhanden, die sich am body- bzw. sourceseitigen Ende der Driftsteuerzonen 241 in vertikaler Richtung in den Halbleiterkörper 100 hineinerstreckt und die die Driftsteuerzonen 241 kontaktiert, gegenüber den Driftzonen 211 jedoch isoliert ist. Eine mögliche Position dieser zweiten Anschlusselektrode 234, die optional vorhanden ist, ist in Figur 134A ebenfalls gestrichelt eingezeichnet. In den Driftsteuerzonen sind in dem Beispiel zweite Anschlusszonen 244 vorhanden, die komplementär zu den Driftsteuerzonen 241 dotiert sind und die durch die zweite Anschlusselektrode kontaktiert sind.

Die Driftsteuerzonen 241 können auf eine beliebige, anhand der Figuren 118 bis 122 erläuterten Weise an die Drainelektrode 232 und die Sourceelektrode 231 angeschlossen werden. Um die Driftsteuerzonen 241 beispielsweise über eine Diode an die Drainelektrode 232 anzuschließen, können in den Driftsteuerzonen 241 im Bereich des Anschlusskontakts 235 Anschlusszonen 243 vorgesehen sein, die komplementär zu den übrigen Bereichen der Driftsteuerzone 241 dotiert sind. Solche Anschlusszonen sind in Figur 134E dargestellt. Insbesondere kann zwischen die Anschlusszone 243 und die Driftsteuerzone 241 eine hochdotierte Zone eingebracht werden, die komplementär zur Anschlusszone 243 dotiert ist, und bei Anliegen einer sperrenden Drainspannung den Abfluss akkumulierter Löcher aus der Driftsteuerzone zur Anschlusselektrode 233 hin verhindern kann. Entsprechend können zum Anschließen der Driftsteuerzonen 241 an die Sourceelektrode 231 in den Driftsteuerzonen 241 im Bereich des weiteren Anschlusskontakts 237 komplementär zu der Driftsteuerzone 241 dotierte Anschlusszonen 244 vorgesehen sein.

Bei dem in Figur 134 dargestellten Bauelement weist die Bodyzone 212 komplementär zu der Driftzone 211 dotierte Abschnitte 218 auf, die sich in der ersten lateralen Richtung x in Richtung der Drainzone 214 erstrecken. Durch diese Gestaltung der Bodyzonen 218 sind die sperrenden pn-Übergänge von Driftzonen 211 und Driftsteuerzonen 241 in der ersten vertikalen Richtung x übereinander und somit der Verlauf der elektrischen Feldstärke und der Raumladungszonen in diesen beiden Halbleiterbereichen praktisch gleich. Dadurch reduziert sich die statische Spannungsbelastung über dem Akkumulationsdielektrikum 251 im Sperrbetrieb.

Die Gateelektrode 221 des in Figur 134 dargestellten MOSFET ist als planare Elektrode oberhalb der Vorderseite 101 des Halbleiterkörpers angeordnet. Die Sourcezone 213 ist vollständig von der Bodyzone 212 umgeben, wobei sich bei leitend angesteuertem Bauelement unterhalb der Vorderseite 101 des Halbleiterkörpers 100 ein Inversionskanal in der ersten lateralen Richtung x zwischen der Sourcezone 213 und der Driftzone 211 ausbildet. Die Flächen des Akkumulationsdielektrikums 251 zwischen den Driftsteuerzonen 241 und der Driftzone 211 verlaufen im dargestellten Beispiel parallel zur Vorderseite 101, so dass sich Akkumulationskanäle in den Driftzonen 211 bei leitend angesteuertem Bauelement ebenfalls parallel zur Vorderseite 101 des Halbleiterkörpers ausbilden.

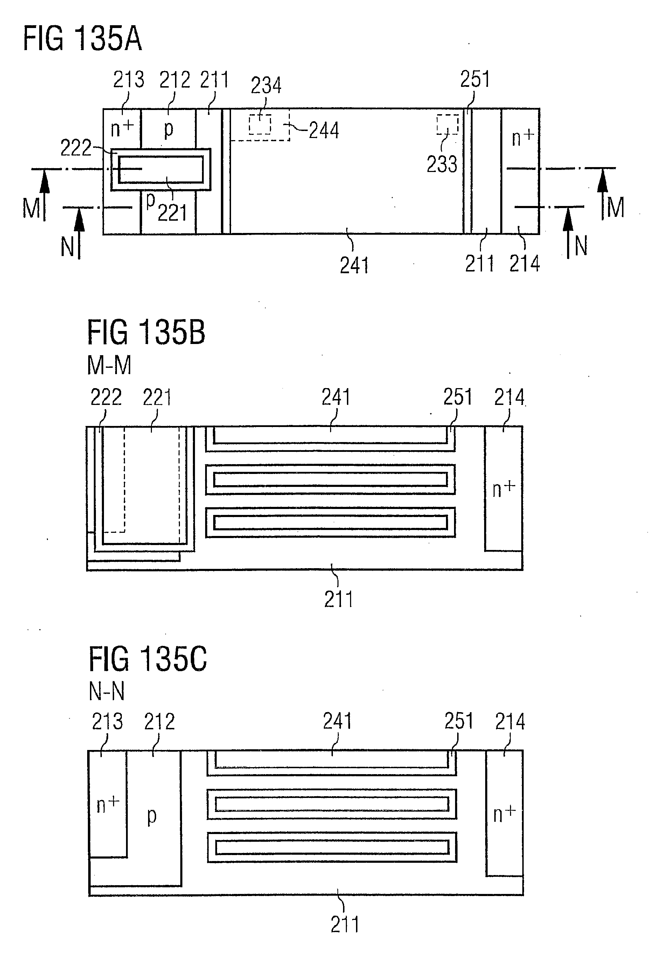

Die Figuren 135A bis 135C zeigen eine Abwandlung des in Figur 134 dargestellten Bauelements. Bei diesem Bauelement ist die Gateelektrode 221 als Trench-Elektrode realisiert, die sich ausgehend von der Vorderseite 101 in vertikaler Richtung in den Halbleiterkörper 100 hineinerstreckt. Figur 135A zeigt eine Draufsicht auf die Vorderseite 101 des Halbleiterkörpers, wobei aus Gründen der Übersichtlichkeit auf die Darstellung von Source-, Drain- und Gateelektroden verzichtet ist. Figur 135B zeigt einen durch die Gateelektrode 221 gehenden vertikalen Querschnitt des Bauelements. Figur 135C zeigt einen vertikalen Querschnitt des Bauelements in einer Ebene, die in der zweiten lateralen Richtung y beabstandet zu der Gateelektrode 221 liegt.

Die Gateelektrode 221 des Bauelements ist derart angeordnet, dass sie sich umgeben von dem Gatedielektrikum 222 in der ersten lateralen Richtung x von der Sourcezone 213 durch die Bodyzone 212 bis in die Driftzone 211 erstreckt. Bei leitend angesteuertem Bauelement bildet sich hierbei ein Inversionskanal in der Bodyzone 212 entlang der Seitenflächen der Gateelektrode 221 in der ersten lateralen Richtung aus.

Die Driftsteuerzonen 241 sind in nicht näher dargestellter Weise entsprechend der Driftsteuerzonen 241 des Bauelements in Figur 134 über die erste Anschlusselektrode 233 (Figur 135A) an die Drainelektrode 232 und über die optional vorhandene zweite Anschlusselektrode 234 (Figur 135A) an die Sourceelektrode 231 anschließbar.

Die Gatestruktur kann auch entsprechend der Ausführungen zu Figur 128, einschließlich der dort angegebenen Alternativen ausgeführt sein.

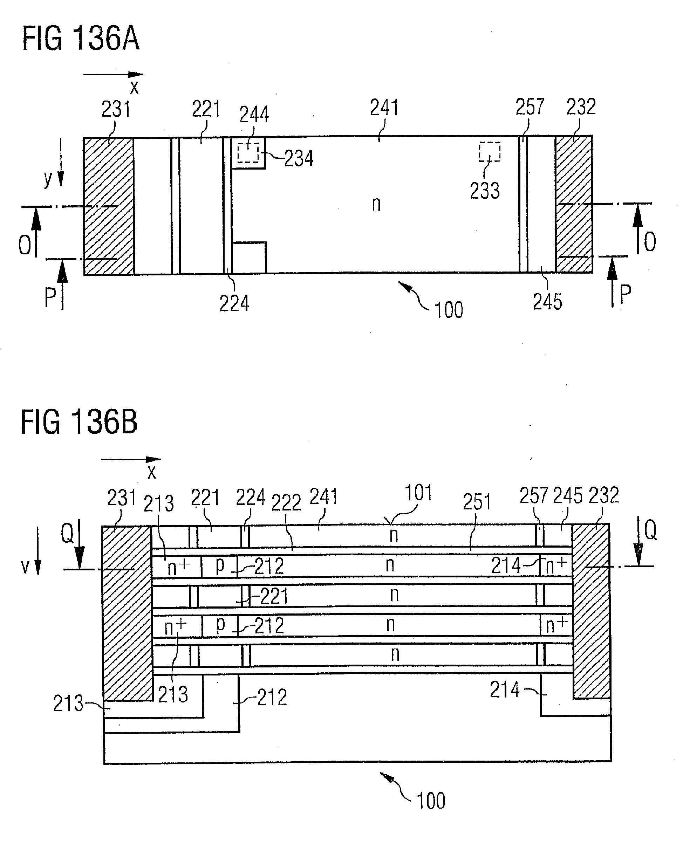

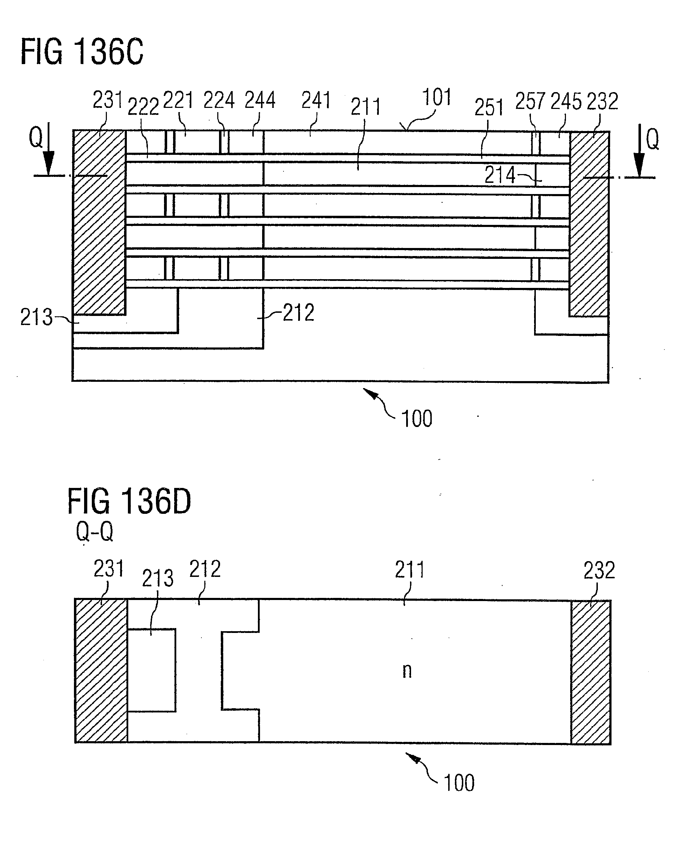

Die Figuren 136A bis 136D zeigen ein weiteres Ausführungsbeispiel eines lateralen Leistungs-MOSFET, bei dem Driftsteuerzonen 241 in vertikaler Richtung v eines Halbleiterkörpers 100 benachbart zu Abschnitten einer Driftzone 211 angeordnet sind. Figur 136A zeigt dabei eine Draufsicht auf die vorderseite 101 des Halbleiterkörpers, die Figuren 136B und 136C zeigen vertikale Querschnitte des Halbleiterkörpers in zwei in der zweiten lateralen Richtung y beabstandet zueinander angeordneten Schnittebenen O-O und P-P. Figur 136D zeigt einen lateralen Querschnitt durch den Halbleiterkörper in einer in den Figuren 136B und 136C dargestellten Schnittebene Q-Q.

Die Gateelektrode 221 weist bei diesem Bauelement mehrere Elektrodenabschnitte auf, die in vertikaler Richtung v des Halbleiterkörpers 100 beabstandet zueinander angeordnet sind. Die einzelnen Gateelektrodenabschnitte 221 sind in der ersten lateralen Richtung x bei diesem Bauelement jeweils benachbart zu den Driftsteuerzonen 241 angeordnet und durch eine Isolationsschicht 224 gegenüber diesen Driftsteuerzonen 241 isoliert. Die Bodyzone 212 weist mehrere Bodyzonenabschnitte auf, von denen jeweils einer in der ersten lateralen Richtung x anschließend an einen Abschnitt der Driftzone 211 und in vertikaler Richtung v benachbart zu mindestens einem Abschnitt der Gateelektrode 221 angeordnet ist. Das zwischen einem Gateelektrodenabschnitt 221 und einem Bodyzonenabschnitt 212 angeordnet Gatedielektrikum 222 und das Akkumulationsdielektrikum 251, das zwischen der zu dem Gateelektrodenabschnitt 221 benachbarten Driftsteuerzone 241 und der anschließend an den Bodyzonenabschnitt 212 angeordneten Driftzone 211 ausgebildet ist, ist bei diesem Bauelement durch eine gemeinsame Dielektrikumsschicht gebildet.

An die Bodyzonenabschnitte 212 schließen sich in der ersten lateralen Richtung x jeweils Abschnitte der Sourcezone 213 an, die durch eine Sourceelektrode 231 kontaktiert sind, die sich ausgehend von der Vorderseite 101 in vertikaler Richtung in den Halbleiterkörper 100 hineinerstreckt.

Die einzelnen Gateelektrodenabschnitte 221, die einzelnen Bodyzonenabschnitte 212 sowie die einzelnen Sourcezonenabschnitte 213 sind bei diesem Bauelement entsprechend der Driftsteuerzonen 241 und der Driftzonen 211 in der zweiten lateralen Richtung y streifenförmig ausgebildet.

Entsprechend der Sourcezone 213 weist die Drainzone 214 bei diesem Bauelement ebenfalls mehrere Abschnitte auf, wobei sich jeweils ein Drainzonenabschnitt 214 an einen Driftzonenabschnitt 211 anschließt. Die einzelnen Drainzonenabschnitte 214 sind durch eine Drainelektrode 232 kontaktiert, die sich ausgehend von der Vorderseite 101 in vertikaler Richtung in den Halbleiterkörper 100 hineinerstreckt. Die einzelnen Drainzonenabschnitte 214 sind entsprechend der Sourcezonenabschnitte 213 in der zweiten vertikalen Richtung y streifenförmig, und damit langgestreckt ausgebildet.

Die Driftsteuerzonen 241 sind bei diesem Bauelement in der ersten lateralen Richtung x durch vertikale Isolationsschichten 257 gegenüber der Drainelektrode 232 bzw. gegenüber einer Halbleiterzone 245, die zwischen diese Isolationsschicht 257 und der Drainelektrode 232 angeordnet ist, isoliert.

Die Driftsteuerzonen 241 sind in nicht näher dargestellter Weise entsprechend der Driftsteuerzonen 241 des Bauelements in Figur 134 über die erste Anschlusselektrode 233 (Figur 135A) an die Drainelektrode 232 und über die optional vorhandene zweite Anschlusselektrode 234 (Figur 135A) an die Sourceelektrode 231 anschließbar. Eine mögliche Position der ersten und zweiten Anschlusselektroden 233, 234 ist in Figur 136A dargestellt. Bezug nehmend auf Figur 136A können innerhalb der einzelnen Driftsteuerzonen 241 komplementär zu der Driftsteuerzone 241 dotierte Anschlusszonen 244 vorhanden sein, die durch die Anschlusselektrode 234 kontaktiert sind. Auf diese Weise kann eine Diode zum Anschließen der Driftsteuerzone 241 an die Sourceelektrode 231 bzw. die Sourcezone 213 realisiert werden.

Das Vorsehen von Driftsteuerzonen 241, die in vertikaler Richtung eines Halbleiterkörpers jeweils benachbart zu Driftzonenabschnitten 211 angeordnet sind, ist selbstverständlich nicht auf die in den Figuren 134 bis 136 erläuterten Leistungs-MOSFET beschränkt, sondern solche Driftsteuerzonen 241 können bei beliebigen, eine Driftzone aufweisenden Leistungsbauelementen, insbesondere Schottky-Dioden, vorgesehen werden. Schottky-Dioden unterscheiden sich von den zuvor erläuterten MOSFET dadurch, dass keine Gateelektroden vorhanden sind und das anstelle der Body- und Sourcezonen eine Schottky-Metallzone vorgesehen ist, die sich an die Driftzone anschließt.

Bei den anhand der Figuren 134 bis 136 erläuterten lateralen Leistungsbauelementen sind stapelartige Bauelementstrukturen vorhanden, bei denen in vertikaler Richtung v des Halbleiterkörpers 100 aufeinanderfolgend eine Halbleiterschicht als Driftzone 211, eine Dielektrikumsschicht als Akkumulationsdielektrikum 251 und eine weitere Halbleiterschicht als Driftsteuerzone 241 und auf dieser Driftsteuerzone eine weitere Dielektrikumsschicht als weiteres Akkumulationsdielektrikum 251 vorhanden sind. Diese Struktur kann sich in vertikaler Richtung mehrfach wiederholen, um in vertikaler Richtung des Halbleiterkörpers jeweils abwechselnd mehrere Driftzonen 211 und mehrere Driftsteuerzonen 241 zu realisieren, die jeweils durch ein Akkumulationsdielektrikum 251 voneinander getrennt sind. Die Halbleiterschichten, die die einzelnen Driftzonen 211 bzw. die einzelnen Driftzonenabschnitte und die einzelnen Driftsteuerzonen 241 bilden, können dabei in vertikaler Richtung jeweils gleiche Abmessungen besitzen und jeweils gleiche Dotierungskonzentrationen aufweisen.

Schichtanordnungen, bei denen abwechselnd eine Halbleiterschicht und eine Dielektrikumsschicht vorhanden sind, lassen sich auf unterschiedliche Weise erzeugen:

Ein mögliches Verfahren zur Herstellung eines solchen Schichtstapels besteht darin, in einer Halbleiterschicht in unterschiedlichen Tiefen vergrabene Isolationsschichten herzustellen. Hierzu werden Sauerstoffionen über eine Oberfläche in die Halbleiterschicht implantiert. An diese Sauerstoffimplantation schließt sich ein Temperaturschritt an, der in den Bereichen, in die Sauerstoff eingebracht wurde, die Entstehung eines Halbleiteroxids bewirkt, welches eine Isolationsschicht bildet. Die Implantationsenergie, mit der die Sauerstoffionen in den Halbleiterkörper implantiert werden, bestimmt die Eindringtiefe der Sauerstoffionen und damit die Position der Isolationsschicht in vertikaler Richtung der Halbleiterschicht. Durch Anwendung unterschiedlicher Implantationsenergien lassen sich durch dieses Verfahren mehrere Isolationsschichten erzeugen, die in der Bestrahlungsrichtung beabstandet zueinander angeordnet sind.

Mittels dieses Verfahrens lassen sich auch Isolationsschichten erzeugen, die senkrecht zur Oberfläche der Halbleiterschicht verlaufen. Hierzu erfolgt die Sauerstoffimplantation maskiert unter Verwendung einer Maske, wobei die Maske die Position und die Abmessungen der Isolationsschicht in lateraler Richtung der Halbleiterschicht und die angewendete Implantationsenergie die Position und die Abmessungen dieser Isolationsschicht in vertikaler Richtung der Halbleiterschicht bestimmen.

Ein weiteres Verfahren zur Herstellung eines Schichtstapels, der abwechselnd eine Halbleiterschicht und eine Dielektrikumsschicht aufweist, sieht zunächst die Herstellung eines Halbleiterschichtstapels vor, der abwechselnd eine Siliziumschicht und eine Silizium-Germanium-Schicht aufweist. Ein solcher Halbleiterschichtstapel kann durch epitaktische Abschaltung in bekannter Weise hergestellt werden. Die Abmessungen der Silizium-Germanium-Schichten in vertikaler Richtung des entstehenden Schichtstapels, d. h. senkrecht zu den einzelnen Schichten, sind dabei geringer als die Abmessungen der einzelnen Siliziumschichten. In diesen Schichtstapeln werden anschließend ausgehend von der Vorderseite Gräben erzeugt, über welche durch ein Ätzmittel selektiv Bereiche der Silizium-Germanium-Schichten ausgehend von den Gräben weggeätzt werden, so dass Hohlräume zwischen jeweils zwei in vertikaler Richtung jeweils benachbarten Siliziumschichten entstehen. In diesen Hohlräumen wird anschließend ein Halbleiteroxid erzeugt, indem bei geeigneten Oxidationstemperaturen ein oxidierendes Gas über den zuvor erzeugten Graben in die Hohlräume des Schichtstapels eingebracht wird.

Ein weiteres Verfahren zur Erzeugung eines Schichtstapels, der abwechselnd Halbleiterschichten und Isolationsschichten aufweist, besteht darin, das anhand der Figuren 132A bis 132E erläuterte Verfahren, bei dem Isolationsschichten epitaktisch mit einer Halbleiterschicht überwachsen werden, mehrfach durchzuführen, d. h. auf eine aufgewachsene Epitaxieschicht erneut eine strukturierte Isolationsschicht und auf diese erneut eine Epitaxieschicht aufzuwachsen.

Ein Schichtstapel, der abwechselnd Halbleiterschichten und Isolationsschichten aufweist, kann außerdem durch Anwendung des sogenannten SmartCut-Verfahrens hergestellt werden. Bei einem SmartCut-Verfahren ist grundsätzlich vorgesehen, von einer Halbleiterschicht eine dünne Halbleiterschicht dadurch "abzusprengen", dass Wasserstoffionen in eine gegebene Tiefe implantiert und anschließend ein Temperaturschritt durchgeführt wird. Dieses Smart-Cut-Verfahren lässt sich zur Herstellung eines Halbleiter-Isolator-Schichtstapels verwenden, indem mittels eines Waferbonding-Verfahrens eine eine Isolationsschicht aufweisende Halbleiterschicht derart auf eine weitere, an der Oberfläche oxidierte Halbleiterschicht aufgebracht wird, dass die Isolationsschicht zwischen diesen beiden Halbleiterschichten angeordnet ist. Mittels des SmartCut-Verfahrens wird die aufgebondete Halbleiterschicht dann derart abgesprengt, dass auf der Trägerschicht die Isolationsschicht und eine dünne Schicht der aufgebondeten Halbleiterschicht verbleiben. Auf diese dünne Halbleiterschicht, die anschließend oxidiert wird, wird dann erneut eine mit einer Isolationsschicht versehene Halbleiterschicht aufgebondet und die aufgebondete Schicht wird erneut mittels des SmartCut-Verfahrens abgesprengt. Diese Verfahrensschritte können mehrfach durchgeführt werden, um einen Halbleiter-Isolator-Schichtstapel herzustellen.

Ein weiteres mögliches Verfahren zur Herstellung vergrabener Oxidschichten besteht darin, in eine Halbleiterschicht Gräben zu ätzen und die Halbleiterschicht anschließend in einer Wasserstoffatmosphäre aufzuheizen. Durch diesen Temperaturschritt entstehen aus den Gräben abgeschlossene Hohlräume in der Halbleiterschicht, die anschließend oxidiert werden. Die Positionierung der einzelnen Hohlräume ausgehend von einer Oberfläche der Halbleiterschicht wird hierbei durch die Tiefe, der in die Halbleiterschicht geätzten Gräben und die Wahl des Ätzprozesses, der die Seitenwandgeometrie bestimmt, vorgegeben. So werden beispielsweise beim sogenannten "Boschprozess" anisotrope und isotrope, die Seitenwand passivierende Phasen bei der Grabenätzung abwechselnd durchgeführt, was zu einer regelmäßigen Struktur der Grabenwand mit Ausbuchtungen, den sogenannten "Scallops" führt. Durch geeignete Wahl des Verhältnisses der Breiten der mit isotropen Ausbuchtungen geätzten Bereiche und der anisotrop und damit schmaler geätzten Bereiche lässt sich das Bilden von Kammern begünstigen. Die Oxidation des Halbleitermaterials in den Hohlräumen mit dem Ziel, eine Isolationsschicht in dem Hohlraum herzustellen, erfordert die Herstellung eines weiteren Grabens, durch welchen die Hohlräume geöffnet werden.

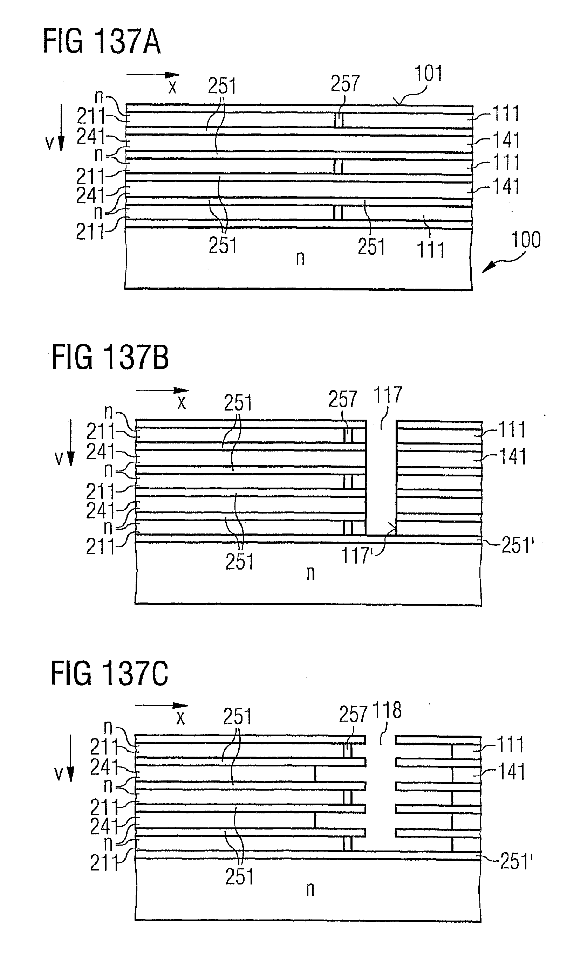

Ein zu lösendes Problem bei der Herstellung der anhand der Figuren 134 bis 136 erläuterten Bauelemente, bei denen die Driftsteuerzonen 241 und die Driftzonen 211 in vertikaler Richtung übereinander liegend angeordnet sind, besteht darin, eine Anschlusselektrode, wie beispielsweise die zuvor erläuterten Anschlusselektroden 233, 234 der Driftsteuerzone 241 oder die die Drainelektrode 232 des Bauelements gemäß Figur 136 herzustellen, die sich ausgehend von der Vorderseite 101 in den Halbleiterkörper hineinerstrecken, und die nur jede zweite Halbleiterschicht des Schichtstapels, d. h. entweder nur jede Driftzone 211 oder nur jede Driftsteuerzone 241 kontaktiert. Ein Verfahren, welches dieses Problem löst wird nachfolgend anhand der Figuren 137A bis 137F für die Herstellung einer nur die Driftzonen 211 kontaktierenden Drainelektrode 232 erläutert. Das Verfahren ist dabei entsprechend auf die Herstellung der ersten und zweiten Anschlusselektroden 233, 234 der Bauelemente der Figuren 134 bis 136 anwendbar.

Figur 137A zeigt den Halbleiterkörper 100 zu Beginn des Verfahrens, in dem in vertikaler Richtung v die Driftzonen 211 und die Driftsteuerzonen 241 übereinanderliegend und jeweils getrennt durch ein Akkumulationsdielektrikum 251 angeordnet sind. Erste Halbleiterschichten, die die späteren Driftzonen 211 des Bauelements bilden, sind dabei mit dem Bezugszeichen 111 bezeichnet, und zweite Halbleiterschichten, die die späteren Driftsteuerzonen 241 des Bauelements bilden, sind dabei mit dem Bezugszeichen 141 bezeichnet. In den ersten Halbleiterschichten 111 sind in vertikaler Richtung v des Halbleiterkörpers 100 übereinander vertikale Isolationsschichten 257 angeordnet, die sich in vertikaler Richtung jeweils zwischen zwei Akkumulationsdielektrikumsschichten 251 erstrecken.

Bezug nehmend auf Figur 137B wird in diese Anordnung anschließend ausgehend von der Vorderseite 101, auf die in dem Beispiel ebenfalls eine Isolationsschicht aufgebracht ist, ein Graben 117 erzeugt, der sich in vertikaler Richtung v ausgehend von der Vorderseite 101 in den Halbleiterkörper hinein erstreckt und der oberhalb oder auf der in vertikaler Richtung ausgehend von der Vorderseite untersten Dielektrikumsschicht 251' des Schichtstapels endet. Die Herstellung des Grabens erfolgt in der ersten lateralen Richtung x beabstandet zu den Isolationsbereichen 257 außerhalb des Bereichs der ersten Halbleiterschichten, die die späteren Driftzonen 211 bilden.

Die Herstellung des Grabens kann mittels eines Ätzverfahrens unter Verwendung einer die laterale Position und die lateralen Abmessungen des Grabens definierenden Ätzmaske erfolgen.

Bezug nehmend auf Figur 137C werden anschließend mittels eines isotropen Ätzverfahrens ausgehend von Seitenwänden des Grabens 117 die zwischen jeweils zwei Dielektrikumsschichten 251 liegenden Halbleiterschichten 111, 141 in der ersten lateralen Richtung teilweise entfernt. Bei den Halbleiterschichten, die abschnittsweise die späteren Driftzonen 211 bilden, funktionieren die vertikalen Isolationsbereiche 257 als Ätzstopp, so dass im Bereich dieser Halbleiterschichten das Halbleitermaterial ausgehend von dem Graben 117 nur bis zu diesen Isolationsbereichen 257 entfernt wird. Das Ätzverfahren wird dabei so lange durchgeführt, bis im Bereich der zweiten Halbleiterschichten 141, die die späteren Driftsteuerzonen 241 bilden, das Halbleitermaterial in der ersten lateralen Richtung x bis hinter die in den ersten Halbleiterschichten 111 angeordneten Isolationsbereiche 257 entfernt wurde. Im Bereich der der Isolationsbereiche 257 gegenüberliegenden Seitenwand 117' des Grabens 117 werden die Halbleiterschichten während dieses isotropen Ätzverfahrens gleichermaßen entfernt.

Ergebnis dieses isotropen Ätzverfahrens ist, dass die Halbleiterschichten, die die späteren Driftzonen 211 bilden, in der ersten lateralen Richtung x auf einer Seite des ursprünglichen Grabens 117 weiter in Richtung der Aussparung ragen, als die Halbleiterschichten, die die späteren Driftsteuerzonen 241 bilden. Ausgehend von der durch das isotrope Ätzverfahren hergestellten Aussparung 118 sind die Driftsteuerzonen 241 in der ersten lateralen Richtung x somit gegenüber den Driftzonen 211 zurückgesetzt.

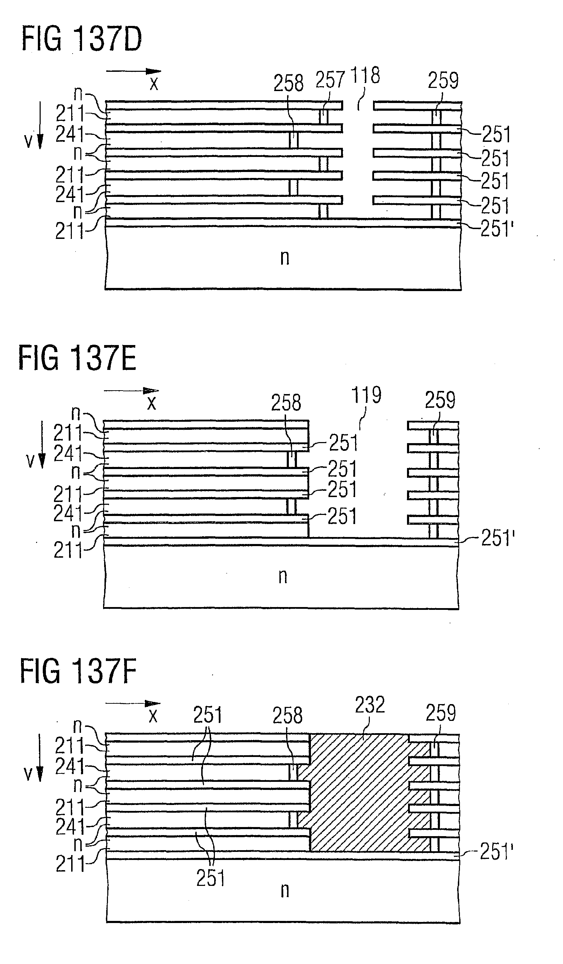

Während weiterer Verfahrensschritte, deren Ergebnis in Figur 137D dargestellt ist, werden innerhalb der durch den isotropen Ätzprozess hergestellten Aussparung 118 Isolationsschichten 258, 259 auf freiliegenden Bereichen der Halbleiterschichten erzeugt. Dies sind auf einer Seite des Grabens nur die zweiten Halbleiterschichten 141, die die Driftsteuerzonen 241 bilden. Die neu erzeugten Isolationsschichten sind in diesem Bereich mit dem Bezugszeichen 258 bezeichnet. Auf der gegenüberliegenden Seite der Aussparung und an nicht dargestellten, in der zweiten lateralen Richtung y beabstandet zueinander angeordneten Seitenwänden, werden die vertikalen Isolationsschichten an freiliegenden Bereichen der ersten und zweiten Halbleiterschichten 111, 141 hergestellt und sind in Figur 137D mit dem Bezugszeichen 259 bezeichnet.

Figur 137E zeigt die Anordnung nach weiteren Verfahrensschritten, bei denen ausgehend von der Vorderseite 101 eine weitere Aussparung 119 in den Schichtstapel geätzt wird, die derart positioniert ist, dass deren eine Seitenfläche in der ersten lateralen Richtung zwischen den ursprünglich in den ersten Halbleiterschichten 111 vorhandenen ersten vertikalen Isolationsbereichen 257 und den später an den freiliegenden Seiten der zweiten Halbleiterschichten 141 erzeugten zweiten vertikalen Isolationsbereichen 258 angeordnet ist. Die ersten vertikalen Isolationsbereiche 257 werden hierbei entfernt, wodurch die ersten Halbleiterschichten 111 in der weiteren Aussparung 119 frei liegen, während die zweiten Halbleiterschichten in der Aussparung 119 durch die zweiten Isolationsbereiche überdeckt sind.

Auf der den ursprünglichen ersten Isolationsbereichen 257 gegenüberliegenden Seite der neu erzeugten Aussparung 119 liegt die Seitenwand dieser Aussparung innerhalb der zweiten Isolationsbereiche 258, so dass in diesem Bereich lediglich in der ersten lateralen Richtung x verlaufende Stege der Dielektrikumsschichten 251, jedoch kein Halbleitermaterial und auch keine der vertikalen Isolationsschichten 259 entfernt wird. Gleiches gilt an den nicht dargestellten in der zweiten lateralen Richtung y gegenüberliegenden Seiten der Aussparung 119.

Den Abschluss des Verfahrens bildet Bezug nehmend auf Figur 137F das Abscheiden einer Elektrodenschicht in der Aussparung 119, wodurch eine Anschlusselektrode 232 entsteht. Diese Elektrode 232 bildet in dem Beispiel die Drainelektrode 232 und kontaktiert die nach Entfernen der Isolationsbereiche 257 an den Seitenwänden der Aussparung freiliegenden ersten Halbleiterschichten 111, die dort die Driftzonen 211 bilden. Gegenüber den zweiten Halbleiterschichten 141, die in Bereichen benachbart zu den Driftzonen 211 die Driftsteuerzonen 241 bilden, ist die Elektrode 232 durch die zweiten Isolationsbereiche 258 isoliert.

In nicht näher dargestellter Weise kann vor Abscheiden der Elektrodenschicht zur Herstellung der Elektrode 232 ein Implantationsverfahren durchgeführt werden, bei dem Dotierstoffatome in die freiliegenden Bereiche der Driftzonen 211 implantiert werden, um dadurch hochdotierte Anschlusszonen zu erzeugen. Die Implantation erfolgt hierbei unter einem Winkel schräg gegenüber der Senkrechten.

Das zuvor anhand der Figuren 137A bis 137F erläuterte Verfahren zur Herstellung einer nur jede zweite der Halbleiterschichten kontaktierenden Anschlusselektrode kann in entsprechender Weise auch zur Herstellung der die Driftsteuerzonen 241 kontaktierenden Anschlusselektroden (236, 237 in den Figuren 134 bis 136) verwendet oder zur Herstellung der Sourceelektrode 231 verwendet werden.

Die Driftsteuerzonen 241 der bislang erläuterten Leistungshalbleiterbauelemente sind jeweils in Stromflussrichtung des Bauelements langgestreckt in der Driftzone 211 ausgebildet. Diese Stromflussrichtung entspricht bei einem MOSFET der Richtung zwischen der Bodyzone 212 und der Drainzone 214 und stimmt bei den bislang erläuterten Ausführungsbeispielen mit der ersten lateralen Richtung x des Halbleiterkörpers 100 überein. In einer Richtung quer zu dieser Stromflussrichtung verlaufen die Driftsteuerzonen bei den Bauelementen gemäß der Figuren 111 bis 131 und 133 jeweils senkrecht zur Vorderseite 101 des Halbleiterkörpers und bei den Ausführungsbeispielen der Figuren 134 bis 136 jeweils parallel zur Vorderseite 101 des Halbleiterkörpers. Bei den Bauelementen gemäß der Figuren 134 bis 136 können sich die Driftsteuerzonen in der zweiten lateralen Richtung y bis zu einem Rand des Halbleiterkörpers bzw. einem Randabschluss des Halbleiterkörpers erstrecken.

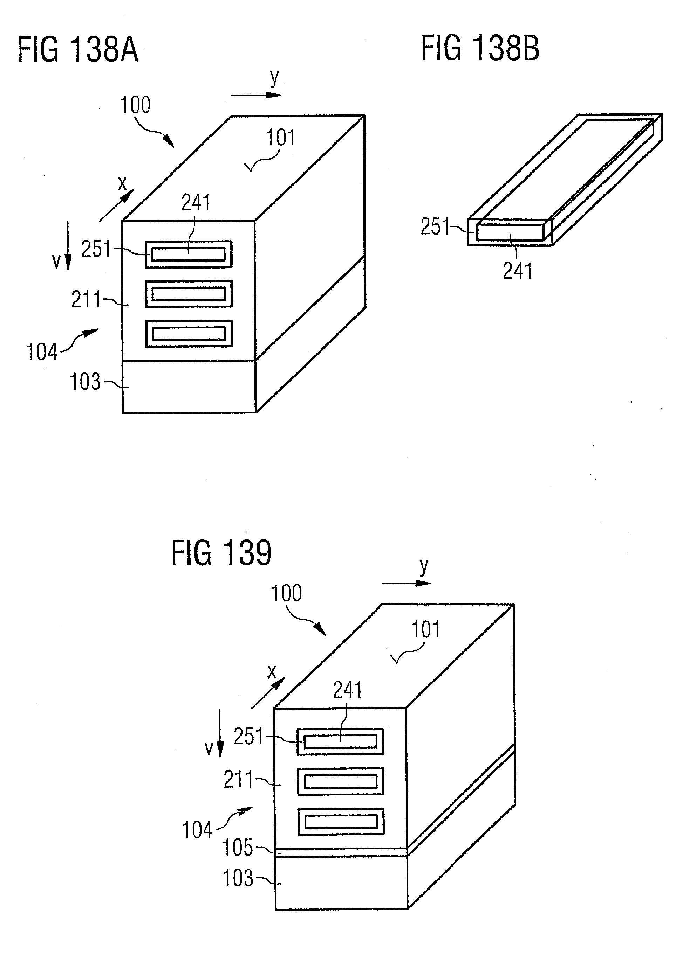

Bezug nehmend auf die nachfolgend erläuterten Figuren 138 bis 145 sind auch Kombinationen der bislang erläuterten Geometrien der Driftsteuerzonen 241 anwendbar. Die Figuren 138 bis 145 zeigen in perspektivischer Darstellung jeweils einen Abschnitt der Driftzonen 211 und Driftsteuerzonen 241 eines Leistungshalbleiterbauelements.

Bezug nehmend auf die Figuren 138A und 138B können die Driftsteuerzonen 241 streifenförmig ausgebildet und in der Driftzone 211 umgeben von dem Akkumulationsdielektrikum 251 angeordnet sein. Akkumulationskanäle können sich bei diesem Bauelement in der Driftzone 211 sowohl in vertikaler Richtung oberhalb und unterhalb der Driftsteuerzonen 241, als auch in lateraler Richtung benachbart zu den Driftsteuerzonen 241 ausbilden.

Der Halbleiterkörper 100 kann in bekannter Weise ein Halbleitersubstrat 103 und eine auf das Halbleitersubstrat aufgebrachte Halbleiterschicht 104 umfassen, wobei das Substrat 103 und die Halbleiterschicht 104 komplementär zueinander dotiert sein können oder vom gleichen Leitungstyp sein können. Eine Grunddotierung dieser Halbleiterschicht 104 kann hierbei der Dotierung der Driftzone 211 entsprechen.

Bezug nehmend auf Figur 139 kann optional eine Isolationsschicht 105 zwischen dem Halbleitersubstrat 103 und der Halbleiterschicht 104 angeordnet sein, die damit die Driftzone 100 gegenüber dem Halbleitersubstrat 103 isoliert.

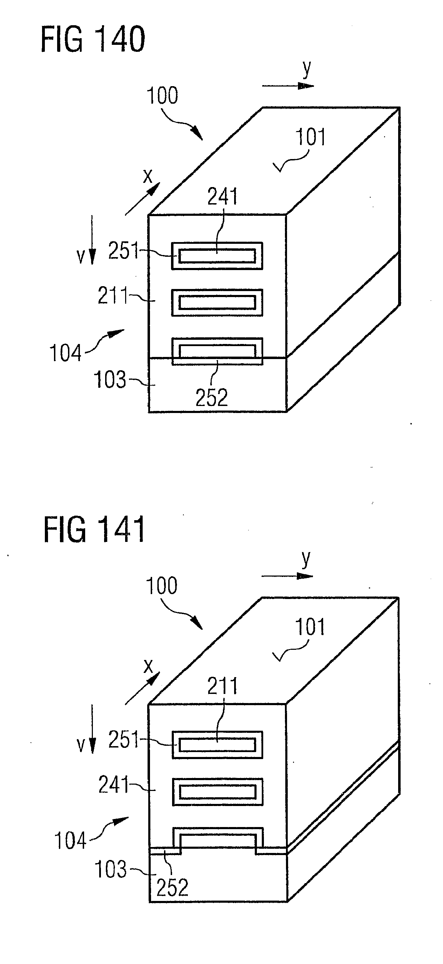

Bei den Bauelementen gemäß der Figuren 138 und 139 ist die ausgehend von der Vorderseite 101 unterste Driftsteuerzone 241 beabstandet zu dem Halbleitersubstrat 103 angeordnet. Eine Abwandlung des Ausführungsbeispiels gemäß Figur 138, bei der die unterste Driftsteuerzone 241 bis an das Halbleitersubstrat 103 reicht, ist in Figur 140 dargestellt. Bei diesem Ausführungsbeispiel ist zwischen der untersten dieser Driftsteuerzonen 241 und dem Halbleitersubstrat 103 eine Isolationsschicht vorhanden, die diese Driftsteuerzone gegen das Halbleitersubstrat 103 isoliert.

Figur 141 zeigt eine Abwandlung der in Figur 140 dargestellten Anordnung. Hierbei sind die Driftzonen 211 streifenförmig ausgebildet und in der Driftsteuerzone 241 angeordnet. Zwischen der Driftsteuerzone 241 und den Driftzonen 211 ist entsprechend das Akkumulationsdielektrikum 251 vorhanden. Wenigstens zwischen der Driftsteuerzone 241 und dem Halbleitersubstrat 103 ist hierbei eine Isolationsschicht 252 angeordnet, während eine unterste der Driftzonen 211 sich unmittelbar an das Halbleitersubstrat 103 anschließt. Das Halbleitersubstrat 103 kann dabei vom gleichen Leitungstyp oder von einem zu der untersten Driftzone 211 komplementären Leitungstyp sein. Optional kann hierbei eine weitere Isolationsschicht zwischen der untersten Driftzone 211 und dem Halbleitersubstrat 103 vorgesehen werden (nicht dargestellt).

Bei den zuvor erläuterten streifenförmigen Ausgestaltungen der Driftsteuerzonen 241 oder der Driftzonen 211 sind die Abmessungen dieser Zonen 241, 211 in der zweiten lateralen Richtung y größer als in vertikaler Richtung, woraus eine streifenförmige Geometrie dieser Bauelementzonen resultiert. Alternativ kann die streifenförmige Ausgestaltung auch dadurch erreicht werden, dass die Abmessungen der Zonen 241, 211 in der vertikalen Richtung größer sind als in der zweiten lateralen Richtung y.

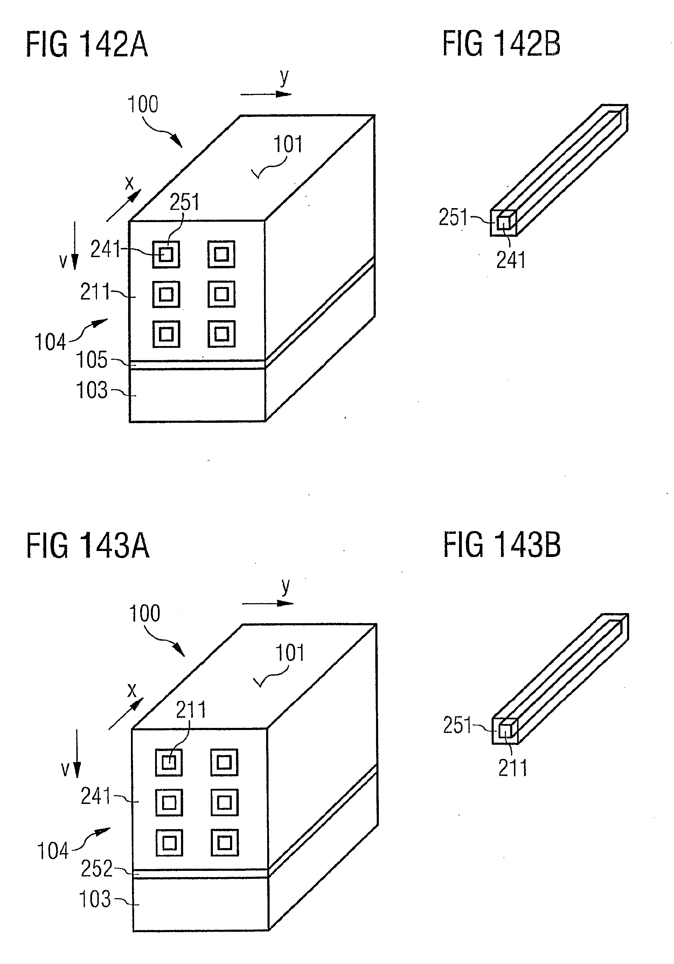

Die Figuren 142A und 142B zeigen eine Abwandlung des in Figur 139 dargestellten Bauelements, wobei die Driftsteuerzonen 241 hierbei "balkenförmig" realisiert sind, d. h. in einer durch die vertikale Richtung v und die zweite laterale Richtung y gebildeten Schnittebene einen wenigstens annähernd quadratischen Querschnitt besitzen. In der ersten lateralen Richtung x sind diese Driftsteuerzonen entsprechend langgestreckt ausgebildet.

Eine in Figur 142A dargestellte Isolationsschicht 105 zwischen dem Halbleitersubstrat 103 und der Halbleiterschicht 104 bzw. der Driftzone 211 ist optional vorhanden. Das Halbleitersubstrat 103 kann vom gleichen Leitungstyp wie die Driftzone 211 oder komplementär zu dieser Driftzone 211 dotiert sein.

Die Figuren 143A, 143B zeigen eine Abwandlung der Anordnung gemäß Figur 142, wobei die Driftzonen 211 hierbei eine balkenförmige Geometrie aufweisen und getrennt durch das Akkumulationsdielektrikum 251 sowohl in vertikaler als auch lateraler Richtung von der Driftsteuerzone 241 umgeben sind. Die Driftsteuerzone 241 ist hierbei durch die weitere Isolationsschicht 252 gegenüber dem Halbleitersubstrat 103 isoliert. Das Halbleitersubstrat kann hierbei von einem zu der Driftsteuerzone 241 gleichen Leitungstyp oder komplementären Leitungstyp sein.

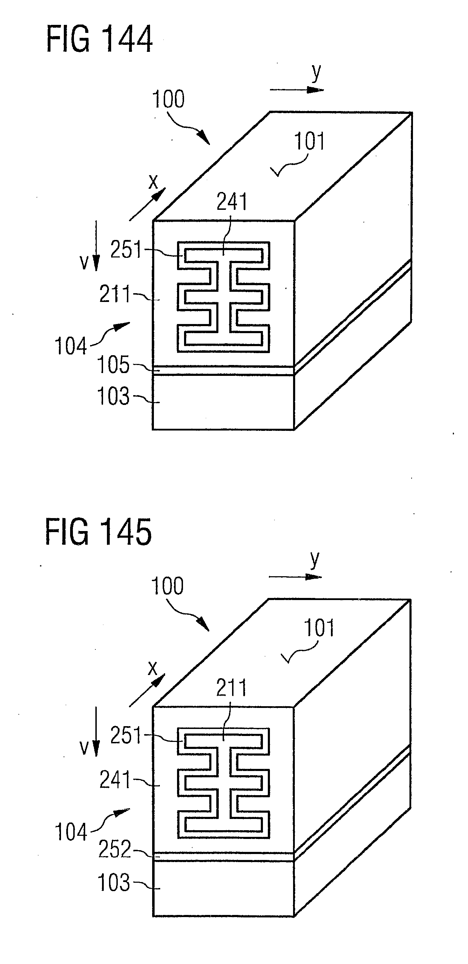

Bei der Anordnung gemäß der Figur 145 ist die Driftsteuerzone 241 in der ersten lateralen Richtung x langgestreckt ausgebildet und weist eine derartige Geometrie auf, dass das Akkumulationsdielektrikum 251 in der vertikalen Richtung v eine mäanderartige Geometrie aufweist. Die Driftsteuerzone 241 ist hierbei getrennt durch das Akkumulationsdielektrikum 251 vollständig von der Driftzone 211 umgeben. Die Driftzone 211 und die Driftsteuerzone 241 sind in der Halbleiterschicht 104 angeordnet, die oberhalb des Halbleitersubstrat 103 angeordnet ist und die optional mittels einer Isolationsschicht 105 gegenüber dem Halbleitersubstrat 103 isoliert ist.

Figur 145 zeigt eine Abwandlung der Anordnung gemäß Figur 145, bei der die Driftzone 211 von der Driftsteuerzone 241 umgeben ist und bei der die Driftzone 211 eine solche Geometrie aufweist, dass das zwischen der Driftzone 211 und der Driftsteuerzone 241 angeordnete Akkumulationsdielektrikum 251 in vertikaler Richtung v eine mäanderartige Geometrie aufweist.

Eine solche mäanderartige Geometrie des Akkumulationsdielektrikums ist insofern vorteilhaft, da bei einem gegebenen Volumen des zur Realisierung der Driftzone 211 und der Driftsteuerzone 241 benötigten Halbleitermaterials eine große Fläche des Akkumulationsdielektrikums 251 und damit eine große Breite des sich bei leitend angesteuertem Bauelement ausbildenden Akkumulationskanals realisierbar ist.

Die vorliegende Erfindung wurde beispielhaft anhand eines MOSFETs und einer Schottky-Diode erläutert. Insbesondere bei einem MOSFET besteht die Möglichkeit, anstelle des gezeigten n-Kanal-MOSFETs einen p-Kanal-MOSFET vorzusehen. In diesem Fall müssten bei den gezeigten Ausführungsbeispielen eines n-Kanal-MOSFETs alle n-dotierten Halbleiterzonen durch p-dotierte Halbleiterzonen und umgekehrt alle p-dotierten Halbleiterzonen durch n-dotierte Halbleiterzonen ersetzt werden. Dies betrifft insbesondere auch die ersten, die zweiten und die dritten Dioden, d.h. diese Dioden müssen in umgekehrter Polarität an die entsprechenden, jedoch komplementär dotierten Gebiete angeschlossen werden.

Das erfindungsgemäße Konzept ist auf beliebige, eine Driftzone aufweisende unipolare Bauelemente, insbesondere auch auf JFETs anwendbar.

Es sei darauf hingewiesen, dass für die Realisierung der Driftsteuerzone nicht notwendigerweise einkristallines Halbleitermaterial erforderlich ist, sondern dass auch polykristallines Halbleitermaterial verwendet werden kann, das der zuvor erläuterten Dotiervorschrift genügt, wonach es vollständig ausräumbar ist. Bei Verwendung eines polykristallinen Halbleitermaterials für die Driftsteuerzone 3 sind allerdings höhere Leckströme zu beachten, die aus einer erhöhten Ladungsträgergeneration an Korngrenzen zwischen einzelnen Kristallen des polykristallinen Materials resultieren.

Wenngleich der Schutzumfang durch die Ansprüche definiert ist, sind einige Aspekte der vorliegenden Beschreibung nachfolgend nochmals kurz zusammengefasst. Bezugszeichen sind zum besseren Verständnis in Klammern angegeben. Beschrieben ist:

1. ein Halbleiterbauelement das einen Halbleiterkörper (100) und folgende weitere Merkmale aufweist:

- eine Driftzone (2; 211) eines ersten Leitungstyps in dem Halbleiterkörper (100),

- eine Driftsteuerzone (3; 241) aus einem Halbleitermaterial, die zumindest abschnittsweise benachbart zu der Driftzone (2) in dem Halbleiterkörper angeordnet ist,

- ein Akkumulationsdielektrikum (4; 251), das zwischen der Driftzone (2; 211) und der Driftsteuerzone (3; 241) angeordnet ist;

2. ein Halbleiterbauelement gemäß Punkt 1., bei dem die Driftsteuerzone (3; 241) wenigstens einen Halbleiterabschnitt aufweist, der so dotiert ist, dass er in einer Richtung senkrecht zu dem Akkumulationsdielektrikum (4; 251) vollständig ausräumbar ist;

3. ein Halbleiterbauelement gemäß Punkt 1. oder 2., das mehrere in dem Halbleiterkörper (100) angeordnete gleichartige Bauelementstrukturen mit je einer Driftzone (2; 211) und einer Driftststeuerzone (3; 241) aufweist;

4. ein Halbleiterbauelement gemäß einem der Punkte 1. bis 3., bei dem die Driftsteuerzone (3; 241) vom gleichen Leitungstyp wie die Driftzone (2; 211) ist;

5. ein Halbleiterbauelement gemäß einem der Punkte 1. bis 3., bei dem die Driftsteuerzone (3; 241) von einem zum Leitungstyp der Driftzone (2; 211) komplementären Leitungstyp ist;

6. ein Halbleiterbauelement gemäß Punkt 1. oder 2., bei dem die Driftzone (2; 211) und/oder die Driftsteuerzone (3; 241) intrinsisch sind;

7. ein Halbleiterbauelement gemäß einem der zuvor genannten Punkte, das eine erste Bauelementzone (8; 212) und eine beabstandet zu der ersten Bauelementzone (8) angeordnete zweite Bauelementzone (5; 214) aufweist, zwischen denen die Driftzone (2; 211) angeordnet ist;

8. ein Halbleiterbauelement gemäß Punkt 7., bei dem die erste Bauelementzone (8) in einer vertikalen Richtung des Halbleiterkörpers (100) beabstandet zu der zweiten Bauelementzone (9) angeordnet ist;

9. ein Halbleiterbauelement gemäß Punkt 7., bei dem die erste Bauelementzone (212) in einer lateralen Richtung des Halbleiterkörpers (100) beabstandet zu der zweiten Bauelementzone (214) angeordnet ist;

10. ein Halbleiterbauelement gemäß einem der zuvor genannten Punkte, bei dem die Driftsteuerzone (3) und die Driftzone (2) die gleiche Netto-Dotierstoffkonzentration aufweisen;

11. ein Halbleiterbauelement gemäß einem der Punkte 1. bis 10., bei dem die Driftzone (2) und die Driftsteuerzone (3) in einer Richtung parallel zu dem Akkumulationsdielektrikum einen gleichen Verlauf der Dotierstoffkonzentration aufweisen;

12. ein Halbleiterbauelement gemäß einem der zuvor genannten Punkte, bei dem die Driftsteuerzone (3; 241) an die zweite Bauelementzone (5; 214) gekoppelt ist;

13. ein Halbleiterbauelement gemäß Punkt 12, bei dem die Driftsteuerzone (3; 241) über ein Gleichrichterelement (43; 261) an die zweite Bauelementzone (5; 214) gekoppelt ist;

14. ein Halbleiterbauelement gemäß Punkt 13., bei dem das Gleichrichterelement (43; 261) eine Diode ist;

15. ein Halbleiterbauelement gemäß Punkt 14., bei dem die Diode durch einen pn-Übergang zwischen der Driftsteuerzone (3; 241) und einer komplementär zu der Driftsteuerzone (3; 241) dotierten Anschlusszone (32; 243) oder durch einen pn-Übergang zwischen einer sich an die Driftsteuerzone (241) anschließenden, höher als diese dotierten Halbleiterzone (31; 242) und einer komplementär zu der Driftsteuerzone (3; 241) dotierten Anschlusszone (32; 243) gebildet ist;

16. ein Halbleiterbauelement gemäß Punkt 12., bei dem die Driftsteuerzone (3; 241) über eine höher als die Driftsteuerzone (3) dotierte Anschlusszone (31; 242) des gleichen Leitungstyps wie die Driftsteuerzone (3; 241) an die zweite Bauelementzone (5; 214) gekoppelt ist;

17. ein Halbleiterbauelement gemäß Punkt 12., bei dem ein Tunneldielektrikum (4') zwischen der Driftsteuerzone (2) und der zweiten Bauelementzone (5) angeordnet ist;

18. ein Halbleiterbauelement gemäß Punkt 12., bei dem die Driftsteuerzone (3) über ein Widerstandselement (55) an die erste Anschlusszone (5) gekoppelt ist;

19. ein Halbleiterbauelement gemäß Punkt 18., bei der das Widerstandselement eine intrinsisch dotierte Halbleiterzone umfasst;

20. ein Halbleiterbauelement gemäß Punkt 17., bei dem ein Abschnitt der Driftzone (2) zwischen dem Tunneldielektrikum (4') und der zweiten Bauelementzone (5) angeordnet ist;

21. ein Halbleiterbauelement gemäß einem der zuvor genannten Punkte, bei dem die Driftsteuerzone (3; 241) elektrisch an die erste Bauelementzone (8; 212) gekoppelt ist;

22. ein Halbleiterbauelement gemäß Punkt 21., bei dem die Driftsteuerzone über ein Gleichrichterelement (42; 262) an die erste Bauelementzone (8; 212) gekoppelt ist;

23. ein Halbleiterbauelement gemäß Punkt 22., bei dem das Gleichrichterelement (42; 262) eine Diode ist;

24. ein Halbleiterbauelement gemäß Punkt 21., bei dem die Driftsteuerzone (3) über eine komplementär zu der Driftsteuerzone (3) dotierte Anschlusszone (33, 34; 244) an die erste Bauelementzone (8; 212) gekoppelt ist;

25. ein Halbleiterbauelement gemäß Punkt 24., bei dem die Anschlusszone (33, 34) eine Anschlusselektrode (19) aufweist und bei dem ein Gleichrichterelement (41) zwischen die Anschlusselektrode (19) und die erste Bauelementzone (8) geschaltet ist;

26. ein Halbleiterbauelement gemäß einem der Punkte 22. bis 25., bei dem ein kapazitives Bauelement (50; 263) zwischen die Driftsteuerzone (3; 241) und die erste Bauelementzone (8; 212) geschaltet ist;

27. ein Halbleiterbauelement gemäß Punkt 26., bei dem das kapazitive Bauelement in dem Halbleiterkörper (100) integriert ist;

28. ein Halbleiterbauelement gemäß einem der zuvor genannten Punkte, bei dem die Driftsteuerzone (3; 241) abschnittsweise über ein Tunneldielektrikum (4', 253) an die Driftzone (2; 211) gekoppelt ist;

29. ein Halbleiterbauelement gemäß einem der zuvor genannten Punkte, bei dem die erste Bauelementzone (8; 212; 271) mit der Driftzone (2; 211) einen Bauelementübergang bildet, ausgehend von dem sich bei Anlegen einer Sperrspannung zwischen der Driftzone (2; 211) und der ersten Bauelementzone (8; 212; 271) eine Raumladungszone in der Driftzone (2; 211) ausbreitet;

30. ein Halbleiterbauelement gemäß einem der zuvor genannten Punkte, das als MOS-Transistor ausgebildet ist, bei dem die erste Bauelementzone (8; 212) eine Bodyzone und die zweite Bauelementzone (5; 214) eine Drainzone bildet und das folgende weitere Merkmale aufweist:

- eine Sourcezone (9; 212), die durch die Bodyzone (8; 212) von der Driftzone (2; 211) getrennt ist,
- eine Gateelektrode (15; 221), die mittels eines Gatedielektrikums (16; 222) gegenüber dem Halbleiterkörper (100) isoliert ist und die sich benachbart zu der Bodyzone (8; 212) von der Sourcezone (9; 213) bis zu der

Driftzone (2; 211) erstreckt;

31. ein Halbleiterbauelement gemäß Punkt 26. und 30., bei dem die Bodyzone (8) und die Sourcezone (9) durch eine Sourceelektrode (13) und eine höher als die Bodyzone (8) dotierte Halbleiterzone (17) des gleichen Leitungstyps wie die Bodyzone (8) miteinander verbunden sind und bei dem die Kapazität (50) an die Sourceelektrode (13) angeschlossen ist;

32. ein Halbleiterbauelement gemäß Punkt 30. oder 31., das als MOSFET ausgebildet ist, bei dem die Drainzone (214) vom gleichen Leitungstyp wie die Driftzone (211) ist;

33. ein Halbleiterbauelement gemäß Punkt 30. oder 31., das als IGBT ausgebildet ist, bei dem die Drainzone (214) komplementär zu der Driftzone (211) dotiert ist;

34. ein Halbleiterbauelement gemäß Punkt 30. oder 31., das als MOSFET ausgebildet ist, bei dem die Driftzone (2) komplementär zu der Sourcezone (9) dotiert ist;

35. ein Halbleiterbauelement gemäß Punkt 34., bei dem eine Zwischenzone (22) des gleichen Leitungstyps wie die Sourcezone (9; 213) zwischen der Driftzone (2; 211) und der Bodyzone (8; 212) angeordnet ist;

36. ein Halbleiterbauelement gemäß einem der Punkte 30. bis 35., bei dem die Gateelektrode (15; 221) oberhalb der Vorderseite (101) des Halbleiterkörpers (100) angeordnet ist;

37. ein Halbleiterbauelement gemäß einem der Punkte 30. bis 35., bei dem die Gateelektrode (15; 221) in einem Graben des Halbleiterkörpers (100) angeordnet ist;

38. ein Halbleiterbauelement gemäß Punkt 37., bei der die Gateelektrode (15; 221) in einer Stromflussrichtung des Bauelements beabstandet zu der Driftsteuerzone (3; 241) angeordnet ist;

39. ein Halbleiterbauelement gemäß Punkt 37., bei der die Gateelektrode (15; 221) in einer Richtung quer zu der Stromflussrichtung des Bauelements beabstandet zu der Driftsteuerzone (3; 241) angeordnet ist;

40. ein Halbleiterbauelement gemäß Punkt 30., bei dem sich die Gateelektrode (221) in der ersten lateralen Richtung des Halbleiterkörpers (100) von der Sourcezone (213) bis zu der Driftzone (211) erstreckt;

41. ein Halbleiterbauelement gemäß Punkt 40., bei dem die Gateelektrode (221) in der ersten lateralen Richtung benachbart zu der wenigstens einen Driftsteuerzone (241) angeordnet ist.

42. ein Halbleiterbauelement gemäß einem der zuvor genannten Punkte, bei dem sich die Gateelektrode (221) in der vertikalen Richtung des Halbleiterkörpers (100) von der Sourcezone (213) bis zu der Driftzone (211) erstreckt;

43. ein Halbleiterbauelement gemäß einem der Punkte 30. bis 42., bei dem die Driftzone (2) wenigstens eine komplementär zu der Driftzone (2) dotierte Kompensationszone (7) aufweist;

44. ein Halbleiterbauelement gemäß einem der Punkte 30. bis 43., bei dem die Driftsteuerzone (3; 241) elektrisch an die Gateelektrode (15; 221) gekoppelt ist;

45. ein Halbleiterbauelement gemäß Punkt 44., bei dem die Driftsteuerzone (3; 241) über ein Gleichrichterelement (42; 264) an die Gateelektrode (15; 221) gekoppelt ist;

46. ein Halbleiterbauelement gemäß einem der Punkte 30. bis 45., das eine die Drainzone (5) kontaktierende Drainelektrode (11) aufweist und bei dem abschnittsweise eine komplementär zu der Drainzone (5) und der Driftzone (2) dotierte Halbleiterzone (27) zwischen der Drainelektrode (11) und der Driftzone (2) angeordnet ist;

47. ein Halbleiterbauelement gemäß einem der zuvor genannten Punkte, bei dem der Halbleiterkörper (100) eine senkrecht zu einer ersten lateralen Richtung (x) verlaufende zweite laterale Richtung (y) aufweist und bei dem die wenigstens eine Driftsteuerzone (241) wenigstens abschnittsweise in der zweiten lateralen Richtung (y) getrennt durch das Akkumulationsdielektrikum (251) benachbart zu der Driftzone (211) angeordnet ist;

48. ein Halbleiterbauelement gemäß Punkt 47., das mehrere in der zweiten lateralen Richtung (y) beabstandet zueinander angeordnete Driftzonen (211) und mehrere in der zweiten lateralen Richtung beabstandet zueinander angeordnete Driftsteuerzonen (241) aufweist;

49. ein Halbleiterbauelement gemäß einem der Punkte 1. bis 46., bei dem der Halbleiterkörper (100) eine vertikale Richtung (v) aufweist und bei dem die wenigstens eine Driftsteuerzone (241) wenigstens abschnittsweise in der vertikalen Richtung (v) benachbart zu der Driftzone (211) angeordnet ist;

50. ein Halbleiterbauelement gemäß Punkt 49., das mehrere in der vertikalen Richtung (v) beabstandet zueinander angeordnete Driftzonen (211) und mehrere in der vertikalen Richtung (v) beabstandet zueinander angeordnete Driftsteuerzonen (241) aufweist;

51. ein Halbleiterbauelement gemäß einem der zuvor genannten Punkte, bei dem der Halbleiterkörper (100) ein Halbleitersubstrat (103) und eine auf dem Halbleitersubstrat (103) angeordnete Halbleiterschicht (104) aufweist, wobei die wenigstens eine Driftzone (211) und die wenigstens eine Driftsteuerzone (241) in der Halbleiterschicht (104) angeordnet sind;

52. ein Halbleiterbauelement gemäß Punkt 51., bei dem die Driftzone (211) an das Halbleitersubstrat (103) angrenzt und bei dem eine Isolationsschicht (252) zwischen der Driftsteuerzone (241) und dem Halbleitersubstrat (103) angeordnet ist;

53. ein Halbleiterbauelement gemäß Punkt 51., bei dem eine Isolationsschicht (105) zwischen dem Halbleitersubstrat (103) und der Driftzone (211) und der Driftsteuerzone (241) angeordnet ist;

54. ein Halbleiterbauelement gemäß Punkt 53., bei dem das Halbleitersubstrat (103) eine Grunddotierung eines Leitungstyps aufweist und bei dem das Halbleitersubstrat (103) anschließend an die Isolationsschicht (105) wenigstens eine Halbleiterzone (218A-218D; 219) aufweist, die von einem zum Leitungstyp der Grunddotierung komplementären Leitungstyp ist;

55. ein Halbleiterbauelement gemäß Punkt 52., bei dem das Halbleitersubstrat (103) eine Grunddotierung eines Leitungstyps aufweist und bei dem das Halbleitersubstrat (103) wenigstens eine Halbleiterzone (218A-218D; 219) aufweist, die von einem zum Leitungstyp der Grunddotierung komplementären Leitungstyp ist;

56. ein Halbleiterbauelement gemäß Punkt 54. oder 55., bei dem die komplementär zu der Grunddotierung dotierte Halbleiterzone (218A-218D; 219) über eine Verbindungszone (217) an die erste Bauelementzone (212) angeschlossen ist;

57. ein Halbleiterbauelement gemäß Punkt 56., das mehrere komplementär zu der Grunddotierung des Halbleitersubstrats dotierte Halbleiterzonen (218A-218D) aufweist, die in der ersten lateralen Richtung beabstandet zueinander angeordnet sind und von denen eine an die Verbindungszone (217) angeschlossen ist;

58. ein Halbleiterbauelement gemäß Punkt 56., bei dem eine Dotierungsdosis der komplementär zu der Grunddotierung des Halbleitersubstrats (103) dotierten Halbleiterzone (219) in der ersten lateralen Richtung (x) abnimmt;

59. ein Halbleiterbauelement gemäß einem der Punkte 1. bis 29., das als Schottky-Diode ausgebildet ist, bei der die erste Bauelementzone (8; 212) eine Anodenzone und die zweite Bauelementzone (5; 214) eine Kathodenzone bildet;

60. ein Halbleiterbauelement gemäß einem der zuvor genannten Punkte, bei der die Driftsteuerzone (3; 241) eine Anschlusselektrode (19) zum Anlegen eines Ansteuerpotentials aufweist;

61. ein Halbleiterbauelement gemäß einem der zuvor genannten Punkte, bei dem das Akkumulationsdielektrikum (4) wenigstens zwei Teilschichten aufweist;

62. ein Halbleiterbauelement gemäß Punkt 61., bei dem das Akkumulationsdielektrikum (4) wenigstens eine Teilschicht mit einer relativen Dielektrizitätskonstante von 7 oder größer aufweist;

63. ein Leistungstransistor, der einen Halbleiterkörper und folgende weitere Merkmale aufweist:

- eine Sourcezone (9) und eine Drainzone (5) eines ersten Leitungstyps,

- eine Driftzone (2), die sich an die Drainzone (5) anschließt,

- eine Bodyzone (8) eines zweiten Leitungstyps, die zwischen der Sourcezone (9) und der Driftzone (2) angeordnet ist,

- eine Gateelektrode (15) und ein Gatedielektrikum (16), das zwischen der Gateelektrode (15) und der Bodyzone (8) angeordnet ist,

- eine Driftsteuerzone (3; 241) aus einem Halbleitermaterial, die zumindest abschnittsweise benachbart zu der Driftzone (2) in dem Halbleiterkörper angeordnet ist und die an die Sourcezone (9) und die Drainzone (5) gekoppelt ist,

- ein Akkumulationsdielektrikum (4; 251), das zwischen der Driftzone (2; 211) und der Driftsteuerzone (3; 241) angeordnet ist;

64. ein Leistungstransistor gemäß Punkt 63., bei dem die Driftsteuerzone (3) über jeweils ein Gleichrichterelement (41, 43) an die Drainzone (5) und die Sourcezone (9) gekoppelt ist;

65. ein Leistungstransistor gemäß Punkt 63., bei dem die Driftsteuerzone (3) über ein Tunneldielektrikum (4') und einen Abschnitt der Driftzone (2) an die Drainzone (5) gekoppelt ist;

66. ein Leistungstransistor gemäß einem der Punkte 63. bis 65., bei dem die Drainzone (5) durch eine Drainelektrode (11) kontaktiert ist und bei dem eine komplementär zu der Driftzone (2) und der Drainzone (5) dotierte Zwischenzone (27) zwischen der Drainelektrode (11) und der Driftzone (2) angeordnet ist;

67. ein Leistungstransistor gemäß einem der Punkte 63. bis 65., bei dem die Driftzone (2) vom gleichen Leitungstyp wie die Bodyzone (8) ist;

68. ein Leistungstransistor gemäß einem der Punkte 63. bis 65., bei dem die Driftzone (2) komplementär zu der Bodyzone (8) dotiert ist;

69. ein Leistungstransistor, der einen Halbleiterkörper und folgende weitere Merkmale aufweist:

- eine Sourcezone (9) und eine Drainzone (5) eines ersten Leitungstyps,

- eine Driftzone (2), die sich an die Drainzone (5) anschließt und die komplementär zu der Drainzone (5) dotiert ist,

- eine Bodyzone (8) eines zweiten Leitungstyps, die zwischen der Sourcezone (9) und der Driftzone (2) angeordnet ist,

- eine Gateelektrode (15) und ein Gatedielektrikum (16), das zwischen der Gateelektrode (15) und der Bodyzone (8) angeordnet ist,

- eine Driftsteuerzone (3; 241) aus einem Halbleitermaterial, die zumindest abschnittsweise benachbart zu der Driftzone (2) in dem Halbleiterkörper angeordnet ist,

- ein Akkumulationsdielektrikum (4; 251), das zwischen der Driftzone (2; 211) und der Driftsteuerzone (3; 241) angeordnet ist;

70. ein Leistungstransistor gemäß Punkt 69., bei dem die Driftsteuerzone (3) an die Drainzone (5) gekoppelt ist;

71. ein Leistungstransistor gemäß Punkt 69. oder 70., bei dem die Driftsteuerzone (3) an die Sourcezone (9) gekoppelt ist.

**Patentansprüche**

1. Halbleiterbauelement das einen Halbleiterkörper (100) und folgende weitere Merkmale aufweist:

   eine Driftzone (2; 211) eines ersten Leitungstyps in dem Halbleiterkörper (100),
   eine Driftsteuerzone (3; 241) aus einem Halbleitermaterial, die zumindest abschnittsweise benachbart zu der Driftzone (2) in dem Halbleiterkörper angeordnet ist,
   ein Akkumulationsdielektrikum (4; 251), das zwischen der Driftzone (2; 211) und der Driftsteuerzone (3; 241) angeordnet ist,
   eine erste Bauelementzone (8; 212) und eine beabstandet zu der ersten Bauelementzone (8) angeordnete zweite Bauelementzone (5; 214), zwischen denen die Driftzone (2; 211) angeordnet ist,
   ein kapazitives Bauelement (50; 263), das zwischen die Driftsteuerzone (3; 241) und die erste Bauelementzone (8; 212) geschaltet ist.

2. Halbleiterbauelement nach Anspruch 1, bei dem die Driftsteuerzone (3; 241) über ein Gleichrichterelement (41; 266) an die erste Bauelementzone (8; 212) gekoppelt ist.

3. Halbleiterbauelement nach einem der Ansprüche 1 oder 2, bei dem die Driftsteuerzone (3; 241) eine Anschlusselektrode (19; 233) aufweist, wobei das kapazitive Bauelement (50; 263) zwischen die Anschlusselektrode (19; 233) und die erste Bauelementzone (8; 212) geschaltet ist.

4. Halbleiterbauelement nach Anspruch 3, bei dem eine komplementär zu der Driftsteuerzone (3; 241) dotierte Anschlusszone (33, 34; 244) zwischen der Driftsteuerzone (3; 241) und der Anschlusselektrode (19; 233) angeordnet ist.

5. Halbleiterbauelement nach Anspruch 4, bei dem die Anschlusszone (34) zwischen der Anschlusselektrode (19) und einem Dielektrikum (129) des kapazitiven Bauelements angeordnet ist.

6. Halbleiterbauelement nach einem der Ansprüche 1 bis 5, bei dem die Driftsteuerzone (3; 241) vom gleichen Leitungstyp wie die Driftzone (2; 211) ist.

7. Halbleiterbauelement nach einem der Ansprüche 1 bis 5, bei dem die Driftsteuerzone (3; 241) von einem zum Leitungstyp der Driftzone (2; 211) komplementären Leitungstyp ist.

8. Halbleiterbauelement nach einem der vorangehenden Ansprüche, bei dem die Driftsteuerzone (3; 241) über ein Gleichrichterelement (43; 261) an die zweite Bauelementzone (5; 214) gekoppelt ist.

9. Halbleiterbauelement nach einem der vorangehenden Ansprüche, bei dem das kapazitive Bauelement (50; 263) in dem Halbleiterkörper (100) integriert ist.

10. Halbleiterbauelement nach Anspruch 9, bei dem das kapazitive Bauelement (50) ein zusätzlich zu dem Akkumulationsdielektrikum vorhandenes Dielektrikum (129) aufweist.

11. Halbleiterbauelement nach einem der vorabgehenden Ansprüche, das als MOS-Transistor ausgebildet ist, bei dem die erste Bauelementzone (8; 212) eine Bodyzone und die zweite Bauelementzone (5; 214) eine Drainzone bildet und das folgende weitere Merkmale aufweist:

    - eine Sourcezone (9; 212), die durch die Bodyzone (8; 212) von der Driftzone (2; 211) getrennt ist,
    - eine Gateelektrode (15; 221), die mittels eines Gatedielektrikums (16; 222) gegenüber dem Halbleiterkörper (100) isoliert ist und die sich benachbart zu der Bodyzone (8; 212) von der Sourcezone (9; 213) bis zu der Driftzone (2; 211) erstreckt.

12. Halbleiterbauelement nach Anspruch 11, bei dem die Bodyzone (8) und die Sourcezone (9) durch eine Sourceelektrode (13) und eine höher als die Bodyzone (8) dotierte Halbleiterzone (17) des gleichen Leitungstyps wie die Bodyzone (8) miteinander verbunden sind und bei dem das kapazitive Bauelement (50) an die Sourceelektrode (13) angeschlossen ist.

13. Halbleiterbauelement nach Anspruch 11 oder 12, bei dem die Drainzone (5; 214) vom gleichen Leitungstyp wie die Driftzone (2; 211) ist oder bei dem die Drainzone (5; 214) komplementär zu der Driftzone (2; 211) dotiert ist.

**14.** Halbleiterbauelement nach Anspruch 11 oder 12, das als MOSFET ausgebildet ist, bei dem die Driftzone (2) komplementär zu der Sourcezone (9) dotiert ist.

**15.** Halbleiterbauelement nach Anspruch 14, bei dem eine Zwischenzone (22) des gleichen Leitungstyps wie die Sourcezone (9; 213) zwischen der Driftzone (2; 211) und der Bodyzone (8; 212) angeordnet ist.

**16.** Halbleiterbauelement nach einem der Ansprüche 11 bis 15, bei dem die Driftsteuerzone (3; 241) elektrisch an die Gateelektrode (15; 221) gekoppelt ist.

**17.** Halbleiterbauelement nach Anspruch 16, bei dem die Driftsteuerzone (3; 241) über ein Gleichrichterelement (42; 264) an die Gateelektrode (15; 221) gekoppelt ist.

**18.** Halbleiterbauelement nach einem der Ansprüche, 11 bis 17, das eine die Drainzone (5) kontaktierende Drainelektrode (11) aufweist und das zusätzlich eine komplementär zu der Drainzone (5) und der Driftzone (2) dotierte Halbleiterzone (27) aufweist, die zwischen der Drainelektrode (11) und der Driftzone (2) angeordnet ist.

FIG 1

FIG 2

EP 2 267 785 A2

EP 2 267 785 A2

**FIG 3**

FIG 4

EP 2 267 785 A2

FIG 5

EP 2 267 785 A2

## FIG 6

FIG 7

EP 2 267 785 A2

FIG 8

EP 2 267 785 A2

FIG 9

FIG 10

EP 2 267 785 A2

FIG 11

# FIG 12

# FIG 13

v

13

15

$10^6$

$10^5$  $10^4$  $10^3$

$10^{15}$

$10^{14}$

$10^{15}$

$10^{16}$  $10^{18}$

11

$e^-/cm^3$

r

# FIG 14

v

19

13

15

3

$10^3$

2

$10^4$

$10^{16}$

$10^{18}$

$10^{17}$

$10^6$

$10^5$

$10^{17}$

108

$10^{18}$

4

11

$e^-/cm^3$

r

EP 2 267 785 A2

# FIG 15

MOSFET gemäß Fig.12
Stand der Technik

# FIG 16

EP 2 267 785 A2

# FIG 17A

42b  42  42a

V

41

50

19
34   p+
33   p-

p+

n+
9   p-

13

15

17   8   16

3   n⁻

n⁻

2

4

31   n
32   p-

n+   5

11   r

100

# FIG 17B

42b  42  42a

50

41

41b  41a

19
34   p+
33   p-

p+

n+
9   p-

13

15

17   8   16

3   n⁻

n⁻

2

4

31   n+

4'   p-

n+   5

11   r

100

FIG 19

FIG 18

FIG 21

FIG 20

FIG 22  I-I

FIG 23A

EP 2 267 785 A2

FIG 24

FIG 25

FIG 23B

# FIG 26

13

100

17 — p+    n+ — 16

p−    9

8

2

n−

17 — p+

n+ — 16

p− — 9

15

4 — 4

3 — 3

n — 31

p− — 32

n+ — 5

11

# FIG 27

13

100

16  15  34

17 — p+    n+

p−  9

8

33

2

n−

4 — 4

3 — 3

n — 31

p− — 32

n+ — 5

11

EP 2 267 785 A2

FIG 28

EP 2 267 785 A2

**FIG 29**

**FIG 30**

FIG 31

FIG 32

EP 2 267 785 A2

# FIG 33

FIG 35

FIG 34

FIG 36

FIG 37

EP 2 267 785 A2

FIG 38

FIG 39

EP 2 267 785 A2

## FIG 40

FIG 41

FIG 42

## FIG 43

FIG 44

FIG 45

EP 2 267 785 A2

FIG 46

FIG 47

EP 2 267 785 A2

## FIG 48A

## FIG 48B

FIG 48D

FIG 48C

FIG 49A

V-V

EP 2 267 785 A2

# FIG 49B

III-III ——— 3

IV-IV - - -

EP 2 267 785 A2

FIG 50B

128 34 129 p+ 4

FIG 51

128 129 p+ 34

FIG 50A

100 101 50 15 16 9 n+ p- 8 17 p+ 2 5 n- n+ 4 129 128 n- n p- 34 33 3 31 32 11

## FIG 52

## FIG 53B

FIG 54

FIG 53A

# FIG 55

# FIG 56

EP 2 267 785 A2

FIG 57

FIG 58

FIG 59

FIG 60

## FIG 61

FIG 62

## FIG 63

FIG 64

# FIG 65

EP 2 267 785 A2

FIG 66

FIG 67

FIG 68

FIG 69

EP 2 267 785 A2

## FIG 70

FIG 71

EP 2 267 785 A2

FIG 72

FIG 73

FIG 74

EP 2 267 785 A2

FIG 75

EP 2 267 785 A2

EP 2 267 785 A2

**FIG 76**

# FIG 77

EP 2 267 785 A2

## FIG 78

EP 2 267 785 A2

# FIG 79

EP 2 267 785 A2

# FIG 80

EP 2 267 785 A2

FIG 81

EP 2 267 785 A2

FIG 82

# FIG 83

EP 2 267 785 A2

# FIG 84

EP 2 267 785 A2

# FIG 85

EP 2 267 785 A2

## FIG 86

## FIG 87

## FIG 88

## FIG 89

# FIG 90

# FIG 91

# FIG 92

# FIG 93

FIG 94

FIG 95

FIG 96

FIG 97

# FIG 98

# FIG 99

# FIG 100

FIG 101

FIG 102

FIG 104

FIG 103

FIG 105

72    n+   13

15
16
9    p    9
74
19          8
34    p          p

3

n⁻/p⁻    n⁻    n⁻/p⁻
4
2

5

31    n+          n+
32    p    n+    p
11

FIG 106A

n+ — 51

52

FIG 106B    p    n+    p — 32
                        — 51
            n+
                        — 101

FIG 106C

            p          — 9'

1 →
            n⁻         — 2'

            n    52
                        — 53'
        p    n+    p    — 32
            n+         — 51

EP 2 267 785 A2

# FIG 106D

# FIG 106E

EP 2 267 785 A2

FIG 107A

FIG 107B

# FIG 107C

# FIG 107D

EP 2 267 785 A2

# FIG 108A

# FIG 108B

EP 2 267 785 A2

FIG 108D

FIG 108C

FIG 108E

FIG 108F

EP 2 267 785 A2

# FIG 109

# FIG 110

EP 2 267 785 A2

# FIG 111A

Z-Z

## FIG 111B

A-A

## FIG 111C

B-B

# FIG 111D

FIG 112

FIG 113

FIG 114A

FIG 114B
C-C

## FIG 114C

D-D

## FIG 114D

FIG 115

FIG 116

221

242

234

233

231

101

232

n

n⁺   p   222   241   251

233

213 212   251   214   252

214

n

211

p

100

102   103

FIG 117

234   221

241

233   100

231   101   232   104

n⁺   p   222   251   n⁺

242

211   213 212   251   214   105

226   226

106   106

p (n)

## FIG 118A

## FIG 118B

## FIG 119

## FIG 120

EP 2 267 785 A2

**FIG 121**

**FIG 122**

FIG 123

FIG 124

255
p⁻ — 103
273
p⁺ 271
272

FIG 125

255
p⁺   p⁻ — 103
273
271
272

FIG 126

255
p⁻ — 103
p⁺ — 273
271
n⁺ — 274
272

# FIG 127A

# FIG 127B
E-E

# FIG 127C
F-F

## FIG 128A

## FIG 128B

## FIG 128C

# FIG 129A

221            241

222    224   244         251     233

H

231       p    212         n     251    232     214 H

213    n+                    n+

G

211

# FIG 129B

G-G

231    212         211            232

213   n+   p         n        n+  — 214    100

105             104

                 226

226   106             106     103

# FIG 129C

H-H

      234        241          223

221                         100

224                n+   242

244          n           104

                  105

                  103

**FIG 130**

**FIG 131**

## FIG 132A

103
103

## FIG 132B

252'
103

## FIG 132C

I–I
y
252
103

## FIG 132D

y
103   252   103   252

## FIG 132E

y

252     252 — 104

103

## FIG 132F

200 107

252

104

103

## FIG 132G

251 211     241

252

104

103

FIG 133

## FIG 134A

## FIG 134B
J-J

## FIG 134C
K-K

## FIG 134D

## FIG 134E

## FIG 135A

213 212 211    234                    251

n+    p          244

222

233

p  221

M

N

241    211 214

M

N

## FIG 135B

M-M

222  221          241        251   214

n+

211

## FIG 135C

N-N

213  212          241        251   214

n+   p                              n+

211

# FIG 136A

# FIG 136B

FIG 136C

231 222 221 224 244 241 211 101 251 257 245 232

Q↓                                                        ↓Q

214

213                        212

100

FIG 136D
Q-Q

231 213 212 211 232

n

100

## FIG 137A

## FIG 137B

## FIG 137C

## FIG 137D

## FIG 137E

## FIG 137F

FIG 138A

FIG 138B

FIG 139

## FIG 140

## FIG 141

## FIG 142A

## FIG 142B

## FIG 143A

## FIG 143B

## FIG 144

## FIG 145

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4754310 A, Coe
- US 5216275 A1, Chen
- US 5438215 A
- DE 4309764 C2, Tihanyi
- US 4903189 A, Ngo
- US 4941026 A, Temple
- US 6555873 B2, Disney
- US 6717230 B2, Kocon
- US 6853033 B2, Liang
- EP 1073123 A2, Yasuhara
- GB 2089118 A
- US 5844272 A, Söderbärg
- US 20030073287 A1, Kocon